# EUROPEAN PATENT SPECIFICATION

(11) **EP 3 630 920 B1**
(45) Date of publication and mention of the grant of the patent: **07.12.2022**
(21) Application number: 18727818.9
(22) Date of filing: 01.06.2018
(51) Int. Cl.: C09K 11/02, C09K 11/70, C09K 11/88, H01L 33/50, C09D 11/50

(54) **INK COMPRISING ENCAPSULATED NANOPARTICLES**
TINTE ENTHALTEND VERKAPSELTE NANOPARTIKEL
ENCRE COMPRENANT DES NANOPARTICULES ENCAPSULÉES

(30) Priority: 02.06.2017 US 201762514297 P; 02.06.2017 US 201762514601 P; 22.09.2017 EP 17306241; 22.09.2017 EP 17306249; 11.12.2017 EP 17206479; 22.12.2017 US 201762609932 P; 16.02.2018 US 201862710298 P; 13.03.2018 US 201862642370 P
(43) Date of publication of application: 08.04.2020
(73) Proprietor: Nexdot, 93230 Romainville (FR)
(72) Inventor: POUSTHOMIS, Marc, 93230 Romainville (FR); D'AMICO, Michele, 93230 Romainville (FR); KUNTZMANN, Alexis, 93230 Romainville (FR); LIN, Yu-Pu, 93230 Romainville (FR); CAO, Edgar, 93230 Romainville (FR); FAIDEAU, Robin, 93230 Romainville (FR)
(74) Representative: Icosa
(86) International application number: PCT/EP2018/064442
(87) International publication number: WO 2018/220168

(56) References cited:
- WO-A1-2016/166514
- WO-A1-2017/020137
- US-A1- 2001 032 964
- US-A1- 2007 045 777
- US-A1- 2011 068 321
- US-A1- 2013 075 692
- US-A1- 2014 264 196

## Description

### FIELD OF INVENTION

The present invention pertains to the field of inks. In particular, the invention relates to inks comprising particles encapsulating luminescent nanoparticles.

### BACKGROUND OF INVENTION

Panel displays and other thin film optoelectronic devices involve the creation of precise patterns on a support. Inkjet printing is a useful technology to achieve these patterns, especially over a large area.

Luminescent inorganic particles, especially semiconductor nanoparticles known as emissive material, are currently used in display devices as phosphors. Printing those nanoparticles on a support to create pixels has become an interest over the last years.

However, an important issue regarding inkjet printing is the abrasion of the printing elements such as printing systems, printheads and especially nozzles. The abrasion can be a mechanical and/or chemical abrasion, due to the hardness and roughness of the particles comprised in the ink, and to the chemically aggressive particles comprised in the ink respectively. This will cause the protective overcoat layer of the printhead to wear prematurely. This abrasion phenomenon induces also diminished performance, early deterioration and a shorten lifetime of the printing elements.

Therefore, there is a real need for solutions reducing the chances of abrasion of the printing elements.

To ensure a long lifetime of the printing elements, mechanical and/or chemical reactions between the printing elements surface and the particles comprised in the ink have to be prevented. This can be achieved by encapsulating said particles in a protective material that will prevent such reactions. The encapsulation of particles in a material can help tailoring the hardness, shape and roughness of said particles and provide a barrier between said particles and the printing elements surface. This protective material has then a dual role as it can protect the printing elements from reaction with the particles and protect said particles from the environment, ensuring this way a long lifetime of the printing elements and a long-term stability of the particles in the environment. However, this encapsulation should not be at the expense of the particles properties.

It is known to coat nanoparticles with a protective shell, *i.e.,* to encapsulate nanoparticles in another material, to prevent deteriorating species or harmful compounds, such as water, oxygen or other harmful compounds, from reaching said nanoparticles surface. Silica is known to be an insulating protective material for nanoparticles.

For example, US patent US 9,425,365 discloses the encapsulation of quantum dots, including a nanocrystalline core and a nanocrystalline shell, in mesoporous silica using a reverse micellar method. The obtained particles are mesoporous silica nanoparticles, each comprising only one quantum dot. However, said particles are mesoporous which means that they comprise a porous network of silica that allows access to the quantum dots surface for deteriorating species, like water and oxygen, or other harmful compounds. The protection of said surface is thus ineffective and does not enable a long-term stability in time and temperature.

Gui et al. discloses the encapsulation of multiple PbSe quantum dots in silica particles using a base-catalyzed sol-gel method (Analyst, 2013, 138, 5956). However, said PbSe quantum dots are aggregated in the silica particles, resulting in a decrease of the photoluminescence quantum yield. The silica particles are porous, allowing access to the quantum dots surface for deteriorating species, like water, oxygen or other harmful compounds.

Document US 2007/045777 disloses an ink comprising particles with a plurality of quantum dots embedded in a micronized polymer. However, said particles are not totally spherical and can have a rough surface, resulting in a high risk of damaging the inkjet nozzle. Document US 2011/068321 discloses beads comprising quantum dots in a polymer and beads comprising quantum dots encapsulated in a first polymer, themselves encapsulated in a second polymer. However, document US 2011/068321 does not disclose an ink. Document US 2013/075692 discloses an ink comprising light emitting particles including a population of quantum dots embedded within a polymeric encapsulation medium. However, said light emitting particles are not totally spherical and can have a rough surface, resulting in a high risk of damaging the inkjet nozzle. Document WO 2017/020137 discloses an ink comprising quantum dots, surfactant, solvent and optionally a polymer. In WO 2017/020137, quantum dots are not encapsulated in an inorganic material, therefore becoming vulnerable to chemical attacks from their environment. Document WO 2016/166514 discloses an ink comprising phosphor particles and a resinous binder. Document US 2001/032964 discloses an ink comprising a fluorescent substance. Neither document WO 2016/166514, nor US 2001/032964 discloses the encapsulation of nanoparticles for incorporation in an ink. Document US 2014/264196 discloses multi-layered beads containing quantum dots. However, document US 2014/264196 does not disclose an ink.

Preparing an ink comprising semiconductor nanoparticles (*i.e.,* quantum dots) can also be fastidious and time consuming as a functionalization step is needed to render the semiconductor nanoparticles compatible with the liquid vehicle of the ink. This additional step always results in a degradation of the photoluminescence properties of said nanoparticles, especially photoluminescence quantum yield. Encapsulating said nanoparticles in a protective material readily compatible with the liquid vehicle of the ink allows for a faster preparation as the functionalization step is not needed anymore. Furthermore, the photoluminescence properties of said nanoparticles are preserved.

Furthermore, encapsulating particles can be tailored to be air processable allowing an easy manipulation, transport and use of said particles in a device such as an optoelectronic device.

It is therefore an object of the present invention to provide an ink comprising particles encapsulating nanoparticles. These particles have one or more of the following advantages: preventing the abrasion of the printing elements by tailoring the hardness, shape and roughness of said particles; enhanced stability over temperature, environment variations and deteriorating species like water and oxygen, or other harmful compounds attacks; coupling the properties of different nanoparticles encapsulated in the same particle; preventing a decrease of the properties of encapsulated nanoparticles; enhanced photoluminescence quantum yield; enhanced resistance to photobleaching and enhanced resistance to photon flux in the case of luminescent particles; air processable particles.

Said particles can also easily comply with ROHS requirements depending on the protective materials selected. It is a great advantage to have ROHS compliant particles while preserving the properties of encapsulated nanoparticles that may not be ROHS compliant themselves.

### SUMMARY

In a first aspect, the present invention relates to an ink comprising:
- at least one particle comprising a first material and at least one liquid vehicle;
   wherein the particle comprises at least one particle comprising a second material and at least one nanoparticle dispersed in said second material;
   wherein the first material and the second material have an attenuation coefficient less or equal to 1×10⁻² cm⁻¹ at 460 nm;
   wherein the at least one nanoparticle is a luminescent nanoparticle and comprises at least 1% of semiconductor nanoplatelets; or
      - at least one particle comprising a plurality of nanoparticles encapsulated in a material and at least one liquid vehicle;
   wherein said particle has a surface roughness less or equal to 5% of the largest dimension of said particle; wherein the at least one nanoparticle is a luminescent nanoparticle and comprises at least 1% of semiconductor nanoplatelets; or
      - at least one particle comprising a first material and at least one liquid vehicle;
   wherein the particle comprises at least one particle comprising a second material and at least one nanoparticle dispersed in said second material;
   wherein said particle has a surface roughness less or equal to 5% of the largest dimension of said particle; wherein the at least one nanoparticle is a luminescent nanoparticle and comprises at least 1% of semiconductor nanoplatelets.

In one embodiment, the first material limits or prevents the diffusion of outer molecular species or fluids (liquid or gas) into said first material.

According to one embodiment, the specific property of the particle **2** is preserved after encapsulation in the particle **1.**

According to one embodiment, the photoluminescence of the particle **2** is preserved after encapsulation in the particle **1.**

According to one embodiment, the first material has a density ranging from 1 g/cm³ to 10 g/cm³, preferably the first material has a density ranging from 3 g/cm³ to 10 g/cm³.

In one embodiment, the first material has a density superior or equal to the density of the second material.

In one embodiment, the first material has a thermal conductivity at standard conditions of at least 0.1 W/(m.K).

In one embodiment, the at least one nanoparticle is a semiconductor nanocrystal.

In one embodiment, the semiconductor nanocrystal comprises a core comprising a material of formula MₓN_{y}E_{z}A_{w}, wherein: M is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; N is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; E is selected from the group consisting of O, S, Se, Te, C, N, P, As, Sb, F, Cl, Br, I, or a mixture thereof; A is selected from the group consisting of O, S, Se, Te, C, N, P, As, Sb, F, Cl, Br, I, or a mixture thereof; and x, y, z and w are independently a decimal number from 0 to 5; x, y, z and w are not simultaneously equal to 0; x and y are not simultaneously equal to 0; z and w may not be simultaneously equal to 0.

In one embodiment, the semiconductor nanocrystal comprises at least one shell comprising a material of formula MₓN_{y}E_{z}A_{w}, wherein: M is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; N is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; E is selected from the group consisting of O, S, Se, Te, C, N, P, As, Sb, F, Cl, Br, I, or a mixture thereof; A is selected from the group consisting of O, S, Se, Te, C, N, P, As, Sb, F, Cl, Br, I, or a mixture thereof; and x, y, z and w are independently a decimal number from 0 to 5; x, y, z and w are not simultaneously equal to 0; x and y are not simultaneously equal to 0; z and w may not be simultaneously equal to 0.

In one embodiment, the semiconductor nanocrystal comprises at least one crown comprising a material of formula MₓN_{y}E_{z}A_{w}, wherein: M is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; N is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; E is selected from the group consisting of O, S, Se, Te, C, N, P, As, Sb, F, Cl, Br, I, or a mixture thereof; A is selected from the group consisting of O, S, Se, Te, C, N, P, As, Sb, F, Cl, Br, I, or a mixture thereof; and x, y, z and w are independently a decimal number from 0 to 5; x, y, z and w are not simultaneously equal to 0; x and y are not simultaneously equal to 0; z and w may not be simultaneously equal to 0.

In one embodiment, the semiconductor nanocrystal is a semiconductor nanoplatelet.

In one embodiment, the at least one liquid vehicle comprises a liquid including but not limited to: 1-methoxy-2-propanol, 2-pyrrolidinone, C4 to C8 1,2-alkanediol, aliphatic or alicycle ketone, methyl ethyl ketone, C1-C4 alkanol such as for example methanol, ethanol, methanol, propanol, or isopropanol, ketones, esters, ether of ethylene glycol or propylene glycol, acetals, acrylic resin, polyvinyl acetate, polyvinyl alcohol, polyamide resin, polyurethane resin, epoxy resin, alkyd ester, nitrated cellulose, ethyl cellulose, sodium carboxymethyl cellulose, alkyds, maleics, cellulose derivatives, formaldehyde, rubber resin, phenolics, propyl acetate, glycol ether, aliphatic hydrocarbon, acetate, ester. acrylic, cellulose ester, nitrocellulose, modified resin, alkoxylated alcohol, 2-pyrrolidone, a homolog of 2-pyrrolidone, glycol, water, or a mixture thereof.

In another aspect, the present invention relates to a particle deposited on a support by inkjet printing; wherein the particle comprises:
- a first material, and at least one particle comprising a second material and at least one nanoparticle dispersed in said second material; and
   wherein the first material and the second material have an attenuation coefficient less or equal to 1×10⁻¹ cm ⁻¹ at 460 nm;
   wherein the at least one nanoparticle is a luminescent nanoparticle and comprises at least 1%, of semiconductor nanoplatelets; or
- a first material, and at least one particle comprising a second material and at least one nanoparticle dispersed in said second material; and
   wherein said particle has a surface roughness less or equal to 5% of the largest dimension of said particle;
   wherein the at least one nanoparticle is a luminescent nanoparticle and comprises at least 1%, of semiconductor nanoplatelets.

In another aspect, the present invention relates to a particle deposited on a support by inkjet printing;
wherein said particle comprises a plurality of nanoparticles encapsulated in a material; and
wherein said particle has a surface roughness less or equal to 5% of the largest dimension of said particle;
wherein the nanoparticles are luminescent nanoparticles and comprise at least 1%, of semiconductor nanoplatelets.

In another aspect, the present invention relates to a pattern comprising at least one ink of the invention deposited by inkjet printing on a support.

In one embodiment, the support is a LED chip or microsized LED.

In another aspect, the present invention relates to an optoelectronic device comprising at least one ink of the invention.

In another aspect, the present invention relates to a method for depositing an ink of the invention on a support. comprising:
- printing the ink on a support using inkjet printing; and
- evaporating the solvent and/or the liquid vehicle.

### DEFINITIONS

In the present invention, the following terms have the following meanings:
- **"Acidic function"** refers to -COOH group.
- **"Activated acidic function"** refers to an acidic function wherein the -OH is replaced by a better leaving group.
- **"Activated alcoholic function"** refers to an alcoholic function modified to be a better leaving group.
- **"Adjacent particle"** refers to neighbouring particles in a space or a volume, without any other particle between said adjacent particles.
- **"Alkenyl"** refers to any linear or branched hydrocarbon chain having at least one double bond, of 2 to 12 carbon atoms, and preferably 2 to 6 carbon atoms. The alkenyl group may be substituted. Examples of alkenyl groups are ethenyl, 2- propenyl, 2-butenyl, 3-butenyl, 2-pentenyl and its isomers, 2-hexenyl and its isomers, 2,4-pentadienyl and the like. The alkenyl group may be substituted by a saturated or unsaturated aryl group.
- The terms **"Alkenylene"** means an alkenyl group as defined above having two single bonds as points of attachment to other groups.
- **"Alkoxy"** refers to any O-alkyl group, preferably an O-alkyl group wherein the alkyl group has 1 to 6 carbon atoms.
- **"Alkyl"** refers to any saturated linear or branched hydrocarbon chain, with 1 to 12 carbon atoms, preferably 1 to 6 carbon atoms, and more preferably methyl, ethyl, propyl, isopropyl, n-butyl, sec-butyl, isobutyl and tert-butyl. The alkyl group may be substituted by a saturated or unsaturated aryl group.
- When the suffix **"ene" ("alkylene")** is used in conjunction with an alkyl group, this is intended to mean the alkyl group as defined herein having two single bonds as points of attachment to other groups. The term "alkylene" includes methylene, ethylene, methylmethylene, propylene, ethylethylene, and 1,2-dimethylethylene.
- **"Alkynyl",** refers to any linear or branched hydrocarbon chain having at least one triple bond, of 2 to 12 carbon atoms, and preferably 2 to 6 carbon atoms.
- **"Amine"** refers to any group derived from ammoniac NH₃ by substitution of one or more hydrogen atoms with an organic radical.
- **"Aqueous solvent"** is defined as a unique-phase solvent wherein water is the main chemical species in terms of molar ratio and/or in terms of mass and/or in terms of volume in respect to the other chemical species contained in said aqueous solvent. The aqueous solvent includes but is not limited to: water, water mixed with an organic solvent miscible with water such as for example methanol, ethanol, acetone, tetrahydrofuran, n-methylformamide, n,n-dimethylformamide, dimethylsulfoxide or a mixture thereof.
- **"Aryl"** refers to a mono- or polycyclic system of 5 to 20, and preferably 6 to 12, carbon atoms having one or more aromatic rings (when there are two rings, it is called a biaryl) among which it is possible to cite the phenyl group, the biphenyl group, the 1-naphthyl group, the 2-naphthyl group, the tetrahydronaphthyl group, the indanyl group and the binaphthyl group. The term aryl also means any aromatic ring including at least one heteroatom chosen from an oxygen, nitrogen or sulfur atom. The aryl group can be substituted by 1 to 3 substituents chosen independently of one another, among a hydroxyl group, a linear or branched alkyl group comprising 1, 2, 3, 4, 5 or 6 carbon atoms, in particular methyl, ethyl, propyl, butyl, an alkoxy group or a halogen atom, in particular bromine, chlorine and iodine, a nitro group, a cyano group, an azido group, an adhehyde group, a boronato group, a phenyl, CF3, methylenedioxy, ethylenedioxy, SO2NRR', NRR', COOR (where R and R' are each independently selected from the group consisting of H and alkyl), an second aryl group which may be substituted as above. Non-limiting examples of aryl comprise phenyl, biphenylyl, biphenylenyl, 5- or 6- tetralinyl, naphthalen-1- or -2-yl, 4-, 5-, 6 or 7-indenyl, 1- 2-, 3-, 4- or 5- acenaphtylenyl, 3-, 4- or 5-acenaphtenyl, 1- or 2-pentalenyl, 4- or 5-indanyl, 5-, 6-, 7- or 8-tetrahydronaphthyl, 1,2,3,4-tetrahydronaphthyl, 1,4-dihydronaphthyl, 1-, 2-, 3-, 4- or 5-pyrenyl.
- **"Arylalkoxy"** refers to an alkoxy group substituted by an aryl group.
- **"Arylalkyl"** refers to an alkyl group substituted by an aryl group, such as for example the phenyl-methyl group.
- The term **"Arylene"** as used herein is intended to include divalent carbocyclic aromatic ring systems such as phenylene, biphenylylene, naphthylene, indenylene, pentalenylene, azulenylene and the like.
- **"Aryloxy"** refers to any O-aryl group.
- **"Azido"** refers to -N₃ group.
- **"Colloidal"** refers to a substance in which particles are dispersed, suspended and do not settle or would take a very long time to settle appreciably, but are not soluble in said substance.
- **"Colloidal particles"** refers to particles that may be dispersed, suspended and which would not settle or would take a very long time to settle appreciably in another substance, typically in an aqueous or organic solvent, and which are not soluble in said substance. **"Colloidal particles"** does not refer to particles grown on substrate.
- **"Core"** refers to the innermost space within a particle.
- **"Curvature"** refers to the reciprocal of the radius.
- **"Cycle"** refers to a saturated, partially unsaturated or unsaturated cyclic group.
- **"Display apparatus"** refers to an apparatus or a device that displays an image signal. Display devices or display apparatus include all devices that display an image, a succession of pictures or a video such as, non-limitatively, a LCD display device, a television, a projector, a computer monitor, a personal digital assistant, a mobile phone, a laptop computer, a tablet PC, an MP3 player, a CD player, a DVD player, a Blu-Ray player, a head mounted display, glasses, a helmet, a headgear, a headwear, a smart watch, a watch phone or a smart device.
- **"Encapsulate"** refers to a material that coats, surrounds, embeds, contains, comprises, wraps, packs, or encloses a plurality of particles.
- The terms **"Film", "Layer"** or **"Sheet"** are interchangeable in the present invention.
- **"Free of oxygen"** refers to a formulation, a solution, a film, or a composition that is free of molecular oxygen, O₂, *i.e.,* wherein molecular oxygen may be present in said formulation, solution, film, or composition in an amount of less than about 10 ppm, 5 ppm, 4 ppm, 3 ppm, 2 ppm, 1 ppm, 500 ppb, 300 ppb or in an amount of less than about 100 ppb in weight.
- **"Free of water"** refers to a formulation, a solution, a film, or a composition that is free of molecular water, H₂O, *i.e.,* wherein molecular water may be present in said formulation, solution, film, or composition in an amount of less than about 100 ppm, 50 ppm, 10 ppm, 5 ppm, 4 ppm, 3 ppm, 2 ppm, 1 ppm, 500 ppb, 300 ppb or in an amount of less than about 100 ppb in weight.
- **"Gas"** refers to a substance in a gaseous state in standard conditions of pressure and temperature.
- **"Halogen"** means fluoro, chloro, bromo, or iodo. Preferred halo groups are fluoro and chloro.
- **"Heterocycle"** refers to a saturated, partially unsaturated or unsaturated cyclic group comprising at least on heteroatom.
- **"Impermeable"** refers to a material that limits or prevents the diffusion of outer molecular species or fluids (liquid or gas) into said material.
- **"Loading charge"** refers to the mass ratio between the mass of an ensemble of objects comprised in a space and the mass of said space.
- **"Monodisperse"** refers to particles or droplets, wherein the size difference is inferior than 20%, 15%, 10%, preferably 5%.
- **"Narrow size distribution"** refers to a size distribution of a statistical set of particles less than 1%, 2%, 3%, 4%, 5%, 6%, 7%, 8%, 9%, 10%, 15%, 20%, 25%, 30%, 35%, or 40% of the average size.
- **"Nanoplatelet"** refers to a 2D shaped nanoparticle, wherein the smallest dimension of said nanoplatelet is smaller than the largest dimension of said nanoplatelet by a factor (aspect ratio) of at least 1.5, at least 2, at least 2.5, at least 3, at least 3.5, at least 4, at least 4.5, at least 5, at least 5.5, at least 6, at least 6.5, at least 7, at least 7.5, at least 8, at least 8.5, at least 9, at least 9.5 or at least 10.
- **"Optically transparent"** refers to a material that absorbs less than 10%, 5%, 2.5%, 1%, 0.99%, 0.98%, 0.97%, 0.96%, 0.95%, 0.94%, 0.93%, 0.92%, 0.91%, 0.9%, 0.89%, 0.88%, 0.87%, 0.86%, 0.85%, 0.84%, 0.83%, 0.82%, 0.81%, 0.8%, 0.79%, 0.78%, 0.77%, 0.76%, 0.75%, 0.74%, 0.73%, 0.72%, 0.71%, 0.7%, 0.69%, 0.68%, 0.67%, 0.66%, 0.65%, 0.64%, 0.63%, 0.62%, 0.61%, 0.6%, 0.59%, 0.58%, 0.57%, 0.56%, 0.55%, 0.54%, 0.53%, 0.52%, 0.51%, 0.5%, 0.49%, 0.48%, 0.47%, 0.46%, 0.45%, 0.44%, 0.43%, 0.42%, 0.41%, 0.4%, 0.39%, 0.38%, 0.37%, 0.36%, 0.35%, 0.34%, 0.33%, 0.32%, 0.31%, 0.3%, 0.29%, 0.28%, 0.27%, 0.26%, 0.25%, 0.24%, 0.23%, 0.22%, 0.21%, 0.2%, 0.19%, 0.18%, 0.17%, 0.16%, 0.15%, 0.14%, 0.13%, 0.12%, 0.11%, 0.1%, 0.09%, 0.08%, 0.07%, 0.06%, 0.05%, 0.04%, 0.03%, 0.02%, 0.01%, 0.009%, 0.008%, 0.007%, 0.006%, 0.005%, 0.004%, 0.003%, 0.002%, 0.001%, 0.0009%, 0.0008%, 0.0007%, 0.0006%, 0.0005%, 0.0004%, 0.0003%, 0.0002%, 0.0001%, or 0% of light at wavelengths between 200 nm and 50 µm, between 200 nm and 10 µm, between 200 nm and 2500 nm, between 200 nm and 2000 nm, between 200 nm and 1500 nm, between 200 nm and 1000 nm, between 200 nm and 800 nm, between 400 nm and 700 nm, between 400 nm and 600 nm, or between 400 nm and 470 nm.
- **"Outer molecular species or fluids (liquid or gas)"** refers to molecular species or fluids (liquid or gas) coming from outside a material or a particle.
- **"Packing fraction"** refers to the volume ratio between the volume filled by an ensemble of objects into a space and the volume of said space. The terms packing fraction, packing density and packing factor are interchangeable in the present invention.
- **"Partially"** means incomplete. In the case of a ligand exchange, partially means that 5%, 10%, 15%, 20%, 25%, 30%, 35%, 40%, 45%, 50%, 55%, 60%, 65%, 70%, 75%, 80%, 85%, 90%, 95% of the ligands at the surface of a particle have been successfully exchanged.
- **"Permeable"** refers to a material that allows the diffusion of outer molecular species or fluids (liquid or gas) into said material.
- **"Pixel pitch"** refers to the distance from the center of a pixel to the center of the next pixel.
- **"Polydisperse"** refers to particles or droplets of varied sizes, wherein the size difference is superior or equal to 20%.
- **"Population of particles"** refers to a statistical set of particles having the same maximum emission wavelength.
- **"Resulting light"** refers to the light supplied by a material after excitation by an incident light and emission of a secondary light. For example, resulting light refers to the light supplied by the luminescent particles, the light emitting material or the color conversion layer and is a combination of a part of the incident light and the secondary light.
- **"ROHS compliant"** refers to a material compliant with Directive 2011/65/EU of the European Parliament and of the Council of 8 June 2011 on the restriction of the use of certain hazardous substances in electrical and electronic equipment.
- **"Roughness"** refers to a surface state of a particle. Surface irregularities can be present at the surface of particles and are defined as peaks or cavities depending on their relative position respect to the average particle surface. All said irregularities constitute the particle roughness. Said roughness is defined as the height difference between the highest peak and the deepest cavity on the surface. The surface of a particle is smooth if they are no irregularities on said surface, *i.e.,* the roughness is equal to 0%, 0.0001%, 0.0002%, 0.0003%, 0.0004%, 0.0005%, 0.0006%, 0.0007%, 0.0008%, 0.0009%, 0.001%, 0.002%, 0.003%, 0.004%, 0.005%, 0.006%, 0.007%, 0.008%, 0.009%, 0.01%, 0.02%, 0.03%, 0.04%, 0.05%, 0.06%, 0.07%, 0.08%, 0.09%, 0.1%, 0.11%, 0.12%, 0.13%, 0.14%, 0.15%, 0.16%, 0.17%, 0.18%, 0.19%, 0.2%, 0.21%, 0.22%, 0.23%, 0.24%, 0.25%, 0.26%, 0.27%, 0.28%, 0.29%, 0.3%, 0.31%, 0.32%, 0.33%, 0.34%, 0.35%, 0.36%, 0.37%, 0.38%, 0.39%, 0.4%, 0.41%, 0.42%, 0.43%, 0.44%, 0.45%, 0.46%, 0.47%, 0.48%, 0.49%, 0.5%, 1%, 1.5%, 2%, 2.5% 3%, 3.5%, 4%, 4.5%, or 5% of the largest dimension of said particle.
- **"Secondary light"** refers to the light emitted by a material in response to an excitation. Said excitation is generally provided by the light source, *i.e.,* the excitation is the incident light. For example, secondary light refers to the light emitted by the luminescent particles, the light emitting material or the color conversion layer in response to an excitation of the particles comprised in said luminescent particles.
- **"Shell"** refers to at least one monolayer of material coating partially or totally a core.
- **"Standard conditions"** refers to the standard conditions of temperature and pressure, *i.e.,* 273.15 K and 10⁵ Pa respectively.
- **"Statistical set"** refers to a collection of at least 2, 3, 4, 5, 6, 7, 8, 9, 10, 11, 12, 13, 14, 15, 16, 17, 18, 19, 20, 30, 40, 50, 60, 70, 80, 90, 100, 150, 200, 250, 300, 350, 400, 450, 500, 550, 600, 650, 700, 750, 800, 850, 900, 950, or 1000 objects obtained by the strict same process. Such statistical set of objects allows determining average characteristics of said objects, for example their average size, their average size distribution or the average distance between them.
- **"Surfactant-free"** refers to a particle that does not comprise any surfactant and was not synthesized by a method comprising the use of surfactants.
- **"Uniformly dispersed"** refers to particles that are not aggregated, do not touch, are not in contact, and are separated by an inorganic material. Each particle is spaced from their adjacent particles by an average minimal distance.
- **"UV curing"** refers to a process in which ultraviolet light (UV) and/or visible light is used to initiate a photochemical reaction that generates a crosslinked network of polymers. Various systems may be used for UV curing, including, without limitation, mercury vapor lamps, UV LEDs and fluorescent lamps.

### DETAILED DESCRIPTION

The following detailed description will be better understood when read in conjunction with the drawings. For the purpose of illustrating, the ink is shown in the preferred embodiments. It should be understood, however that the application is not limited to the precise arrangements, structures, features, embodiments, and aspect shown. The drawings are not drawn to scale and are not intended to limit the scope of the claims to the embodiments depicted. Accordingly it should be understood that where features mentioned in the appended claims are followed by reference signs, such signs are included solely for the purpose of enhancing the intelligibility of the claims and are in no way limiting on the scope of the claims.

In a first aspect, the present invention relates to an ink comprising:
- at least one particle comprising a first material and at least one liquid vehicle;
   wherein the particle comprises at least one particle comprising a second material and at least one nanoparticle dispersed in said second material;
   wherein the first material and the second material have an attenuation coefficient less or equal to 1×10⁻¹ cm⁻¹ at 460 nm;
   wherein the at least one nanoparticle is a luminescent nanoparticle and comprises at least 1% of semiconductor nanoplatelets; or
      - at least one particle comprising a plurality of nanoparticles encapsulated in a material and at least one liquid vehicle;
   wherein said particle has a surface roughness less or equal to 5% of the largest dimension of said particle;
   wherein the at least one nanoparticle is a luminescent nanoparticle and comprises at least 1% of semiconductor nanoplatelets; or
      - at least one particle comprising a first material; and
      - at least one liquid vehicle;
   wherein the particle comprises at least one particle comprising a second material and at least one nanoparticle dispersed in said second material;
   wherein said particle has a surface roughness less or equal to 5% of the largest dimension of said particle;
   wherein the at least one nanoparticle is a luminescent nanoparticle and comprises at least 1% of semiconductor nanoplatelets.

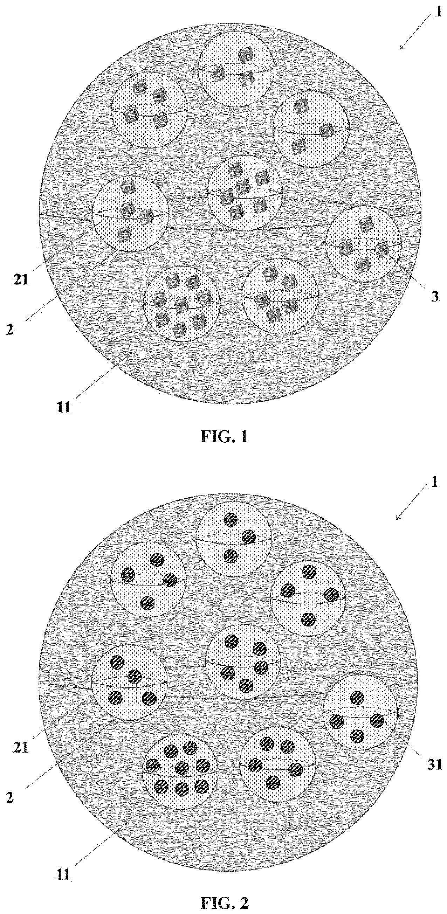

This invention relates to an ink comprising at least one particle **1** (illustrated in figure 1) comprising a first material **11** and at least one liquid vehicle; wherein the particle **1** comprises at least one particle **2** comprising a second material **21** and at least one nanoparticle **3** dispersed in said second material **21;** and wherein the first material **11** and the second material **21** have an attenuation coefficient less or equal to 1×10⁻¹ cm⁻¹ at 460 nm.

The encapsulation of the at least one particle **2** in the first material **11** allows for an increased protection of the at least one nanoparticle **3** regarding the diffusion of outer molecular species or fluids (liquid or gas), especially deteriorating species like O₂ and H₂O to the surface of said nanoparticle **3.** The first material **11** acts as a supplementary barrier against outer molecular species or fluids that could impair the properties of the at least one nanoparticle **3.**

The "double encapsulation" of nanoparticles **3** have several advantages: i) it allows a passivation of nanoparticles **3** surface, thus a better protection of said nanoparticles **3** from temperature, environment variations and deteriorating species like water and oxygen therefore preventing the degradation of said nanoparticles 3; ii) in the case of luminescent nanoparticles **3** it helps preventing photoluminescence quantum yield decrease and photoluminescence decrease due to interaction with the environment; iii) it allows the scattering of the light emitted by a light source and the light resulting from the excitation of said nanoparticles **3.** Particles **1** of the invention are also particularly interesting as they can easily comply with ROHS requirements depending on the first and second materials **(11, 21)** selected. It is then possible to have ROHS compliant particles while preserving the properties of nanoparticles **3.** that may not be ROHS compliant themselves.

In one embodiment, the extinction coefficient is measured by an absorbance measuring technique such as absorbance spectroscopy or any other method known in the art.

According to one embodiment, the particle **1** is air processable. This embodiment is particularly advantageous for the manipulation or the transport of said particle **1** and for the use of an ink comprising said particle **1** in a device such as an optoelectronic device.

According to one embodiment, the particle **1** is compatible with standard lithography processes. This embodiment is particularly advantageous for the use of an ink comprising said particle 1 in a device such as an optoelectronic device.

According to one embodiment, the particle **1** is a colloidal particle.

According to one embodiment, the particle **1** does not comprise a spherical porous bead, preferably the particle **1** does not comprise a central spherical porous bead.

According to one embodiment, the particle **1** does not comprise a spherical porous bead, wherein nanoparticles **3** are linked to the surface of said spherical porous bead.

According to one embodiment, the particle **1** does not comprise a bead and nanoparticles 3 having opposite electronic charges.

According to one embodiment, the particle **1** is dispersible in aqueous solvents, organic solvents and/or mixture thereof.

According to one embodiment, the particle **1** is dispersible in the liquid vehicle.

According to one embodiment, the particle **1** does not comprise organic molecules or polymer chains.

According to one embodiment, the particle **1** is coated by an organic layer comprising organic molecules or polymer chains.

According to one embodiment, the particle **1** is coated by an organic layer comprising polymerizable groups. In this embodiment, polymerizable groups are capable of undergoing a polymerization reaction. According to one embodiment, the particle **1** incorporates polymerizable groups (*e.g.,* in the first **(11)** and/or second **(21)** materials). In this embodiment, polymerizable groups are capable of undergoing a polymerization reaction.

According to one embodiment, examples of polymerizable groups include but are not limited to: vinyl monomers, acrylate monomers, methacrylate monomers, ethylacrylate monomers, acrylamide monomers, methacrylamide monomers, ethyl acrylamide monomers, ethylene glycol monomers, epoxide monomers, glycidyl monomers, olefin monomers, norbornyl monomers, isocyanide monomers, and any of the above mention in di/tri functional group format, or a mixture thereof.

According to one embodiment, the polymerization reaction can be achieved by thermal curing.

According to one embodiment, the polymerization reaction can be achieved by UV curing. An example of such process is described, e.g., in WO2017063968, WO2017063983 and WO2017162579. Briefly, the particle **1** can be coated and/or can incorporate a photoinitiator, a thiol compound and polymeric particles comprising a polymer, an oligomer or a monomer (preferably having ethylenically unsaturated polymerizable groups).

According to one embodiment, the particle **1** is luminescent.

According to one embodiment, the particle **1** is fluorescent.

According to one embodiment, the particle **1** is phosphorescent.

According to one embodiment, the particle **1** is electroluminescent.

According to one embodiment, the particle **1** is chemiluminescent.

According to one embodiment, the particle **1** is triboluminescent.

According to one embodiment, the features of the light emission of particle **1** are sensible to external pressure variations. In this embodiment, "sensible" means that the features of the light emission can be modified by external pressure variations.

According to one embodiment, the wavelength emission peak of particle **1** is sensible to external pressure variations. In this embodiment, "sensible" means that the wavelength emission peak can be modified by external pressure variations, *i.e.,* external pressure variations can induce a wavelength shift.

According to one embodiment, the FWHM of particle **1** is sensible to external pressure variations. In this embodiment, "sensible" means that the FWHM can be modified by external pressure variations, *i.e.,* FWHM can be reduced or increased.

According to one embodiment, the PLQY of particle **1** is sensible to external pressure variations. In this embodiment, "sensible" means that the PLQY can be modified by external pressure variations, *i.e.,* PLQY can be reduced or increased.

According to one embodiment, the features of the light emission of particle **1** are sensible to external temperature variations.

According to one embodiment, the wavelength emission peak of particle **1** is sensible to external temperature variations. In this embodiment, "sensible" means that the wavelength emission peak can be modified by external temperature variations, *i.e.,* external temperature variations can induce a wavelength shift.

According to one embodiment, the FWHM of particle **1** is sensible to external temperature variations. In this embodiment, "sensible" means that the FWHM can be modified by external temperature variations, *i.e.,* FWHM can be reduced or increased.

According to one embodiment, the PLQY of particle **1** is sensible to external temperature variations. In this embodiment, "sensible" means that the PLQY can be modified by external temperature variations, *i.e.,* PLQY can be reduced or increased.

According to one embodiment, the features of the light emission of particle **1** are sensible to external variations of pH.

According to one embodiment, the wavelength emission peak of particle **1** is sensible to external variations of pH. In this embodiment, "sensible" means that the wavelength emission peak can be modified by external variations of pH, *i.e.,* external variations of pH can induce a wavelength shift.

According to one embodiment, the FWHM of particle **1** is sensible to e external variations of pH. In this embodiment, "sensible" means that the FWHM can be modified by external variations of pH, *i*.*e*., FWHM can be reduced or increased.

According to one embodiment, the PLQY of particle **1** is sensible to external variations of pH. In this embodiment, "sensible" means that the PLQY can be modified by external variations of pH, *i.e.,* PLQY can be reduced or increased.

According to one embodiment, the particle **1** comprise at least one nanoparticle wherein the wavelength emission peak is sensible to external temperature variations; and at least one nanoparticle wherein the wavelength emission peak is not or less sensible to external temperature variations. In this embodiment, "sensible" means that the wavelength emission peak can be modified by external temperature variations, *i.e.,* wavelength emission peak can be reduced or increased. This embodiment is particularly advantageous for temperature sensor applications.

According to one embodiment, the particle **1** exhibits an emission spectrum with at least one emission peak, wherein said emission peak has a maximum emission wavelength ranging from 400 nm to 50 µm.

According to one embodiment, the particle **1** exhibits an emission spectrum with at least one emission peak, wherein said emission peak has a maximum emission wavelength ranging from 400 nm to 500 nm. In this embodiment, the particle **1** emits blue light.

According to one embodiment, the particle **1** exhibits an emission spectrum with at least one emission peak, wherein said emission peak has a maximum emission wavelength ranging from 500 nm to 560 nm, more preferably ranging from 515 nm to 545 nm. In this embodiment, the particle **1** emits green light.

According to one embodiment, the particle **1** exhibits an emission spectrum with at least one emission peak, wherein said emission peak has a maximum emission wavelength ranging from 560 nm to 590 nm. In this embodiment, the particle **1** emits yellow light.

According to one embodiment, the particle **1** exhibits an emission spectrum with at least one emission peak, wherein said emission peak has a maximum emission wavelength ranging from 590 nm to 750 nm, more preferably ranging from 610 nm to 650 nm. In this embodiment, the particle **1** emits red light.

According to one embodiment, the particle **1** exhibits an emission spectrum with at least one emission peak, wherein said emission peak has a maximum emission wavelength ranging from 750 nm to 50 µm. In this embodiment, the particle **1** emits near infra-red, mid-infra-red, or infra-red light.

According to one embodiment, the particle **1** exhibits emission spectra with at least one emission peak having a full width half maximum lower than 90 nm, 80 nm, 70 nm, 60 nm, 50 nm, 40 nm, 30 nm, 25 nm, 20 nm, 15 nm, or 10 nm.

According to one embodiment, the particle **1** exhibits emission spectra with at least one emission peak having a full width half maximum strictly lower than 40 nm, 30 nm, 25 nm, 20 nm, 15 nm, or 10 nm.

According to one embodiment, the particle **1** exhibits emission spectra with at least one emission peak having a full width at quarter maximum lower than 90 nm, 80 nm, 70 nm, 60 nm, 50 nm, 40 nm, 30 nm, 25 nm, 20 nm, 15 nm, or 10 nm.

According to one embodiment, the particle **1** exhibits emission spectra with at least one emission peak having a full width at quarter maximum strictly lower than 40 nm, 30 nm, 25 nm, 20 nm, 15 nm, or 10 nm.

According to one embodiment, the particle **1** has a photoluminescence quantum yield (PLQY) of at least 5%, 10%, 15%, 20%, 25%, 30%, 35%, 40%, 45%, 50%, 55%, 60%, 65%, 70%, 75%, 80%, 85%, 90%, 95%, 99% or 100%.

According to one embodiment, the particle **1** absorbs the incident light with wavelength lower than 50 µm, 40 µm, 30 µm, 20 µm, 10 µm, 1 µm, 950 nm, 900 nm, 850 nm, 800 nm, 750 nm, 700 nm, 650 nm, 600 nm, 550 nm, 500 nm, 450 nm, 400 nm, 350 nm, 300 nm, 250 nm, or lower than 200 nm.

According to one embodiment, the particle **1** has an average fluorescence lifetime of at least 0.1 nanosecond, 0.2 nanosecond, 0.3 nanosecond, 0.4 nanosecond, 0.5 nanosecond, 0.6 nanosecond, 0.7 nanosecond, 0.8 nanosecond, 0.9 nanosecond, 1 nanosecond, 2 nanoseconds, 3 nanoseconds, 4 nanoseconds, 5 nanoseconds, 6 nanoseconds, 7 nanoseconds, 8 nanoseconds, 9 nanoseconds, 10 nanoseconds, 11 nanoseconds, 12 nanoseconds, 13 nanoseconds, 14 nanoseconds, 15 nanoseconds, 16 nanoseconds, 17 nanoseconds, 18 nanoseconds, 19 nanoseconds, 20 nanoseconds, 21 nanoseconds, 22 nanoseconds, 23 nanoseconds, 24 nanoseconds, 25 nanoseconds, 26 nanoseconds, 27 nanoseconds, 28 nanoseconds, 29 nanoseconds, 30 nanoseconds, 31 nanoseconds, 32 nanoseconds, 33 nanoseconds, 34 nanoseconds, 35 nanoseconds, 36 nanoseconds, 37 nanoseconds, 38 nanoseconds, 39 nanoseconds, 40 nanoseconds, 41 nanoseconds, 42 nanoseconds, 43 nanoseconds, 44 nanoseconds, 45 nanoseconds, 46 nanoseconds, 47 nanoseconds, 48 nanoseconds, 49 nanoseconds, 50 nanoseconds, 100 nanoseconds, 150 nanoseconds, 200 nanoseconds, 250 nanoseconds, 300 nanoseconds, 350 nanoseconds, 400 nanoseconds, 450 nanoseconds, 500 nanoseconds, 550 nanoseconds, 600 nanoseconds, 650 nanoseconds, 700 nanoseconds, 750 nanoseconds, 800 nanoseconds, 850 nanoseconds, 900 nanoseconds, 950 nanoseconds, or 1 µsecond.

In one embodiment, the particle **1** exhibits photoluminescence quantum yield (PQLY) decrease of less than 80%, 70%, 60%, 50%, 40%, 30%, 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under pulsed light with an average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one preferred embodiment, the particle **1** exhibits photoluminescence quantum yield (PQLY) decrease of less than 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under pulsed light or continuous light with an average peak pulse power or photon flux of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻²,600 W.cm⁻², 700 W.cm⁻², 800 W.cm⁻², 900 W.cm⁻², 1 kW.cm⁻², 50 kW.cm⁻², or 100 kW.cm⁻².

In one embodiment, the particle **1** exhibits FCE decrease of less than 80%, 70%, 60%, 50%, 40%, 30%, 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under pulsed light with an average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻²,100 W.cm⁻², 110 W.cm⁻², 120 W.cm⁻², 130 W.cm⁻², 140 W.cm⁻², 150 W.cm⁻², 160 W.cm⁻²,170 W.cm⁻², 180 W.cm⁻², 190 W.cm⁻², 200 W.cm⁻², 300 W.cm⁻², 400 W.cm⁻², 500 W.cm⁻²,600 W.cm⁻², 700 W.cm⁻², 800 W.cm⁻², 900 W.cm⁻², 1 kW.cm⁻², 50 kW.cm⁻², or 100 kW.cm⁻².

In one preferred embodiment, the particle **1** exhibits FCE decrease of less than 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000,42000, 43000, 44000, 45000,46000, 47000, 48000, 49000, or 50000 hours under pulsed light or continuous light with an average peak pulse power or photon flux of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

According to one embodiment, the particle **1** has a size above 50 nm.

According to one embodiment, the particle **1** has a size of at least 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, a statistical set of particles **1** has an average size of at least 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the particle **1** has a largest dimension of at least 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the particle **1** has a smallest dimension of at least 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm

According to one embodiment, the smallest dimension of the particle **1** is smaller than the largest dimension of said particle **1** by a factor (aspect ratio) of at least 1.5; of at least 2; at least 2.5; at least 3; at least 3.5; at least 4; at least 4.5; at least 5; at least 5.5; at least 6; at least 6.5; at least 7; at least 7.5; at least 8; at least 8.5; at least 9; at least 9.5; at least 10; at least 10.5; at least 11; at least 11.5; at least 12; at least 12.5; at least 13; at least 13.5; at least 14; at least 14.5; at least 15; at least 15.5; at least 16; at least 16.5; at least 17; at least 17.5; at least 18; at least 18.5; at least 19; at least 19.5; at least 20; at least 25; at least 30; at least 35; at least 40; at least 45; at least 50; at least 55; at least 60; at least 65; at least 70; at least 75; at least 80; at least 85; at least 90; at least 95; at least 100; at least 150; at least 200; at least 250; at least 300; at least 350; at least 400; at least 450; at least 500; at least 550; at least 600; at least 650; at least 700; at least 750; at least 800; at least 850; at least 900; at least 950; or at least 1000.

According to one embodiment, the particle 1 has a smallest curvature of at least 200 µm⁻¹, 100 µm⁻¹, 66.6 µm⁻¹, 50 µm⁻¹, 33.3 µm⁻¹, 28.6 µm⁻¹, 25 µm⁻¹, 20 µm⁻¹, 18.2 µm⁻¹, 16.7 µm⁻¹, 15.4 µm⁻¹, 14.3 µm⁻¹, 13.3 µm⁻¹, 12.5 µm⁻¹, 11.8 µm⁻¹, 11.1 µm⁻¹, 10.5 µm⁻¹, 10 µm⁻¹, 9.5 µm⁻¹, 9.1 µm⁻¹, 8.7 µm⁻¹, 8.3 µm⁻¹, 8 µm⁻¹, 7.7 µm⁻¹, 7.4 µm⁻¹, 7.1 µm⁻¹, 6.9 µm⁻¹, 6.7 µm⁻¹, 5.7 µm⁻¹, 5 µm⁻¹, 4.4 µm⁻¹, 4 µm⁻¹, 3.6 µm⁻¹, 3.3 µm⁻¹, 3.1 µm⁻¹, 2.9 µm⁻¹, 2.7 µm⁻¹, 2.5 µm⁻¹, 2.4 µm⁻¹, 2.2 µm⁻¹, 2.1 µm⁻¹, 2 µm⁻¹, 1.3333 µm⁻¹, 0.8 µm⁻¹, 0.6666 µm⁻¹, 0.5714 µm⁻¹, 0.5 µm⁻¹, 0.4444 µm⁻¹, 0.4 µm⁻¹, 0.3636 µm⁻¹, 0.3333 µm⁻¹, 0.3080 µm⁻¹, 0.2857 µm⁻¹, 0.2667 µm⁻¹, 0.25 µm⁻¹, 0.2353 µm⁻¹, 0.2222 µm⁻¹, 0.2105 µm⁻¹, 0.2 µm⁻¹, 0.1905 µm⁻¹, 0.1818 µm⁻¹, 0.1739 µm⁻¹, 0.1667 µm⁻¹, 0.16 µm⁻¹, 0.1538 µm⁻¹, 0.1481 µm⁻¹, 0.1429 µm⁻¹, 0.1379 µm⁻¹, 0.1333 µm⁻¹, 0.1290 µm⁻¹, 0.125 µm⁻¹, 0.1212 µm⁻¹, 0.1176 µm⁻¹, 0.1176 µm⁻¹, 0.1143 µm⁻¹, 0.1111 µm⁻¹, 0.1881 µm⁻¹, 0.1053 µm⁻¹, 0.1026 µm⁻¹, 0.1 µm⁻¹, 0.0976 µm⁻¹, 0.9524 µm⁻¹, 0.0930 µm⁻¹, 0.0909 µm⁻¹, 0.0889 µm⁻¹, 0.870 µm⁻¹, 0.0851 µm⁻¹, 0.0833 µm⁻¹, 0.0816 µm⁻¹, 0.08 µm⁻¹, 0.0784 µm⁻¹, 0.0769 µm⁻¹, 0.0755 µm⁻¹, 0.0741 µm⁻¹, 0.0727 µm⁻¹, 0.0714 µm⁻¹, 0.0702 µm⁻¹, 0.0690 µm⁻¹, 0.0678 µm⁻¹, 0.0667 µm⁻¹, 0.0656 µm⁻¹, 0.0645 µm⁻¹, 0.0635 µm⁻¹, 0.0625 µm⁻¹, 0.0615 µm⁻¹, 0.0606 µm⁻¹, 0.0597 µm⁻¹, 0.0588 µm⁻¹, 0.0580 µm⁻¹, 0.0571 µm⁻¹, 0.0563 µm⁻¹, 0.0556 µm⁻¹, 0.0548 µm⁻¹, 0.0541 µm⁻¹, 0.0533 µm⁻¹, 0.0526 µm⁻¹, 0.0519 µm⁻¹, 0.0513 µm⁻¹, 0.0506 µm⁻¹, 0.05 µm⁻¹, 0.0494 µm⁻¹, 0.0488 µm⁻¹, 0.0482 µm⁻¹, 0.0476 µm⁻¹, 0.0471 µm⁻¹, 0.0465 µm⁻¹, 0.0460 µm⁻¹, 0.0455 µm⁻¹, 0.0450 µm⁻¹, 0.0444 µm⁻¹, 0.0440 µm⁻¹, 0.0435 µm⁻¹, 0.0430 µm⁻¹, 0.0426 µm⁻¹, 0.0421 µm⁻¹, 0.0417 µm⁻¹, 0.0412 µm⁻¹, 0.0408 µm⁻¹, 0.0404 µm⁻¹, 0.04 µm⁻¹, 0.0396 µm⁻¹, 0.0392 µm⁻¹, 0.0388 µm⁻¹, 0.0385 µm⁻¹; 0.0381 µm⁻¹, 0.0377 µm⁻¹, 0.0374 µm⁻¹, 0.037 µm⁻¹, 0.0367 µm⁻¹, 0.0364 µm⁻¹, 0.0360 µm⁻¹, 0.0357 µm⁻¹, 0.0354 µm⁻¹, 0.0351 µm⁻¹, 0.0348 µm⁻¹, 0.0345 µm⁻¹, 0.0342 µm⁻¹, 0.0339 µm⁻¹, 0.0336 µm⁻¹, 0.0333 µm⁻¹, 0.0331 µm⁻¹, 0.0328 µm⁻¹, 0.0325 µm⁻¹, 0.0323 µm⁻¹, 0.032 µm⁻¹, 0.0317 µm⁻¹, 0.0315 µm⁻¹, 0.0312 µm⁻¹, 0.031 µm⁻¹, 0.0308 µm⁻¹, 0.0305 µm⁻¹, 0.0303 µm⁻¹, 0.0301 µm⁻¹, 0.03 µm⁻¹, 0.0299 µm⁻¹, 0.0296 µm⁻¹, 0.0294 µm⁻¹, 0.0292 µm⁻¹, 0.029 µm⁻¹, 0.0288 µm⁻¹, 0.0286 µm⁻¹, 0.0284 µm⁻¹, 0.0282 µm⁻¹, 0.028 µm⁻¹, 0.0278 µm⁻¹, 0.0276 µm⁻¹, 0.0274 µm⁻¹, 0.0272 µm⁻¹; 0.0270 µm⁻¹, 0.0268 µm⁻¹, 0.02667 µm⁻¹, 0.0265 µm⁻¹, 0.0263 µm⁻¹, 0.0261 µm⁻¹, 0.026 µm⁻¹, 0.0258 µm⁻¹, 0.0256 µm⁻¹, 0.0255 µm⁻¹, 0.0253 µm⁻¹, 0.0252 µm⁻¹, 0.025 µm⁻¹, 0.0248 µm⁻¹, 0.0247 µm⁻¹, 0.0245 µm⁻¹, 0.0244 µm⁻¹, 0.0242 µm⁻¹, 0.0241 µm⁻¹, 0.024 µm⁻¹, 0.0238 µm⁻¹, 0.0237 µm⁻¹, 0.0235 µm⁻¹, 0.0234 µm⁻¹, 0.0233 µm⁻¹, 0.231 µm⁻¹, 0.023 µm⁻¹, 0.0229 µm⁻¹, 0.0227 µm⁻¹, 0.0226 µm⁻¹, 0.0225 µm⁻¹, 0.0223 µm⁻¹, 0.0222 µm⁻¹, 0.0221 µm⁻¹, 0.022 µm⁻¹, 0.0219 µm⁻¹, 0.0217 µm⁻¹, 0.0216 µm⁻¹, 0.0215 µm⁻¹, 0.0214 µm⁻¹, 0.0213 µm⁻¹, 0.0212 µm⁻¹, 0.0211 µm⁻¹, 0.021 µm⁻¹, 0.0209 µm⁻¹, 0.0208 µm⁻¹, 0.0207 µm⁻¹, 0.0206 µm⁻¹, 0.0205 µm⁻¹, 0.0204 µm⁻¹, 0.0203 µm⁻¹, 0.0202 µm⁻¹, 0.0201 µm⁻¹, 0.02 µm⁻¹, or 0.002 µm⁻¹.

According to one embodiment, the particle 1 has a largest curvature of at least 200 µm⁻¹, 100 µm⁻¹, 66.6 µm⁻¹, 50 µm⁻¹, 33.3 µm⁻¹, 28.6 µm⁻¹, 25 µm⁻¹, 20 µm⁻¹, 18.2 µm⁻¹, 16.7 µm⁻¹, 15.4 µm⁻¹, 14.3 µm⁻¹, 13.3 µm⁻¹, 12.5 µm⁻¹, 11.8 µm⁻¹, 11.1 µm⁻¹, 10.5 µm⁻¹, 10 µm⁻¹, 9.5 µm⁻¹, 9.1 µm⁻¹, 8.7 µm⁻¹, 8.3 µm⁻¹, 8 µm⁻¹, 7.7 µm⁻¹, 7.4 µm⁻¹, 7.1 µm⁻¹, 6.9 µm⁻¹, 6.7 µm⁻¹, 5.7 µm⁻¹, 5 µm⁻¹, 4.4 µm⁻¹, 4 µm⁻¹, 3.6 µm⁻¹, 3.3 µm⁻¹, 3.1 µm⁻¹, 2.9 µm⁻¹, 2.7 µm⁻¹, 2.5 µm⁻¹, 2.4 µm⁻¹, 2.2 µm⁻¹, 2.1 µm⁻¹, 2 µm⁻¹, 1.3333 µm⁻¹, 0.8 µm⁻¹, 0.6666 µm⁻¹, 0.5714 µm⁻¹, 0.5 µm⁻¹, 0.4444 µm⁻¹, 0.4 µm⁻¹, 0.3636 µm⁻¹, 0.3333 µm⁻¹, 0.3080 µm⁻¹, 0.2857 µm⁻¹, 0.2667 µm⁻¹, 0.25 µm⁻¹, 0.2353 µm⁻¹, 0.2222 µm⁻¹, 0.2105 µm⁻¹, 0.2 µm⁻¹, 0.1905 µm⁻¹, 0.1818 µm⁻¹, 0.1739 µm⁻¹, 0.1667 µm⁻¹, 0.16 µm⁻¹, 0.1538 µm⁻¹, 0.1481 µm⁻¹, 0.1429 µm⁻¹, 0.1379 µm⁻¹, 0.1333 µm⁻¹, 0.1290 µm⁻¹, 0.125 µm⁻¹, 0.1212 µm⁻¹, 0.1176 µm⁻¹, 0.1176 µm⁻¹, 0.1143 µm⁻¹, 0.1111 µm⁻¹, 0.1881 µm⁻¹, 0.1053 µm⁻¹, 0.1026 µm⁻¹, 0.1 µm⁻¹, 0.0976 µm⁻¹, 0.9524 µm⁻¹, 0.0930 µm⁻¹, 0.0909 µm⁻¹, 0.0889 µm⁻¹, 0.870 µm⁻¹, 0.0851 µm⁻¹, 0.0833 µm⁻¹, 0.0816 µm⁻¹, 0.08 µm⁻¹, 0.0784 µm⁻¹, 0.0769 µm⁻¹, 0.0755 µm⁻¹, 0.0741 µm⁻¹, 0.0727 µm⁻¹, 0.0714 µm⁻¹, 0.0702 µm⁻¹, 0.0690 µm⁻¹, 0.0678 µm⁻¹, 0.0667 µm⁻¹, 0.0656 µm⁻¹, 0.0645 µm⁻¹, 0.0635 µm⁻¹, 0.0625 µm⁻¹, 0.0615 µm⁻¹, 0.0606 µm⁻¹, 0.0597 µm⁻¹, 0.0588 µm⁻¹, 0.0580 µm⁻¹, 0.0571 µm⁻¹, 0.0563 µm⁻¹, 0.0556 µm⁻¹, 0.0548 µm⁻¹, 0.0541 µm⁻¹, 0.0533 µm⁻¹, 0.0526 µm⁻¹, 0.0519 µm⁻¹, 0.0513 µm⁻¹, 0.0506 µm⁻¹, 0.05 µm⁻¹, 0.0494 µm⁻¹, 0.0488 µm⁻¹, 0.0482 µm⁻¹, 0.0476 µm⁻¹, 0.0471 µm⁻¹, 0.0465 µm⁻¹, 0.0460 µm⁻¹, 0.0455 µm⁻¹, 0.0450 µm⁻¹, 0.0444 µm⁻¹, 0.0440 µm⁻¹, 0.0435 µm⁻¹, 0.0430 µm⁻¹, 0.0426 µm⁻¹, 0.0421 µm⁻¹, 0.0417 µm⁻¹, 0.0412 µm⁻¹, 0.0408 µm⁻¹, 0.0404 µm⁻¹, 0.04 µm⁻¹, 0.0396 µm⁻¹, 0.0392 µm⁻¹, 0.0388 µm⁻¹, 0.0385 µm⁻¹; 0.0381 µm⁻¹, 0.0377 µm⁻¹, 0.0374 µm⁻¹, 0.037 µm⁻¹, 0.0367 µm⁻¹, 0.0364 µm⁻¹, 0.0360 µm⁻¹, 0.0357 µm⁻¹, 0.0354 µm⁻¹, 0.0351 µm⁻¹, 0.0348 µm⁻¹, 0.0345 µm⁻¹, 0.0342 µm⁻¹, 0.0339 µm⁻¹, 0.0336 µm⁻¹, 0.0333 µm⁻¹, 0.0331 µm⁻¹, 0.0328 µm⁻¹, 0.0325 µm⁻¹, 0.0323 µm⁻¹, 0.032 µm⁻¹, 0.0317 µm⁻¹, 0.0315 µm⁻¹, 0.0312 µm⁻¹, 0.031 µm⁻¹, 0.0308 µm⁻¹, 0.0305 µm⁻¹, 0.0303 µm⁻¹, 0.0301 µm⁻¹, 0.03 µm⁻¹, 0.0299 µm⁻¹, 0.0296 µm⁻¹, 0.0294 µm⁻¹, 0.0292 µm⁻¹, 0.029 µm⁻¹, 0.0288 µm⁻¹, 0.0286 µm⁻¹, 0.0284 µm⁻¹, 0.0282 µm⁻¹, 0.028 µm⁻¹, 0.0278 µm⁻¹, 0.0276 µm⁻¹, 0.0274 µm⁻¹, 0.0272 µm⁻¹; 0.0270 µm⁻¹, 0.0268 µm⁻¹, 0.02667 µm⁻¹, 0.0265 µm⁻¹, 0.0263 µm⁻¹, 0.0261 µm⁻¹, 0.026 µm⁻¹, 0.0258 µm⁻¹, 0.0256 µm⁻¹, 0.0255 µm⁻¹, 0.0253 µm⁻¹, 0.0252 µm⁻¹, 0.025 µm⁻¹, 0.0248 µm⁻¹, 0.0247 µm⁻¹, 0.0245 µm⁻¹, 0.0244 µm⁻¹, 0.0242 µm⁻¹, 0.0241 µm⁻¹, 0.024 µm⁻¹, 0.0238 µm⁻¹, 0.0237 µm⁻¹, 0.0235 µm⁻¹, 0.0234 µm⁻¹, 0.0233 µm⁻¹, 0.231 µm⁻¹, 0.023 µm⁻¹, 0.0229 µm⁻¹, 0.0227 µm⁻¹, 0.0226 µm⁻¹, 0.0225 µm⁻¹, 0.0223 µm⁻¹, 0.0222 µm⁻¹, 0.0221 µm⁻¹, 0.022 µm⁻¹, 0.0219 µm⁻¹, 0.0217 µm⁻¹, 0.0216 µm⁻¹, 0.0215 µm⁻¹, 0.0214 µm⁻¹, 0.0213 µm⁻¹, 0.0212 µm⁻¹, 0.0211 µm⁻¹, 0.021 µm⁻¹, 0.0209 µm⁻¹, 0.0208 µm⁻¹, 0.0207 µm⁻¹, 0.0206 µm⁻¹, 0.0205 µm⁻¹, 0.0204 µm⁻¹, 0.0203 µm⁻¹, 0.0202 µm⁻¹, 0.0201 µm⁻¹, 0.02 µm⁻¹, or 0.002 µm⁻¹.

According to one embodiment, in a statistical set of particles 1, said particles 1 are polydisperse.

According to one embodiment, in a statistical set of particles 1, said particles 1 are monodisperse.

According to one embodiment, in a statistical set of particles 1, said particles 1 have a narrow size distribution.

According to one embodiment, in a statistical set of particles 1, said particles 1 are not aggregated.

According to one embodiment, in an ink comprising a plurality of particles 1, said particles 1 are polydisperse.

According to one embodiment, in an ink comprising a plurality of particles 1, said particles 1 are monodisperse.

According to one embodiment, in an ink comprising a plurality of particles 1, said particles 1 have a narrow size distribution.

According to one embodiment, in an ink comprising a plurality of particles 1, said particles 1 are not aggregated in the liquid vehicle.

According to one embodiment, in an ink comprising a plurality of particles 1, said particles 1 are not in contact in the liquid vehicle.

According to one embodiment, in an ink comprising a plurality of particles 1, said particles 1 are individually dispersed in the liquid vehicle.

According to one embodiment, in an ink comprising a plurality of particles 1, said particles 1 are aggregated in the liquid vehicle.

According to one embodiment, in an ink comprising a plurality of particles 1, said particles 1 are in contact in the liquid vehicle.

According to one embodiment, the surface roughness of the particle 1 is less or equal to 0%, 0.0001%, 0.0002%, 0.0003%, 0.0004%, 0.0005%, 0.0006%, 0.0007%, 0.0008%, 0.0009%, 0.001%, 0.002%, 0.003%, 0.004%, 0.005%, 0.006%, 0.007%, 0.008%, 0.009%, 0.01%, 0.02%, 0.03%, 0.04%, 0.05%, 0.06%, 0.07%, 0.08%, 0.09%, 0.1%, 0.11%, 0.12%, 0.13%, 0.14%, 0.15%, 0.16%, 0.17%, 0.18%, 0.19%, 0.2%, 0.21%, 0.22%, 0.23%, 0.24%, 0.25%, 0.26%, 0.27%, 0.28%, 0.29%, 0.3%, 0.31%, 0.32%, 0.33%, 0.34%, 0.35%, 0.36%, 0.37%, 0.38%, 0.39%, 0.4%, 0.41%, 0.42%, 0.43%, 0.44%, 0.45%, 0.46%, 0.47%, 0.48%, 0.49%, 0.5%, 1%, 1.5%, 2%, 2.5% 3%, 3.5%, 4%, 4.5%, or 5% of the largest dimension of said particle 1, meaning that the surface of said particle 1 is completely smooth.

According to one embodiment, the surface roughness of the particle 1 is less or equal to 0.5% of the largest dimension of said particle 1, meaning that the surface of said particle 1 is completely smooth.

According to one embodiment, the particle 1 has a spherical shape, an ovoid shape, a discoidal shape, a cylindrical shape, a faceted shape, a hexagonal shape, a triangular shape, a cubic shape, or a platelet shape.

According to one embodiment, the particle 1 has a raspberry shape, a prism shape, a polyhedron shape, a snowflake shape, a flower shape, a thorn shape, a hemisphere shape, a cone shape, a urchin shape, a filamentous shape, a biconcave discoid shape, a worm shape, a tree shape, a dendrite shape, a necklace shape, a chain shape, or a bush shape.

According to one embodiment, the particle **1** has a spherical shape, or the particle **1** is a bead.

According to one embodiment, the particle **1** is hollow, *i.e.,* the particle **1** is a hollow bead.

According to one embodiment, the particle **1** does not have a core/shell structure.

According to one embodiment, the particle **1** has a core/shell structure as described hereafter.

According to one embodiment, the particle **1** is not a fiber.

According to one embodiment, the particle **1** is not a matrix with undefined shape.

According to one embodiment, the particle **1** is not macroscopical piece of glass. In this embodiment, a piece of glass refers to glass obtained from a bigger glass entity for example by cutting it, or to glass obtained by using a mold. In one embodiment, a piece of glass has at least one dimension exceeding 1 mm.

According to one embodiment, the particle 1 is not obtained by reducing the size of the first material 11. For example, particle 1 is not obtained by milling a piece of first material 11, nor by cutting it, nor by firing it with projectiles like particles, atomes or electrons, or by any other method.

According to one embodiment, the particle 1 is not obtained by milling bigger particles or by spraying a powder.

According to one embodiment, the particle 1 is not a piece of nanometer pore glass doped with nanoparticles 3.

According to one embodiment, the particle 1 is not a glass monolith.

According to one embodiment, the spherical particle 1 has a diameter of at least 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm

According to one embodiment, a statistical set of spherical particles 1 has an average diameter of at least 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm

According to one embodiment, the average diameter of a statistical set of spherical particles 1 may have a deviation less or equal to 0.01%, 0.02%, 0.03%, 0.04%, 0.05%, 0.06%, 0.07%, 0.08%, 0.09%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 1.6%, 1.7%, 1.8%, 1.9%, 2%, 2.1%, 2.2%, 2.3%, 2.4%, 2.5%, 2.6%, 2.7%, 2.8%, 2.9%, 3%, 3.1%, 3.2%, 3.3%, 3.4%, 3.5%, 3.6%, 3.7%, 3.8%, 3.9%, 4%, 4.1%, 4.2%, 4.3%, 4.4%, 4.5%, 4.6%, 4.7%, 4.8%, 4.9%, 5%, 5.1%, 5.2%, 5.3%, 5.4%, 5.5%, 5.6%, 5.7%, 5.8%, 5.9%, 6%, 6.1%, 6.2%, 6.3%, 6.4%, 6.5%, 6.6%, 6.7%, 6.8%, 6.9%, 7%, 7.1%, 7.2%, 7.3%, 7.4%, 7.5%, 7.6%, 7.7%, 7.8%, 7.9%, 8%, 8.1%, 8.2%, 8.3%, 8.4%, 8.5%, 8.6%, 8.7%, 8.8%, 8.9%, 9%, 9.1%, 9.2%, 9.3%, 9.4%, 9.5%, 9.6%, 9.7%, 9.8%, 9.9%, 10%, 20%, 30%, 40%, 50%, 60%, 70%, 80%, 85%, 90%, 95%, 100%, 105%, 110%, 115%, 120%, 125%, 130%, 135%, 140%, 145%, 150%, 155%, 160%, 165%, 170%, 175%, 180%, 185%, 190%, 195%, or 200%.

According to one embodiment, the spherical particle 1 has a unique curvature of at least 200 µm⁻¹, 100 µm⁻¹, 66.6 µm⁻¹, 50 µm⁻¹, 33.3 µm⁻¹, 28.6 µm⁻¹, 25 µm⁻¹, 20 µm⁻¹, 18.2 µm⁻¹, 16.7 µm⁻¹, 15.4 µm⁻¹, 14.3 µm⁻¹, 13.3 µm⁻¹, 12.5 µm⁻¹, 11.8 µm⁻¹, 11.1 µm⁻¹, 10.5 µm⁻¹, 10 µm⁻¹, 9.5 µm⁻¹, 9.1 µm⁻¹, 8.7 µm⁻¹, 8.3 µm⁻¹, 8 µm⁻¹, 7.7 µm⁻¹, 7.4 µm⁻¹, 7.1 µm⁻¹, 6.9 µm⁻¹, 6.7 µm⁻¹, 5.7 µm⁻¹, 5 µm⁻¹, 4.4 µm⁻¹, 4 µm⁻¹, 3.6 µm⁻¹, 3.3 µm⁻¹, 3.1 µm⁻¹, 2.9 µm⁻¹, 2.7 µm⁻¹, 2.5 µm⁻¹, 2.4 µm⁻¹, 2.2 µm⁻¹, 2.1 µm⁻¹, 2 µm⁻¹, 1.3333 µm⁻¹, 0.8 µm⁻¹, 0.6666 µm⁻¹, 0.5714 µm⁻¹, 0.5 µm⁻¹, 0.4444 µm⁻¹, 0.4 µm⁻¹, 0.3636 µm⁻¹, 0.3333 µm⁻¹, 0.3080 µm⁻¹, 0.2857 µm⁻¹, 0.2667 µm⁻¹, 0.25 µm⁻¹, 0.2353 µm⁻¹, 0.2222 µm⁻¹, 0.2105 µm⁻¹, 0.2 µm⁻¹, 0.1905 µm⁻¹, 0.1818 µm⁻¹, 0.1739 µm⁻¹, 0.1667 µm⁻¹, 0.16 µm⁻¹, 0.1538 µm⁻¹, 0.1481 µm⁻¹, 0.1429 µm⁻¹, 0.1379 µm⁻¹, 0.1333 µm⁻¹, 0.1290 µm⁻¹, 0.125 µm⁻¹, 0.1212 µm⁻¹, 0.1176 µm⁻¹, 0.1176 µm⁻¹, 0.1143 µm⁻¹, 0.1111 µm⁻¹, 0.1881 µm⁻¹, 0.1053 µm⁻¹, 0.1026 µm⁻¹, 0.1 µm⁻¹, 0.0976 µm⁻¹, 0.9524 µm⁻¹, 0.0930 µm⁻¹, 0.0909 µm⁻¹, 0.0889 µm⁻¹, 0.870 µm⁻¹, 0.0851 µm⁻¹, 0.0833 µm⁻¹, 0.0816 µm⁻¹, 0.08 µm⁻¹, 0.0784 µm⁻¹, 0.0769 µm⁻¹, 0.0755 µm⁻¹, 0.0741 µm⁻¹, 0.0727 µm⁻¹, 0.0714 µm⁻¹, 0.0702 µm⁻¹, 0.0690 µm⁻¹, 0.0678 µm⁻¹, 0.0667 µm⁻¹, 0.0656 µm⁻¹, 0.0645 µm⁻¹, 0.0635 µm⁻¹, 0.0625 µm⁻¹, 0.0615 µm⁻¹, 0.0606 µm⁻¹, 0.0597 µm⁻¹, 0.0588 µm⁻¹, 0.0580 µm⁻¹, 0.0571 µm⁻¹, 0.0563 µm⁻¹, 0.0556 µm⁻¹, 0.0548 µm⁻¹, 0.0541 µm⁻¹, 0.0533 µm⁻¹, 0.0526 µm⁻¹, 0.0519 µm⁻¹, 0.0513 µm⁻¹, 0.0506 µm⁻¹, 0.05 µm⁻¹, 0.0494 µm⁻¹, 0.0488 µm⁻¹, 0.0482 µm⁻¹, 0.0476 µm⁻¹, 0.0471 µm⁻¹, 0.0465 µm⁻¹, 0.0460 µm⁻¹, 0.0455 µm⁻¹, 0.0450 µm⁻¹, 0.0444 µm⁻¹, 0.0440 µm⁻¹, 0.0435 µm⁻¹, 0.0430 µm⁻¹, 0.0426 µm⁻¹, 0.0421 µm⁻¹, 0.0417 µm⁻¹, 0.0412 µm⁻¹, 0.0408 µm⁻¹, 0.0404 µm⁻¹, 0.04 µm⁻¹, 0.0396 µm⁻¹, 0.0392 µm⁻¹, 0.0388 µm⁻¹, 0.0385 µm⁻¹; 0.0381 µm⁻¹, 0.0377 µm⁻¹, 0.0374 µm⁻¹, 0.037 µm⁻¹, 0.0367 µm⁻¹, 0.0364 µm⁻¹, 0.0360 µm⁻¹, 0.0357 µm⁻¹, 0.0354 µm⁻¹, 0.0351 µm⁻¹, 0.0348 µm⁻¹, 0.0345 µm⁻¹, 0.0342 µm⁻¹, 0.0339 µm⁻¹, 0.0336 µm⁻¹, 0.0333 µm⁻¹, 0.0331 µm⁻¹, 0.0328 µm⁻¹, 0.0325 µm⁻¹, 0.0323 µm⁻¹, 0.032 µm⁻¹, 0.0317 µm⁻¹, 0.0315 µm⁻¹, 0.0312 µm⁻¹, 0.031 µm⁻¹, 0.0308 µm⁻¹, 0.0305 µm⁻¹, 0.0303 µm⁻¹, 0.0301 µm⁻¹, 0.03 µm⁻¹, 0.0299 µm⁻¹, 0.0296 µm⁻¹, 0.0294 µm⁻¹, 0.0292 µm⁻¹, 0.029 µm⁻¹, 0.0288 µm⁻¹, 0.0286 µm⁻¹, 0.0284 µm⁻¹, 0.0282 µm⁻¹, 0.028 µm⁻¹, 0.0278 µm⁻¹, 0.0276 µm⁻¹, 0.0274 µm⁻¹, 0.0272 µm⁻¹; 0.0270 µm⁻¹, 0.0268 µm⁻¹, 0.02667 µm⁻¹, 0.0265 µm⁻¹, 0.0263 µm⁻¹, 0.0261 µm⁻¹, 0.026 µm⁻¹, 0.0258 µm⁻¹, 0.0256 µm⁻¹, 0.0255 µm⁻¹, 0.0253 µm⁻¹, 0.0252 µm⁻¹, 0.025 µm⁻¹, 0.0248 µm⁻¹, 0.0247 µm⁻¹, 0.0245 µm⁻¹, 0.0244 µm⁻¹, 0.0242 µm⁻¹, 0.0241 µm⁻¹, 0.024 µm⁻¹, 0.0238 µm⁻¹, 0.0237 µm⁻¹, 0.0235 µm⁻¹, 0.0234 µm⁻¹, 0.0233 µm⁻¹, 0.231 µm⁻¹, 0.023 µm⁻¹, 0.0229 µm⁻¹, 0.0227 µm⁻¹, 0.0226 µm⁻¹, 0.0225 µm⁻¹, 0.0223 µm⁻¹, 0.0222 µm⁻¹, 0.0221 µm⁻¹, 0.022 µm⁻¹, 0.0219 µm⁻¹, 0.0217 µm⁻¹, 0.0216 µm⁻¹, 0.0215 µm⁻¹, 0.0214 µm⁻¹, 0.0213 µm⁻¹, 0.0212 µm⁻¹, 0.0211 µm⁻¹, 0.021 µm⁻¹, 0.0209 µm⁻¹, 0.0208 µm⁻¹, 0.0207 µm⁻¹, 0.0206 µm⁻¹, 0.0205 µm⁻¹, 0.0204 µm⁻¹, 0.0203 µm⁻¹, 0.0202 µm⁻¹, 0.0201 µm⁻¹, 0.02 µm⁻¹, or 0.002 µm⁻¹.

According to one embodiment, a statistical set of the spherical particles 1 has an average unique curvature of at least 200 µm⁻¹, 100 µm⁻¹, 66.6 µm⁻¹, 50 µm⁻¹, 33.3 µm⁻¹, 28.6 µm⁻¹, 25 µm⁻¹, 20 µm⁻¹, 18.2 µm⁻¹, 16.7 µm⁻¹, 15.4 µm⁻¹, 14.3 µm⁻¹, 13.3 µm⁻¹, 12.5 µm⁻¹, 11.8 µm⁻¹, 11.1 µm⁻¹, 10.5 µm⁻¹, 10 µm⁻¹, µm⁻¹, µm⁻¹, 9.1 µm⁻¹, 8.7 µm⁻¹, 8.3 µm⁻¹, 8 µm⁻¹, 7.7 µm⁻¹, 7.4 µm⁻¹, 7.1 µm⁻¹, 6.9 µm⁻¹, 6.7 µm⁻¹, 5.7 µm⁻¹, 5 µm⁻¹, 4.4 µm⁻¹, 4 µm⁻¹, 3.6 µm⁻¹, 3.3 µm⁻¹, 3.1 µm⁻¹, 2.9 µm⁻¹, 2.7 µm⁻¹, 2.5 µm⁻¹, 2.4 µm⁻¹, 2.2 µm⁻¹, 2.1 µm⁻¹, 2 µm⁻¹, 1.3333 µm⁻¹, 0.8 µm⁻¹, 0.6666 µm⁻¹, 0.5714 µm⁻¹, 0.5 µm⁻¹, 0.4444 µm⁻¹, 0.4 µm⁻¹, 0.3636 µm⁻¹, 0.3333 µm⁻¹, 0.3080 µm⁻¹, 0.2857 µm⁻¹, 0.2667 µm⁻¹, 0.25 µm⁻¹, 0.2353 µm⁻¹, 0.2222 µm⁻¹, 0.2105 µm⁻¹, 0.2 µm⁻¹, 0.1905 µm⁻¹, 0.1818 µm⁻¹, 0.1739 µm⁻¹, 0.1667 µm⁻¹, 0.16 µm⁻¹, 0.1538 µm⁻¹, 0.1481 µm⁻¹, 0.1429 µm⁻¹, 0.1379 µm⁻¹, 0.1333 µm⁻¹, 0.1290 µm⁻¹, 0.125 µm⁻¹, 0.1212 µm⁻¹, 0.1176 µm⁻¹, 0.1176 µm⁻¹, 0.1143 µm⁻¹, 0.1111 µm⁻¹, 0.1881 µm⁻¹, 0.1053 µm⁻¹, 0.1026 µm⁻¹, 0.1 µm⁻¹, 0.0976 µm⁻¹, 0.9524 µm⁻¹, 0.0930 µm⁻¹, 0.0909 µm⁻¹, 0.0889 µm⁻¹, 0.870 µm⁻¹, 0.0851 µm⁻¹, 0.0833 µm⁻¹, 0.0816 µm⁻¹, 0.08 µm⁻¹, 0.0784 µm⁻¹, 0.0769 µm⁻¹, 0.0755 µm⁻¹, 0.0741 µm⁻¹, 0.0727 µm⁻¹, 0.0714 µm⁻¹, 0.0702 µm⁻¹, 0.0690 µm⁻¹, 0.0678 µm⁻¹, 0.0667 µm⁻¹, 0.0656 µm⁻¹, 0.0645 µm⁻¹, 0.0635 µm⁻¹, 0.0625 µm⁻¹, 0.0615 µm⁻¹, 0.0606 µm⁻¹, 0.0597 µm⁻¹, 0.0588 µm⁻¹, 0.0580 µm⁻¹, 0.0571 µm⁻¹, 0.0563 µm⁻¹, 0.0556 µm⁻¹, 0.0548 µm⁻¹, 0.0541 µm⁻¹, 0.0533 µm⁻¹, 0.0526 µm⁻¹, 0.0519 µm⁻¹, 0.0513 µm⁻¹, 0.0506 µm⁻¹, 0.05 µm⁻¹, 0.0494 µm⁻¹, 0.0488 µm⁻¹, 0.0482 µm⁻¹, 0.0476 µm⁻¹, 0.0471 µm⁻¹, 0.0465 µm⁻¹, 0.0460 µm⁻¹, 0.0455 µm⁻¹, 0.0450 µm⁻¹, 0.0444 µm⁻¹, 0.0440 µm⁻¹, 0.0435 µm⁻¹, 0.0430 µm⁻¹, 0.0426 µm⁻¹, 0.0421 µm⁻¹, 0.0417 µm⁻¹, 0.0412 µm⁻¹, 0.0408 µm⁻¹, 0.0404 µm⁻¹, 0.04 µm⁻¹, 0.0396 µm⁻¹, 0.0392 µm⁻¹, 0.0388 µm⁻¹, 0.0385 µm⁻¹; 0.0381 µm⁻¹, 0.0377 µm⁻¹, 0.0374 µm⁻¹, 0.037 µm⁻¹, 0.0367 µm⁻¹, 0.0364 µm⁻¹, 0.0360 µm⁻¹, 0.0357 µm⁻¹, 0.0354 µm⁻¹, 0.0351 µm⁻¹, 0.0348 µm⁻¹, 0.0345 µm⁻¹, 0.0342 µm⁻¹, 0.0339 µm⁻¹, 0.0336 µm⁻¹, 0.0333 µm⁻¹, 0.0331 µm⁻¹, 0.0328 µm⁻¹, 0.0325 µm⁻¹, 0.0323 µm⁻¹, 0.032 µm⁻¹, 0.0317 µm⁻¹, 0.0315 µm⁻¹, 0.0312 µm⁻¹, 0.031 µm⁻¹, 0.0308 µm⁻¹, 0.0305 µm⁻¹, 0.0303 µm⁻¹, 0.0301 µm⁻¹, 0.03 µm⁻¹, 0.0299 µm⁻¹, 0.0296 µm⁻¹, 0.0294 µm⁻¹, 0.0292 µm⁻¹, 0.029 µm⁻¹, 0.0288 µm⁻¹, 0.0286 µm⁻¹, 0.0284 µm⁻¹, 0.0282 µm⁻¹, 0.028 µm⁻¹, 0.0278 µm⁻¹, 0.0276 µm⁻¹, 0.0274 µm⁻¹, 0.0272 µm⁻¹; 0.0270 µm⁻¹, 0.0268 µm⁻¹, 0.02667 µm⁻¹, 0.0265 µm⁻¹, 0.0263 µm⁻¹, 0.0261 µm⁻¹, 0.026 µm⁻¹, 0.0258 µm⁻¹, 0.0256 µm⁻¹, 0.0255 µm⁻¹, 0.0253 µm⁻¹, 0.0252 µm⁻¹, 0.025 µm⁻¹, 0.0248 µm⁻¹, 0.0247 µm⁻¹, 0.0245 µm⁻¹, 0.0244 µm⁻¹, 0.0242 µm⁻¹, 0.0241 µm⁻¹, 0.024 µm⁻¹, 0.0238 µm⁻¹, 0.0237 µm⁻¹, 0.0235 µm⁻¹, 0.0234 µm⁻¹, 0.0233 µm⁻¹, 0.231 µm⁻¹, 0.023 µm⁻¹, 0.0229 µm⁻¹, 0.0227 µm⁻¹, 0.0226 µm⁻¹, 0.0225 µm⁻¹, 0.0223 µm⁻¹, 0.0222 µm⁻¹, 0.0221 µm⁻¹, 0.022 µm⁻¹, 0.0219 µm⁻¹, 0.0217 µm⁻¹, 0.0216 µm⁻¹, 0.0215 µm⁻¹, 0.0214 µm⁻¹, 0.0213 µm⁻¹, 0.0212 µm⁻¹, 0.0211 µm⁻¹, 0.021 µm⁻¹, 0.0209 µm⁻¹, 0.0208 µm⁻¹, 0.0207 µm⁻¹, 0.0206 µm⁻¹, 0.0205 µm⁻¹, 0.0204 µm⁻¹, 0.0203 µm⁻¹, 0.0202 µm⁻¹, 0.0201 µm⁻¹, 0.02 µm⁻¹, or 0.002 µm⁻¹.

According to one embodiment, the curvature of the spherical particle 1 has no deviation, meaning that said particle 1 has a perfect spherical shape. A perfect spherical shape prevents fluctuations of the intensity of the scattered light.

According to one embodiment, the unique curvature of the spherical particle 1 may have a deviation less or equal to 0.01%, 0.02%, 0.03%, 0.04%, 0.05%, 0.06%, 0.07%, 0.08%, 0.09%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 1.6%, 1.7%, 1.8%, 1.9%, 2%, 2.1%, 2.2%, 2.3%, 2.4%, 2.5%, 2.6%, 2.7%, 2.8%, 2.9%, 3%, 3.1%, 3.2%, 3.3%, 3.4%, 3.5%, 3.6%, 3.7%, 3.8%, 3.9%, 4%, 4.1%, 4.2%, 4.3%, 4.4%, 4.5%, 4.6%, 4.7%, 4.8%, 4.9%, 5%, 5.1%, 5.2%, 5.3%, 5.4%, 5.5%, 5.6%, 5.7%, 5.8%, 5.9%, 6%, 6.1%, 6.2%, 6.3%, 6.4%, 6.5%, 6.6%, 6.7%, 6.8%, 6.9%, 7%, 7.1%, 7.2%, 7.3%, 7.4%, 7.5%, 7.6%, 7.7%, 7.8%, 7.9%, 8%, 8.1%, 8.2%, 8.3%, 8.4%, 8.5%, 8.6%, 8.7%, 8.8%, 8.9%, 9%, 9.1%, 9.2%, 9.3%, 9.4%, 9.5%, 9.6%, 9.7%, 9.8%, 9.9%, or 10% along the surface of said particle 1.

According to one embodiment, the particles 1 have an average size of at least 5 nm, 10 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

Particle 1 with an average size less than 1 µm have several advantages compared to bigger particles comprising the same number of particles 2: i) increasing the light scattering compared to bigger particles; ii) obtaining more stable colloidal suspensions compared to bigger particles, when they are dispersed in a solvent; iii) having a size compatible with pixels of at least 100 nm.

Particle 1 with an average size larger than 1 µm have several advantages compared to smaller particles comprising the same number of particles 2: i) reducing light scattering compared to smaller particles; ii) having whispering-gallery wave modes; iii) having a size compatible with pixels larger than or equal to 1 µm; iv) increasing the average distance between nanoparticles 3 comprised in the at least one particle 2 comprised in the particle 1, resulting in a better heat draining; v) increasing the average distance between nanoparticles 3 comprised in the at least one particle 2 comprised in the particle 1 and the surface of said particles 1, thus better protecting the nanoparticles 3 against oxidation, or delaying oxidation resulting from a chemical reaction with chemical species coming from the outer space of said particles 1; vi) increasing the mass ratio between the particle 1 and nanoparticle 3 comprised in said at least one particle 2 comprised in the particle 1 compared to smaller particles 1, thus reducing the mass concentration of chemical elements subject to ROHS standards, making it easier to comply with ROHS requirements.

According to one embodiment, the particle 1 is ROHS compliant.

According to one embodiment, the particle 1 comprises less than 10 ppm, less than 20 ppm, less than 30 ppm, less than 40 ppm, less than 50 ppm, less than 100 ppm, less than 150 ppm, less than 200 ppm, less than 250 ppm, less than 300 ppm, less than 350 ppm, less than 400 ppm, less than 450 ppm, less than 500 ppm, less than 550 ppm, less than 600 ppm, less than 650 ppm, less than 700 ppm, less than 750 ppm, less than 800 ppm, less than 850 ppm, less than 900 ppm, less than 950 ppm, less than 1000 ppm in weight of cadmium.

According to one embodiment, the particle 1 comprises less than 10 ppm, less than 20 ppm, less than 30 ppm, less than 40 ppm, less than 50 ppm, less than 100 ppm, less than 150 ppm, less than 200 ppm, less than 250 ppm, less than 300 ppm, less than 350 ppm, less than 400 ppm, less than 450 ppm, less than 500 ppm, less than 550 ppm, less than 600 ppm, less than 650 ppm, less than 700 ppm, less than 750 ppm, less than 800 ppm, less than 850 ppm, less than 900 ppm, less than 950 ppm, less than 1000 ppm, less than 2000 ppm, less than 3000 ppm, less than 4000 ppm, less than 5000 ppm, less than 6000 ppm, less than 7000 ppm, less than 8000 ppm, less than 9000 ppm, less than 10000 ppm in weight of lead.

According to one embodiment, the particle 1 comprises less than 10 ppm, less than 20 ppm, less than 30 ppm, less than 40 ppm, less than 50 ppm, less than 100 ppm, less than 150 ppm, less than 200 ppm, less than 250 ppm, less than 300 ppm, less than 350 ppm, less than 400 ppm, less than 450 ppm, less than 500 ppm, less than 550 ppm, less than 600 ppm, less than 650 ppm, less than 700 ppm, less than 750 ppm, less than 800 ppm, less than 850 ppm, less than 900 ppm, less than 950 ppm, less than 1000 ppm, less than 2000 ppm, less than 3000 ppm, less than 4000 ppm, less than 5000 ppm, less than 6000 ppm, less than 7000 ppm, less than 8000 ppm, less than 9000 ppm, less than 10000 ppm in weight of mercury.

According to one embodiment, the particle 1 comprises heavier chemical elements than the main chemical element present in the first and/or second materials (11, 21). In this embodiment, said heavy chemical elements in the particle 1 will lower the mass concentration of chemical elements subject to ROHS standards, allowing said particle 1 to be ROHS compliant.

According to one embodiment, examples of heavy chemical elements include but are not limited to B, C, N, F, Na, Mg, Al, Si, P, S, Cl, K, Ca, Sc, Ti, V, Cr, Mn, Fe, Co, Ni, Cu, Zn, Ga, Ge, As, Se, Br, Rb, Sr, Y, Zr, Nb, Mo, Tc, Ru, Rh, Pd, Ag, Cd, In, Sn, Sb, Te, I, Cs, Ba, La, Hf, Ta, W, Re, Os, Ir, Pt, Au, Hg, Tl, Pb, Bi, Po, At, Ce, Pr, Nd, Pm, Sm, Eu, Gd, Tb, Dy, Ho, Er, Tm, Yb, Lu or a mixture of thereof.

According to one embodiment, the particle **1** exhibits at least one other property so that the particle **1** is also: magnetic; ferromagnetic; paramagnetic; superparamagnetic; diamagnetic; plasmonic; piezo-electric; pyro-electric; ferro-electric; drug delivery featured; a light scatterer; an electrical insulator; an electrical conductor; a thermal insulator; a thermal conductor; and/or a local high temperature heating system.

According to one embodiment, the particle **1** exhibits at least one other property comprising one or more of the following: capacity of increasing local electromagnetic field, magnetization, magnetic coercivity, catalytic yield, catalytic properties, photovoltaic properties, photovoltaic yield, electrical polarization, thermal conductivity, electrical conductivity, permeability to molecular oxygen, permeability to molecular water, or any other properties.

According to one embodiment, the particle **1** is an electrical insulator. In this embodiment, the quenching of fluorescent properties for fluorescent nanoparticles **3** encapsulated in the second material **21** is prevented when it is due to electron transport. In this embodiment, the particle **1** may be used as an electrical insulator material exhibiting the same properties as the nanoparticles **3** encapsulated in the second material **21.**

According to one embodiment, the particle **1** is an electrical conductor. This embodiment is particularly advantageous for an application of the particle **1** in photovoltaics or LEDs.

According to one embodiment, the particle **1** has an electrical conductivity at standard conditions ranging from 1×10⁻²⁰ to 10⁷ S/m, preferably from 1×10⁻¹⁵ to 5 S/m, more preferably from 1×10⁻⁷ to 1 S/m.

According to one embodiment, the particle **1** has an electrical conductivity at standard conditions of at least 1×10⁻²⁰ S/m, 0.5×10⁻¹⁹ S/m, 1×10⁻¹⁹ S/m, 0.5×10⁻¹⁸ S/m, 1×10⁻¹⁸ S/m, 0.5×10⁻¹⁷ S/m, 1×10⁻¹⁷ S/m, 0.5×10⁻¹⁶ S/m, 1×10⁻¹⁶ S/m, 0.5×10⁻¹⁵ S/m, 1×10⁻¹⁵ S/m, 0.5×10⁻¹⁴ S/m, 1×10⁻¹⁴ S/m, 0.5×10⁻¹³ S/m, 1×10⁻¹³ S/m, 0.5×10⁻¹² S/m, 1×10⁻¹² S/m, 0.5×10⁻¹¹ S/m, 1×10⁻¹¹ S/m, 0.5×10⁻¹⁰ S/m, 1×10⁻¹⁰ S/m, 0.5×10⁻⁹ S/m, 1×10⁻⁹ S/m, 0.5×10⁻⁸ S/m, 1×10⁻⁸ S/m, 0.5×10⁻⁷ S/m, 1×10⁻⁷ S/m, 0.5×10⁻⁶ S/m, 1×10⁻⁶ S/m, 0.5×10⁻⁵ S/m, 1×10⁻⁵ S/m, 0.5×10⁻⁴ S/m, 1×10⁻⁴ S/m, 0.5×10⁻³ S/m, 1×10⁻³ S/m, 0.5×10⁻² S/m, 1×10⁻² S/m, 0.5×10⁻¹ S/m, 1×10⁻¹ S/m, 0.5 S/m, 1 S/m, 1.5 S/m, 2 S/m, 2.5 S/m, 3 S/m, 3.5 S/m, 4 S/m, 4.5 S/m, 5 S/m, 5.5 S/m, 6 S/m, 6.5 S/m, 7 S/m, 7.5 S/m, 8 S/m, 8.5 S/m, 9 S/m, 9.5 S/m, 10 S/m, 50 S/m, 10² S/m, 5×10² S/m, 10³ S/m, 5×10³ S/m, 10⁴ S/m, 5×10⁴ S/m, 10⁵ S/m, 5×10⁵ S/m, 10⁶ S/m, 5×10⁶ S/m, or 10⁷ S/m.

According to one embodiment, the electrical conductivity of the particle **1** may be measured for example with an impedance spectrometer.

According to one embodiment, the particle **1** is a thermal insulator.

According to one embodiment, the particle **1** is a thermal conductor. In this embodiment, the particle 1 is capable of draining away the heat originating from the nanoparticles **3** encapsulated in the second material **21,** or from the environment.

According to one embodiment, the particle **1** has a thermal conductivity at standard conditions ranging from 0.1 to 450 W/(m.K), preferably from 1 to 200 W/(m.K), more preferably from 10 to 150 W/(m.K).

According to one embodiment, the particle **1** has a thermal conductivity at standard conditions of at least 0.1 W/(m.K), 0.2 W/(m.K), 0.3 W/(m.K), 0.4 W/(m.K), 0.5 W/(m.K), 0.6 W/(m.K), 0.7 W/(m.K), 0.8 W/(m.K), 0.9 W/(m.K), 1 W/(m.K), 1.1 W/(m.K), 1.2 W/(m.K), 1.3 W/(m.K), 1.4 W/(m.K), 1.5 W/(m.K), 1.6 W/(m.K), 1.7 W/(m.K), 1.8 W/(m.K), 1.9 W/(m.K), 2 W/(m.K), 2.1 W/(m.K), 2.2 W/(m.K), 2.3 W/(m.K), 2.4 W/(m.K), 2.5 W/(m.K), 2.6 W/(m.K), 2.7 W/(m.K), 2.8 W/(m.K), 2.9 W/(m.K), 3 W/(m.K), 3.1 W/(m.K), 3.2 W/(m.K), 3.3 W/(m.K), 3.4 W/(m.K), 3.5 W/(m.K), 3.6 W/(m.K), 3.7 W/(m.K), 3.8 W/(m.K), 3.9 W/(m.K), 4 W/(m.K), 4.1 W/(m.K), 4.2 W/(m.K), 4.3 W/(m.K), 4.4 W/(m.K), 4.5 W/(m.K), 4.6 W/(m.K), 4.7 W/(m.K), 4.8 W/(m.K), 4.9 W/(m.K), 5 W/(m.K), 5.1 W/(m.K), 5.2 W/(m.K), 5.3 W/(m.K), 5.4 W/(m.K), 5.5 W/(m.K), 5.6 W/(m.K), 5.7 W/(m.K), 5.8 W/(m.K), 5.9 W/(m.K), 6 W/(m.K), 6.1 W/(m.K), 6.2 W/(m.K), 6.3 W/(m.K), 6.4 W/(m.K), 6.5 W/(m.K), 6.6 W/(m.K), 6.7 W/(m.K), 6.8 W/(m.K), 6.9 W/(m.K), 7 W/(m.K), 7.1 W/(m.K), 7.2 W/(m.K), 7.3 W/(m.K), 7.4 W/(m.K), 7.5 W/(m.K), 7.6 W/(m.K), 7.7 W/(m.K), 7.8 W/(m.K), 7.9 W/(m.K), 8 W/(m.K), 8.1 W/(m.K), 8.2 W/(m.K), 8.3 W/(m.K), 8.4 W/(m.K), 8.5 W/(m.K), 8.6 W/(m.K), 8.7 W/(m.K), 8.8 W/(m.K), 8.9 W/(m.K), 9 W/(m.K), 9.1 W/(m.K), 9.2 W/(m.K), 9.3 W/(m.K), 9.4 W/(m.K), 9.5 W/(m.K), 9.6 W/(m.K), 9.7 W/(m.K), 9.8 W/(m.K), 9.9 W/(m.K), 10 W/(m.K), 10.1 W/(m.K), 10.2 W/(m.K), 10.3 W/(m.K), 10.4 W/(m.K), 10.5 W/(m.K), 10.6 W/(m.K), 10.7 W/(m.K), 10.8 W/(m.K), 10.9 W/(m.K), 11 W/(m.K), 11.1 W/(m.K), 11.2 W/(m.K), 11.3 W/(m.K), 11.4 W/(m.K), 11.5 W/(m.K), 11.6 W/(m.K), 11.7 W/(m.K), 11.8 W/(m.K), 11.9 W/(m.K), 12 W/(m.K), 12.1 W/(m.K), 12.2 W/(m.K), 12.3 W/(m.K), 12.4 W/(m.K), 12.5 W/(m.K), 12.6 W/(m.K), 12.7 W/(m.K), 12.8 W/(m.K), 12.9 W/(m.K), 13 W/(m.K), 13.1 W/(m.K), 13.2 W/(m.K), 13.3 W/(m.K), 13.4 W/(m.K), 13.5 W/(m.K), 13.6 W/(m.K), 13.7 W/(m.K), 13.8 W/(m.K), 13.9 W/(m.K), 14 W/(m.K), 14.1 W/(m.K), 14.2 W/(m.K), 14.3 W/(m.K), 14.4 W/(m.K), 14.5 W/(m.K), 14.6 W/(m.K), 14.7 W/(m.K), 14.8 W/(m.K), 14.9 W/(m.K), 15 W/(m.K), 15.1 W/(m.K), 15.2 W/(m.K), 15.3 W/(m.K), 15.4 W/(m.K), 15.5 W/(m.K), 15.6 W/(m.K), 15.7 W/(m.K), 15.8 W/(m.K), 15.9 W/(m.K), 16 W/(m.K), 16.1 W/(m.K), 16.2 W/(m.K), 16.3 W/(m.K), 16.4 W/(m.K), 16.5 W/(m.K), 16.6 W/(m.K), 16.7 W/(m.K), 16.8 W/(m.K), 16.9 W/(m.K), 17 W/(m.K), 17.1 W/(m.K), 17.2 W/(m.K), 17.3 W/(m.K), 17.4 W/(m.K), 17.5 W/(m.K), 17.6 W/(m.K), 17.7 W/(m.K), 17.8 W/(m.K), 17.9 W/(m.K), 18 W/(m.K), 18.1 W/(m.K), 18.2 W/(m.K), 18.3 W/(m.K), 18.4 W/(m.K), 18.5 W/(m.K), 18.6 W/(m.K), 18.7 W/(m.K), 18.8 W/(m.K), 18.9 W/(m.K), 19 W/(m.K), 19.1 W/(m.K), 19.2 W/(m.K), 19.3 W/(m.K), 19.4 W/(m.K), 19.5 W/(m.K), 19.6 W/(m.K), 19.7 W/(m.K), 19.8 W/(m.K), 19.9 W/(m.K), 20 W/(m.K), 20.1 W/(m.K), 20.2 W/(m.K), 20.3 W/(m.K), 20.4 W/(m.K), 20.5 W/(m.K), 20.6 W/(m.K), 20.7 W/(m.K), 20.8 W/(m.K), 20.9 W/(m.K), 21 W/(m.K), 21.1 W/(m.K), 21.2 W/(m.K), 21.3 W/(m.K), 21.4 W/(m.K), 21.5 W/(m.K), 21.6 W/(m.K), 21.7 W/(m.K), 21.8 W/(m.K), 21.9 W/(m.K), 22 W/(m.K), 22.1 W/(m.K), 22.2 W/(m.K), 22.3 W/(m.K), 22.4 W/(m.K), 22.5 W/(m.K), 22.6 W/(m.K), 22.7 W/(m.K), 22.8 W/(m.K), 22.9 W/(m.K), 23 W/(m.K), 23.1 W/(m.K), 23.2 W/(m.K), 23.3 W/(m.K), 23.4 W/(m.K), 23.5 W/(m.K), 23.6 W/(m.K), 23.7 W/(m.K), 23.8 W/(m.K), 23.9 W/(m.K), 24 W/(m.K), 24.1 W/(m.K), 24.2 W/(m.K), 24.3 W/(m.K), 24.4 W/(m.K), 24.5 W/(m.K), 24.6 W/(m.K), 24.7 W/(m.K), 24.8 W/(m.K), 24.9 W/(m.K), 25 W/(m.K), 30 W/(m.K), 40 W/(m.K), 50 W/(m.K), 60 W/(m.K), 70 W/(m.K), 80 W/(m.K), 90 W/(m.K), 100 W/(m.K), 110 W/(m.K), 120 W/(m.K), 130 W/(m.K), 140 W/(m.K), 150 W/(m.K), 160 W/(m.K), 170 W/(m.K), 180 W/(m.K), 190 W/(m.K), 200 W/(m.K), 210 W/(m.K), 220 W/(m.K), 230 W/(m.K), 240 W/(m.K), 250 W/(m.K), 260 W/(m.K), 270 W/(m.K), 280 W/(m.K), 290 W/(m.K), 300 W/(m.K), 310 W/(m.K), 320 W/(m.K), 330 W/(m.K), 340 W/(m.K), 350 W/(m.K), 360 W/(m.K), 370 W/(m.K), 380 W/(m.K), 390 W/(m.K), 400 W/(m.K), 410 W/(m.K), 420 W/(m.K), 430 W/(m.K), 440 W/(m.K), or 450 W/(m.K).

According to one embodiment, the thermal conductivity of the particle **1** may be measured for example by steady-state methods or transient methods.

According to one embodiment, the particle **1** is hydrophobic.

According to one embodiment, the particle **1** is hydrophilic.

According to one embodiment, the particle **1** is surfactant-free. In this embodiment, the surface of the particle **1** will be easy to functionalize as said surface will not be blocked by any surfactant molecule.

According to one embodiment, the particle **1** is not surfactant-free.

According to one embodiment, the particle **1** is amorphous.

According to one embodiment, the particle **1** is crystalline.

According to one embodiment, the particle **1** is totally crystalline.

According to one embodiment, the particle **1** is partially crystalline.

According to one embodiment, the particle **1** is monocrystalline.

According to one embodiment, the particle **1** is polycrystalline. In this embodiment, the particle 1 comprises at least one grain boundary.

According to one embodiment, the particle **1** is not porous.

According to one embodiment, the particle **1** does not comprise pores or cavities.

According to one embodiment, the particle **1** is considered non-porous when the quantity adsorbed by the said particle **1** determined by adsorption-desorption of nitrogen in the Brunauer-Emmett-Teller (BET) theory is less than 20 cm³/g, 15 cm³/g, 10 cm³/g, 5 cm³/g at a nitrogen pressure of 650 mmHg, preferably 700 mmHg.

According to one embodiment, the particle **1** is impermeable to outer molecular species, gas or liquid. In this embodiment, outer molecular species, gas or liquid refers to molecular species, gas or liquid external to said particle **1.**

According to one embodiment, the impermeable particle **1** has an intrinsic permeability to fluids less or equal to 10⁻¹¹ cm², 10⁻¹² cm², 10⁻¹³ cm², 10⁻¹⁴ cm², or 10⁻¹⁵ cm².

According to one embodiment, the particle **1** has an oxygen transmission rate ranging from 10⁻⁷ to 10 cm³.m⁻².day⁻¹, preferably from 10⁻⁷ to 1 cm³.m⁻².day⁻¹, more preferably from 10⁻⁷ to 10⁻¹ cm³.m⁻².day⁻¹, even more preferably from 10⁻⁷ to 10⁻⁴ cm³.m⁻².day⁻¹ at room temperature.

According to one embodiment, the particle **1** has a water vapor transmission rate ranging from 10⁻⁷ to 10 g.m⁻².day⁻¹, preferably from 10⁻⁷ to 1 g.m⁻².day⁻¹, more preferably from 10⁻⁷ to 10⁻¹ g.m⁻².day⁻¹, even more preferably from 10⁻⁷ to 10⁻⁴ g.m⁻².day⁻¹ at room temperature. A water vapor transmission rate of 10⁻⁶ g.m⁻².day⁻¹ is particularly adequate for a use on LED.

According to one embodiment, the particle **1** is optically transparent, *i.e.,* the particle **1** is transparent at wavelengths between 200 nm and 50 µm, between 200 nm and 10 µm, between 200 nm and 2500 nm, between 200 nm and 2000 nm, between 200 nm and 1500 nm, between 200 nm and 1000 nm, between 200 nm and 800 nm, between 400 nm and 700 nm, between 400 nm and 600 nm, or between 400 nm and 470 nm.

According to one embodiment, the particle **1** is a homostructure.

According to one embodiment, the particle **1** is not a core/shell structure wherein the core does not comprise particles **2** and the shell comprises particles **2.**

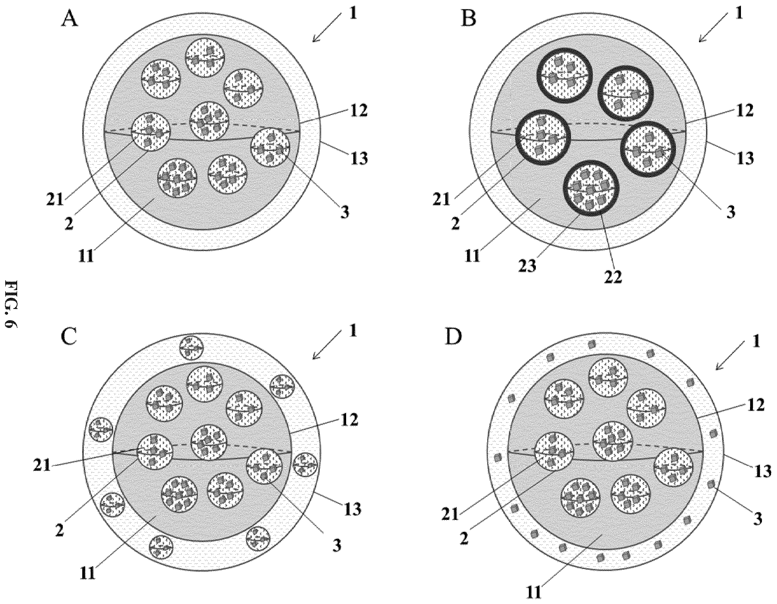

According to one embodiment as illustrated in Fig. 6A-D, the particle **1** is a heterostructure, comprising a core **12** and at least one shell **13.**

According to one embodiment, the shell **13** of the core/shell particle **1** comprises an inorganic material. In this embodiment, said inorganic material is the same or different than the first material **11** comprised in the core **12** of the core/shell particle **1.**

According to one embodiment, the shell **13** of the core/shell particle **1** consists of an inorganic material. In this embodiment, said inorganic material is the same or different than the first material **11** comprised in the core **12** of the core/shell particle **1.**

According to one embodiment illustrated in Fig. 6A, the core **12** of the core/shell particle **1** comprises at least one particle **2** as described herein and the shell **13** of the core/shell particle **1** does not comprise particles **2.**

According to one embodiment illustrated in Fig. 6C, the core **12** of the core/shell particle **1** comprises at least one particle **2** as described herein and the shell **13** of the core/shell particle **1** comprises at least one particle **2.**

According to one embodiment illustrated in Fig. 6D, the core **12** of the core/shell particle **1** comprises at least one particle **2** as described herein and the shell **13** of the core/shell particle **1** comprises at least one nanoparticle **3.** In this embodiment, said at least one nanoparticle **3** comprised in the shell **13** may be different or identical to the at least one nanoparticle **3** dispersed in the second material **21** of the at least one particle **2** comprised in the core **12.**

According to one embodiment, the at least one particle **2** comprised in the core **12** of the core/shell particle **1** is identical to the at least one particle **2** comprised in the shell **13** of the core/shell particle **1.**

According to one embodiment, the at least one particle **2** comprised in the core **12** of the core/shell particle **1** is different to the at least one particle **2** comprised in the shell **13** of the core/shell particle **1.** In this embodiment, the resulting core/shell particle **1** will exhibit different properties.

According to one embodiment, the core **12** of the core/shell particle **1** comprises at least one luminescent particle **2** and the shell **13** of the core/shell particle **1** comprises at least one particle **2** selected in the group of magnetic particle, plasmonic particle, dielectric particle, piezoelectric particle, pyro-electric particle, ferro-electric particle, light scattering particle, electrically insulating particle, thermally insulating particle, or catalytic particle.

According to one embodiment, the shell **13** of the core/shell particle **1** comprises at least one luminescent particle **2** and the core **12** of the core/shell particle **1** comprises at least one particle **2** selected in the group of magnetic particle, plasmonic particle, dielectric particle, piezoelectric particle, pyro-electric particle, ferro-electric particle, light scattering particle, electrically insulating particle, thermally insulating particle, or catalytic particle.

In a preferred embodiment, the core **12** of the core/shell particle **1** and the shell **13** of the core/shell particle **1** comprise at least two different luminescent particles **2,** wherein said luminescent particles **2** emit at different emission wavelengths. This means that the core **12** comprises at least one luminescent particle and the shell **13** comprises at least one luminescent particle, said luminescent particles having different emission wavelengths.

In a preferred embodiment, the core **12** of the core/shell particle **1** and the shell **13** of the core/shell particle **1** comprise at least two different luminescent particles **2,** wherein at least one luminescent particle **2** emits at a wavelength in the range from 500 to 560 nm, and at least one luminescent particle **2** emits at a wavelength in the range from 600 to 2500 nm. In this embodiment, the core **12** of the core/shell particle **1** and the shell **13** of the core/shell particle **1** comprise at least one luminescent particle **2** emitting in the green region of the visible spectrum and at least one luminescent particle **2** emitting in the red region of the visible spectrum, thus the particle **1** paired with a blue LED will be a white light emitter.

In a preferred embodiment, the core **12** of the core/shell particle **1** and the shell **13** of the core/shell particle **1** comprise at least two different luminescent particles **2,** wherein at least one luminescent particle **2** emits at a wavelength in the range from 400 to 490 nm, and at least one luminescent particle **2** emits at a wavelength in the range from 600 to 2500 nm. In this embodiment, the core **12** of the core/shell particle **1** and the shell **13** of the core/shell particle **1** comprise at least one luminescent particle **2** emitting in the blue region of the visible spectrum and at least one luminescent particle **2** emitting in the red region of the visible spectrum, thus the particle **1** will be a white light emitter.

In a preferred embodiment, the core **12** of the core/shell particle **1** and the shell **13** of the core/shell particle **1** comprise comprises at least two different luminescent particles **2,** wherein at least one luminescent particle **2** emits at a wavelength in the range from 400 to 490 nm, and at least one luminescent particle **2** emits at a wavelength in the range from 500 to 560 nm. In this embodiment, the core **12** of the core/shell particle **1** and the shell **13** of the core/shell particle **1** comprise at least one luminescent particle **2** emitting in the blue region of the visible spectrum and at least one luminescent particle **2** emitting in the green region of the visible spectrum.

According to one embodiment, the shell **13** of the particle 1 has a thickness of at least 0.1 nm, 0.2 nm, 0.3 nm, 0.4 nm, 0.5 nm, 1 nm, 1.5 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the shell **13** of the particle **1** has a thickness homogeneous all along the core **12,** *i.e.*, the shell **13** of the particle **1** has a same thickness all along the core **12.**

According to one embodiment, the shell **13** of the particle **1** has a thickness heterogeneous along the core **12,** *i.e.,* said thickness varies along the core **12.**

According to one embodiment, the particle **1** is not a core/shell particle wherein the core is an aggregate of metallic particles and the shell comprises the first material **11.**

According to one embodiment, the particle **1** is a core/shell particle wherein the core is filled with solvent and the shell comprises particles **2** dispersed in a first material **11,** *i.e.*, said particle **1** is a hollow bead with a solvent filled core.

According to one embodiment, the particle **1** comprises one particle **2** dispersed in the first material **11.**

According to one embodiment, the particle **1** is not a core/shell particle wherein the core is an aggregate of particles and the shell comprises the first material **11.**

According to one embodiment, the particle **1** is not a core/shell particle wherein the core is an aggregate of metallic particles and the shell comprises the first material **11.**

According to one embodiment, the particle **1** does not comprise only one particle **2** dispersed in the first material **11.** In this embodiment, the particle **1** is not a core/shell particle wherein the at least one particle **2** is the core with a shell of the first material **11.**

According to one embodiment, the particle 1 does not comprise only one core/shell particle **2** dispersed in the first material **11,** *i.e.*, the particle **1** is not a core/shell/shell particle, wherein the at least one core/shell particle **2** is the core with a first shell, and the second shell is made of the first material **11.**

According to one embodiment, the particle **1** comprises at least two particles **2** dispersed in the first material **11.**

According to one embodiment, the particle **1** comprises a plurality of particles **2** dispersed in the first material **11.**

According to one embodiment, the particle **1** comprises at least 1, at least 2, at least 3, at least 4, at least 5, at least 6, at least 7, at least 8, at least 9, at least 10, at least 11, at least 12, at least 13, at least 14, at least 15, at least 16, at least 17, at least 18, at least 19, at least 20, at least 21, at least 22, at least 23, at least 24, at least 25, at least 26, at least 27, at least 28, at least 29, at least 30, at least 31, at least 32, at least 33, at least 34, at least 35, at least 36, at least 37, at least 38, at least 39, at least 40, at least 41, at least 42, at least 43, at least 44, at least 45, at least 46, at least 47, at least 48, at least 49, at least 50, at least 51, at least 52, at least 53, at least 54, at least 55, at least 56, at least 57, at least 58, at least 59, at least 60, at least 61, at least 62, at least 63, at least 64, at least 65, at least 66, at least 67, at least 68, at least 69, at least 70, at least 71, at least 72, at least 73, at least 74, at least 75, at least 76, at least 77, at least 78, at least 79, at least 80, at least 81, at least 82, at least 83, at least 84, at least 85, at least 86, at least 87, at least 88, at least 89, at least 90, at least 91, at least 92, at least 93, at least 94, at least 95, at least 96, at least 97, at least 98, at least 99, at least 100, at least 200, at least 300, at least 400, at least 500, at least 600, at least 700, at least 800, at least 900, at least 1000, at least 1500, at least 2000, at least 2500, at least 3000, at least 3500, at least 4000, at least 4500, at least 5000, at least 5500, at least 6000, at least 6500, at least 7000, at least 7500, at least 8000, at least 8500, at least 9000, at least 9500, at least 10000, at least 15000, at least 20000, at least 25000, at least 30000, at least 35000, at least 40000, at least 45000, at least 50000, at least 55000, at least 60000, at least 65000, at least 70000, at least 75000, at least 80000, at least 85000, at least 90000, at least 95000, or at least 100000 particles **2** dispersed in the first material **11.**

According to one embodiment, the particle **1** comprises a combination of at least two different particles **2.** In this embodiment, the resulting particle **1** will exhibit different properties.

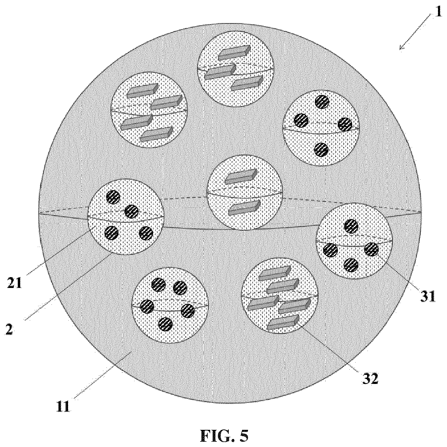

In a preferred embodiment illustrated in Fig. 5, the particle **1** comprises at least two different particles **2,** wherein at least one particle **2** emits at a wavelength in the range from 500 to 560 nm, and at least one particle **2** emits at a wavelength in the range from 600 to 2500 nm. In this embodiment, the particle **1** comprises at least one particle **2** emitting in the green region of the visible spectrum and at least one particle **2** emitting in the red region of the visible spectrum, thus the particle **1** paired with a blue LED will be a white light emitter.

In a preferred embodiment, the particle **1** comprises at least two different particles **2,** wherein at least one particle **2** emits at a wavelength in the range from 400 to 490 nm, and at least one particle **2** emits at a wavelength in the range from 600 to 2500 nm. In this embodiment, the particle **1** comprises at least one particle **2** emitting in the blue region of the visible spectrum and at least one particle **2** emitting in the red region of the visible spectrum, thus the particle **1** will be a white light emitter.

In a preferred embodiment, the particle **1** comprises at least two different particles **2,** wherein at least one particle **2** emits at a wavelength in the range from 400 to 490 nm, and at least one particle **2** emits at a wavelength in the range from 500 to 560 nm. In this embodiment, the particle **1** comprises at least one particle **2** emitting in the blue region of the visible spectrum and at least one particle **2** emitting in the green region of the visible spectrum.

In a preferred embodiment, the particle **1** comprises three different particles **2,** wherein said particles **2** emit different emission wavelengths or color.

In a preferred embodiment, the particle **1** comprises at least three different particles **2,** wherein at least one particle **2** emits at a wavelength in the range from 400 to 490 nm, at least one particle **2** emits at a wavelength in the range from 500 to 560 nm and at least one particle **2** emits at a wavelength in the range from 600 to 2500 nm. In this embodiment, the particle **1** comprises at least one particle **2** emitting in the blue region of the visible spectrum, at least one particle **2** emitting in the green region of the visible spectrum and at least one particle **2** emitting in the red region of the visible spectrum.

In a preferred embodiment, the particle **1** does not comprise any particle **2** on its surface. In this embodiment, the at least particle **2** is completely surrounded by the first material **11.**

According to one embodiment, at least 100%, 95%, 90%, 85%, 80%, 75%, 70%, 65%, 60%, 55%, 50%, 45%, 40%, 35%, 30%, 25%, 20%, 15%, 10%, 5%, or 1% of particles **2** are comprised in the first material **11.** In this embodiment, each of said particles **2** is completely surrounded by the first material **11.**

According to one embodiment, the particle **1** comprises at least 100%, 95%, 90%, 85%, 80%, 75%, 70%, 65%, 60%, 55%, 50%, 45%, 40%, 35%, 30%, 25%, 20%, 15%, 10%, 5%, 1% or 0% of particles **2** on its surface.

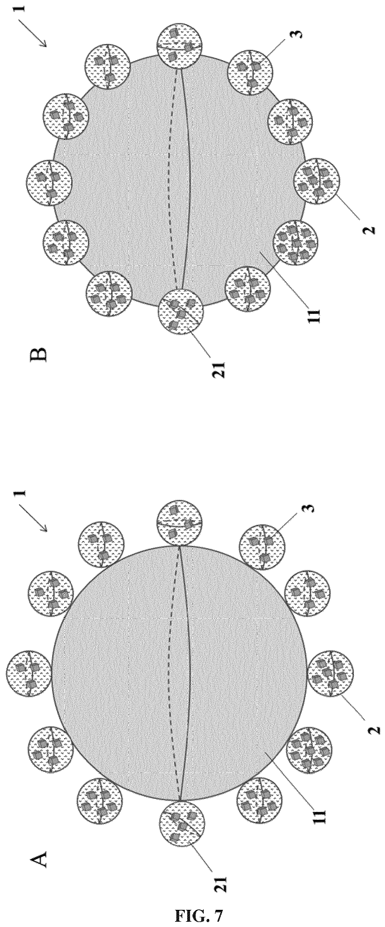

According to one embodiment illustrated in Fig. 7A-B, the particle **1** comprises at least one particle **2** located on the surface of said particle **1.**

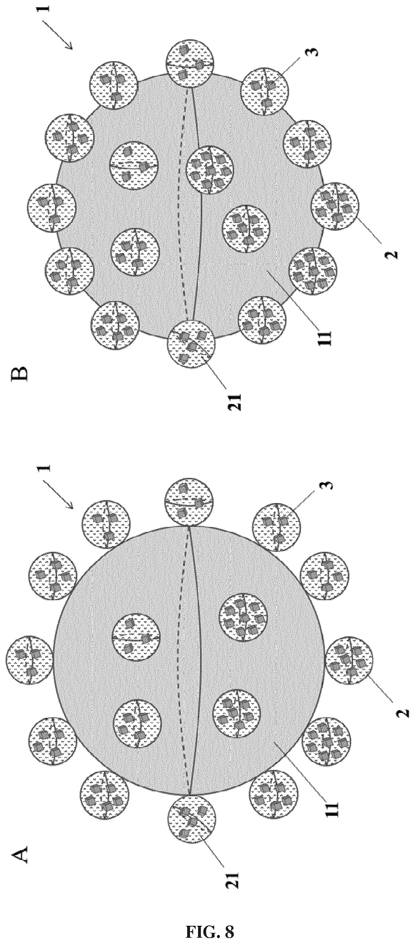

According to one embodiment illustrated in Fig. 8A-B, the particle **1** comprises at least one particle **2** dispersed in the first material **11**, *i.e.,* totally surrounded by said first material **11;** and at least one particle **2** located on the surface of said particle **1.**

According to one embodiment, the particle **1** comprises at least one particle **2** dispersed in the first material **11,** wherein said at least one particle **2** emits at a wavelength in the range from 500 to 560 nm; and at least one particle **2** located on the surface of said particle **1,** wherein said at least one particle **2** emits at a wavelength in the range from 600 to 2500 nm.

According to one embodiment, the particle **1** comprises at least one particle **2** dispersed in the first material **11,** wherein said at least one particle **2** emits at a wavelength in the range from 600 to 2500 nm; and at least one particle **2** located on the surface of said particle **1,** wherein said at least one particle **2** emits at a wavelength in the range from 500 to 560 nm.

According to one embodiment, the at least one particle **2** is only located on the surface of said particle **1.** This embodiment is advantageous as the at least one particle **2** will be better excited by the incident light than if said particle **2** was dispersed in the first material **11.**

According to one embodiment, the at least one particle **2** located on the surface of said particle **1** may be chemically or physically adsorbed on said surface.

According to one embodiment illustrated in Fig. 7A and Fig. 8A, the at least one particle **2** located on the surface of said particle **1** may be adsorbed on said surface.

According to one embodiment illustrated in Fig. 7A and Fig. 8A, the at least one particle **2** located on the surface of said particle **1** may be adsorbed with a cement on said surface.

According to one embodiment, examples of cement include but are not limited to: polymers, silicone, oxides, or a mixture thereof.

According to one embodiment illustrated in Fig. 7B and Fig. 8B, the at least one particle **2** located on the surface of said particle **1** may have at least 1%, 2%, 3%, 4%, 5%, 6%, 7%, 8%, 9%, 10%, 15%, 20%, 25%, 30%, 35%, 40%, 45%, 50%, 55%, 60%, 65%, 70%, 75%, 80%, 85%, 90%, 95%, or 100% of its volume trapped in the first material **11.**

According to one embodiment, the plurality of particles **2** is uniformly spaced on the surface of the particle **1.**

According to one embodiment, each particle **2** of the plurality of particles **2** is spaced from its adjacent particle **2** by an average minimal distance.

According to one embodiment, the average minimal distance between two particles **2** is controlled.

According to one embodiment, the average minimal distance between two particles **2** on the surface of the particle **1** is at least 1 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 300 µm, 400 µm, 500 µm, 600 µm, 700 µm, 800 µm, 900 µm, or 1mm.

According to one embodiment, the average distance between two particles 2 on the surface of the particle 1 is at least 1 nm, 1.5 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 300 µm, 400 µm, 500 µm, 600 µm, 700 µm, 800 µm, 900 µm, or 1 mm.

According to one embodiment, the average distance between two particles 2 on the surface of the particle 1 may have a deviation less or equal to 0.01%, 0.02%, 0.03%, 0.04%, 0.05%, 0.06%, 0.07%, 0.08%, 0.09%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 1.6%, 1.7%, 1.8%, 1.9%, 2%, 2.1%, 2.2%, 2.3%, 2.4%, 2.5%, 2.6%, 2.7%, 2.8%, 2.9%, 3%, 3.1%, 3.2%, 3.3%, 3.4%, 3.5%, 3.6%, 3.7%, 3.8%, 3.9%, 4%, 4.1%, 4.2%, 4.3%, 4.4%, 4.5%, 4.6%, 4.7%, 4.8%, 4.9%, 5%, 5.1%, 5.2%, 5.3%, 5.4%, 5.5%, 5.6%, 5.7%, 5.8%, 5.9%, 6%, 6.1%, 6.2%, 6.3%, 6.4%, 6.5%, 6.6%, 6.7%, 6.8%, 6.9%, 7%, 7.1%, 7.2%, 7.3%, 7.4%, 7.5%, 7.6%, 7.7%, 7.8%, 7.9%, 8%, 8.1%, 8.2%, 8.3%, 8.4%, 8.5%, 8.6%, 8.7%, 8.8%, 8.9%, 9%, 9.1%, 9.2%, 9.3%, 9.4%, 9.5%, 9.6%, 9.7%, 9.8%, 9.9%, 10%, 15%, 20%, 25%, 30%, 35%, 40%, 45%, or 50%.

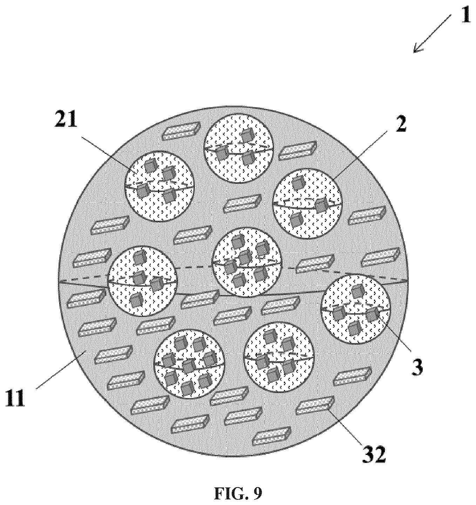

According to one embodiment illustrated in Fig. 9, the particle **1** further comprises at least one nanoparticle **3** dispersed in the first material **11.** In this embodiment, said at least one nanoparticle **3** is not dispersed in the second material **12;** said at least one nanoparticle **3** may be identical or different from the at least one nanoparticle **3** encapsulated in the second particle **2.**

According to one embodiment, the particle **1** comprises at least one nanoparticle **3** dispersed in the first material **11,** wherein said at least one nanoparticle **3** emits at a wavelength in the range from 500 to 560 nm; and at least one nanoparticle **3** in the particle **2,** wherein said at least one nanoparticle **3** emits at a wavelength in the range from 600 to 2500 nm.

According to one embodiment, the particle **1** comprises at least one nanoparticle **3** dispersed in the first material **11,** wherein said at least one nanoparticle **3** emits at a wavelength in the range from 600 to 2500 nm; and at least one nanoparticle **3** in the particle **2,** wherein said at least one nanoparticle **3** emits at a wavelength in the range from500 to 560 nm.

According to one embodiment, the particle **1** exhibits a shelf life of at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years.

According to one embodiment, the particle **1** exhibits a degradation of its photoluminescence of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years.

Photoluminescence refers to fluorescence and/or phosphorescence.

According to one embodiment, the particle **1** exhibits a degradation of its photoluminescence of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the particle **1** exhibits a degradation of its photoluminescence of less than 90%, 80%, 70%, 60%, 50%, 40%, 30%, 25%, 20%, 10%, 5%, 4%, 3%, 2%, 1%, or 0% under 0%, 10%, 20%, 30%, 40%, 50%, 55%, 60%, 65%, 70%, 75%, 80%, 85%, 90%, 95%, or 99% of humidity.

According to one embodiment, the particle **1** exhibits a degradation of its photoluminescence of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the particle **1** exhibits a degradation of its photoluminescence of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0%, 10%, 20%, 30%, 40%, 50%, 55%, 60%, 65%, 70%, 75%, 80%, 85%, 90%, 95%, or 99% of humidity.

According to one embodiment, the particle **1** exhibits a degradation of its photoluminescence of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the particle **1** exhibits a degradation of its photoluminescence of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the particle **1** exhibits a degradation of its photoluminescence of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂.

According to one embodiment, the particle **1** exhibits a degradation of its photoluminescence of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the particle **1** exhibits a degradation of its photoluminescence of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0%, 10%, 20%, 30%, 40%, 50%, 55%, 60%, 65%, 70%, 75%, 80%, 85%, 90%, 95%, or 99% of humidity.

According to one embodiment, the particle **1** exhibits a degradation of its photoluminescence of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

In one embodiment, the particle **1** exhibits photoluminescence quantum yield (PLQY) decrease of less than 80%, 70%, 60%, 50%, 40%, 30%, 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination.

According to one embodiment, the light illumination is provided by blue, green, red, or UV light source such as laser, diode, fluorescent lamp or Xenon Arc Lamp. According to one embodiment, the photon flux or average peak pulse power of the illumination is comprised between 1 mW.cm⁻² and 100 kW.cm⁻², more preferably between 10 mW.cm⁻² and 100 W.cm⁻², and even more preferably between 10 mW.cm⁻² and 30 W.cm⁻².

According to one embodiment, the photon flux or average peak pulse power of the illumination is at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

According to one embodiment, the light illumination described herein provides continuous lighting.

According to one embodiment, the light illumination described herein provides pulsed light. This embodiment is particularly advantageous as it allows the evacuation of heat and/or electrical charges from nanoparticles 3. This embodiment is also particularly advantageous as using pulsed light allow a longer lifespan of the nanoparticles 3, thus of the particles 1, indeed under continuous light, nanoparticles 3 degrade faster than under pulsed light.

According to one embodiment, the light illumination described herein provides pulsed light. In this embodiment, if a continuous light illuminates a material with regular periods during which said material is voluntary removed from the illumination, said light may be considered as pulsed light. This embodiment is particularly advantageous as it allows the evacuation of heat and/or electrical charges from nanoparticles 3.

According to one embodiment, said pulsed light has a time off (or time without illumination) of at least 1 µsecond, 2 µseconds, 3 µseconds, 4 µseconds, 5 µseconds, 6 µseconds, 7 µseconds, 8 µseconds, 9 µseconds, 10 µseconds, 11 µseconds, 12 µseconds, 13 µseconds, 14 µseconds, 15 µseconds, 16 µseconds, 17 µseconds, 18 µseconds, 19 µseconds, 20 µseconds, 21 µseconds, 22 µseconds, 23 µseconds, 24 µseconds, 25 µseconds, 26 µseconds, 27 µseconds, 28 µseconds, 29 µseconds, 30 µseconds, 31 µseconds, 32 µseconds, 33 µseconds, 34 µseconds, 35 µseconds, 36 µseconds, 37 µseconds, 38 µseconds, 39 µseconds, 40 µseconds, 41 µseconds, 42 µseconds, 43 µseconds, 44 µseconds, 45 µseconds, 46 µseconds, 47 µseconds, 48 µseconds, 49 µseconds, 50 µseconds, 100 µseconds, 150 µseconds, 200 µseconds, 250 µseconds, 300 µseconds, 350 µseconds, 400 µseconds, 450 µseconds, 500 µseconds, 550 µseconds, 600 µseconds, 650 µseconds, 700 µseconds, 750 µseconds, 800 µseconds, 850 µseconds, 900 µseconds, 950 µseconds, 1 msecond, 2 mseconds, 3 mseconds, 4 mseconds, 5 mseconds, 6 mseconds, 7 mseconds, 8 mseconds, 9 mseconds, 10 mseconds, 11 mseconds, 12 mseconds, 13 mseconds, 14 mseconds, 15 mseconds, 16 mseconds, 17 mseconds, 18 mseconds, 19 mseconds, 20 mseconds, 21 mseconds, 22 mseconds, 23 mseconds, 24 mseconds, 25 mseconds, 26 mseconds, 27 mseconds, 28 mseconds, 29 mseconds, 30 mseconds, 31 mseconds, 32 mseconds, 33 mseconds, 34 mseconds, 35 mseconds, 36 mseconds, 37 mseconds, 38 mseconds, 39 mseconds, 40 mseconds, 41 mseconds, 42 mseconds, 43 mseconds, 44 mseconds, 45 mseconds, 46 mseconds, 47 mseconds, 48 mseconds, 49 mseconds, or 50 mseconds.

According to one embodiment, said pulsed light has a time on (or illumination time) of at least 0.1 nanosecond, 0.2 nanosecond, 0.3 nanosecond, 0.4 nanosecond, 0.5 nanosecond, 0.6 nanosecond, 0.7 nanosecond, 0.8 nanosecond, 0.9 nanosecond, 1 nanosecond, 2 nanoseconds, 3 nanoseconds, 4 nanoseconds, 5 nanoseconds, 6 nanoseconds, 7 nanoseconds, 8 nanoseconds, 9 nanoseconds, 10 nanoseconds, 11 nanoseconds, 12 nanoseconds, 13 nanoseconds, 14 nanoseconds, 15 nanoseconds, 16 nanoseconds, 17 nanoseconds, 18 nanoseconds, 19 nanoseconds, 20 nanoseconds, 21 nanoseconds, 22 nanoseconds, 23 nanoseconds, 24 nanoseconds, 25 nanoseconds, 26 nanoseconds, 27 nanoseconds, 28 nanoseconds, 29 nanoseconds, 30 nanoseconds, 31 nanoseconds, 32 nanoseconds, 33 nanoseconds, 34 nanoseconds, 35 nanoseconds, 36 nanoseconds, 37 nanoseconds, 38 nanoseconds, 39 nanoseconds, 40 nanoseconds, 41 nanoseconds, 42 nanoseconds, 43 nanoseconds, 44 nanoseconds, 45 nanoseconds, 46 nanoseconds, 47 nanoseconds, 48 nanoseconds, 49 nanoseconds, 50 nanoseconds, 100 nanoseconds, 150 nanoseconds, 200 nanoseconds, 250 nanoseconds, 300 nanoseconds, 350 nanoseconds, 400 nanoseconds, 450 nanoseconds, 500 nanoseconds, 550 nanoseconds, 600 nanoseconds, 650 nanoseconds, 700 nanoseconds, 750 nanoseconds, 800 nanoseconds, 850 nanoseconds, 900 nanoseconds, 950 nanoseconds, 1 µsecond, 2 µseconds, 3 µseconds, 4 µseconds, 5 µseconds, 6 µseconds, 7 µseconds, 8 µseconds, 9 µseconds, 10 µseconds, 11 µseconds, 12 µseconds, 13 µseconds, 14 µseconds, 15 µseconds, 16 µseconds, 17 µseconds, 18 µseconds, 19 µseconds, 20 µseconds, 21 µseconds, 22 µseconds, 23 µseconds, 24 µseconds, 25 µseconds, 26 µseconds, 27 µseconds, 28 µseconds, 29 µseconds, 30 µseconds, 31 µseconds, 32 µseconds, 33 µseconds, 34 µseconds, 35 µseconds, 36 µseconds, 37 µseconds, 38 µseconds, 39 µseconds, 40 µseconds, 41 µseconds, 42 µseconds, 43 µseconds, 44 µseconds, 45 µseconds, 46 µseconds, 47 µseconds, 48 µseconds, 49 µseconds, or 50 µseconds.

According to one embodiment, said pulsed light has a frequency of at least 10 Hz, 11 Hz, 12 Hz, 13 Hz, 14 Hz, 15 Hz, 16 Hz, 17 Hz, 18 Hz, 19 Hz, 20 Hz, 21 Hz, 22 Hz, 23 Hz, 24 Hz, 25 Hz, 26 Hz, 27 Hz, 28 Hz, 29 Hz, 30 Hz, 31 Hz, 32 Hz, 33 Hz, 34 Hz, 35 Hz, 36 Hz, 37 Hz, 38 Hz, 39 Hz, 40 Hz, 41 Hz, 42 Hz, 43 Hz, 44 Hz, 45 Hz, 46 Hz, 47 Hz, 48 Hz, 49 Hz, 50 Hz, 100 Hz, 150 Hz, 200 Hz, 250 Hz, 300 Hz, 350 Hz, 400 Hz, 450 Hz, 500 Hz, 550 Hz, 600 Hz, 650 Hz, 700 Hz, 750 Hz, 800 Hz, 850 Hz, 900 Hz, 950 Hz, 1 kHz, 2 kHz, 3 kHz, 4 kHz, 5 kHz, 6 kHz, 7 kHz, 8 kHz, 9 kHz, 10 kHz, 11 kHz, 12 kHz, 13 kHz, 14 kHz, 15 kHz, 16 kHz, 17 kHz, 18 kHz, 19 kHz, 20 kHz, 21 kHz, 22 kHz, 23 kHz, 24 kHz, 25 kHz, 26 kHz, 27 kHz, 28 kHz, 29 kHz, 30 kHz, 31 kHz, 32 kHz, 33 kHz, 34 kHz, 35 kHz, 36 kHz, 37 kHz, 38 kHz, 39 kHz, 40 kHz, 41 kHz, 42 kHz, 43 kHz, 44 kHz, 45 kHz, 46 kHz, 47 kHz, 48 kHz, 49 kHz, 50 kHz, 100 kHz, 150 kHz, 200 kHz, 250 kHz, 300 kHz, 350 kHz, 400 kHz, 450 kHz, 500 kHz, 550 kHz, 600 kHz, 650 kHz, 700 kHz, 750 kHz, 800 kHz, 850 kHz, 900 kHz, 950 kHz, 1 MHz, 2 MHz, 3 MHz, 4 MHz, 5 MHz, 6 MHz, 7 MHz, 8 MHz, 9 MHz, 10 MHz, 11 MHz, 12 MHz, 13 MHz, 14 MHz, 15 MHz, 16 MHz, 17 MHz, 18 MHz, 19 MHz, 20 MHz, 21 MHz, 22 MHz, 23 MHz, 24 MHz, 25 MHz, 26 MHz, 27 MHz, 28 MHz, 29 MHz, 30 MHz, 31 MHz, 32 MHz, 33 MHz, 34 MHz, 35 MHz, 36 MHz, 37 MHz, 38 MHz, 39 MHz, 40 MHz, 41 MHz, 42 MHz, 43 MHz, 44 MHz, 45 MHz, 46 MHz, 47 MHz, 48 MHz, 49 MHz, 50 MHz, or 100 MHz.

According to one embodiment, the spot area of the light which illuminates the particle 1, the particle 2, the ink, the nanoparticles 3 and/or the light emitting material 7 is at least 10 µm², 20 µm², 30 µm², 40 µm², 50 µm², 60 µm², 70 µm², 80 µm², 90 µm²,100 µm², 200 µm², 300 µm², 400 µm², 500 µm², 600 µm², 700 µm², 800 µm², 900 µm², 10³ µm², 10⁴ µm², 10⁵ µm², 1 mm², 10 mm², 20 mm², 30 mm², 40 mm², 50 mm², 60 mm², 70 mm², 80 mm², 90 mm², 100 mm², 200 mm², 300 mm², 400 mm², 500 mm², 600 mm², 700 mm², 800 mm², 900 mm², 10³ mm², 10⁴ mm², 10⁵ mm², 1 m², 10 m², 20 m², 30 m², 40 m², 50 m², 60 m², 70 m², 80 m², 90 m², or 100 m².

According to one embodiment, the emission saturation of the particle 1, the particle 2, the ink, the nanoparticles 3 and/or the light emitting material 7 is reached under a pulsed light with a peak pulse power of at least 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², 100 kW.cm⁻², 200 kW.cm⁻², 300 kW.cm⁻², 400 kW.cm⁻², 500 kW.cm⁻², 600 kW.cm⁻², 700 kW.cm⁻², 800 kW.cm⁻², 900 kW.cm⁻², or 1 MW.cm⁻².

According to one embodiment, the emission saturation of the particle 1, the particle 2, the ink, the nanoparticles 3 and/or the light emitting material 7 is reached under a continuous illumination with a peak pulse power of at least 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², or 1 kW.cm⁻².

Emission saturation of particles under illumination with a given photon flux occurs when said particles cannot emit more photons. In other words, a higher photon flux doesn't lead to a higher number of photons emitted by said particles.

According to one embodiment, the FCE (Frequency Conversion Efficiency) of illuminated particle 1, the particle 2, the ink, nanoparticles 3 and/or light emitting material 7 is of at least 1%, 2%, 3%, 4%, 5%, 6%, 7%, 8%, 9%, 10%, 15%, 16%, 17%, 18%, 18%, 19%, 20%, 21%, 22%, 23%, 24%, 25%, 30%, 35%, 40%, 45%, 50%, 55%, 60%, 65%, 70%, 75%, 80%, 85%, 90%, 95%, or 100%. In this embodiment, the FCE was measured at 480 nm.

In one embodiment, the particle **1** exhibits photoluminescence quantum yield (PQLY) decrease of less than 80%, 70%, 60%, 50%, 40%, 30%, 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one embodiment, the particle **1** exhibits FCE decrease of less than 80%, 70%, 60%, 50%, 40%, 30%, 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

According to one embodiment, the particle **1** exhibits a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years.

According to one embodiment, the particle **1** exhibits a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the particle **1** exhibits a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% under 0%, 10%, 20%, 30%, 40%, 50%, 55%, 60%, 65%, 70%, 75%, 80%, 85%, 90%, 95%, or 99% of humidity.

According to one embodiment, the particle **1** exhibits a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the particle **1** exhibits a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0%, 10%, 20%, 30%, 40%, 50%, 55%, 60%, 65%, 70%, 75%, 80%, 85%, 90%, 95%, or 99% of humidity.

According to one embodiment, the particle **1** exhibits a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the particle **1** exhibits a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the particle **1** exhibits a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂.

According to one embodiment, the particle **1** exhibits a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the particle **1** exhibits a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0%, 10%, 20%, 30%, 40%, 50%, 55%, 60%, 65%, 70%, 75%, 80%, 85%, 90%, 95%, or 99% of humidity.

According to one embodiment, the particle **1** exhibits a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the particle **1** exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years.

According to one embodiment, the particle **1** exhibits a degradation of its FCE of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the particle **1** exhibits a degradation of its FCE of less than 90%, 80%, 70%, 60%, 50%, 40%, 30%, 25%, 20%, 10%, 5%, 4%, 3%, 2%, 1%, or 0% under 0%, 10%, 20%, 30%, 40%, 50%, 55%, 60%, 65%, 70%, 75%, 80%, 85%, 90%, 95%, or 99% of humidity.

According to one embodiment, the particle **1** exhibits a degradation of its FCE of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the particle **1** exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0%, 10%, 20%, 30%, 40%, 50%, 55%, 60%, 65%, 70%, 75%, 80%, 85%, 90%, 95%, or 99% of humidity.

According to one embodiment, the particle **1** exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the particle **1** exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the particle **1** exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂.

According to one embodiment, the particle **1** exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the particle **1** exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0%, 10%, 20%, 30%, 40%, 50%, 55%, 60%, 65%, 70%, 75%, 80%, 85%, 90%, 95%, or 99% of humidity.

According to one embodiment, the particle **1** exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

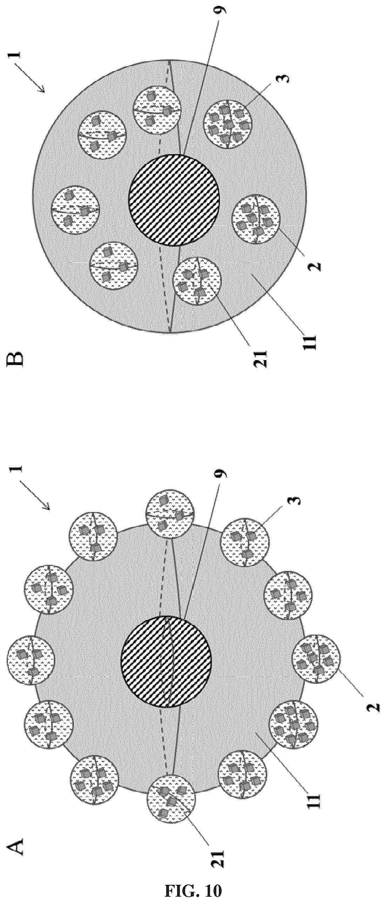

According to one embodiment illustrated in Fig. 10A-B, the particle **1** further comprises at least one dense particle 9 dispersed in the first material **11.** In this embodiment, said at least one dense particle **9** comprises a dense material with a density superior to the density of the first material **11.**

According to one embodiment, the dense material has a bandgap superior or equal to 3 eV.

According to one embodiment, examples of dense material include but are not limited to: oxides such as for example tin oxide, silicon oxide, germanium oxide, aluminium oxide, gallium oxide, hafmium oxide, titanium oxide, tantalum oxide, ytterbium oxide, zirconium oxide, yttrium oxide, thorium oxide, zinc oxide, lanthanide oxides, actinide oxides, alkaline earth metal oxides, mixed oxides, mixed oxides thereof; metal sulfides; carbides; nitrides; or a mixture thereof.

According to one embodiment, the at least one dense particle **9** has a maximal packing fraction of 70%, 60%, 50%, 40%, 30%, 20%, 10% or 1%.

According to one embodiment, the at least one dense particle **9** has a density of at least 3, 4, 5, 6, 7, 8, 9 or 10.

According to one embodiment, the particle **1** is semiconductor nanoplatelet coated with grease and encapsulated in Al₂O₃.

According to one embodiment, the particle **1** is semiconductor nanoplatelet encapsulated in a PMMA particle further encapsulated in Al₂O₃: semiconductor nanoplatelet@PMMA@ Al₂O₃.

According to one embodiment, the first material **11** and the second material **21** have a bandgap superior or equal to 3eV.

Having a bandgap superior or equal to 3eV, the first material **11** and the second material **21** are optically transparent to UV and blue light.

According to one embodiment, the first material **11** and the second material **21** have a bandgap of at least 3.0 eV, 3.1 eV, 3.2 eV, 3.3 eV, 3.4 eV, 3.5 eV, 3.6 eV, 3.7 eV, 3.8 eV, 3.9 eV, 4.0 eV, 4.1 eV, 4.2 eV, 4.3 eV, 4.4 eV, 4.5 eV, 4.6 eV, 4.7 eV, 4.8 eV, 4.9 eV, 5.0 eV, 5.1 eV, 5.2 eV, 5.3 eV, 5.4 eV or 5.5 eV.

According to one embodiment, the first material **11** and/or the second material **21** are inorganic materials.

According to one embodiment, the first material **11** and/or the second material **21** do not comprise organic molecules.

According to one embodiment, the first material **11** and/or the second material **21** do not comprise polymers.

According to one embodiment, the first material **11** and/or the second material **21** comprises inorganic polymers.

According to one embodiment, the first material **11** and/or the second material **21** are selected from the group consisting of oxide materials, semiconductor materials, wide-bandgap semiconductor materials or a mixture thereof.

According to one embodiment, examples of semiconductor materials include but are not limited to: III-V semiconductors, II-VI semiconductors, or a mixture thereof.

According to one embodiment, examples of wide-bandgap semiconductor materials include but are not limited to: silicon carbide SiC, aluminium nitride AlN, gallium nitride GaN, boron nitride BN, or a mixture thereof.

According to one embodiment, examples of oxide materials include but are not limited to: SiO₂, Al₂O₃, TiO₂, ZrO₂, FeO, ZnO, MgO, SnO₂, Nb₂O₅, CeO₂, BeO, IrO₂, CaO, Sc₂O₃, Na₂O, BaO, K₂O, TeO₂, MnO, B₂O₃, GeO₂, As₂O₃, Ta₂O₅, Li₂O, SrO, Y₂O₃, HfO₂, MoO₂, Tc₂O₇, ReO₂, Co₃O₄, OsO, RhO₂, Rh₂O₃, CdO, HgO, Tl₂O, Ga₂O₃, In₂O₃, Bi₂O₃, Sb₂O₃, PoO₂, SeO₂, Cs₂O, La₂O₃, Pr₆O₁₁, Nd₂O₃, La₂O₃, Sm₂O₃, Eu₂O₃, Tb₄O₇, Dy₂O₃, Ho₂O₃, Er₂O₃, Tm₂O₃, Yb₂O₃, Lu₂O₃, Gd₂O₃, or a mixture thereof.

According to one embodiment, the first material 11 and/or the second material **21** are selected from the group consisting of silicon oxide, aluminium oxide, titanium oxide, iron oxide, calcium oxide, magnesium oxide, zinc oxide, tin oxide, beryllium oxide, zirconium oxide, niobium oxide, cerium oxide, iridium oxide, scandium oxide, sodium oxide, barium oxide, potassium oxide, tellurium oxide, manganese oxide, boron oxide, germanium oxide, osmium oxide, rhenium oxide, arsenic oxide, tantalum oxide, lithium oxide, strontium oxide, yttrium oxide, hafnium oxide, molybdenum oxide, technetium oxide, rhodium oxide, cobalt oxide, gallium oxide, indium oxide, antimony oxide, polonium oxide, selenium oxide, cesium oxide, lanthanum oxide, praseodymium oxide, neodymium oxide, samarium oxide, europium oxide, terbium oxide, dysprosium oxide, erbium oxide, holmium oxide, thulium oxide, ytterbium oxide, lutetium oxide, gadolinium oxide, silicon carbide SiC, aluminium nitride AlN, gallium nitride GaN, boron nitride BN, mixed oxides, mixed oxides thereof, or a mixture thereof.

According to one embodiment, examples of oxide materials include but are not limited to: SiO₂, Al₂O₃, TiO₂, ZrO₂, FeO, ZnO, MgO, SnO₂, PbO, Ag₂O, Nb₂O₅, CeO₂, BeO, IrO₂, CaO, Sc₂O₃, Na₂O, BaO, K₂O, TeO₂, MnO, B₂O₃, GeO₂, As₂O₃, Ta₂O₅, Li₂O, SrO, P₂O₅, P₂O₃, P₄O₇, P₄O₈, P₄O₉, P₂O₆, PO, Fe₂O₃, Fe₃O₄, WO₂, Cr₂O₃, RuO₂, PtO, PdO, CuO, Cu₂O, Y₂O₃, HfO₂, V₂O₅, MoO₂, Tc₂O₇, ReO₂, Co₃O₄, OsO, RhO₂, Rh₂O₃, CdO, HgO, Tl₂O, Ga₂O₃, In₂O₃, Bi₂O₃, Sb₂O₃, PoO₂, SeO₂, Cs₂O, La₂O₃, Pr₆O₁₁, Nd₂O₃, La₂O₃, Sm₂O₃, Eu₂O₃, Tb₄O₇, Dy₂O₃, Ho₂O₃, Er₂O₃, Tm₂O₃, Yb₂O₃, Lu₂O₃, Gd₂O₃, or a mixture thereof.

According to one embodiment, the first material **11** and/or the second material **21** are selected from the group consisting of silicon oxide, aluminium oxide, titanium oxide, copper oxide, iron oxide, silver oxide, lead oxide, calcium oxide, magnesium oxide, zinc oxide, tin oxide, beryllium oxide, zirconium oxide, niobium oxide, cerium oxide, iridium oxide, scandium oxide, nickel oxide, sodium oxide, barium oxide, potassium oxide, vanadium oxide, tellurium oxide, manganese oxide, boron oxide, phosphorus oxide, germanium oxide, osmium oxide, rhenium oxide, platinum oxide, arsenic oxide, tantalum oxide, lithium oxide, strontium oxide, yttrium oxide, hafnium oxide, tungsten oxide, molybdenum oxide, chromium oxide, technetium oxide, rhodium oxide, ruthenium oxide, cobalt oxide, palladium oxide, cadmium oxide, mercury oxide, thallium oxide, gallium oxide, indium oxide, bismuth oxide, antimony oxide, polonium oxide, selenium oxide, cesium oxide, lanthanum oxide, praseodymium oxide, neodymium oxide, samarium oxide, europium oxide, terbium oxide, dysprosium oxide, erbium oxide, holmium oxide, thulium oxide, ytterbium oxide, lutetium oxide, gadolinium oxide, mixed oxides, mixed oxides thereof or a mixture thereof.

According to one embodiment, the first material **11** and/or the second material **21** comprise or consist of a ZrO₂/SiO₂ mixture: SiₓZr₁₋ₓO₂, wherein 0 ≤x≥ 1. In this embodiment, the first material **11** and/or the second material **21** are able to resist to any pH in a range from 0 to 14. This allows for a better protection of the at least one nanoparticle **3.**

According to one embodiment, the first material **11** and/or the second material **21** comprise or consist Si_{0.8}Zr_{0.2}O₂.

According to one embodiment, the first material **11** and/or the second material **21** comprise or consist of a HfO₂/SiO₂ mixture: SiₓHf₁₋ₓO₂, wherein 0 ≤x≥ 1.

According to one embodiment, the first material **11** and/or the second material **21** comprise or consist Si_{0.8}Hf_{0.2}O₂.

According to one embodiment, the first material **11** and/or the second material **21** comprise garnets.

According to one embodiment, examples of garnets include but are not limited to: Y₃Al₅O₁₂, Y₃Fe₂(FeO₄)₃, Y₃Fe₅O₁₂, Y₄Al₂O₉, YAlO₃, Fe₃Al₂(SiO₄)₃, Mg₃Al₂(SiO₄)₃, Mn₃Al₂(SiO₄)₃, Ca₃Fe₂(SiO₄)₃, Ca₃Al₂(SiO₄)₃, Ca₃Cr₂(SiO₄)₃, Al₅Lu₃O₁₂, GAL, GaYAG, or a mixture thereof.

According to one embodiment, the ceramic is crystalline or non-crystalline ceramics. According to one embodiment, the ceramic is selected from oxide ceramics and/or non-oxides ceramics, According to one embodiment, the ceramic is selected from pottery, bricks, tiles, cements and/glasses.

According to one embodiment, the stone is selected from agate, aquamarine, amazonite, amber, amethyst, ametrine, angelite, apatite, aragonite, silver, astrophylite, aventurine, azurite, beryk, silicified wood, bronzite, chalcedony, calcite, celestine, chakras, charoite, chiastolite, chrysocolla, chrysoprase, citrine, coral, cornalite, rock crystal, native copper, cyanite, danburite, diamond, dioptase, dolomite, dumorérite, emerald, fluorite, foliage, galene, garnet, heliotrope; hematite, hemimorphite, howlite, hypersthene, iolite, jades, jet, jasper, kunzite, labradorite, lazuli lazuli, larimar, lava, lepidolite, magnetist, magnetite, alachite, marcasite, meteorite, mokaite, moldavite, morganite, mother-of-pearl, obsidian, eye hawk, iron eye, bull's eye, tiger eye, onyx tree, black onyx, opal, gold, peridot, moonstone, star stone, sun stone, pietersite, prehnite, pyrite, blue quartz, smoky quartz, quartz, quatz hematoide, milky quartz, rose quartz, rutile quartz, rhodochrosite, rhodonite, rhyolite, ruby, sapphire, rock salt, selenite, seraphinite, serpentine, shattukite, shiva lingam, shungite, flint, smithsonite, sodalite, stealite, straumatolite, sugilite, tanzanite, topaz, tourmaline watermelon, black tourmaline, turquoise, ulexite, unakite, variscite, zoizite.

According to one embodiment, the first material **11** and/or the second material **21** comprise or consist of a thermal conductive material wherein said thermal conductive material includes but is not limited to: Al_{y}Oₓ, Ag_{y}Oₓ, Cu_{y}Oₓ, Fe_{y}Oₓ, Si_{y}Oₓ, Pb_{y}Oₓ, Ca_{y}Oₓ, Mg_{y}Oₓ, Zn_{y}Oₓ, Sn_{y}Oₓ, Ti_{y}Oₓ, Be_{y}Oₓ, mixed oxides, mixed oxides thereof or a mixture thereof; x and y are independently a decimal number from 0 to 10, at the condition that x and y are not simultaneously equal to 0, and x ≠ 0.

According to one embodiment, the first material **11** and/or the second material **21** comprise or consist of a thermal conductive material wherein said thermal conductive material includes but is not limited to: Al₂O₃, Ag₂O, Cu₂O, CuO, Fe₃O₄, FeO, SiO₂, PbO, CaO, MgO, ZnO, SnO₂, TiO₂, BeO, mixed oxides, mixed oxides thereof or a mixture thereof.

According to one embodiment, the first material **11** and/or the second material **21** comprise or consist of a thermal conductive material wherein said thermal conductive material includes but is not limited to: aluminium oxide, silver oxide, copper oxide, iron oxide, silicon oxide, lead oxide, calcium oxide, magnesium oxide, zinc oxide, tin oxide, titanium oxide, beryllium oxide, mixed oxides, mixed oxides thereof or a mixture thereof.

According to one embodiment, the first material **11** and/or the second material **21** comprise a material including but not limited to: silicon oxide, aluminium oxide, titanium oxide, copper oxide, iron oxide, silver oxide, lead oxide, calcium oxide, magnesium oxide, zinc oxide, tin oxide, beryllium oxide, zirconium oxide, niobium oxide, cerium oxide, iridium oxide, scandium oxide, nickel oxide, sodium oxide, barium oxide, potassium oxide, vanadium oxide, tellurium oxide, manganese oxide, boron oxide, phosphorus oxide, germanium oxide, osmium oxide, rhenium oxide, platinum oxide, arsenic oxide, tantalum oxide, lithium oxide, strontium oxide, yttrium oxide, hafnium oxide, tungsten oxide, molybdenum oxide, chromium oxide, technetium oxide, rhodium oxide, ruthenium oxide, cobalt oxide, palladium oxide, cadmium oxide, mercury oxide, thallium oxide, gallium oxide, indium oxide, bismuth oxide, antimony oxide, polonium oxide, selenium oxide, cesium oxide, lanthanum oxide, praseodymium oxide, neodymium oxide, samarium oxide, europium oxide, terbium oxide, dysprosium oxide, erbium oxide, holmium oxide, thulium oxide, ytterbium oxide, lutetium oxide, gadolinium oxide, mixed oxides, mixed oxides thereof, garnets such as for example Y₃Al₅O₁₂, Y₃Fe₂(FeO₄)₃, Y₃Fe₅O₁₂, Y₄Al₂O₉, YAlO₃, Fe₃Al₂(SiO₄)₃, Mg₃Al₂(SiO₄)₃, Mn₃Al₂(SiO₄)₃, Ca₃Fe₂(SiO₄)₃, Ca₃Al₂(SiO₄)₃, Ca₃Cr₂(SiO₄)₃, Al₅Lu₃O₁₂, GAL, GaYAG, or a mixture thereof.

According to one embodiment, the first material **11** and/or the second material **21** do not comprise organic molecules, organic groups or polymer chains.

According to one embodiment, the first material **11** and/or the second material **21** do not comprise polymers.

According to one embodiment, the first material **11** and/or the second material **21** are composed of a material selected in the group of metals, halides, chalcogenides, phosphides, sulfides, metalloids, metallic alloys, ceramics such as for example oxides, carbides, nitrides, glasses, enamels, ceramics, stones, precious stones, pigments, cements and/or inorganic polymers. Said first material **11** and/or the second material **21** are prepared using protocols known to the person skilled in the art.

According to one embodiment, the first material **11** and/or the second material **21** are composed of a material selected in the group of metals, halides, chalcogenides, phosphides, sulfides, metalloids, metallic alloys, ceramics such as for example oxides, carbides, nitrides, enamels, ceramics, stones, precious stones, pigments, and/or cements. Said first material **11** and/or the second material **21** are prepared using protocols known to the person skilled in the art.

According to one embodiment, the first material **11** and/or the second material **21** comprise or consists of a ZrO₂/SiO₂ mixture: SiₓZr₁₋ₓO₂, wherein 0 ≤x≤ 1. In this embodiment, the first the first material **11** and/or the second material **21** are able to resist to any pH in a range from 0 to 14. This allows for a better protection of the particles **2** and/or nanoparticles **3.**

According to one embodiment, the first material **11** and/or the second material **21** comprise or consists of Si_{0.8}Zr_{0.2}O₂.

According to one embodiment, the first material **11** and/or the second material **21** are comprise or consist of mixture: SiₓZr_{1.x}O_{z}, wherein 0 <x≤ 1 and 0 <z≤ 3.

According to one embodiment, the first material **11** and/or the second material **21** are comprise or consist of a HfO₂/SiO₂ mixture: SiₓHf₁₋ₓO₂, wherein 0 <x≤1 and 0 <z≤ 3.

According to one embodiment, the first material **11** and/or the second material **21** are comprise or consist of Si_{0.8}Hf_{0.2}O₂.

According to one embodiment, a chalcogenide is a chemical compound consisting of at least one chalcogen anion selected in the group of O, S, Se, Te, Po, and at least one or more electropositive element.

According to one embodiment, the metallic first material **11** and/or second material **21** are selected in the group of gold, silver, copper, vanadium, platinum, palladium, ruthenium, rhenium, yttrium, mercury, cadmium, osmium, chromium, tantalum, manganese, zinc, zirconium, niobium, molybdenum, rhodium, tungsten, iridium, nickel, iron, or cobalt.

According to one embodiment, examples of carbide first material **11** and/or second material **21** include but are not limited to: SiC, WC, BC, MoC, TiC, Al₄C₃, LaC₂, FeC, CoC, HfC, SiₓC_{y}, WₓC_{y}, BₓC_{y}, MoₓC_{y}, TiₓC_{y}, AlₓC_{y}, LaₓC_{y}, FeₓC_{y}, CoₓC_{y}, HfₓC_{y}, or a mixture thereof; x and y are independently a decimal number from 0 to 5, at the condition that x and y are not simultaneously equal to 0, and x ≠ 0.

According to one embodiment, examples of nitride first material **11** and/or second material **21** include but are not limited to: TiN, Si₃N₄, MoN, VN, TaN, Zr₃N₄, HfN, FeN, NbN, GaN, CrN, AlN, InN, TiₓN_{y}, SiₓN_{y}, MoₓN_{y}, VₓN_{y}, TaₓN_{y}, ZrₓN_{y}, HfₓN_{y}, FeₓN_{y}, NbₓN_{y}, GaₓN_{y}, CrₓN_{y}, AlₓN_{y}, InₓN_{y}, or a mixture thereof; x and y are independently a decimal number from 0 to 5, at the condition that when x and y are not simultaneously equal to 0, and x ≠ 0.

According to one embodiment, examples of sulfide first material **11** and/or second material **21** include but are not limited to: Si_{y}Sₓ, Al_{y}Sₓ, Ti_{y}Sₓ, Zr_{y}Sₓ, Zn_{y}Sₓ, Mg_{y}Sₓ, Sn_{y}Sₓ, Nb_{y}Sₓ, Ce_{y}Sₓ, Be_{y}Sₓ, Ir_{y}Sₓ, Ca_{y}Sₓ, Sc_{y}Sₓ, Ni_{y}Sₓ, Na_{y}Sₓ, Ba_{y}Sₓ, K_{y}Sₓ, Pb_{y}Sₓ, Ag_{y}Sₓ, V_{y}Sₓ, Te_{y}Sₓ, Mn_{y}Sₓ, B_{y}Sₓ, P_{y}Sₓ, Ge_{y}Sₓ, As_{y}Sₓ, Fe_{y}Sₓ, Ta_{y}Sₓ, Li_{y}Sₓ, Sr_{y}Sₓ, Y_{y}Sₓ, Hf_{y}Sₓ, W_{y}Sₓ, Mo_{y}Sₓ, Cr_{y}Sₓ, Tc_{y}Sₓ, Re_{y}Sₓ, Ru_{y}Sₓ, Co_{y}Sₓ, Os_{y}Sₓ, Rh_{y}Sₓ, Pt_{y}Sₓ, Pd_{y}Sₓ, Cu_{y}Sₓ, Au_{y}Sₓ, Cd_{y}Sₓ, Hg_{y}Sₓ, Tl_{y}Sₓ, Ga_{y}Sₓ, In_{y}Sₓ, Bi_{y}Sₓ, Sb_{y}Sₓ, Po_{y}Sₓ, Se_{y}Sₓ, Cs_{y}Sₓ, mixed sulfides, mixed sulfides thereof or a mixture thereof; x and y are independently a decimal number from 0 to 10, at the condition that x and y are not simultaneously equal to 0, and x ≠ 0.

According to one embodiment, examples of halide first material **11** and/or second material **21** include but are not limited to: BaF₂, LaF₃, CeF₃, YF₃, CaF₂, MgF₂, PrF₃, AgCl, MnCl₂, NiCl₂, Hg₂Cl₂, CaCl₂, CsPbCl₃, AgBr, PbBr₃, CsPbBr₃, AgI, CuI, PbI, HgI₂, BiI₃, CH₃NH₃PbI₃, CH₃NH₃PbCl₃, CH₃NH₃PbBr₃, CsPbI₃, FAPbBr₃ (with FA formamidinium), or a mixture thereof.

According to one embodiment, examples of chalcogenide first material **11** and/or second material **21** include but are not limited to: CdO, CdS, CdSe, CdTe, ZnO, ZnS, ZnSe, ZnTe, HgO, HgS, HgSe, HgTe, CuO, Cu₂O, CuS, Cu₂S, CuSe, CuTe, Ag₂O, Ag₂S, Ag₂Se, Ag₂Te, Au₂S, PdO, PdS, Pd₄S, PdSe, PdTe, PtO, PtS, PtS₂, PtSe, PtTe, RhO₂, Rh₂O₃, RhS2, Rh₂S₃, RhSe₂, Rh₂Se₃, RhTe₂, IrO₂, IrS₂, Ir₂S₃, IrSe₂, IrTe₂, RuO₂, RuS₂, OsO, OsS, OsSe, OsTe, MnO, MnS, MnSe, MnTe, ReO₂, ReS₂, Cr₂O₃, Cr₂S₃, MoO₂, MoS₂, MoSe₂, MoTe₂, WO₂, WS₂, WSe₂, V₂O₅, V₂S₃, Nb₂O₅, NbS₂, NbSe₂, HfO₂, HfS₂, TiO₂, ZrO₂, ZrS₂, ZrSe₂, ZrTe₂, Sc₂O₃, Y₂O₃, Y₂S₃, SiO₂, GeO₂, GeS, GeS₂, GeSe, GeSe₂, GeTe, SnO₂, SnS, SnS₂, SnSe, SnSe₂, SnTe, PbO, PbS, PbSe, PbTe, MgO, MgS, MgSe, MgTe, CaO, CaS, SrO, Al₂O₃, Ga₂O₃, Ga₂S₃, Ga₂Se₃, In₂O₃, In₂S₃, In₂Se₃, In₂Te₃, La₂O₃, La₂S₃, CeO₂, CeS₂, Pr₆O₁₁, Nd₂O₃, NdS₂, La₂O₃, Tl₂O, Sm₂O₃, SmS₂, Eu₂O₃, EuS₂, Bi₂O₃, Sb₂O₃, PoO₂, SeO₂, Cs₂O, Tb₄O₇, TbS₂, Dy₂O₃, Ho₂O₃, Er₂O₃, ErS₂, Tm₂O₃, Yb₂O₃, Lu₂O₃, CuInS₂, CuInSe₂, AgInS₂, AgInSe₂, Fe₂O₃, Fe₃O₄, FeS, FeS₂, Co₃S₄, CoSe, Co₃O₄, NiO, NiSe₂, NiSe, Ni₃Se₄, Gd₂O₃, BeO, TeO₂, Na₂O, BaO, K₂O, Ta₂O₅, Li₂O, Tc₂O₇, As₂O₃, B₂O₃, P₂O₅, P₂O₃, P₄O₇, P₄O₈, P₄O₉, P₂O₆, PO, or a mixture thereof.

According to one embodiment, examples of phosphide first material 11 and/or second material 21 include but are not limited to: InP, Cd₃P₂, Zn₃P₂, AlP, GaP, TIP, or a mixture thereof.

According to one embodiment, examples of metalloid first material 11 and/or second material 21 include but are not limited to: Si, B, Ge, As, Sb, Te, or a mixture thereof.

According to one embodiment, examples of metallic alloy first material 11 and/or second material 21 include but are not limited to: Au-Pd, Au-Ag, Au-Cu, Pt-Pd, Pt-Ni, Cu-Ag, Cu-Sn, Ru-Pt, Rh-Pt, Cu-Pt, Ni-Au, Pt-Sn, Pd-V, Ir-Pt, Au-Pt, Pd-Ag, Cu-Zn, Cr-Ni, Fe-Co, Co-Ni, Fe-Ni or a mixture thereof.

According to one embodiment, the first material **11** and the second material **21** are independently chosen from the lists of materials cited herein.

According to one embodiment, the first material **11** and/or the second material **21** comprise organic molecules in small amounts of 0 mole%, 1 mole%, 5 mole%, 10 mole%, 15 mole%, 20 mole%, 25 mole%, 30 mole%, 35 mole%, 40 mole%, 45 mole%, 50 mole%, 55 mole%, 60 mole%, 65 mole%, 70 mole%, 75 mole%, 80 mole% relative to the majority element of said first material **11** and/or second material **21.**

According to one embodiment, the first material **11** and/or the second material **21** do not comprise SiO₂.

According to one embodiment, the first material **11** and/or the second material **21** do not comprise inorganic polymers.

According to one embodiment, the first material **11** and/or the second material **21** comprise at least 1% of SiO₂, 5% of SiO₂, 10% of SiO₂, 15% of SiO₂, 20% of SiO₂, 25% of SiO₂, 30% of SiO₂, 35% of SiO₂, 40% of SiO₂, 45% of SiO₂, 50% of SiO₂, 55% of SiO₂, 60% of SiO₂, 65% of SiO₂, 70% of SiO₂, 75% of SiO₂, 80% of SiO₂, 85% of SiO₂, 90% of SiO₂, 95% of SiO₂, or 100% SiO₂.

According to one embodiment, the first material **11** and/or the second material **21** comprise less than 1%, 2%, 3%, 4%, 5%, 6%, 7%, 8%, 9%, 10%, 15%, 20%, 25%, 30%, 35%, 40%, 45%, 50%, 55%, 60%, 65%, 70%, 75%, 80%, 85%, 90%, 95%, or 100% of SiO₂.

According to one embodiment, the first material **11** and/or the second material **21** comprise at least 1%, 2%, 3%, 4%, 5%, 6%, 7%, 8%, 9%, 10%, 15%, 20%, 25%, 30%, 35%, 40%, 45%, 50%, 55%, 60%, 65%, 70%, 75%, 80%, 85%, 90%, 95%, or 100% of SiO₂ precursors.

According to one embodiment, the first material **11** and/or the second material **21** comprise less than 1%, 2%, 3%, 4%, 5%, 6%, 7%, 8%, 9%, 10%, 15%, 20%, 25%, 30%, 35%, 40%, 45%, 50%, 55%, 60%, 65%, 70%, 75%, 80%, 85%, 90%, 95%, or 100% of SiO₂ precursors.

According to one embodiment, the first material **11** and/or the second material **21** comprise at least one precursor of SiO₂.

According to one embodiment, examples of precursors of SiO₂ include but are not limited to: tetramethyl orthosilicate, tetraethyl orthosilicate, polydiethyoxysilane, n- alkyltrimethoxylsilanes such as for example n-butyltrimethoxysilane, n- octyltrimethoxylsilane, n-dodecyltrimethoxysilane, n-octadecyltrimethoxysilane, 3-mercaptopropyltrimethoxysilane, 11- mercaptoundecyltrimethoxysilane, 3-aminopropyltrimethoxysilane, 11-aminoundecyltrimethoxysilane, 3-(2-(2-aminoethylamino)ethylamino)propyltrimethoxysilane, 3-(trimethoxysilyl)propyl methacrylate, 3-(aminopropyl)trimethoxysilane, or a mixture thereof.

According to one embodiment, the first material **11** and/or the second material **21** do not consist of pure SiO₂, *i.e.,* 100% SiO₂.

According to one embodiment, the first material **11** and/or the second material **21** do not consist of pure Al₂O₃, *i.e.,* 100% Al₂O₃.

According to one embodiment, the first material **11** and/or the second material **21** comprise at least 1%, 2%, 3%, 4%, 5%, 6%, 7%, 8%, 9%, 10%, 15%, 20%, 25%, 30%, 35%, 40%, 45%, 50%, 55%, 60%, 65%, 70%, 75%, 80%, 85%, 90%, 95%, or 100% of Al₂O₃.

According to one embodiment, the first material **11** and/or the second material **21** comprise less than 1%, 2%, 3%, 4%, 5%, 6%, 7%, 8%, 9%, 10%, 15%, 20%, 25%, 30%, 35%, 40%, 45%, 50%, 55%, 60%, 65%, 70%, 75%, 80%, 85%, 90%, 95%, or 100% of Al₂O₃.

According to one embodiment, the first material **11** and/or the second material **21** comprise at least 1%, 2%, 3%, 4%, 5%, 6%, 7%, 8%, 9%, 10%, 15%, 20%, 25%, 30%, 35%, 40%, 45%, 50%, 55%, 60%, 65%, 70%, 75%, 80%, 85%, 90%, 95%, or 100% of Al₂O₃ precursors.

According to one embodiment, the first material **11** and/or the second material **21** comprise less than 1%, 2%, 3%, 4%, 5%, 6%, 7%, 8%, 9%, 10%, 15%, 20%, 25%, 30%, 35%, 40%, 45%, 50%, 55%, 60%, 65%, 70%, 75%, 80%, 85%, 90%, 95%, or 100% of Al₂O₃ precursors.

According to one embodiment, the first material **11** and/or the second material **21** do not comprise TiO₂.

According to one embodiment, the first material **11** and/or the second material **21** do not consist of pure TiO₂, *i.e.,* 100% TiO₂.

According to one embodiment, the first material **11** and/or the second material **21** do not comprise zeolite.

According to one embodiment, the first material **11** and/or the second material **21** do not consist of pure zeolite, *i.e.,* 100% zeolite.

According to one embodiment, the first material **11** and/or the second material **21** do not comprise glass.

According to one embodiment, the first material **11** and/or the second material **21** do not comprise vitrified glass.

According to one embodiment, the first material **11** and/or the second material **21** comprise an inorganic polymer.

According to one embodiment, the inorganic polymer is a polymer not containing carbon. According to one embodiment, the inorganic polymer is selected from polysilanes, polysiloxanes (or silicones), polythiazyles, polyaluminosilicates, polygermanes, polystannanes, polyborazylenes, polyphosphazenes, polydichlorophosphazenes, polysulfides, polysulfur and/or nitrides. According to one embodiment, the inorganic polymer is a liquid crystal polymer.

According to one embodiment, the inorganic polymer is a natural or synthetic polymer. According to one embodiment, the inorganic polymer is synthetized by inorganic reaction, radical polymerization, polycondensation, polyaddition, or ring opening polymerization (ROP). According to one embodiment, the inorganic polymer is a homopolymer or a copolymer. According to one embodiment, the inorganic polymer is linear, branched, and/or cross-linked. According to one embodiment, the inorganic polymer is amorphous, semi-crystalline or crystalline.

According to one embodiment, the inorganic polymer has an average molecular weight ranging from 2 000 g/mol to 5.10⁶ g/mol, preferably from 5 000 g/mol to 4.10⁶ g/mol; from 6 000 to 4.10⁶; from 7 000 to 4.10⁶; from 8 000 to 4.10⁶; from 9 000 to 4.10⁶; from 10 000 to 4.10⁶; from 15 000 to 4.10⁶; from 20 000 to 4.10⁶; from 25 000 to 4.10⁶; from 30 000 to 4.10⁶; from 35 000 to 4.10⁶; from 40 000 to 4.10⁶; from 45 000 to 4.10⁶; from 50 000 to 4.10⁶; from 55 000 to 4.10⁶; from 60 000 to 4.10⁶; from 65 000 to 4.10⁶; from 70 000 to 4.10⁶; from 75 000 to 4.10⁶; from 80 000 to 4.10⁶; from 85 000 to 4.10⁶; from 90 000 to 4.10⁶; from 95 000 to 4.10⁶; from 100 000 to 4.10⁶; from 200 000 to 4.10⁶; from 300 000 to 4.10⁶; from 400 000 to 4.10⁶; from 500 000 to 4.10⁶; from 600 000 to 4.10⁶; from 700 000 to 4.10⁶; from 800 000 to 4.10⁶; from 900 000 to 4.10⁶; from 1.10⁶ to 4.10⁶; from 2.10⁶ to 4.10⁶; from 3.10⁶ g/mol to 4.10⁶ g/mol.

According to one embodiment, the first material 11 and/or the second material 21 are organic materials.

According to one embodiment, the organic material refers to any element and/or material containing carbon, preferably any element and/or material containing at least one carbon-hydrogen bond.

According to one embodiment, the organic material may be natural or synthetic.

According to one embodiment, the organic material is a small organic compound or an organic polymer.

According to one embodiment, the first material 11 and/or the second material 21 are polymers.

According to one embodiment, examples of polymers include but are not limited to: silicone, PMMA, Polyethylene glycol/polyethylene oxide, Polyethylene Terephthalate, Polyimide, Polyetherimide, Polyamide, Polyetherimine, Polyamic acid, polyethers, polyester, polyacrylates, polymethacrylate, polycarbonates, polycaprolactone, polyvinyl alcohol, polydimethylsiloxane, polyvinylpyrrolidone, polyvinyl pyridine, silicone, polyvinylimidazole, polyimidazole, Polystyrine, Poly(vinyl acetate), poly(acrylonitrile), poly(propylene), poly(acrylic acid), polyoxazoline (poly-2-oxazoline), polylauryl methacrylate, polyglycolide, polylactic acid, poly(nucleotides), polysaccharides, block copolymers or copolymers such as polylactic-co-glycolic acid (PGLA), or a mixture thereof.

According to one embodiment, the first material **11** and/or the second material **21** comprises a monomer or a polymer as described hereafter.

According to one embodiment, the first material **11** and/or the second material **21** can polymerize by heating it *(i.e.,* by thermal curing) and/or by exposing it to UV light *(i.e.,* by UV curing). Examples of UV curing processes which can be contemplated in the present invention are described, *e.g*., in WO2017063968, WO2017063983 and WO2017162579.

According to one embodiment, examples of polymers include but are not limited to: silicone based polymers, polydimethylsiloxanes (PDMS), polyethylene terephthalate, polyesters, polyacrylates, polymethacrylates, polycarbonate, poly(vinyl alcohol), polyvinylpyrrolidone, polyvinylpyridine, polysaccharides, poly(ethylene glycol), melamine resins, a phenol resin, an alkyl resin, an epoxy resin, a polyurethane resin, a maleic resin, a polyamide resin, an alkyl resin, a maleic resin, terpenes resins, an acrylic resin or acrylate based resin such as PMMA, copolymers forming the resins, co-polymers, block co-polymers, polymerizable monomers comprising an UV initiator or thermic initiator, or a mixture thereof.

According to one embodiment, examples of polymers include but are not limited to: thermosetting resin, photosensitive resin, photoresist resin, photocurable resin, or dry-curable resin. The thermosetting resin and the photocurable resin are cured using heat and light, respectively. For the use of the dry hard resin, the resin is cured by applying heat to a solvent in which the particle and/or the nanoparticle.

When a thermosetting resin or a photocurable resin is used, the composition of the resulting particle is equal to the composition of the raw material of the particle. However, when a dry-curable resin is used, the composition of the resulting particle may be different from the composition of the raw material of the particle. During the dry-curing by heat, the solvent is partially evaporated. Thus, the volume ratio of particle of the invention in the raw material of the particle may be lower than the volume ratio of said particle in the resulting particle. In this embodiment, particle of the invention refers to particle **2** and/or nanoparticle.

Upon curing of the resin, a volume contraction is caused. According to one embodiment, a least 2%, 3%, 4%, 5%, 6%, 7%, 8%, 9%, 10%, 15%, or 20%, of contraction are aroused from a thermosetting resin or a photocurable resin. According to one embodiment, a dry-curable resin is contracted by at least 0.1%, 0.2%, 0.3%, 0.4%, 0.5%, 0.6%, 0.7%, 0.8%, 0.9%, 1%, 1.5%, 2%, 2.5%, 3%, 3.5%, 4%, 4.5%, 5%, 5.5%, 6%, 6.5%, 7%, 7.5%, 8%, 8.5%, 9%, 9.5%, 10%, 15%, or 20%. The contraction of the resin may cause movement of the particles **2** and/or nanoparticles, which may be lower the degree of dispersion of said particles in the first material **11** and/or the second material **21.** However, embodiments of the present invention can maintain high dispersibility by preventing the movement of said particles by introducing other particles in the first material **11** and/or the second material **21**

In one embodiment, the first material **11** and/or the second material **21** may be a polymerizable formulation which can include monomers, oligomers, polymers, or mixture thereof.

In one embodiment, the polymerizable formulation may further comprise a crosslinking agent, a scattering agent, a photo initiator or a thermal initiator.

In one embodiment, the polymerizable formulation includes but is not limited to: monomers, oligomers or polymers made from an alkyl methacrylates or an alkyl acrylates such as acrylic acid, methacrylic acid, crotonic acid, acrylonitrile, acrylic esters substituted with methoxy, ethoxy, propoxy, butoxy, and similar derivatives for example, methyl acrylate, ethyle acrylate, propyl acrylate, butyl acrylate, isobutyl acrylate, lauryl acrylate, norbornyl acrylate, 2-ethyl hexyl acrylate, 2-hydroxyethyl acrylate, 4-hydroxybutyl acrylate, benzyl acrylate, phenyl acrylate, isobornyle acrylate, hydroxypropyl acrylate, fluorinated acrylic monomers, chlorinated acrylic monomers, methacrylic acid, methyl methacrylate, n-butyl methacrylate, isobutyl methacrylate, 2-ethyl hexyl methacrylate, 2-hydroxyethyl methacrylate, 4-hydroxybutyl methacrylate, benzyl methacrylate, phenyl methacrylate, lauryl methacrylate, norbornyl methacrylate, isobornyle methacrylate, hydroxypropyl methacrylate, fluorinated methacrylic monomers, chlorinated methacrylic monomers, alkyl crotonates, allyl crotonates, glycidyl methacrylate and related esters.

In another embodiment, the polymerizable formulation includes but is not limited to: monomers, oligomers or polymers made from an alkyl acrylamide or alkyl methacrylamide such as acrylamide, Alkylacrylamide, N-tert-Butylacrylamide, Diacetone acrylamide, N,N-Diethylacrylamide, N-(Isobutoxymethyl)acrylamide, N-(3-Methoxypropyl)acrylamide, N-Diphenylmethylacrylamide, N-Ethylacrylamide, N-Hydroxyethyl acrylamide, N-(Isobutoxymethyl)acrylamide, N-Isopropylacrylamide, N-(3-Methoxypropyl)acrylamide, N-Phenylacrylamide, N-[Tris(hydroxymethyl)methyl]acrylamide, N,N-Diethylmethacrylamide, N,NDimethylacrylamide, N-[3-(Dimethylamino)propyl]methacrylamide, N-(Hydroxymethyl)acrylamide, 2-Hydroxypropyl methacrylamide, N-Isopropylmethacrylamide, Methacrylamide, N-(Triphenylmethyl)methacrylamide, poly (3,4-ethylenedioxythiopene), poly(ethylene dioxythiophene)/poly(styrene sulfonic acid) (PEDOT/PSS), an aqueous solution of polyaniline/camphor sulfonic acid (PANI/CSA), PTPDES, Et-PIT- DEK, PPBA, and similar derivatives.

In one embodiment, the polymerizable formulation includes but is not limited to: acrylate monomers, such as a mono- or multidentate acrylates; various methacrylate monomers, such as a mono- or multidentate methacrylates; and copolymers and mixtures thereof.

In one embodiment, the mono(meth)acrylate monomers and di(meth)acrylate monomers include but are not limited to: linear aliphatic mono(meth)acrylates and di(meth)acrylates, or cyclic and/or aromatic groups. In various embodiments, the mono(meth)acrylate monomers and/or di(meth)acrylate monomers are polyethers, or alkoxylated aliphatic di(meth)acrylate monomers such as for example neopentyl glycol group-containing di(meth)acrylates, alkoxylated neopentyl glycol diacrylates, neopentyl glycol propoxylate di(meth)acrylate, neopentyl glycol ethoxylate di(meth)acrylate.

In one embodiment, the mono(meth)acrylate monomers and di(meth)acrylate monomers include but are not limited to: alkyl (meth)acrylates, such as methyl (meth)acrylate and ethyl (meth)acrylate; cyclic trimethylolpropane formal (meth)acrylate; alkoxylated tetrahydrofurfuryl (meth)acrylate; phenoxyalkyl (meth)acrylates, such as 2-phenoxyethyl (meth)acrylate and phenoxymethyl (meth)acrylate; 2(2-ethoxyethoxy)ethyl (meth)acrylate. Other suitable di(meth)acrylate monomers include 1,6-hexanediol diacrylate, 1, 12 dodecanediol di(meth)acrylate; 1,3-butylene glycol di(meth)acrylate; di(ethylene glycol) methyl ether methacrylate; polyethylene glycol di(meth)acrylate monomers, including ethylene glycol di(meth)acrylate monomers and polyethylene glycol di(meth)acrylate monomers; dicyclopentenyloxyethyl acrylate (DCPOEA), isobornyl acrylate (ISOBA), dicyclopentenyloxyethyl methacrylate (DCPOEMA), isobornyl methacrylate (ISOBMA), and N-octadecyl methacrylate (OctaM). Homologs of ISOBA and ISOBMA.

In one embodiment, the polymerizable formulation includes but is not limited to: monomers, oligomers or polymers made from alpha-olefins, dienes such as butadiene and chloroprene; styrene, alpha-methyl styrene, and the like; heteroatom substituted alpha-olefins, for example, vinyl acetate, vinyl alkyl ethers for example, ethyl vinyl ether, vinyltrimethylsilane, vinyl chloride, tetrafluoroethylene, chlorotrifiuoroethylene, cyclic and polycyclic olefin compounds for example, cyclopentene, cyclohexene, cycloheptene, cyclooctene, and cyclic derivatives up to C20; polycyclic derivates for example, norbornene, and similar derivatives up to C20; cyclic vinyl ethers for example, 2, 3-dihydrofuran, 3,4-dihydropyran, and similar derivatives; allylic alcohol derivatives for example, vinylethylene carbonate, disubstituted olefins such as maleic and fumaric compounds for example, maleic anhydride, diethylfumarate, and the like, and mixtures thereof.

In one embodiment, examples of crosslinking agent include but are not limited to: di-acrylate, tri-acrylate, tetra-acrylate, di-methacrylate, tri-methacrylate and tetra- methacrylate monomers derivatives and the like. Another example of crosslinking agent includes but is not limited to: monomers, oligomers or polymers made from di- or trifunctional monomers such as allyl methacrylate, diallyl maleate, 1,3-butanediol dimethacrylate, 1,4-butanediol dimethacrylate, 1,6-hexanediol dimethacrylate, pentaerythritol triacrylate, trimethylolpropane triacrylate, Ethylene glycol dimethacrylate, Triethylene glycol dimethacrylate, N,N-methylenebis(acrylamide), N,N'-Hexamethylenebis(methacrylamide), and divinyl benzene.

In one embodiment, the polymerizable formulation may further comprise scattering particles Examples of scattering particles include but are not limited to: SiO₂, ZrO₂, ZnO, MgO, SnO₂, TiO₂, Ag, Au, alumina, barium sulfate, PTFE, barium titanate and the like.

In one embodiment, the polymerizable formulation may further comprise a thermal conductor. Examples of thermal conductor include but are not limited to: SiO₂, ZrO₂, ZnO, MgO, SnO₂, TiO₂, CaO, alumina, barium sulfate, PTFE, barium titanate and the like. In this embodiment, the thermal conductivity of the first and/or second material **(11, 21)** is increased.

In one embodiment, the polymerizable formulation may further comprise a photo initiator. Examples of photo initiator include but are not limited to: α-hydroxyketone, phenylglyoxylate, benzyldimethyl-ketal, α-aminoketone, monoacylphosphine oxides, bisacylphosphine oxides, phosphine oxide, benzophenone and derivatives, polyvinyl cinnamate, metallocene or iodonium salt derivatives, 1-hydroxycyclohexyl phenyl ketone, thioxanthones (such as isopropylthioxanthone), 2-hydroxy-2-methyl-1-phenylpropan-1-one, 2-benzyl-2-dimethylamino-(4-morpholinophenyl)butan-1-one, benzil dimethylketal, bis(2,6- dimethylbenzoyl)-2,4,4-trimethylpentylphosphine oxide, 2,4,6-trimethylbenzoyldiphenylphosphine oxide, 2-methyl-1-[4-(methylthio)phenyl]-2-morpholinopropan-1-one, 2,2-dimethoxy-1,2-diphenylethan-1-one or 5,7-diiodo-3-butoxy-6-fluorone and the like. Other examples of photo initiators include, without limitation, Irgacure^{™} 184, Irgacure^{™} 500, Irgacure^{™} 907, Irgacure^{™} 369, Irgacure^{™} 1700, Irgacure^{™} 651 , Irgacure^{™} 819, Irgacure^{™} 1000, Irgacure^{™} 1300, Irgacure^{™} 1870, Darocur^{™} 1 173, Darocur^{™} 2959, Darocur^{™} 4265 and Darocur^{™} ITX (available from Ciba Specialty Chemicals), Lucerin^{™} TPO (available from BASF AG), Esacure^{™} KT046, Esacure^{™} KIP150, Esacure^{™} KT37 and Esacure^{™} EDB (available from Lamberti), H-Nu^{™} 470 and H-Nu^{™} 470X (available from Spectra Group Ltd) and the like.

In one embodiment, the polymerizable formulation may further comprise a thermal initiator. Examples of thermal initiator include but are limited to: peroxide compounds, azo compounds such as azobisisobutyronitrile (AIBN) and 4,4-Azobis(4-cyanovaleric acid), potassium and ammonium persulfate, tert-Butyl peroxide, benzoyl peroxide and the like.

In one embodiment, the first material **11** and/or the second material **21** comprise a polymerized solid made from an alkyl methacrylates or an alkyl acrylates such as acrylic acid, methacrylic acid, crotonic acid, acrylonitrile, acrylic esters substituted with methoxy, ethoxy, propoxy, butoxy, and similar derivatives for example, methyl acrylate, ethyle acrylate, propyl acrylate, butyl acrylate, isobutyl acrylate, lauryl acrylate, norbornyl acrylate, 2-ethyl hexyl acrylate, 2-hydroxyethyl acrylate, 4-hydroxybutyl acrylate, benzyl acrylate, phenyl acrylate, isobornyle acrylate, hydroxypropyl acrylate, fluorinated acrylic monomers, chlorinated acrylic monomers, methacrylic acid, methyl methacrylate, nbutyl methacrylate, isobutyl methacrylate, 2-ethyl hexyl methacrylate, 2-hydroxyethyl methacrylate, 4-hydroxybutyl methacrylate, benzyl methacrylate, phenyl methacrylate, lauryl methacrylate, norbornyl methacrylate, isobornyle methacrylate, hydroxypropyl methacrylate, fluorinated methacrylic monomers, chlorinated methacrylic monomers, alkyl crotonates, allyl crotonates, glycidyl methacrylate and related esters.

In one embodiment, the first material **11** and/or the second material **21** comprise a polymerized solid made from an alkyl acrylamide or alkyl methacrylamide such as acrylamide, Alkylacrylamide, Ntert-Butylacrylamide, Diacetone acrylamide, N,N-Diethylacrylamide, N- Isobutoxymethyl)acrylamide, N-(3-Methoxypropyl)acrylamide, NDiphenylmethylacrylamide, N-Ethylacrylamide, N-Hydroxyethyl acrylamide, N-(Isobutoxymethyl)acrylamide, N-Isopropylacrylamide, N-(3- Methoxypropyl)acrylamide, N-Phenylacrylamide, N- [Tris(hydroxymethyl)methyl]acrylamide, N,N-Diethylmethacrylamide, N,NDimethylacrylamide, N-[3-(Dimethylamino)propyl]methacrylamide, N- (Hydroxymethyl)acrylamide, 2-Hydroxypropyl methacrylamide, NIsopropylmethacrylamide, Methacrylamide, N-(Triphenylmethyl)methacrylamide and similar derivatives.

In one embodiment, the first material **11** and/or the second material **21** comprise a polymerized solid made from alpha-olefins, dienes such as butadiene and chloroprene; styrene, alpha-methyl styrene, and the like; heteroatom substituted alpha-olefins, for example, vinyl acetate, vinyl alkyl ethers for example, ethyl vinyl ether, vinyltrimethylsilane, vinyl chloride, tetrafluoroethylene, chlorotrifiuoroethylene, cyclic and polycyclic olefin compounds for example, cyclopentene, cyclohexene, cycloheptene, cyclooctene, and cyclic derivatives up to C20; polycyclic derivates for example, norbornene, and similar derivatives up to C20; cyclic vinyl ethers for example, 2, 3-dihydrofuran, 3,4-dihydropyran, and similar derivatives; allylic alcohol derivatives for example, vinylethylene carbonate, disubstituted olefins such as maleic and fumaric compounds for example, maleic anhydride, diethylfumarate, and the like, and mixtures thereof.

In one embodiment, the first material **11** and/or the second material **21** comprise PMMA, Poly(lauryl methacrylate), glycolized poly(ethylene terephthalate), Poly(maleic anhydride -altoctadecene), or mixtures thereof.

In one embodiment, the first material **11** and/or the second material **21** may comprise a copolymer of vinyl chloride and a hydroxyfunctional monomer. Such copolymer is described, e.g., in WO2017102574. In such embodiment, examples of hydroxyfunctional monomers include, without limitation, 2-hydroxypropyl acrylate, 1-hydroxy-2-propyl acrylate, 3-methyl-3-buten-1-ol, 2-methyl-2-propenoic acid 2-hydroxypropyl ester, 2-hydroxy-3-chloropropyl methacrylate, N-methylolmethacrylamide, 2-hydroxyethyl methacrylate, poly(ethylene oxide) monomethacrylate, glycerine monomethacrylate, 1 ,2-propylene glycol methacrylate, 2,3-hydroxypropyl methacrylate, 2-hydroxyethyl acrylate, vinyl alcohol, N-methylolacrylamid, 2-propenoic acid 5-hydroxypentyl ester, 2-methyl-2- propenoic acid, 3-chloro-2-hydroxypropyl ester, 1-hydroxy-2-propenoic acid, 1-methylethyl ester, 2-hydroxyethyl allyl ether, 4-hydroxybutyl acrylate, 1,4-butanediol monovinyl ether, poly(e-caprolactone) hydroxyethyl methacrylate ester, poly(ethylene oxide) monomethacrylate, 2-methyl-2-propenoic acid, 2,5-dihydroxypentyl ester, 2-methyl-2-propenoic acid, 5,6-dihydroxyhexyl ester, 1,6-hexanediol monomethacrylate, 1,4-dideoxy-pentitol, 5-(2-methyl-2-propenoate), 2-propenoic acid, 2,4-dihydroxybutyl ester, 2-propenoic acid, 3,4-dihydroxybutyl ester, 2-methyi-2-propenoic acid, 2-hydroxy butyl ester, 3-hydroxypropyl methacrylate, 2-propenoic acid, 2,4-dihydroxybutyl ester and isopropenyl alcohol. Examples of copolymers of vinyl chloride and a hydroxyfunctional monomer include, without limitation, chloroethylene-vinyl acetate-vinyl alcohol copolymer, vinyl alcohol-vinyl chloride copolymer, 2-hydroxypropyl acrylate-vinyl chloride polymer, propanediol monoacrylate-vinyl chloride copolymer, vinyl acetate-vinyl chloride-2-hydroxypropyl acrylate copolymer, hydroxyethyl acrylate-vinyl chloride copolymer and 2-hydroxyethyl methacrylate-vinyl chloride copolymer.

According to one embodiment, the organic polymer is selected from polyacrylates; polymethacrylates; polyacrylamides; polyamides; polyesters; polyethers; polyoelfins; polysaccharides; polyurethanes (or polycarbamates), polystyrenes; polyacrylonitrile-butadiene-styrene (ABS); polycarbonate; poly(styrene acrylonitrile); vinyl polymers such as polyvinyl chloride; polyvinyl alcohol, polyvinyl acetate, polyvinylpyrrolidone, polyvinyl pyridine, polyvinylimidazole; poly(p-phenylene oxide); polysulfone; polyethersulfone; polyethylenimine; polyphenylsulfone; poly(acrylonitrile styrene acrylate); polyepoxides, polythiophenes, polypyrroles; polyanilines; polyaryletherketones; polyfurans; polyimides; polyimidazoles; polyetherimides; polyketones; polynucleotides; polystyrene sulfonates; polyetherimines; polyamic acid; or any combinations and/or derivatives and/or copolymers thereof.

According to one embodiment, the organic polymer is a polyacrylate, preferably selected from poly(methyl acrylate), poly(ethyl acrylate), poly(propyl acrylate), poly(butyl acrylate), poly(pentyl acrylate), and poly(hexyl acrylate).

According to one embodiment, the organic polymer is a polymethacrylate, preferably selected from poly(methyl methacrylate), poly(ethyl methacrylate), poly(propyl methacrylate), poly(butyl methacrylate), poly(pentyl methacrylate), and poly(hexyl methacrylate). According to one embodiment, the organic polymer is poly(methyl methacrylate) (PMMA).

According to one embodiment, the organic polymer is a polyacrylamide, preferably selected from poly(acrylamide); poly(methyl acrylamide), poly(dimethyl acrylamide), poly(ethyl acrylamide), poly(diethyl acrylamide), poly(propyl acrylamide), poly(isopropyl acrylamide); poly(butyl acrylamide); and poly(tert-butyl acrylamide).

According to one embodiment, the organic polymer is a polyester, preferably selected from poly(glycolic acid) (PGA), poly(lactic acid) (PLA), poly(caprolactone) (PCL), polyhydroxyalcanoate (PHA), polyhydroxybutyrate (PHB), polyethylene adipate, polybutylene succinate, poly(ethylene terephthalate), poly(butylene terephthalate), poly(trimethylene terephthalate), polyarylate or any combination thereof.

According to one embodiment, the organic polymer is a polyether, preferably selected from aliphatic poly ethers such as poly(glycol ether) or aromatic polyethers. According to one embodiment, the polyether is selected from poly(methylene oxide); poly(ethylene glycol)/poly(ethylene oxide), poly(propylene glycol) and poly(tetrahydrofuran).

According to one embodiment, the organic polymer is a polyolefin (or polyalkene), preferably selected from poly(ethylene), poly(propylene), poly(butadiene), poly(methylpentene), poly(butane) and poly(isobutylene).

According to one embodiment, the organic polymer is a polysaccharide selected from chitosan, dextran, hyaluronic acid, amylose, amylopectin, pullulan, heparin, chitin, cellulose, dextrin, starch, pectin, alginates, carrageenans, fucan, curdlan, xylan, polyguluronic acid, xanthan, arabinan, polymannuronic acid and their derivatives.

According to one embodiment, the organic polymer is a polyamide, preferably selected from polycaprolactame, polyauroamide, polyundecanamide, polytetramethylene adipamide, polyhexamethylene adipamide (also called nylon), polyhexamethylene nonanediamide, polyhexamethylene sebacamide, polyhexamethylene dodecanediamide; polydecamethylene sebacamide; polyhexamethylene isophthalamide; polymetaxylylene adipamide; polymetaphenylene isophthalamide; polyparaphenylene terephtalamide; polyphtalimides.

According to one embodiment, the organic polymer is a naturel or synthetic polymer.

According to one embodiment, the organic polymer is synthetized by organic reaction, radical polymerization, polycondensation, poly addition, or ring opening polymerization (ROP).

According to one embodiment, the organic polymer is a homopolymer or a copolymer. According to one embodiment, the organic polymer is linear, branched, and/or cross-linked. According to one embodiment, the branched organic polymer is brush polymer (or also called comb polymer) or is a dendrimer.

According to one embodiment, the organic polymer is amorphous, semi-crystalline or crystalline. According to one embodiment, the organic polymer is a thermoplastic polymer or an elastomer.

According to one embodiment, the organic polymer is not a polyelectrolyte.

According to one embodiment, the organic polymer is not a hydrophilic polymer.

According to one embodiment, the organic polymer has an average molecular weight ranging from 2 000 g/mol to 5.10⁶ g/mol, preferably from 5 000 g/mol to 4.10⁶ g/mol; from 6 000 to 4.10⁶; from 7 000 to 4.10⁶; from 8 000 to 4.10⁶; from 9 000 to 4.10⁶; from 10 000 to 4.10⁶; from 15 000 to 4.10⁶; from 20 000 to 4.10⁶; from 25 000 to 4.10⁶; from 30 000 to 4.10⁶; from 35 000 to 4.10⁶; from 40 000 to 4.10⁶; from 45 000 to 4.10⁶; from 50 000 to 4.10⁶; from 55 000 to 4.10⁶; from 60 000 to 4.10⁶; from 65 000 to 4.10⁶; from 70 000 to 4.10⁶; from 75 000 to 4.10⁶; from 80 000 to 4.10⁶; from 85 000 to 4.10⁶; from 90 000 to 4.10⁶; from 95 000 to 4.10⁶; from 100 000 to 4.10⁶; from 200 000 to 4.10⁶; from 300 000 to 4.10⁶; from 400 000 to 4.10⁶; from 500 000 to 4.10⁶; from 600 000 to 4.10⁶; from 700 000 to 4.10⁶; from 800 000 to 4.10⁶; from 900 000 to 4.10⁶; from 1.10⁶ to 4.10⁶; from 2.10⁶ to 4.10⁶; from 3.10⁶ g/mol to 4.10⁶ g/mol.

According to one embodiment, the organic material is selected from polyacrylates; polymethacrylate; polyacrylamide; polyester; polyether; polyolefin (or polyalkene); polysaccharide; polyamide; or a mixture thereof; preferably the organic material is an organic polymer.

According to one embodiment, the first material **11** and/or the second material **21** are hybrid materials comprising at least one inorganic constituent and at least one organic constituent. In this embodiment the inorganic constituent is an inorganic material as described hereabove and the organic constituent is an organic material as described hereabove.

According to one embodiment, the polymer is optically transparent, *i.e.,* the polymer is transparent at wavelengths between 200 nm and 50 µm, between 200 nm and 10 µm, between 200 nm and 2500 nm, between 200 nm and 2000 nm, between 200 nm and 1500 nm, between 200 nm and 1000 nm, between 200 nm and 800 nm, between 400 nm and 700 nm, between 400 nm and 600 nm, or between 400 nm and 470 nm.

According to one embodiment, the polymer is not optically transparent.

According to one embodiment, the polymer transmits at least 5%, 10%, 15%, 20%, 25%, 30%, 35%, 40%, 45%, 50%, 55%, 60%, 65%, 70%, 75%, 80%, 85%, 90%, 95%, or 100% of the incident light.

According to one embodiment, the polymer transmits a part of the incident light and emits at least one secondary light. In this embodiment, the resulting light is a combination of the remaining transmitted incident light.

According to one embodiment, the polymer absorbs the incident light with wavelength lower than 50 µm, 40 µm, 30 µm, 20 µm, 10 µm, 1 µm, 950 nm, 900 nm, 850 nm, 800 nm, 750 nm, 700 nm, 650 nm, 600 nm, 550 nm, 500 nm, 450 nm, 400 nm, 350 nm, 300 nm, 250 nm, or lower than 200 nm.

According to one embodiment, the polymer absorbs the incident light with wavelength lower than 460 nm.

According to one embodiment, the first material **11** and/or the second material **21** comprise additional heteroelements, wherein said additional heteroelements include but are not limited to: Cd, S, Se, Zn, In, Te, Hg, Sn, Cu, N, Ga, Sb, Tl, Mo, Pd, Ce, W, Co, Mn, Si, Ge, B, P, Al, As, Fe, Ti, Zr, Ni, Ca, Na, Ba, K, Mg, Pb, Ag, V, Be, Ir, Sc, Nb, Ta or a mixture thereof. In this embodiment, heteroelements can diffuse in the particle 1 and/or the particle **2** during heating step. They may form nanoclusters inside the particle **1** and/or the particle **2.** These elements can limit the degradation of the photoluminescence of said particle **1** and/or the particle **2** during the heating step, and/or drain away the heat if it is a good thermal conductor, and/or evacuate electrical charges.

According to one embodiment, the first material **11** and/or the second material **21** comprise additional heteroelements in small amounts of 0 mole%, 1 mole%, 5 mole%, 10 mole%, 15 mole%, 20 mole%, 25 mole%, 30 mole%, 35 mole%, 40 mole%, 45 mole%, 50 mole% relative to the majority element of said first material **11.**

According to one embodiment, the first material **11** and/or the second material **21** comprise Al₂O₃, SiO₂, MgO, ZnO, ZrO₂, TiO₂, IrO₂, SnO₂, BaO, BaSO₄, BeO, CaO, CeO₂, CuO, Cu₂O, DyO₃, Fe₂O₃, Fe₃O₄, GeO₂, HfO₂, Lu₂O₃, Nb₂O₅, Sc₂O₃, TaO₅, TeO₂, or Y₂O₃ additional nanoparticles. These additional nanoparticles can drain away the heat if it is a good thermal conductor, and/or evacuate electrical charges, and/or scatter an incident light.

According to one embodiment, the first material **11** and/or the second material **21** comprise additional nanoparticles in small amounts at a level of at least 100 ppm, 200 ppm, 300 ppm, 400 ppm, 500 ppm, 600 ppm, 700 ppm, 800 ppm, 900 ppm, 1000 ppm, 1100 ppm, 1200 ppm, 1300 ppm, 1400 ppm, 1500 ppm, 1600 ppm, 1700 ppm, 1800 ppm, 1900 ppm, 2000 ppm, 2100 ppm, 2200 ppm, 2300 ppm, 2400 ppm, 2500 ppm, 2600 ppm, 2700 ppm, 2800 ppm, 2900 ppm, 3000 ppm, 3100 ppm, 3200 ppm, 3300 ppm, 3400 ppm, 3500 ppm, 3600 ppm, 3700 ppm, 3800 ppm, 3900 ppm, 4000 ppm, 4100 ppm, 4200 ppm, 4300 ppm, 4400 ppm, 4500 ppm, 4600 ppm, 4700 ppm, 4800 ppm, 4900 ppm, 5000 ppm, 5100 ppm, 5200 ppm, 5300 ppm, 5400 ppm, 5500 ppm, 5600 ppm, 5700 ppm, 5800 ppm, 5900 ppm, 6000 ppm, 6100 ppm, 6200 ppm, 6300 ppm, 6400 ppm, 6500 ppm, 6600 ppm, 6700 ppm, 6800 ppm, 6900 ppm, 7000 ppm, 7100 ppm, 7200 ppm, 7300 ppm, 7400 ppm, 7500 ppm, 7600 ppm, 7700 ppm, 7800 ppm, 7900 ppm, 8000 ppm, 8100 ppm, 8200 ppm, 8300 ppm, 8400 ppm, 8500 ppm, 8600 ppm, 8700 ppm, 8800 ppm, 8900 ppm, 9000 ppm, 9100 ppm, 9200 ppm, 9300 ppm, 9400 ppm, 9500 ppm, 9600 ppm, 9700 ppm, 9800 ppm, 9900 ppm, 10000 ppm, 10500 ppm, 11000 ppm, 11500 ppm, 12000 ppm, 12500 ppm, 13000 ppm, 13500 ppm, 14000 ppm, 14500 ppm, 15000 ppm, 15500 ppm, 16000 ppm, 16500 ppm, 17000 ppm, 17500 ppm, 18000 ppm, 18500 ppm, 19000 ppm, 19500 ppm, 20000 ppm, 30000 ppm, 40000 ppm, 50000 ppm, 60000 ppm, 70000 ppm, 80000 ppm, 90000 ppm, 100000 ppm, 110000 ppm, 120000 ppm, 130000 ppm, 140000 ppm, 150000 ppm, 160000 ppm, 170000 ppm, 180000 ppm, 190000 ppm, 200000 ppm, 210000 ppm, 220000 ppm, 230000 ppm, 240000 ppm, 250000 ppm, 260000 ppm, 270000 ppm, 280000 ppm, 290000 ppm, 300000 ppm, 310000 ppm, 320000 ppm, 330000 ppm, 340000 ppm, 350000 ppm, 360000 ppm, 370000 ppm, 380000 ppm, 390000 ppm, 400000 ppm, 410000 ppm, 420000 ppm, 430000 ppm, 440000 ppm, 450000 ppm, 460000 ppm, 470000 ppm, 480000 ppm, 490000 ppm, or 500 000 ppm in weight compared to the particle **1** and/or the particle **2.**

According to one embodiment, the first material **11** and/or the second material **21** have a density ranging from 1 to 10, preferably the first material **11** has a density ranging from 3 to 10.

According to one embodiment, the first material **11** has a density superior or equal to the density of the second material **21.**

According to one embodiment, the refractive index of first material **11** and second material **21** is tuned by the first material **11** and second material **21** chosen.

According to one embodiment, the first material **11** and/or the second material **21** have a refractive index ranging from 1 to 5, from 1.2 to 2.6, from 1.4 to 2.0.

According to one embodiment, the first material **11** and/or the second material **21** have a refractive index of at least 1.0, 1.1, 1.2, 1.3, 1.4, 1.5, 1.6, 1.7, 1.8, 1.9, 2.0, 2.1, 2.2, 2.3, 2.4, 2.5, 2.6, 2.7, 2.8, 2.9, 3.0, 3.1, 3.2, 3.3, 3.4, 3.5, 3.6, 3.7, 3.8, 3.9, 4.0, 4.1, 4.2, 4.3, 4.4, 4.5, 4.6, 4.7, 4.8, 4.9, or 5.0.

According to one embodiment, the first material **11** has the same refractive index than the second material **21.**

According to one embodiment, the first material **11** has a refractive index distinct from the refractive index of the second material **21.** This embodiment allows for a wider scattering of light. This embodiment also allows to have a difference in light scattering as a function of the wavelength, in particular to increase the scattering of the excitation light with respect to the scattering of the emitted light, as the wavelength of the excitation light is lower than the wavelength of the emitted light.

According to one embodiment, the first material **11** has a refractive index superior or equal to the refractive index of the second material **21.**

According to one embodiment, the first material **11** has a refractive index inferior to the refractive index of the second material **21.**

According to one embodiment, the first material **11** has a difference of refractive index with the refractive index of the second material **21** of at least 0.02, 0.025, 0.03, 0.035, 0.04, 0.045, 0.05, 0.055, 0.06, 0.065, 0.07, 0.075, 0.08, 0.085, 0.09, 0.095, 0.1, 0.11, 0.115, 0.12, 0.125, 0.13, 0.135, 0.14, 0.145, 0.15, 0.155, 0.16, 0.165, 0.17, 0.175, 0.18, 0.185, 0.19, 0.195, 0.2, 0.25, 0.3, 0.35, 0.4, 0.45, 0.5, 0.55, 0.6, 0.65, 0.7, 0.75, 0.8, 0.85, 0.9, 0.95, 1, 1.1, 1.15, 1.2, 1.25, 1.3, 1.35, 1.4, 1.45, 1.5, 1.55, 1.6, 1.65, 1.7, 1.75, 1.8, 1.85, 1.9, 1.95, or 2.

According to one embodiment, the first material **11** has a difference of refractive index with the second material **21** ranging from 0.02 to 2, ranging from 0.02 to 1.5, ranging from 0.03 to 1.5, ranging from 0.04 to 1.5, ranging from 0.05 to 1.5, ranging from 0.02 to 1.2, ranging from 0.03 to 1.2, ranging from 0.04 to 1.2, ranging from 0.05 to 1.2, ranging from 0.05 to 1, ranging from 0.1 to 1, ranging from 0.2 to 1, ranging from 0.3 to 1, ranging from 0.5 to 1, ranging from 0.05 to 2, ranging from 0.1 to 2, ranging from 0.2 to 2, ranging from 0.3 to 2, or ranging from 0.5 to 2.

The difference of refractive index was measured at 450 nm.

According to one embodiment, the first material **11** has a difference of refractive index with the refractive index of the second material **21** of 0.02.

According to one embodiment, the first material **11** and/or the second material **21** act as a barrier against oxidation of the at least one nanoparticle **3.**

According to one embodiment, the first material **11** and/or the second material **21** are thermally conductive.

According to one embodiment, the first material **11** and/or the second material **21** have a thermal conductivity at standard conditions ranging from 0.1 to 450 W/(m.K), preferably from 1 to 200 W/(m.K), more preferably from 10 to 150 W/(m.K).

According to one embodiment, the first material **11** and/or the second material **21** have a thermal conductivity at standard conditions of at least 0.1 W/(m.K), 0.2 W/(m.K), 0.3 W/(m.K), 0.4 W/(m.K), 0.5 W/(m.K), 0.6 W/(m.K), 0.7 W/(m.K), 0.8 W/(m.K), 0.9 W/(m.K), 1 W/(m.K), 1.1 W/(m.K), 1.2 W/(m.K), 1.3 W/(m.K), 1.4 W/(m.K), 1.5 W/(m.K), 1.6 W/(m.K), 1.7 W/(m.K), 1.8 W/(m.K), 1.9 W/(m.K), 2 W/(m.K), 2.1 W/(m.K), 2.2 W/(m.K), 2.3 W/(m.K), 2.4 W/(m.K), 2.5 W/(m.K), 2.6 W/(m.K), 2.7 W/(m.K), 2.8 W/(m.K), 2.9 W/(m.K), 3 W/(m.K), 3.1 W/(m.K), 3.2 W/(m.K), 3.3 W/(m.K), 3.4 W/(m.K), 3.5 W/(m.K), 3.6 W/(m.K), 3.7 W/(m.K), 3.8 W/(m.K), 3.9 W/(m.K), 4 W/(m.K), 4.1 W/(m.K), 4.2 W/(m.K), 4.3 W/(m.K), 4.4 W/(m.K), 4.5 W/(m.K), 4.6 W/(m.K), 4.7 W/(m.K), 4.8 W/(m.K), 4.9 W/(m.K), 5 W/(m.K), 5.1 W/(m.K), 5.2 W/(m.K), 5.3 W/(m.K), 5.4 W/(m.K), 5.5 W/(m.K), 5.6 W/(m.K), 5.7 W/(m.K), 5.8 W/(m.K), 5.9 W/(m.K), 6 W/(m.K), 6.1 W/(m.K), 6.2 W/(m.K), 6.3 W/(m.K), 6.4 W/(m.K), 6.5 W/(m.K), 6.6 W/(m.K), 6.7 W/(m.K), 6.8 W/(m.K), 6.9 W/(m.K), 7 W/(m.K), 7.1 W/(m.K), 7.2 W/(m.K), 7.3 W/(m.K), 7.4 W/(m.K), 7.5 W/(m.K), 7.6 W/(m.K), 7.7 W/(m.K), 7.8 W/(m.K), 7.9 W/(m.K), 8 W/(m.K), 8.1 W/(m.K), 8.2 W/(m.K), 8.3 W/(m.K), 8.4 W/(m.K), 8.5 W/(m.K), 8.6 W/(m.K), 8.7 W/(m.K), 8.8 W/(m.K), 8.9 W/(m.K), 9 W/(m.K), 9.1 W/(m.K), 9.2 W/(m.K), 9.3 W/(m.K), 9.4 W/(m.K), 9.5 W/(m.K), 9.6 W/(m.K), 9.7 W/(m.K), 9.8 W/(m.K), 9.9 W/(m.K), 10 W/(m.K), 10.1 W/(m.K), 10.2 W/(m.K), 10.3 W/(m.K), 10.4 W/(m.K), 10.5 W/(m.K), 10.6 W/(m.K), 10.7 W/(m.K), 10.8 W/(m.K), 10.9 W/(m.K), 11 W/(m.K), 11.1 W/(m.K), 11.2 W/(m.K), 11.3 W/(m.K), 11.4 W/(m.K), 11.5 W/(m.K), 11.6 W/(m.K), 11.7 W/(m.K), 11.8 W/(m.K), 11.9 W/(m.K), 12 W/(m.K), 12.1 W/(m.K), 12.2 W/(m.K), 12.3 W/(m.K), 12.4 W/(m.K), 12.5 W/(m.K), 12.6 W/(m.K), 12.7 W/(m.K), 12.8 W/(m.K), 12.9 W/(m.K), 13 W/(m.K), 13.1 W/(m.K), 13.2 W/(m.K), 13.3 W/(m.K), 13.4 W/(m.K), 13.5 W/(m.K), 13.6 W/(m.K), 13.7 W/(m.K), 13.8 W/(m.K), 13.9 W/(m.K), 14 W/(m.K), 14.1 W/(m.K), 14.2 W/(m.K), 14.3 W/(m.K), 14.4 W/(m.K), 14.5 W/(m.K), 14.6 W/(m.K), 14.7 W/(m.K), 14.8 W/(m.K), 14.9 W/(m.K), 15 W/(m.K), 15.1 W/(m.K), 15.2 W/(m.K), 15.3 W/(m.K), 15.4 W/(m.K), 15.5 W/(m.K), 15.6 W/(m.K), 15.7 W/(m.K), 15.8 W/(m.K), 15.9 W/(m.K), 16 W/(m.K), 16.1 W/(m.K), 16.2 W/(m.K), 16.3 W/(m.K), 16.4 W/(m.K), 16.5 W/(m.K), 16.6 W/(m.K), 16.7 W/(m.K), 16.8 W/(m.K), 16.9 W/(m.K), 17 W/(m.K), 17.1 W/(m.K), 17.2 W/(m.K), 17.3 W/(m.K), 17.4 W/(m.K), 17.5 W/(m.K), 17.6 W/(m.K), 17.7 W/(m.K), 17.8 W/(m.K), 17.9 W/(m.K), 18 W/(m.K), 18.1 W/(m.K), 18.2 W/(m.K), 18.3 W/(m.K), 18.4 W/(m.K), 18.5 W/(m.K), 18.6 W/(m.K), 18.7 W/(m.K), 18.8 W/(m.K), 18.9 W/(m.K), 19 W/(m.K), 19.1 W/(m.K), 19.2 W/(m.K), 19.3 W/(m.K), 19.4 W/(m.K), 19.5 W/(m.K), 19.6 W/(m.K), 19.7 W/(m.K), 19.8 W/(m.K), 19.9 W/(m.K), 20 W/(m.K), 20.1 W/(m.K), 20.2 W/(m.K), 20.3 W/(m.K), 20.4 W/(m.K), 20.5 W/(m.K), 20.6 W/(m.K), 20.7 W/(m.K), 20.8 W/(m.K), 20.9 W/(m.K), 21 W/(m.K), 21.1 W/(m.K), 21.2 W/(m.K), 21.3 W/(m.K), 21.4 W/(m.K), 21.5 W/(m.K), 21.6 W/(m.K), 21.7 W/(m.K), 21.8 W/(m.K), 21.9 W/(m.K), 22 W/(m.K), 22.1 W/(m.K), 22.2 W/(m.K), 22.3 W/(m.K), 22.4 W/(m.K), 22.5 W/(m.K), 22.6 W/(m.K), 22.7 W/(m.K), 22.8 W/(m.K), 22.9 W/(m.K), 23 W/(m.K), 23.1 W/(m.K), 23.2 W/(m.K), 23.3 W/(m.K), 23.4 W/(m.K), 23.5 W/(m.K), 23.6 W/(m.K), 23.7 W/(m.K), 23.8 W/(m.K), 23.9 W/(m.K), 24 W/(m.K), 24.1 W/(m.K), 24.2 W/(m.K), 24.3 W/(m.K), 24.4 W/(m.K), 24.5 W/(m.K), 24.6 W/(m.K), 24.7 W/(m.K), 24.8 W/(m.K), 24.9 W/(m.K), 25 W/(m.K), 30 W/(m.K), 40 W/(m.K), 50 W/(m.K), 60 W/(m.K), 70 W/(m.K), 80 W/(m.K), 90 W/(m.K), 100 W/(m.K), 110 W/(m.K), 120 W/(m.K), 130 W/(m.K), 140 W/(m.K), 150 W/(m.K), 160 W/(m.K), 170 W/(m.K), 180 W/(m.K), 190 W/(m.K), 200 W/(m.K), 210 W/(m.K), 220 W/(m.K), 230 W/(m.K), 240 W/(m.K), 250 W/(m.K), 260 W/(m.K), 270 W/(m.K), 280 W/(m.K), 290 W/(m.K), 300 W/(m.K), 310 W/(m.K), 320 W/(m.K), 330 W/(m.K), 340 W/(m.K), 350 W/(m.K), 360 W/(m.K), 370 W/(m.K), 380 W/(m.K), 390 W/(m.K), 400 W/(m.K), 410 W/(m.K), 420 W/(m.K), 430 W/(m.K), 440 W/(m.K), or 450 W/(m.K).

According to one embodiment, the thermal conductivity of the first material **11** and/or the second material **21** may be measured by for example by steady-state methods or transient methods.

According to one embodiment, the first material **11** and/or the second material **21** are not thermally conductive.

According to one embodiment, the first material **11** and/or the second material **21** comprise a refractory material.

According to one embodiment, the first material **11** and/or the second material **21** are electrically insulator. In this embodiment, the quenching of fluorescent properties for fluorescent nanoparticles encapsulated in the second material **21** is prevented when it is due to electron transport. In this embodiment, the particle **1** may be used as an electrical insulator material exhibiting the same properties as the nanoparticles **3** encapsulated in the second material **21.**

According to one embodiment, the first material **11** and/or the second material **21** are electrically conductive. This embodiment is particularly advantageous for an application of the particle **1** in photovoltaics or LEDs.

According to one embodiment, the first material **11** and/or the second material **21** have an electrical conductivity at standard conditions ranging from 1×10⁻²⁰ to 10⁷ S/m, preferably from 1×10⁻¹⁵ to 5 S/m, more preferably from 1×10⁻⁷ to 1 S/m.

According to one embodiment, the first material **11** and/or the second material **21** have an electrical conductivity at standard conditions of at least 1×10⁻²⁰ S/m, 0.5×10⁻¹⁹ S/m, 1×10⁻¹⁹ S/m, 0.5×10⁻¹⁸ S/m, 1×10⁻¹⁸ S/m, 0.5×10⁻¹⁷ S/m, 1×10⁻¹⁷ S/m, 0.5×10⁻¹⁶ S/m, 1×10⁻¹⁶ S/m, 0.5×10⁻¹⁵ S/m, 1×10⁻¹⁵ S/m, 0.5×10⁻¹⁴ S/m, 1×10⁻¹⁴ S/m, 0.5×10⁻¹³ S/m, 1×10⁻¹³ S/m, 0.5×10⁻¹² S/m, 1×10⁻¹² S/m, 0.5×10⁻¹¹ S/m, 1×10⁻¹¹ S/m, 0.5×10⁻¹⁰ S/m, 1×10⁻¹⁰ S/m, 0.5×10⁻⁹ S/m, 1×10⁻⁹ S/m, 0.5×10⁻⁸ S/m, 1×10⁻⁸ S/m, 0.5×10⁻⁷ S/m, 1×10⁻⁷ S/m, 0.5×10⁻⁶ S/m, 1×10⁻⁶ S/m, 0.5×10⁻⁵ S/m, 1×10⁻⁵ S/m, 0.5×10⁻⁴ S/m, 1×10⁻⁴ S/m, 0.5×10⁻³ S/m, 1×10⁻³ S/m, 0.5×10⁻² S/m, 1×10⁻² S/m, 0.5×10⁻¹ S/m, 1×10⁻¹ S/m, 0.5 S/m, 1 S/m, 1.5 S/m, 2 S/m, 2.5 S/m, 3 S/m, 3.5 S/m, 4 S/m, 4.5 S/m, 5 S/m, 5.5 S/m, 6 S/m, 6.5 S/m, 7 S/m, 7.5 S/m, 8 S/m, 8.5 S/m, 9 S/m, 9.5 S/m, 10 S/m, 50 S/m, 10² S/m, 5×10² S/m, 10³ S/m, 5×10³ S/m, 10⁴ S/m, 5×10⁴ S/m, 10⁵ S/m, 5×10⁵ S/m, 10⁶ S/m, 5×10⁶ S/m, or 10⁷ S/m.

According to one embodiment, the electrical conductivity of the first material **11** and/or the second material **21** may be measured for example with an impedance spectrometer.

According to one embodiment, the first material **11** and/or the second material **21** are amorphous.

According to one embodiment, the first material **11** and/or the second material **21** are crystalline.

According to one embodiment, the first material **11** and/or the second material **21** are totally crystalline.

According to one embodiment, the first material **11** and/or the second material **21** are partially crystalline.

According to one embodiment, the first material **11** and/or the second material **21** are monocrystalline.

According to one embodiment, the first material **11** and/or the second material **21** are polycrystalline. In this embodiment, the first material **11** and/or the second material **21** comprise at least one grain boundary.

According to one embodiment, the first material **11** and/or the second material **21** are hydrophobic.

According to one embodiment, the first material **11** and/or the second material **21** are hydrophilic.

According to one embodiment, the first material **11** and/or the second material **21** are not porous.

According to one embodiment, the first material **11** and/or the second material **21** do not comprise pores or cavities.

According to one embodiment, the first material **11** and/or the second material **21** are considered non-porous when the quantity adsorbed by the particle **1** and/or the particle **2** determined by adsorption-desorption of nitrogen in the Brunauer-Emmett-Teller (BET) theory is less than 20 cm³/g, 15 cm³/g, 10 cm³/g, 5 cm³/g at a nitrogen pressure of 650 mmHg, preferably 700 mmHg.

According to one embodiment, the first material **11** and/or the second material **21** are impermeable to outer molecular species, gas or liquid. In this embodiment, the first material **11** and/or the second material **21** limit or prevent the degradation of the chemical and physical properties of the at least one nanoparticle **3** from molecular oxygen, water and/or high temperature.

According to one embodiment, the impermeable first material **11** and/or the second material **21** have an intrinsic permeability to fluids less or equal to 10⁻¹¹ cm², 10⁻¹² cm², 10⁻¹³ cm², 10⁻¹⁴ cm², 10⁻¹⁵ cm², 10⁻¹⁶ cm², 10⁻¹⁷ cm², 10⁻¹⁸ cm², 10⁻¹⁹ cm², or 10⁻²⁰ cm².

According to one embodiment, the first material **11** and/or the second material **21** limit or prevent the diffusion of outer molecular species or fluids (liquid or gas) into said first material **11** and/or said second material **21.**

According to one embodiment, the specific property of the nanoparticles **3** is preserved after encapsulation in the particle **1.**

According to one embodiment, the photoluminescence of the nanoparticles **3** is preserved after encapsulation in the particle **1.**

According to one embodiment, the first material **11** and/or the second material **21** have a density ranging from 1 to 10, preferably the first material **11** and/or the second material **21** have a density ranging from 3 to 10 g/cm³. According to one embodiment, the first material **11** and/or the second material **21** are optically transparent, *i.e.,* the first material **11** and/or the second material **21** are transparent at wavelengths between 200 nm and 50 µm, between 200 nm and 10 µm, between 200 nm and 2500 nm, between 200 nm and 2000 nm, between 200 nm and 1500 nm, between 200 nm and 1000 nm, between 200 nm and 800 nm, between 400 nm and 700 nm, between 400 nm and 600 nm, or between 400 nm and 470 nm. In this embodiment, the first material **11** and/or the second material **21** do not absorb all incident light allowing the at least one nanoparticle **3** to absorb all the incident light; and/or the first material **11** and/or the second material **21** do not absorb the light emitted by the at least one nanoparticle **3** allowing to said light emitted to be transmitted through the first material **11** and/or the second material **21.**

According to one embodiment, the first material **11** and/or the second material **21** are not optically transparent, *i.e.,* the first material **11** and/or the second material **21** absorb light at wavelengths between 200 nm and 50 µm, between 200 nm and 10 µm, between 200 nm and 2500 nm, between 200 nm and 2000 nm, between 200 nm and 1500 nm, between 200 nm and 1000 nm, between 200 nm and 800 nm, between 400 nm and 700 nm, between 400 nm and 600 nm, or between 400 nm and 470 nm. In this embodiment, the first material **11** and/or the second material **21** absorb part of the incident light allowing the at least one nanoparticle **3** to absorb only a part of the incident light; and/or the first material **11** and/or the second material **21** absorb part of the light emitted by the at least one nanoparticle **3** allowing said light emitted to be partially transmitted through the first material **11** and/or the second material **21.**

According to one embodiment, the first material **11** and/or the second material **21** transmit at least 5%, 10%, 15%, 20%, 25%, 30%, 35%, 40%, 45%, 50%, 55%, 60%, 65%, 70%, 75%, 80%, 85%, 90%, 95%, or 100% of the incident light.

According to one embodiment, the first material **11** and/or the second material **21** transmit a part of the incident light and emits at least one secondary light. In this embodiment, the resulting light is a combination of the remaining transmitted incident light.

According to one embodiment, the first material **11** and/or the second material **21** absorb the incident light with wavelength lower than 50 µm, 40 µm, 30 µm, 20 µm, 10 µm, 1 µm, 950 nm, 900 nm, 850 nm, 800 nm, 750 nm, 700 nm, 650 nm, 600 nm, 550 nm, 500 nm, 450 nm, 400 nm, 350 nm, 300 nm, 250 nm, or lower than 200 nm.

According to one embodiment, the first material **11** and/or the second material **21** absorb the incident light with wavelength lower than 460 nm.

According to one embodiment, the first material **11** and/or the second material **21** have an extinction coefficient less or equal to 1×10⁻⁵, 1.1×10⁻⁵, 1.2×10⁻⁵, 1.3×10⁻⁵, 1.4×10⁻⁵, 1.5×10⁻⁵, 1.6×10⁻⁵, 1.7×10⁻⁵, 1.8×10⁻⁵, 1.9×10⁻⁵, 2×10⁻⁵, 3×10⁻⁵, 4×10⁻⁵, 5×10⁻⁵, 6×10⁻⁵, 7×10⁻⁵, 8×10⁻⁵, 9×10⁻⁵, 10×10⁻⁵, 11×10⁻⁵, 12×10⁻⁵, 13×10⁻⁵, 14×10⁻⁵, 15×10⁻⁵, 16×10⁻⁵, 17×10⁻⁵, 18×10⁻⁵, 19×10⁻⁵, 20×10⁻⁵, 21×10⁻⁵, 22×10⁻⁵, 23×10⁻⁵, 24×10⁻⁵, or 25×10⁻⁵ at 460 nm.

According to one embodiment, the first material **11** and/or the second material **21** have an attenuation coefficient less or equal to 1×10⁻² cm⁻¹, 1×10⁻¹ cm⁻¹, 0.5×10⁻¹ cm⁻¹, 0.1 cm⁻¹, 0.2 cm⁻¹, 0.3 cm⁻¹, 0.4 cm⁻¹, 0.5 cm⁻¹, 0.6 cm⁻¹, 0.7 cm⁻¹, 0.8 cm⁻¹, 0.9 cm⁻¹, 1 cm⁻¹, 1.1 cm⁻¹, 1.2 cm⁻¹, 1.3 cm⁻¹, 1.4 cm⁻¹, 1.5 cm⁻¹, 1.6 cm⁻¹, 1.7 cm⁻¹, 1.8 cm⁻¹, 1.9 cm⁻¹, 2.0 cm⁻¹, 2.5 cm⁻¹, 3.0 cm⁻¹, 3.5 cm⁻¹, 4.0 cm⁻¹, 4.5 cm⁻¹, 5.0 cm⁻¹, 5.5 cm⁻¹, 6.0 cm⁻¹, 6.5 cm⁻¹, 7.0 cm⁻¹, 7.5 cm⁻¹, 8.0 cm⁻¹, 8.5 cm⁻¹, 9.0 cm⁻¹, 9.5 cm⁻¹, 10 cm⁻¹, 15 cm⁻¹, 20 cm⁻¹, 25 cm⁻¹, or 30 cm⁻¹ at 460 nm.

According to one embodiment, the first material **11** and/or the second material **21** have an attenuation coefficient less or equal to 1×10⁻² cm⁻¹, 1×10⁻¹ cm⁻¹, 0.5×10⁻¹ cm⁻¹, 0.1 cm⁻¹, 0.2 cm⁻¹, 0.3 cm⁻¹, 0.4 cm⁻¹, 0.5 cm⁻¹, 0.6 cm⁻¹, 0.7 cm⁻¹, 0.8 cm⁻¹, 0.9 cm⁻¹, 1 cm⁻¹, 1.1 cm⁻¹, 1.2 cm⁻¹, 1.3 cm⁻¹, 1.4 cm⁻¹, 1.5 cm⁻¹, 1.6 cm⁻¹, 1.7 cm⁻¹, 1.8 cm⁻¹, 1.9 cm⁻¹, 2.0 cm⁻¹, 2.5 cm⁻¹, 3.0 cm⁻¹, 3.5 cm⁻¹, 4.0 cm⁻¹, 4.5 cm⁻¹, 5.0 cm⁻¹, 5.5 cm⁻¹, 6.0 cm⁻¹, 6.5 cm⁻¹, 7.0 cm⁻¹, 7.5 cm⁻¹, 8.0 cm⁻¹, 8.5 cm⁻¹, 9.0 cm⁻¹, 9.5 cm⁻¹, 10 cm⁻¹, 15 cm⁻¹, 20 cm⁻¹, 25 cm⁻¹, or 30 cm⁻¹ at 450 nm.

According to one embodiment, the first material **11** and/or the second material **21** have an optical absorption cross section less or equal to 1.10⁻³⁵ cm², 1.10⁻³⁴ cm², 1.10⁻³³ cm², 1.10⁻³² cm², 1.10⁻³¹ cm², 1.10⁻³⁰ cm², 1.10⁻²⁹ cm², 1.10⁻²⁸ cm², 1.10⁻²⁷ cm², 1.10⁻²⁶ cm², 1.10⁻²⁵ cm², 1.10⁻²⁴ cm², 1.10⁻²³ cm², 1.10⁻²² cm², 1.10⁻²¹ cm², 1.10⁻²⁰ cm², 1.10⁻¹⁹ cm², 1.10⁻¹⁸ cm², 1.10⁻¹⁷ cm², 1.10⁻¹⁶ cm², 1.10⁻¹⁵ cm², 1.10⁻¹⁴ cm², 1.10⁻¹³ cm², 1.10⁻¹² cm², 1.10⁻¹¹ cm², 1.10⁻¹⁰ cm², 1.10⁻⁹ cm², 1.10⁻⁸ cm², 1.10⁻⁷ cm², 1.10⁻⁶ cm², 1.10⁻⁵ cm², 1.10⁻⁴ cm², 1.10⁻³ cm², 1.10⁻² cm² or 1.10⁻¹ cm² at 460 nm.

According to one embodiment, the first material **11** and/or the second material **21** are stable under acidic conditions, *i.e.,* at pH inferior or equal to 7. In this embodiment, the first material **11** and/or the second material **21** are sufficiently robust to withstand acidic conditions, meaning that the properties of the particle **1** are preserved under said conditions.

According to one embodiment, the first material **11** and/or the second material **21** are stable under basic conditions, *i.e.*, at pH superior to 7. In this embodiment, the first material **11** and/or the second material **21** are sufficiently robust to withstand basic conditions, meaning that the properties of the particle **1** are preserved under said conditions.

According to one embodiment, the first material **11** and/or the second material **21** are physically and chemically stable under various conditions. In this embodiment, the first material **11** and/or the second material **21** are sufficiently robust to withstand the conditions to which the particle **1** will be subjected.

According to one embodiment, the first material **11** and/or the second material **21** are physically and chemically stable under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C for at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years. In this embodiment, the first material **11** and/or the second material **21** are sufficiently robust to withstand the conditions to which the particle **1** will be subjected.

According to one embodiment, the first material **11** and/or the second material **21** are physically and chemically stable under 0%, 10%, 20%, 30%, 40%, 50%, 55%, 60%, 65%, 70%, 75%, 80%, 85%, 90%, 95%, or 99% of humidity for at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years. In this embodiment, the first material **11** and/or the second material **21** are sufficiently robust to withstand the conditions to which the particle **1** will be subjected.

According to one embodiment, the first material **11** and/or the second material **21** are physically and chemically stable under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂ for at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years. In this embodiment, the first material **11** and/or the second material **21** are sufficiently robust to withstand the conditions to which the particle **1** will be subjected.

According to one embodiment, the first material **11** and/or the second material **21** are physically and chemically stable under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C and under 0%, 10%, 20%, 30%, 40%, 50%, 55%, 60%, 65%, 70%, 75%, 80%, 85%, 90%, 95%, or 99% of humidity for at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years. In this embodiment, the first material **11** and/or the second material **21** are sufficiently robust to withstand the conditions to which the particle **1** will be subjected.

According to one embodiment, the first material **11** and/or the second material **21** are physically and chemically stable under 0%, 10%, 20%, 30%, 40%, 50%, 55%, 60%, 65%, 70%, 75%, 80%, 85%, 90%, 95%, or 99% of humidity and under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂ for at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years. In this embodiment, the first material **11** and/or the second material **21** are sufficiently robust to withstand the conditions to which the particle **1** will be subjected.

According to one embodiment, the first material **11** and/or the second material **21** are physically and chemically stable under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C and under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂ for at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years. In this embodiment, the first material **11** and/or the second material **21** are sufficiently robust to withstand the conditions to which the particle **1** will be subjected.

According to one embodiment, the first material **11** and the second material **21** have an extinction coefficient less or equal to 1×10⁻⁵, 1.1×10⁻⁵, 1.2×10⁻⁵, 1.3×10⁻⁵, 1.4×10⁻⁵, 1.5×10⁻⁵, 1.6×10⁻⁵, 1.7×10⁻⁵, 1.8×10⁻⁵, 1.9×10⁻⁵, 2×10⁻⁵, 3×10⁻⁵ , 4×10⁻⁵, 5×10⁻⁵, 6×10⁻⁵, 7×10⁻⁵, 8×10⁻⁵, 9×10⁻⁵, 10×10⁻⁵, 11×10⁻⁵, 12×10⁻⁵, 13×10⁻⁵, 14×10⁻⁵, 15×10⁻⁵, 16×10⁻⁵, 17×10⁻⁵, 18×10⁻⁵, 19×10⁻⁵, 20×10⁻⁵, 21×10⁻⁵, 22×10⁻⁵, 23×10⁻⁵, 24×10⁻⁵, or 25×10⁻⁵ at 460 nm. In one embodiment, the extinction coefficient is measured by an absorbance measuring technique such as absorbance spectroscopy or any other method known in the art.

In one embodiment, the extinction coefficient is measured by an absorbance measurement divided by the length of the path light passing through the sample.

According to the invention the first material **11** and the second material **21** have an attenuation coefficient less or equal to 1×10⁻² 1×10⁻² cm⁻¹ at 460 nn.

According to one embodiment, the first material **11** and/or the second material **21** have an attenuation coefficient less or equal to 1×10⁻² cm⁻¹, 1×10⁻¹ cm⁻¹, 0.5×10⁻¹ cm⁻¹, 0.1 cm⁻¹, 0.2 cm⁻¹, 0.3 cm⁻¹, 0.4 cm⁻¹, 0.5 cm⁻¹, 0.6 cm⁻¹, 0.7 cm⁻¹, 0.8 cm⁻¹, 0.9 cm⁻¹, 1 cm⁻¹, 1.1 cm⁻¹, 1.2 cm⁻¹, 1.3 cm⁻¹, 1.4 cm⁻¹, 1.5 cm⁻¹, 1.6 cm⁻¹, 1.7 cm⁻¹, 1.8 cm⁻¹, 1.9 cm⁻¹, 2.0 cm⁻¹, 2.5 cm⁻¹, 3.0 cm⁻¹, 3.5 cm⁻¹, 4.0 cm⁻¹, 4.5 cm⁻¹, 5.0 cm⁻¹, 5.5 cm⁻¹, 6.0 cm⁻¹, 6.5 cm⁻¹, 7.0 cm⁻¹, 7.5 cm⁻¹, 8.0 cm⁻¹, 8.5 cm⁻¹, 9.0 cm⁻¹, 9.5 cm⁻¹, 10 cm⁻¹, 15 cm⁻¹, 20 cm⁻¹, 25 cm⁻¹, or 30 cm⁻¹ at 450 nm.

According to one embodiment, the first material **11** and/or the second material **21** have an optical absorption cross section less or equal to 1.10⁻³⁵ cm², 1.10⁻³⁴ cm², 1.10⁻³³ cm², 1.10⁻³² cm², 1.10⁻³¹ cm², 1.10⁻³⁰ cm², 1.10⁻²⁹ cm², 1.10⁻²⁸ cm², 1.10⁻²⁷ cm², 1.10⁻²⁶ cm², 1.10⁻²⁵ cm², 1.10⁻²⁴ cm², 1.10⁻²³ cm², 1.10⁻²² cm², 1.10⁻²¹ cm², 1.10⁻²⁰ cm², 1.10⁻¹⁹ cm², 1.10⁻¹⁸ cm², 1.10⁻¹⁷ cm², 1.10⁻¹⁶ cm², 1.10⁻¹⁵ cm², 1.10⁻¹⁴ cm², 1.10⁻¹³ cm², 1.10⁻¹² cm², 1.10⁻¹¹ cm², 1.10⁻¹⁰ cm², 1.10⁻⁹ cm², 1.10⁻⁸ cm², 1.10⁻⁷ cm², 1.10⁻⁶ cm², 1.10⁻⁵ cm², 1.10⁻⁴ cm², 1.10⁻³ cm², 1.10⁻² cm² or 1.10⁻¹ cm² at 460 nm.

According to one embodiment, the second material **21** is the same as the first material **11** as described hereabove.

According to one embodiment, the second material **21** is different from the first material **11** as described hereabove.

According to one embodiment, the particle **2** is dispersed in the first material **11.**

According to one embodiment, the particle **2** is totally surrounded by or encapsulated in the first material **11.**

According to one embodiment, the particle **2** is partially surrounded by or encapsulated in the first material **11.**

According to one embodiment, the particle **2** is fluorescent.

According to one embodiment, the particle **2** is phosphorescent.

According to one embodiment, the particle **2** is luminescent.

According to one embodiment, the particle **2** is electroluminescent.

According to one embodiment, the particle **2** is chemiluminescent.

According to one embodiment, the particle **2** is triboluminescent.

According to one embodiment, the features of the light emission of particle **2** are sensible to external pressure variations. In this embodiment, "sensible" means that the features of the light emission can be modified by external pressure variations.

According to one embodiment, the wavelength emission peak of particle **2** is sensible to external pressure variations. In this embodiment, "sensible" means that the wavelength emission peak can be modified by external pressure variations, *i.e.*, external pressure variations can induce a wavelength shift.

According to one embodiment, the FWHM of particle **2** is sensible to external pressure variations. In this embodiment, "sensible" means that the FWHM can be modified by external pressure variations, *i.e.,* FWHM can be reduced or increased.

According to one embodiment, the PLQY of particle **2** is sensible to external pressure variations. In this embodiment, "sensible" means that the PLQY can be modified by external pressure variations, *i.e.*, PLQY can be reduced or increased.

According to one embodiment, the features of the light emission of particle **2** are sensible to external temperature variations.

According to one embodiment, the wavelength emission peak of particle **2** is sensible to external temperature variations. In this embodiment, "sensible" means that the wavelength emission peak can be modified by external temperature variations, *i.e.,* external temperature variations can induce a wavelength shift.

According to one embodiment, the FWHM of particle **2** is sensible to external temperature variations. In this embodiment, "sensible" means that the FWHM can be modified by external temperature variations, *i.e.,* FWHM can be reduced or increased.

According to one embodiment, the PLQY of particle **2** is sensible to external temperature variations. In this embodiment, "sensible" means that the PLQY can be modified by external temperature variations, *i.e.*, PLQY can be reduced or increased.

According to one embodiment, the features of the light emission of particle **2** are sensible to external variations of pH.

According to one embodiment, the wavelength emission peak of particle **2** is sensible to external variations of pH. In this embodiment, "sensible" means that the wavelength emission peak can be modified by external variations of pH, *i.e.,* external variations of pH can induce a wavelength shift.

According to one embodiment, the FWHM of particle **2** is sensible to e external variations of pH. In this embodiment, "sensible" means that the FWHM can be modified by external variations of pH, *i.e.*, FWHM can be reduced or increased.

According to one embodiment, the PLQY of particle **2** is sensible to external variations of pH. In this embodiment, "sensible" means that the PLQY can be modified by external variations of pH, *i.e.*, PLQY can be reduced or increased.

According to one embodiment, the particle **2** comprise at least one nanoparticle wherein the wavelength emission peak is sensible to external temperature variations; and at least one nanoparticle wherein the wavelength emission peak is not or less sensible to external temperature variations. In this embodiment, "sensible" means that the wavelength emission peak can be modified by external temperature variations, *i.e.*, wavelength emission peak can be reduced or increased. This embodiment is particularly advantageous for temperature sensor applications.

According to one embodiment, the particle **2** exhibits an emission spectrum with at least one emission peak, wherein said emission peak has a maximum emission wavelength ranging from 400 nm to 50 µm.

According to one embodiment, the particle **2** exhibits an emission spectrum with at least one emission peak, wherein said emission peak has a maximum emission wavelength ranging from 400 nm to 500 nm. In this embodiment, the particle **2** emits blue light.

According to one embodiment, the particle **2** exhibits an emission spectrum with at least one emission peak, wherein said emission peak has a maximum emission wavelength ranging from 500 nm to 560 nm, more preferably ranging from 515 nm to 545 nm. In this embodiment, the particle **2** emits green light.

According to one embodiment, the particle **2** exhibits an emission spectrum with at least one emission peak, wherein said emission peak has a maximum emission wavelength ranging from 560 nm to 590 nm. In this embodiment, the particle **2** emits yellow light.

According to one embodiment, the particle **2** exhibits an emission spectrum with at least one emission peak, wherein said emission peak has a maximum emission wavelength ranging from 590 nm to 750 nm, more preferably ranging from 610 nm to 650 nm. In this embodiment, the particle **2** emits red light.

According to one embodiment, the particle **2** exhibits an emission spectrum with at least one emission peak, wherein said emission peak has a maximum emission wavelength ranging from 750 nm to 50 µm. In this embodiment, the particle **2** emits near infra-red, mid-infra-red, or infra-red light.

According to one embodiment, the particle **2** exhibits emission spectra with at least one emission peak having a full width half maximum lower than 90 nm, 80 nm, 70 nm, 60 nm, 50 nm, 40 nm, 30 nm, 25 nm, 20 nm, 15 nm, or 10 nm.

According to one embodiment, the particle **2** exhibits emission spectra with at least one emission peak having a full width half maximum strictly lower than 40 nm, 30 nm, 25 nm, 20 nm, 15 nm, or 10 nm.

According to one embodiment, the particle **2** exhibits emission spectra with at least one emission peak having a full width at quarter maximum lower than 90 nm, 80 nm, 70 nm, 60 nm, 50 nm, 40 nm, 30 nm, 25 nm, 20 nm, 15 nm, or 10 nm.

According to one embodiment, the particle **2** exhibits emission spectra with at least one emission peak having a full width at quarter maximum strictly lower than 40 nm, 30 nm, 25 nm, 20 nm, 15 nm, or 10 nm.

According to one embodiment, the particle **2** has a photoluminescence quantum yield (PLQY) of at least 5%, 10%, 15%, 20%, 25%, 30%, 35%, 40%, 45%, 50%, 55%, 60%, 65%, 70%, 75%, 80%, 85%, 90%, 95%, 99% or 100%.

According to one embodiment, the particle **2** absorbs the incident light with wavelength lower than 50 µm, 40 µm, 30 µm, 20 µm, 10 µm, 1 µm, 950 nm, 900 nm, 850 nm, 800 nm, 750 nm, 700 nm, 650 nm, 600 nm, 550 nm, 500 nm, 450 nm, 400 nm, 350 nm, 300 nm, 250 nm, or lower than 200 nm.

According to one embodiment, the particle **2** has an average fluorescence lifetime of at least 0.1 nanosecond, 0.2 nanosecond, 0.3 nanosecond, 0.4 nanosecond, 0.5 nanosecond, 0.6 nanosecond, 0.7 nanosecond, 0.8 nanosecond, 0.9 nanosecond, 1 nanosecond, 2 nanoseconds, 3 nanoseconds, 4 nanoseconds, 5 nanoseconds, 6 nanoseconds, 7 nanoseconds, 8 nanoseconds, 9 nanoseconds, 10 nanoseconds, 11 nanoseconds, 12 nanoseconds, 13 nanoseconds, 14 nanoseconds, 15 nanoseconds, 16 nanoseconds, 17 nanoseconds, 18 nanoseconds, 19 nanoseconds, 20 nanoseconds, 21 nanoseconds, 22 nanoseconds, 23 nanoseconds, 24 nanoseconds, 25 nanoseconds, 26 nanoseconds, 27 nanoseconds, 28 nanoseconds, 29 nanoseconds, 30 nanoseconds, 31 nanoseconds, 32 nanoseconds, 33 nanoseconds, 34 nanoseconds, 35 nanoseconds, 36 nanoseconds, 37 nanoseconds, 38 nanoseconds, 39 nanoseconds, 40 nanoseconds, 41 nanoseconds, 42 nanoseconds, 43 nanoseconds, 44 nanoseconds, 45 nanoseconds, 46 nanoseconds, 47 nanoseconds, 48 nanoseconds, 49 nanoseconds, 50 nanoseconds, 100 nanoseconds, 150 nanoseconds, 200 nanoseconds, 250 nanoseconds, 300 nanoseconds, 350 nanoseconds, 400 nanoseconds, 450 nanoseconds, 500 nanoseconds, 550 nanoseconds, 600 nanoseconds, 650 nanoseconds, 700 nanoseconds, 750 nanoseconds, 800 nanoseconds, 850 nanoseconds, 900 nanoseconds, 950 nanoseconds, or 1 µsecond.

In one embodiment, the particle **2** exhibits photoluminescence quantum yield (PQLY) decrease of less than 80%, 70%, 60%, 50%, 40%, 30%, 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under pulsed light with an average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one preferred embodiment, the particle **2** exhibits photoluminescence quantum yield (PQLY) decrease of less than 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under pulsed light or continuous light with an average peak pulse power or photon flux of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one embodiment, the particle **2** exhibits FCE decrease of less than 80%, 70%, 60%, 50%, 40%, 30%, 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under pulsed light with an average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one preferred embodiment, the particle **2** exhibits FCE decrease of less than 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000,42000, 43000, 44000, 45000,46000, 47000, 48000, 49000, or 50000 hours under pulsed light or continuous light with an average peak pulse power or photon flux of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

According to one embodiment, the particle **2** absorbs the incident light with wavelength lower than 50 µm, 40 µm, 30 µm, 20 µm, 10 µm, 1 µm, 950 nm, 900 nm, 850 nm, 800 nm, 750 nm, 700 nm, 650 nm, 600 nm, 550 nm, 500 nm, 450 nm, 400 nm, 350 nm, 300 nm, 250 nm, or lower than 200 nm.

According to one embodiment, the particle **2** is an electrical insulator. In this embodiment, the quenching of fluorescent properties for fluorescent nanoparticles **3** encapsulated in the material **21** is prevented when it is due to electron transport. In this embodiment, the particle **2** may be used as an electrical insulator material exhibiting the same properties as the nanoparticles **3** encapsulated in the material **21.**

According to one embodiment, the particle **2** is an electrical conductor. This embodiment is particularly advantageous for an application of the particle **2** in photovoltaics or LEDs.

According to one embodiment, the particle **2** has an electrical conductivity at standard conditions ranging from 1×10⁻²⁰ to 10⁷ S/m, preferably from 1×10⁻¹⁵ to 5 S/m, more preferably from 1×10⁻⁷ to 1 S/m.

According to one embodiment, the particle **2** has an electrical conductivity at standard conditions of at least 1×10⁻²⁰ S/m, 0.5×10⁻¹⁹ S/m, 1×10⁻¹⁹ S/m, 0.5×10⁻¹⁸ S/m, 1×10⁻¹⁸ S/m, 0.5×10⁻¹⁷ S/m, 1×10⁻¹⁷ S/m, 0.5×10⁻¹⁶ S/m, 1×10⁻¹⁶ S/m, 0.5×10⁻¹⁵ S/m, 1×10⁻¹⁵ S/m, 0.5×10⁻¹⁴ S/m, 1×10⁻¹⁴ S/m, 0.5×10⁻¹³ S/m, 1×10⁻¹³ S/m, 0.5×10⁻¹² S/m, 1×10⁻¹² S/m, 0.5×10⁻¹¹ S/m, 1×10⁻¹¹ S/m, 0.5×10⁻¹⁰ S/m, 1×10⁻¹⁰ S/m, 0.5×10⁻⁹ S/m, 1×10⁻⁹ S/m, 0.5×10⁻⁸ S/m, 1×10⁻⁸ S/m, 0.5×10⁻⁷ S/m, 1×10⁻⁷ S/m, 0.5×10⁻⁶ S/m, 1×10⁻⁶ S/m, 0.5×10⁻⁵ S/m, 1×10⁻⁵ S/m, 0.5×10⁻⁴ S/m, 1×10⁻⁴ S/m, 0.5×10⁻³ S/m, 1×10⁻³ S/m, 0.5×10⁻² S/m, 1×10⁻² S/m, 0.5×10⁻¹ S/m, 1×10⁻¹ S/m, 0.5 S/m, 1 S/m, 1.5 S/m, 2 S/m, 2.5 S/m, 3 S/m, 3.5 S/m, 4 S/m, 4.5 S/m, 5 S/m, 5.5 S/m, 6 S/m, 6.5 S/m, 7 S/m, 7.5 S/m, 8 S/m, 8.5 S/m, 9 S/m, 9.5 S/m, 10 S/m, 50 S/m, 10² S/m, 5×10² S/m, 10³ S/m, 5×10³ S/m, 10⁴ S/m, 5×10⁴ S/m, 10⁵ S/m, 5×10⁵ S/m, 10⁶ S/m, 5×10⁶ S/m, or 10⁷ S/m.

According to one embodiment, the electrical conductivity of the particle **2** may be measured for example with an impedance spectrometer.

According to one embodiment, the particle **2** is a thermal insulator.

According to one embodiment, the material **21** comprises a refractory material.

According to one embodiment, the particle **2** is a thermal conductor. In this embodiment, the particle **2** is capable of draining away the heat originating from the nanoparticles **3** encapsulated in the material **21,** or from the environment.

According to one embodiment, the particle **2** has a thermal conductivity at standard conditions ranging from 0.1 to 450 W/(m.K), preferably from 1 to 200 W/(m.K), more preferably from 10 to 150 W/(m.K).

According to one embodiment, the particle **2** has a thermal conductivity at standard conditions of at least 0.1 W/(m.K), 0.2 W/(m.K), 0.3 W/(m.K), 0.4 W/(m.K), 0.5 W/(m.K), 0.6 W/(m.K), 0.7 W/(m.K), 0.8 W/(m.K), 0.9 W/(m.K), 1 W/(m.K), 1.1 W/(m.K), 1.2 W/(m.K), 1.3 W/(m.K), 1.4 W/(m.K), 1.5 W/(m.K), 1.6 W/(m.K), 1.7 W/(m.K), 1.8 W/(m.K), 1.9 W/(m.K), 2 W/(m.K), 2.1 W/(m.K), 2.2 W/(m.K), 2.3 W/(m.K), 2.4 W/(m.K), 2.5 W/(m.K), 2.6 W/(m.K), 2.7 W/(m.K), 2.8 W/(m.K), 2.9 W/(m.K), 3 W/(m.K), 3.1 W/(m.K), 3.2 W/(m.K), 3.3 W/(m.K), 3.4 W/(m.K), 3.5 W/(m.K), 3.6 W/(m.K), 3.7 W/(m.K), 3.8 W/(m.K), 3.9 W/(m.K), 4 W/(m.K), 4.1 W/(m.K), 4.2 W/(m.K), 4.3 W/(m.K), 4.4 W/(m.K), 4.5 W/(m.K), 4.6 W/(m.K), 4.7 W/(m.K), 4.8 W/(m.K), 4.9 W/(m.K), 5 W/(m.K), 5.1 W/(m.K), 5.2 W/(m.K), 5.3 W/(m.K), 5.4 W/(m.K), 5.5 W/(m.K), 5.6 W/(m.K), 5.7 W/(m.K), 5.8 W/(m.K), 5.9 W/(m.K), 6 W/(m.K), 6.1 W/(m.K), 6.2 W/(m.K), 6.3 W/(m.K), 6.4 W/(m.K), 6.5 W/(m.K), 6.6 W/(m.K), 6.7 W/(m.K), 6.8 W/(m.K), 6.9 W/(m.K), 7 W/(m.K), 7.1 W/(m.K), 7.2 W/(m.K), 7.3 W/(m.K), 7.4 W/(m.K), 7.5 W/(m.K), 7.6 W/(m.K), 7.7 W/(m.K), 7.8 W/(m.K), 7.9 W/(m.K), 8 W/(m.K), 8.1 W/(m.K), 8.2 W/(m.K), 8.3 W/(m.K), 8.4 W/(m.K), 8.5 W/(m.K), 8.6 W/(m.K), 8.7 W/(m.K), 8.8 W/(m.K), 8.9 W/(m.K), 9 W/(m.K), 9.1 W/(m.K), 9.2 W/(m.K), 9.3 W/(m.K), 9.4 W/(m.K), 9.5 W/(m.K), 9.6 W/(m.K), 9.7 W/(m.K), 9.8 W/(m.K), 9.9 W/(m.K), 10 W/(m.K), 10.1 W/(m.K), 10.2 W/(m.K), 10.3 W/(m.K), 10.4 W/(m.K), 10.5 W/(m.K), 10.6 W/(m.K), 10.7 W/(m.K), 10.8 W/(m.K), 10.9 W/(m.K), 11 W/(m.K), 11.1 W/(m.K), 11.2 W/(m.K), 11.3 W/(m.K), 11.4 W/(m.K), 11.5 W/(m.K), 11.6 W/(m.K), 11.7 W/(m.K), 11.8 W/(m.K), 11.9 W/(m.K), 12 W/(m.K), 12.1 W/(m.K), 12.2 W/(m.K), 12.3 W/(m.K), 12.4 W/(m.K), 12.5 W/(m.K), 12.6 W/(m.K), 12.7 W/(m.K), 12.8 W/(m.K), 12.9 W/(m.K), 13 W/(m.K), 13.1 W/(m.K), 13.2 W/(m.K), 13.3 W/(m.K), 13.4 W/(m.K), 13.5 W/(m.K), 13.6 W/(m.K), 13.7 W/(m.K), 13.8 W/(m.K), 13.9 W/(m.K), 14 W/(m.K), 14.1 W/(m.K), 14.2 W/(m.K), 14.3 W/(m.K), 14.4 W/(m.K), 14.5 W/(m.K), 14.6 W/(m.K), 14.7 W/(m.K), 14.8 W/(m.K), 14.9 W/(m.K), 15 W/(m.K), 15.1 W/(m.K), 15.2 W/(m.K), 15.3 W/(m.K), 15.4 W/(m.K), 15.5 W/(m.K), 15.6 W/(m.K), 15.7 W/(m.K), 15.8 W/(m.K), 15.9 W/(m.K), 16 W/(m.K), 16.1 W/(m.K), 16.2 W/(m.K), 16.3 W/(m.K), 16.4 W/(m.K), 16.5 W/(m.K), 16.6 W/(m.K), 16.7 W/(m.K), 16.8 W/(m.K), 16.9 W/(m.K), 17 W/(m.K), 17.1 W/(m.K), 17.2 W/(m.K), 17.3 W/(m.K), 17.4 W/(m.K), 17.5 W/(m.K), 17.6 W/(m.K), 17.7 W/(m.K), 17.8 W/(m.K), 17.9 W/(m.K), 18 W/(m.K), 18.1 W/(m.K), 18.2 W/(m.K), 18.3 W/(m.K), 18.4 W/(m.K), 18.5 W/(m.K), 18.6 W/(m.K), 18.7 W/(m.K), 18.8 W/(m.K), 18.9 W/(m.K), 19 W/(m.K), 19.1 W/(m.K), 19.2 W/(m.K), 19.3 W/(m.K), 19.4 W/(m.K), 19.5 W/(m.K), 19.6 W/(m.K), 19.7 W/(m.K), 19.8 W/(m.K), 19.9 W/(m.K), 20 W/(m.K), 20.1 W/(m.K), 20.2 W/(m.K), 20.3 W/(m.K), 20.4 W/(m.K), 20.5 W/(m.K), 20.6 W/(m.K), 20.7 W/(m.K), 20.8 W/(m.K), 20.9 W/(m.K), 21 W/(m.K), 21.1 W/(m.K), 21.2 W/(m.K), 21.3 W/(m.K), 21.4 W/(m.K), 21.5 W/(m.K), 21.6 W/(m.K), 21.7 W/(m.K), 21.8 W/(m.K), 21.9 W/(m.K), 22 W/(m.K), 22.1 W/(m.K), 22.2 W/(m.K), 22.3 W/(m.K), 22.4 W/(m.K), 22.5 W/(m.K), 22.6 W/(m.K), 22.7 W/(m.K), 22.8 W/(m.K), 22.9 W/(m.K), 23 W/(m.K), 23.1 W/(m.K), 23.2 W/(m.K), 23.3 W/(m.K), 23.4 W/(m.K), 23.5 W/(m.K), 23.6 W/(m.K), 23.7 W/(m.K), 23.8 W/(m.K), 23.9 W/(m.K), 24 W/(m.K), 24.1 W/(m.K), 24.2 W/(m.K), 24.3 W/(m.K), 24.4 W/(m.K), 24.5 W/(m.K), 24.6 W/(m.K), 24.7 W/(m.K), 24.8 W/(m.K), 24.9 W/(m.K), 25 W/(m.K), 30 W/(m.K), 40 W/(m.K), 50 W/(m.K), 60 W/(m.K), 70 W/(m.K), 80 W/(m.K), 90 W/(m.K), 100 W/(m.K), 110 W/(m.K), 120 W/(m.K), 130 W/(m.K), 140 W/(m.K), 150 W/(m.K), 160 W/(m.K), 170 W/(m.K), 180 W/(m.K), 190 W/(m.K), 200 W/(m.K), 210 W/(m.K), 220 W/(m.K), 230 W/(m.K), 240 W/(m.K), 250 W/(m.K), 260 W/(m.K), 270 W/(m.K), 280 W/(m.K), 290 W/(m.K), 300 W/(m.K), 310 W/(m.K), 320 W/(m.K), 330 W/(m.K), 340 W/(m.K), 350 W/(m.K), 360 W/(m.K), 370 W/(m.K), 380 W/(m.K), 390 W/(m.K), 400 W/(m.K), 410 W/(m.K), 420 W/(m.K), 430 W/(m.K), 440 W/(m.K), or 450 W/(m.K).

According to one embodiment, the thermal conductivity of the particle **2** may be measured for example by steady-state methods or transient methods.

According to one embodiment, the particle **2** is a local high temperature heating system.

According to one embodiment, the particle **2** is not a metallic particle.

According to one embodiment, the particle **2** is surfactant-free.

According to one embodiment, the particle **2** is not surfactant-free.

According to one embodiment, the particle **2** is amorphous.

According to one embodiment, the particle **2** is crystalline.

According to one embodiment, the particle **2** is totally crystalline.

According to one embodiment, the particle **2** is partially crystalline.

According to one embodiment, the particle **2** is monocrystalline.

According to one embodiment, the particle **2** is polycrystalline. In this embodiment, the particle **2** comprises at least one grain boundary.

According to one embodiment, the particle **2** is a colloidal particle.

According to one embodiment, the particle **2** does not comprise a spherical porous bead, preferably the particle **2** does not comprise a central spherical porous bead.

According to one embodiment, the particle **2** does not comprise a spherical porous bead, wherein nanoparticles **3** are linked to the surface of said spherical porous bead.

According to one embodiment, the particle **2** does not comprise a bead and nanoparticles **3** having opposite electronic charges.

According to one embodiment, the particle **2** is porous.

According to one embodiment, the particle **2** is considered porous when the quantity adsorbed by the particle **2** determined by adsorption-desorption of nitrogen in the Brunauer-Emmett-Teller (BET) theory is more than 20 cm³/g, 15 cm³/g, 10 cm³/g, 5 cm³/g at a nitrogen pressure of 650 mmHg, preferably 700 mmHg.

According to one embodiment, the organization of the porosity of the particle **2** can be hexagonal, vermicular or cubic.

According to one embodiment, the organized porosity of the particle **2** has a pore size of at least 1 nm, 1.5 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 11 nm, 12 nm, 13 nm, 14 nm, 15 nm, 16 nm, 17 nm, 18 nm, 19 nm, 20 nm, 21 nm, 22 nm, 23 nm, 24 nm, 25 nm, 26 nm, 27 nm, 28 nm, 29 nm, 30 nm, 31 nm, 32 nm, 33 nm, 34 nm, 35 nm, 36 nm, 37 nm, 38 nm, 39 nm, 40 nm, 41 nm, 42 nm, 43 nm, 44 nm, 45 nm, 46 nm, 47 nm, 48 nm, 49 nm, or 50 nm.

According to one embodiment, the particle **2** is not porous.

According to one embodiment, the particle **2** does not comprise pores or cavities.

According to one embodiment, the particle **2** is considered non-porous when the quantity adsorbed by the said particle **2** determined by adsorption-desorption of nitrogen in the Brunauer-Emmett-Teller (BET) theory is less than 20 cm³/g, 15 cm³/g, 10 cm³/g, 5 cm³/g at a nitrogen pressure of 650 mmHg, preferably 700 mmHg.

According to one embodiment, the particle **2** is permeable.

According to one embodiment, the permeable particle **2** has an intrinsic permeability to fluids higher or equal to 10⁻¹¹ cm², 10⁻¹¹ cm², 10⁻⁹ cm², 10⁻⁸ cm², 10⁻⁷ cm², 10⁻⁶ cm², 10⁻⁵ cm², 10⁻⁴ cm², or 10⁻³ cm².

According to one embodiment, the particle **2** is impermeable to outer molecular species, gas or liquid. In this embodiment, outer molecular species, gas or liquid refers to molecular species, gas or liquid external to said particle **2.**

According to one embodiment, the impermeable particle **2** has an intrinsic permeability to fluids less or equal to 10⁻¹¹ cm², 10⁻¹² cm², 10⁻¹¹ cm², 10⁻¹⁴ cm², or 10⁻¹⁵ cm².

According to one embodiment, the particle **2** has an oxygen transmission rate ranging from 10⁻⁷ to 10 cm³.m⁻².day⁻¹, preferably from 10⁻⁷ to 1 cm³.m⁻².day⁻¹, more preferably from 10⁻⁷ to 10⁻¹ cm³.m⁻².day⁻¹, even more preferably from 10⁻⁷ to 10⁻⁴ cm³.m⁻².day⁻¹ at room temperature.

According to one embodiment, the particle **2** has a water vapor transmission rate ranging from 10⁻⁷ to 10 g.m⁻².day⁻¹, preferably from 10⁻⁷ to 1 g.m⁻².day⁻¹, more preferably from 10⁻⁷ to 10⁻¹ g.m⁻².day⁻¹, even more preferably from 10⁻⁷ to 10⁻⁴ g.m⁻².day⁻¹ at room temperature. A water vapor transmission rate of 10⁻⁶ g.m⁻².day⁻¹ is particularly adequate for a use on LED.

According to one embodiment, the particle **2** is dispersible in aqueous solvents, organic solvents and/or mixture thereof.

According to one embodiment, the particle **2** is dispersible in the liquid vehicle.

According to one embodiment, the particle **2** has a size above 20 nm.

According to one embodiment, the particle **2** has a size of at least 5 nm, 10 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm

According to one embodiment, a statistical set of particles 2 has an average size of at least 5 nm, 10 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm

According to one embodiment, the particle 2 has a largest dimension of at least 5 nm, 10 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the particle **2** has a smallest dimension of at least 5 nm, 10 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the smallest dimension of the particle 2 smaller than the largest dimension of said particle 2 by a factor (aspect ratio) of at least 1.5; of at least 2; at least 2.5; at least 3; at least 3.5; at least 4; at least 4.5; at least 5; at least 5.5; at least 6; at least 6.5; at least 7; at least 7.5; at least 8; at least 8.5; at least 9; at least 9.5; at least 10; at least 10.5; at least 11; at least 11.5; at least 12; at least 12.5; at least 13; at least 13.5; at least 14; at least 14.5; at least 15; at least 15.5; at least 16; at least 16.5; at least 17; at least 17.5; at least 18; at least 18.5; at least 19; at least 19.5; at least 20; at least 25; at least 30; at least 35; at least 40; at least 45; at least 50; at least 55; at least 60; at least 65; at least 70; at least 75; at least 80; at least 85; at least 90; at least 95; at least 100; at least 150; at least 200; at least 250; at least 300; at least 350; at least 400; at least 450; at least 500; at least 550; at least 600; at least 650; at least 700; at least 750; at least 800; at least 850; at least 900; at least 950; or at least 1000.

According to one embodiment, the particle 2 has a smallest curvature of at least 200 µm⁻¹, 100 µm⁻¹, 66.6 µm⁻¹, 50 µm⁻¹, 33.3 µm⁻¹, 28.6 µm⁻¹, 25 µm⁻¹, 20 µm⁻¹, 18.2 µm⁻¹, 16.7 µm⁻¹, 15.4 µm⁻¹ 14.3 µm⁻¹, 13.3 µm⁻¹, 12.5 µm⁻¹ 11.8 µm⁻¹, 11.1 µm⁻¹, 10.5 µm⁻¹, 10 µm⁻¹, 9.5 µm⁻¹, 9.1 µm⁻¹, 8.7 µm⁻¹ 8.3 µm⁻¹, 8 µm⁻¹, 7.7 µm⁻¹, 7.4 µm⁻¹, 7.1 µm⁻¹, 6.9 µm⁻¹, 6.7 µm⁻¹, 5.7 µm⁻¹, 5 µm⁻¹, 4.4 µm⁻¹, 4 µm⁻¹, 3.6 µm⁻¹, 3.3 µm⁻¹, 3.1 µm⁻¹, 2.9 µm⁻¹, 2.7 µm⁻¹ 2.5 µm⁻¹, 2.4 µm⁻¹, 2.2 µm⁻¹ 2.1 µm⁻¹, 2 µm⁻¹ 1.3333 µm⁻¹, 0.8 µm⁻¹, 0.6666 µm⁻¹ 0.5714 µm⁻¹, 0.5 µm⁻¹, 0.4444 µm⁻¹, 0.4 µm⁻¹, 0.3636 µm⁻¹ 0.3333 µm⁻¹, 0.3080 µm⁻¹, 0.2857 µm⁻¹ 0.2667 µm⁻¹ 0.25 µm⁻¹, 0.2353 µm⁻¹, 0.2222 µm⁻¹ 0.2105 µm⁻¹ 0.2 µm⁻¹, 0.1905 µm⁻¹, 0.1818 µm⁻¹ 0.1739 µm⁻¹ 0.1667 µm⁻¹ 0.16 µm⁻¹ 0.1538 µm⁻¹ 0.1481 µm⁻¹ 0.1429 µm⁻¹, 0.1379 µm⁻¹, 0.1333 µm⁻¹ 0.1290 µm⁻¹ 0.125 µm⁻¹ 0.1212 µm⁻¹ 0.1176 µm⁻¹ 0.1176 µm⁻¹ 0.1143 µm⁻¹, 0.1111 µm⁻¹, 0.1881 µm⁻¹, 0.1053 µm⁻¹, 0.1026 µm⁻¹, 0.1 µm⁻¹, 0.0976 µm⁻¹, 0.9524 µm⁻¹, 0.0930 µm⁻¹, 0.0909 µm⁻¹, 0.0889 µm⁻¹, 0.870 µm⁻¹ 0.0851 µm⁻¹, 0.0833 µm⁻¹ 0.0816 µm⁻¹, 0.08 µm⁻¹, 0.0784 µm⁻¹, 0.0769 µm⁻¹, 0.0755 µm⁻¹ 0.0741 µm⁻¹ 0.0727 µm⁻¹ 0.0714 µm⁻¹ 0.0702 µm⁻¹ 0.0690 µm⁻¹ 0.0678 µm⁻¹ 0.0667 µm⁻¹ 0.0656 µm⁻¹ 0.0645 µm⁻¹, 0.0635 µm⁻¹ 0.0625 µm⁻¹, 0.0615 µm⁻¹, 0.0606 µm⁻¹ 0.0597 µm⁻¹, 0.0588 µm⁻¹ 0.0580 µm⁻¹, 0.0571 µm⁻¹, 0.0563 µm⁻¹, 0.0556 µm⁻¹, 0.0548 µm⁻¹ 0.0541 µm⁻¹, 0.0533 µm⁻¹, 0.0526 µm⁻¹, 0.0519 µm⁻¹, 0.0513 µm⁻¹, 0.0506 µm⁻¹, 0.05 µm⁻¹, 0.0494 µm⁻¹ 0.0488 µm⁻¹, 0.0482 µm⁻¹, 0.0476 µm⁻¹, 0.0471 µm⁻¹, 0.0465 µm⁻¹, 0.0460 µm⁻¹, 0.0455 µm⁻¹, 0.0450 µm⁻¹, 0.0444 µm⁻¹, 0.0440 µm⁻¹, 0.0435 µm⁻¹, 0.0430 µm⁻¹, 0.0426 µm⁻¹, 0.0421 µm⁻¹, 0.0417 µm⁻¹, 0.0412 µm⁻¹, 0.0408 µm⁻¹, 0.0404 µm⁻¹, 0.04 µm⁻¹, 0.0396 µm⁻¹ 0.0392 µm⁻¹, 0.0388 µm⁻¹ 0.0385 µm⁻¹; 0.0381 µm⁻¹, 0.0377 µm⁻¹ 0.0374 µm⁻¹, 0.037 µm⁻¹ 0.0367 µm⁻¹, 0.0364 µm⁻¹, 0.0360 µm⁻¹ 0.0357 µm⁻¹, 0.0354 µm⁻¹ 0.0351 µm⁻¹, 0.0348 µm⁻¹, 0.0345 µm⁻¹ 0.0342 µm⁻¹, 0.0339 µm⁻¹ 0.0336 µm⁻¹, 0.0333 µm⁻¹, 0.0331 µm⁻¹ 0.0328 µm⁻¹, 0.0325 µm⁻¹ 0.0323 µm⁻¹, 0.032 µm⁻¹, 0.0317 µm⁻¹ 0.0315 µm⁻¹, 0.0312 µm⁻¹ 0.031 µm⁻¹, 0.0308 µm⁻¹, 0.0305 µm⁻¹ 0.0303 µm⁻¹, 0.0301 µm⁻¹ 0.03 µm⁻¹, 0.0299 µm⁻¹, 0.0296 µm⁻¹ 0.0294 µm⁻¹, 0.0292 µm⁻¹, 0.029 µm⁻¹, 0.0288 µm⁻¹, 0.0286 µm⁻¹, 0.0284 µm⁻¹, 0.0282 µm⁻¹, 0.028 µm⁻¹, 0.0278 µm⁻¹, 0.0276 µm⁻¹, 0.0274 µm⁻¹, 0.0272 µm⁻¹; 0.0270 µm⁻¹, 0.0268 µm⁻¹, 0.02667 µm⁻¹ 0.0265 µm⁻¹, 0.0263 µm⁻¹, 0.0261 µm⁻¹, 0.026 µm⁻¹, 0.0258 µm⁻¹, 0.0256 µm⁻¹ 0.0255 µm⁻¹ 0.0253 µm⁻¹ 0.0252 µm⁻¹ 0.025 µm⁻¹ 0.0248 µm⁻¹ 0.0247 µm⁻¹ 0.0245 µm⁻¹ 0.0244 µm⁻¹ 0.0242 µm⁻¹ 0.0241 µm⁻¹ 0.024 µm⁻¹ 0.0238 µm⁻¹ 0.0237 µm⁻¹ 0.0235 µm⁻¹ 0.0234 µm⁻¹ 0.0233 µm⁻¹ 0.231 µm⁻¹, 0.023 µm⁻¹, 0.0229 µm⁻¹ 0.0227 µm⁻¹, 0.0226 µm⁻¹ 0.0225 µm⁻¹, 0.0223 µm⁻¹, 0.0222 µm⁻¹ 0.0221 µm⁻¹ 0.022 µm⁻¹ 0.0219 µm⁻¹ 0.0217 µm⁻¹ 0.0216 µm⁻¹ 0.0215 µm⁻¹ 0.0214 µm⁻¹ 0.0213 µm⁻¹, 0.0212 µm⁻¹, 0.0211 µm⁻¹ 0.021 µm⁻¹, 0.0209 µm⁻¹ 0.0208 µm⁻¹, 0.0207 µm⁻¹, 0.0206 µm⁻¹ 0.0205 µm⁻¹, 0.0204 µm⁻¹, 0.0203 µm⁻¹, 0.0202 µm⁻¹, 0.0201 µm⁻¹ 0.02 µm⁻¹, or 0.002 µm⁻¹.

According to one embodiment, the particle **2** has a largest curvature of at least 200 µm⁻¹, 100 µm⁻¹, 66.6 µm⁻¹, 50 µm⁻¹ 33.3 µm⁻¹, 28.6 µm⁻¹ 25 µm⁻¹, 20 µm⁻¹ 18.2 µm⁻¹ 16.7 µm⁻¹ 15.4 µm⁻¹ 14.3 µm⁻¹ 13.3 µm⁻¹ 12.5 µm⁻¹ 11.8 µm⁻¹, 11.1 µm⁻¹ 10.5 µm⁻¹ 10 µm⁻¹ 9.5 µm⁻¹ 9.1 µm⁻¹ 8.7 µm⁻¹ 8.3 µm⁻¹ 8 µm⁻¹ 7.7 µm⁻¹ 7.4 µm⁻¹, 7.1 µm⁻¹, 6.9 µm⁻¹, 6.7 µm⁻¹, 5.7 µm⁻¹, 5 µm⁻¹, 4.4 µm⁻¹, 4 µm⁻¹, 3.6 µm⁻¹, 3.3 µm⁻¹, 3.1 µm⁻¹, 2.9 µm⁻¹ 2.7 µm⁻¹ 2.5 µm⁻¹ 2.4 µm⁻¹, 2.2 µm⁻¹ 2.1 µm⁻¹ 2 µm⁻¹ 1.3333 µm⁻¹ 0.8 µm⁻¹ 0.6666 µm⁻¹ 0.5714 µm⁻¹ 0.5 µm⁻¹, 0.4444 µm⁻¹ 0.4 µm⁻¹ 0.3636 µm⁻¹ 0.3333 µm⁻¹ 0.3080 µm⁻¹, 0.2857 µm⁻¹, 0.2667 µm⁻¹ 0.25 µm⁻¹, 0.2353 µm⁻¹, 0.2222 µm⁻¹ 0.2105 µm⁻¹, 0.2 µm⁻¹ 0.1905 µm⁻¹, 0.1818 µm⁻¹, 0.1739 µm⁻¹, 0.1667 µm⁻¹, 0.16 µm⁻¹, 0.1538 µm⁻¹, 0.1481 µm⁻¹, 0.1429 µm⁻¹, 0.1379 µm⁻¹, 0.1333 µm⁻¹, 0.1290 µm⁻¹, 0.125 µm⁻¹, 0.1212 µm⁻¹, 0.1176 µm⁻¹, 0.1176 µm⁻¹, 0.1143 µm⁻¹, 0.1111 µm⁻¹, 0.1881 µm⁻¹, 0.1053 µm⁻¹, 0.1026 µm⁻¹, 0.1 µm⁻¹, 0.0976 µm⁻¹, 0.9524 µm⁻¹ 0.0930 µm⁻¹, 0.0909 µm⁻¹, 0.0889 µm⁻¹, 0.870 µm⁻¹, 0.0851 µm⁻¹ 0.0833 µm⁻¹, 0.0816 µm⁻¹, 0.08 µm⁻¹ 0.0784 µm⁻¹, 0.0769 µm⁻¹, 0.0755 µm⁻¹, 0.0741 µm⁻¹, 0.0727 µm⁻¹, 0.0714 µm⁻¹, 0.0702 µm⁻¹, 0.0690 µm⁻¹, 0.0678 µm⁻¹, 0.0667 µm⁻¹, 0.0656 µm⁻¹, 0.0645 µm⁻¹, 0.0635 µm⁻¹, 0.0625 µm⁻¹, 0.0615 µm⁻¹, 0.0606 µm⁻¹, 0.0597 µm⁻¹, 0.0588 µm⁻¹, 0.0580 µm⁻¹, 0.0571 µm⁻¹, 0.0563 µm⁻¹, 0.0556 µm⁻¹, 0.0548 µm⁻¹, 0.0541 µm⁻¹, 0.0533 µm⁻¹, 0.0526 µm⁻¹, 0.0519 µm⁻¹, 0.0513 µm⁻¹, 0.0506 µm⁻¹, 0.05 µm⁻¹, 0.0494 µm⁻¹, 0.0488 µm⁻¹, 0.0482 µm⁻¹, 0.0476 µm⁻¹, 0.0471 µm⁻¹, 0.0465 µm⁻¹, 0.0460 µm⁻¹, 0.0455 µm⁻¹, 0.0450 µm⁻¹, 0.0444 µm⁻¹, 0.0440 µm⁻¹, 0.0435 µm⁻¹, 0.0430 µm⁻¹, 0.0426 µm⁻¹, 0.0421 µm⁻¹, 0.0417 µm⁻¹, 0.0412 µm⁻¹, 0.0408 µm⁻¹, 0.0404 µm⁻¹, 0.04 µm⁻¹, 0.0396 µm⁻¹, 0.0392 µm⁻¹, 0.0388 µm⁻¹, 0.0385 µm⁻¹; 0.0381 µm⁻¹, 0.0377 µm⁻¹, 0.0374 µm⁻¹, 0.037 µm⁻¹, 0.0367 µm⁻¹, 0.0364 µm⁻¹, 0.0360 µm⁻¹, 0.0357 µm⁻¹, 0.0354 µm⁻¹, 0.0351 µm⁻¹, 0.0348 µm⁻¹, 0.0345 µm⁻¹, 0.0342 µm⁻¹, 0.0339 µm⁻¹, 0.0336 µm⁻¹, 0.0333 µm⁻¹, 0.0331 µm⁻¹, 0.0328 µm⁻¹, 0.0325 µm⁻¹, 0.0323 µm⁻¹, 0.032 µm⁻¹, 0.0317 µm⁻¹, 0.0315 µm⁻¹, 0.0312 µm⁻¹, 0.031 µm⁻¹, 0.0308 µm⁻¹, 0.0305 µm⁻¹, 0.0303 µm⁻¹, 0.0301 µm⁻¹, 0.03 µm⁻¹, 0.0299 µm⁻¹, 0.0296 µm⁻¹, 0.0294 µm⁻¹, 0.0292 µm⁻¹, 0.029 µm⁻¹, 0.0288 µm⁻¹, 0.0286 µm⁻¹, 0.0284 µm⁻¹, 0.0282 µm⁻¹, 0.028 µm⁻¹, 0.0278 µm⁻¹, 0.0276 µm⁻¹, 0.0274 µm⁻¹, 0.0272 µm⁻¹; 0.0270 µm⁻¹, 0.0268 µm⁻¹, 0.02667 µm⁻¹, 0.0265 µm⁻¹, 0.0263 µm⁻¹, 0.0261 µm⁻¹, 0.026 µm⁻¹, 0.0258 µm⁻¹, 0.0256 µm⁻¹, 0.0255 µm⁻¹, 0.0253 µm⁻¹, 0.0252 µm⁻¹, 0.025 µm⁻¹, 0.0248 µm⁻¹, 0.0247 µm⁻¹, 0.0245 µm⁻¹, 0.0244 µm⁻¹, 0.0242 µm⁻¹, 0.0241 µm⁻¹, 0.024 µm⁻¹, 0.0238 µm⁻¹, 0.0237 µm⁻¹, 0.0235 µm⁻¹, 0.0234 µm⁻¹, 0.0233 µm⁻¹, 0.231 µm⁻¹, 0.023 µm⁻¹, 0.0229 µm⁻¹, 0.0227 µm⁻¹, 0.0226 µm⁻¹, 0.0225 µm⁻¹, 0.0223 µm⁻¹, 0.0222 µm⁻¹, 0.0221 µm⁻¹, 0.022 µm⁻¹, 0.0219 µm⁻¹, 0.0217 µm⁻¹, 0.0216 µm⁻¹, 0.0215 µm⁻¹, 0.0214 µm⁻¹, 0.0213 µm⁻¹, 0.0212 µm⁻¹, 0.0211 µm⁻¹, 0.021 µm⁻¹, 0.0209 µm⁻¹, 0.0208 µm⁻¹, 0.0207 µm⁻¹, 0.0206 µm⁻¹, 0.0205 µm⁻¹, 0.0204 µm⁻¹, 0.0203 µm⁻¹, 0.0202 µm⁻¹, 0.0201 µm⁻¹, 0.02 µm⁻¹, or 0.002 µm⁻¹.

According to one embodiment, the surface roughness of the particle 2 is less or equal to 0%, 0.0001%, 0.0002%, 0.0003%, 0.0004%, 0.0005%, 0.0006%, 0.0007%, 0.0008%, 0.0009%, 0.001%, 0.002%, 0.003%, 0.004%, 0.005%, 0.006%, 0.007%, 0.008%, 0.009%, 0.01%, 0.02%, 0.03%, 0.04%, 0.05%, 0.06%, 0.07%, 0.08%, 0.09%, 0.1%, 0.11%, 0.12%, 0.13%, 0.14%, 0.15%, 0.16%, 0.17%, 0.18%, 0.19%, 0.2%, 0.21%, 0.22%, 0.23%, 0.24%, 0.25%, 0.26%, 0.27%, 0.28%, 0.29%, 0.3%, 0.31%, 0.32%, 0.33%, 0.34%, 0.35%, 0.36%, 0.37%, 0.38%, 0.39%, 0.4%, 0.41%, 0.42%, 0.43%, 0.44%, 0.45%, 0.46%, 0.47%, 0.48%, 0.49%, 0.5%, 1%, 1.5%, 2%, 2.5% 3%, 3.5%, 4%, 4.5%, or 5% of the largest dimension of said particle **2,** meaning that the surface of said particle **2** is completely smooth.

According to one embodiment, the surface roughness of the particle **2** is less or equal to 0.5% of the largest dimension of said particle **2,** meaning that the surface of said particle **2** is completely smooth.

According to one embodiment, the particle **2** has a spherical shape, an ovoid shape, a discoidal shape, a cylindrical shape, a faceted shape, a hexagonal shape, a triangular shape, a cubic shape, or a platelet shape.

According to one embodiment, the particle **2** has a raspberry shape, a prism shape, a polyhedron shape, a snowflake shape, a flower shape, a thorn shape, a hemisphere shape, a cone shape, a urchin shape, a filamentous shape, a biconcave discoid shape, a worm shape, a tree shape, a dendrite shape, a necklace shape, a chain shape, or a bush shape.

According to one embodiment, the particle **2** has a spherical shape, or the particle **2** is a bead.

According to one embodiment, the particle **2** is hollow, *i.e.,* the particle **2** is a hollow bead.

According to one embodiment, the particle **2** does not have a core/shell structure.

According to one embodiment, the particle **2** has a core/shell structure as described hereafter.

According to one embodiment, the particle **2** is not a fiber.

According to one embodiment, the particle **2** is not a matrix with undefined shape.

According to one embodiment, the particle **2** is not macroscopical piece of glass. In this embodiment, a piece of glass refers to glass obtained from a bigger glass entity for example by cutting it, or to glass obtained by using a mold. In one embodiment, a piece of glass has at least one dimension exceeding 1 mm.

According to one embodiment, the particle **2** is not obtained by reducing the size of the second material **21.** For example, particle **2** is not obtained by milling a piece of second material **21,** nor by cutting it, nor by firing it with projectiles like particles, atomes or electrons, or by any other method.

According to one embodiment, the particle **2** is not obtained by milling bigger particles or by spraying a powder.

According to one embodiment, the particle **2** is not a piece of nanometer pore glass doped with nanoparticles **3.**

According to one embodiment, the particle **2** is not a glass monolith.

According to one embodiment, the spherical particle **2** has a diameter of at least 5 nm, 10 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm

According to one embodiment, a statistical set of spherical particles **2** has an average diameter of at least 5 nm, 10 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the average diameter of a statistical set of spherical particles **2** may have a deviation less or equal to 0.01%, 0.02%, 0.03%, 0.04%, 0.05%, 0.06%, 0.07%, 0.08%, 0.09%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 1.6%, 1.7%, 1.8%, 1.9%, 2%, 2.1%, 2.2%, 2.3%, 2.4%, 2.5%, 2.6%, 2.7%, 2.8%, 2.9%, 3%, 3.1%, 3.2%, 3.3%, 3.4%, 3.5%, 3.6%, 3.7%, 3.8%, 3.9%, 4%, 4.1%, 4.2%, 4.3%, 4.4%, 4.5%, 4.6%, 4.7%, 4.8%, 4.9%, 5%, 5.1%, 5.2%, 5.3%, 5.4%, 5.5%, 5.6%, 5.7%, 5.8%, 5.9%, 6%, 6.1%, 6.2%, 6.3%, 6.4%, 6.5%, 6.6%, 6.7%, 6.8%, 6.9%, 7%, 7.1%, 7.2%, 7.3%, 7.4%, 7.5%, 7.6%, 7.7%, 7.8%, 7.9%, 8%, 8.1%, 8.2%, 8.3%, 8.4%, 8.5%, 8.6%, 8.7%, 8.8%, 8.9%, 9%, 9.1%, 9.2%, 9.3%, 9.4%, 9.5%, 9.6%, 9.7%, 9.8%, 9.9%, 10%, 20%, 30%, 40%, 50%, 60%, 70%, 80%, 85%, 90%, 95%, 100%, 105%, 110%, 115%, 120%, 125%, 130%, 135%, 140%, 145%, 150%, 155%, 160%, 165%, 170%, 175%, 180%, 185%, 190%, 195%, or 200%.

According to one embodiment, the spherical particle **2** has a unique curvature of at least 200 µm⁻¹, 100 µm⁻¹, 66.6 µm⁻¹, 50 µm⁻¹, 33.3 µm⁻¹, 28.6 µm⁻¹, 25 µm⁻¹, 20 µm⁻¹, 18.2 µm⁻¹, 16.7 µm⁻¹, 15.4 µm⁻¹, 14.3 µm⁻¹, 13.3 µm⁻¹, 12.5 µm⁻¹, 11.8 µm⁻¹, 11.1 µm⁻¹, 10.5 µm⁻¹, 10 µm⁻¹, 9.5 µm⁻¹, 9.1 µm⁻¹, 8.7 µm⁻¹, 8.3 µm⁻¹, 8 µm⁻¹, 7.7 µm⁻¹, 7.4 µm⁻¹, 7.1 µm⁻¹, 6.9 µm⁻¹, 6.7 µm⁻¹, 5.7 µm⁻¹, 5 µm⁻¹, 4.4 µm⁻¹, 4 µm⁻¹, 3.6 µm⁻¹, 3.3 µm⁻¹, 3.1 µm⁻¹, 2.9 µm⁻¹, 2.7 µm⁻¹, 2.5 µm⁻¹, 2.4 µm⁻¹, 2.2 µm⁻¹, 2.1 µm⁻¹, 2 µm⁻¹, 1.3333 µm⁻¹, 0.8 µm⁻¹, 0.6666 µm⁻¹, 0.5714 µm⁻¹, 0.5 µm⁻¹, 0.4444 µm⁻¹, 0.4 µm⁻¹, 0.3636 µm⁻¹, 0.3333 µm⁻¹, 0.3080 µm⁻¹, 0.2857 µm⁻¹, 0.2667 µm⁻¹, 0.25 µm⁻¹, 0.2353 µm⁻¹, 0.2222 µm⁻¹, 0.2105 µm⁻¹, 0.2 µm⁻¹, 0.1905 µm⁻¹, 0.1818 µm⁻¹, 0.1739 µm⁻¹, 0.1667 µm⁻¹, 0.16 µm⁻¹, 0.1538 µm⁻¹, 0.1481 µm⁻¹, 0.1429 µm⁻¹, 0.1379 µm⁻¹, 0.1333 µm⁻¹, 0.1290 µm⁻¹, 0.125 µm⁻¹, 0.1212 µm⁻¹, 0.1176 µm⁻¹, 0.1176 µm⁻¹, 0.1143 µm⁻¹, 0.1111 µm⁻¹, 0.1881 µm⁻¹, 0.1053 µm⁻¹, 0.1026 µm⁻¹, 0.1 µm⁻¹, 0.0976 µm⁻¹, 0.9524 µm⁻¹, 0.0930 µm⁻¹, 0.0909 µm⁻¹, 0.0889 µm⁻¹, 0.870 µm⁻¹, 0.0851 µm⁻¹, 0.0833 µm⁻¹, 0.0816 µm⁻¹, 0.08 µm⁻¹, 0.0784 µm⁻¹, 0.0769 µm⁻¹, 0.0755 µm⁻¹, 0.0741 µm⁻¹, 0.0727 µm⁻¹, 0.0714 µm⁻¹, 0.0702 µm⁻¹, 0.0690 µm⁻¹, 0.0678 µm⁻¹, 0.0667 µm⁻¹, 0.0656 µm⁻¹, 0.0645 µm⁻¹, 0.0635 µm⁻¹, 0.0625 µm⁻¹, 0.0615 µm⁻¹, 0.0606 µm⁻¹, 0.0597 µm⁻¹, 0.0588 µm⁻¹, 0.0580 µm⁻¹, 0.0571 µm⁻¹, 0.0563 µm⁻¹, 0.0556 µm⁻¹, 0.0548 µm⁻¹, 0.0541 µm⁻¹, 0.0533 µm⁻¹, 0.0526 µm⁻¹, 0.0519 µm⁻¹, 0.0513 µm⁻¹, 0.0506 µm⁻¹, 0.05 µm⁻¹, 0.0494 µm⁻¹, 0.0488 µm⁻¹, 0.0482 µm⁻¹, 0.0476 µm⁻¹, 0.0471 µm⁻¹, 0.0465 µm⁻¹, 0.0460 µm⁻¹, 0.0455 µm⁻¹, 0.0450 µm⁻¹, 0.0444 µm⁻¹, 0.0440 µm⁻¹, 0.0435 µm⁻¹, 0.0430 µm⁻¹, 0.0426 µm⁻¹, 0.0421 µm⁻¹, 0.0417 µm⁻¹, 0.0412 µm⁻¹, 0.0408 µm⁻¹, 0.0404 µm⁻¹, 0.04 µm⁻¹, 0.0396 µm⁻¹, 0.0392 µm⁻¹, 0.0388 µm⁻¹, 0.0385 µm⁻¹; 0.0381 µm⁻¹, 0.0377 µm⁻¹, 0.0374 µm⁻¹, 0.037 µm⁻¹, 0.0367 µm⁻¹, 0.0364 µm⁻¹, 0.0360 µm⁻¹, 0.0357 µm⁻¹, 0.0354 µm⁻¹, 0.0351 µm⁻¹, 0.0348 µm⁻¹, 0.0345 µm⁻¹, 0.0342 µm⁻¹, 0.0339 µm⁻¹, 0.0336 µm⁻¹, 0.0333 µm⁻¹, 0.0331 µm⁻¹, 0.0328 µm⁻¹, 0.0325 µm⁻¹, 0.0323 µm⁻¹, 0.032 µm⁻¹, 0.0317 µm⁻¹, 0.0315 µm⁻¹, 0.0312 µm⁻¹, 0.031 µm⁻¹, 0.0308 µm⁻¹, 0.0305 µm⁻¹, 0.0303 µm⁻¹, 0.0301 µm⁻¹, 0.03 µm⁻¹, 0.0299 µm⁻¹, 0.0296 µm⁻¹, 0.0294 µm⁻¹, 0.0292 µm⁻¹, 0.029 µm⁻¹, 0.0288 µm⁻¹, 0.0286 µm⁻¹, 0.0284 µm⁻¹, 0.0282 µm⁻¹, 0.028 µm⁻¹, 0.0278 µm⁻¹, 0.0276 µm⁻¹, 0.0274 µm⁻¹, 0.0272 µm⁻¹; 0.0270 µm⁻¹, 0.0268 µm⁻¹, 0.02667 µm⁻¹, 0.0265 µm⁻¹, 0.0263 µm⁻¹, 0.0261 µm⁻¹, 0.026 µm⁻¹, 0.0258 µm⁻¹, 0.0256 µm⁻¹, 0.0255 µm⁻¹, 0.0253 µm⁻¹, 0.0252 µm⁻¹, 0.025 µm⁻¹, 0.0248 µm⁻¹, 0.0247 µm⁻¹, 0.0245 µm⁻¹, 0.0244 µm⁻¹, 0.0242 µm⁻¹, 0.0241 µm⁻¹, 0.024 µm⁻¹, 0.0238 µm⁻¹, 0.0237 µm⁻¹, 0.0235 µm⁻¹, 0.0234 µm⁻¹, 0.0233 µm⁻¹, 0.231 µm⁻¹, 0.023 µm⁻¹, 0.0229 µm⁻¹, 0.0227 µm⁻¹, 0.0226 µm⁻¹, 0.0225 µm⁻¹, 0.0223 µm⁻¹, 0.0222 µm⁻¹, 0.0221 µm⁻¹, 0.022 µm⁻¹, 0.0219 µm⁻¹, 0.0217 µm⁻¹, 0.0216 µm⁻¹, 0.0215 µm⁻¹, 0.0214 µm⁻¹, 0.0213 µm⁻¹, 0.0212 µm⁻¹, 0.0211 µm⁻¹, 0.021 µm⁻¹, 0.0209 µm⁻¹, 0.0208 µm⁻¹, 0.0207 µm⁻¹, 0.0206 µm⁻¹, 0.0205 µm⁻¹, 0.0204 µm⁻¹, 0.0203 µm⁻¹, 0.0202 µm⁻¹, 0.0201 µm⁻¹, 0.02 µm⁻¹, or 0.002 µm⁻¹.

According to one embodiment, a statistical set of the spherical particle 2 has an average unique curvature of at least 200 µm⁻¹, 100 µm⁻¹, 66.6 µm⁻¹, 50 µm⁻¹, 33.3 µm⁻¹, 28.6 µm⁻¹, 25 µm⁻¹, 20 µm⁻¹, 18.2 µm⁻¹, 16.7 µm⁻¹, 15.4 µm⁻¹, 14.3 µm⁻¹, 13.3 µm⁻¹, 12.5 µm⁻¹, 11.8 µm⁻¹, 11.1 µm⁻¹, 10.5 µm⁻¹, 10 µm⁻¹, 9.5 µm⁻¹, 9.1 µm⁻¹, 8.7 µm⁻¹, 8.3 µm⁻¹, 8 µm⁻¹, 7.7 µm⁻¹, 7.4 µm⁻¹, 7.1 µm⁻¹, 6.9 µm⁻¹, 6.7 µm⁻¹, 5.7 µm⁻¹, 5 µm⁻¹, 4.4 µm⁻¹, 4 µm⁻¹, 3.6 µm⁻¹, 3.3 µm⁻¹, 3.1 µm⁻¹, 2.9 µm⁻¹, 2.7 µm⁻¹, 2.5 µm⁻¹, 2.4 µm⁻¹, 2.2 µm⁻¹, 2.1 µm⁻¹, 2 µm⁻¹, 1.3333 µm⁻¹, 0.8 µm⁻¹, 0.6666 µm⁻¹, 0.5714 µm⁻¹, 0.5 µm⁻¹, 0.4444 µm⁻¹, 0.4 µm⁻¹, 0.3636 µm⁻¹, 0.3333 µm⁻¹, 0.3080 µm⁻¹, 0.2857 µm⁻¹, 0.2667 µm⁻¹, 0.25 µm⁻¹, 0.2353 µm⁻¹, 0.2222 µm⁻¹, 0.2105 µm⁻¹, 0.2 µm⁻¹, 0.1905 µm⁻¹, 0.1818 µm⁻¹, 0.1739 µm⁻¹, 0.1667 µm⁻¹, 0.16 µm⁻¹, 0.1538 µm⁻¹, 0.1481 µm⁻¹, 0.1429 µm⁻¹, 0.1379 µm⁻¹, 0.1333 µm⁻¹, 0.1290 µm⁻¹, 0.125 µm⁻¹, 0.1212 µm⁻¹, 0.1176 µm⁻¹, 0.1176 µm⁻¹, 0.1143 µm⁻¹, 0.1111 µm⁻¹, 0.1881 µm⁻¹, 0.1053 µm⁻¹, 0.1026 µm⁻¹, 0.1 µm⁻¹, 0.0976 µm⁻¹, 0.9524 µm⁻¹, 0.0930 µm⁻¹, 0.0909 µm⁻¹, 0.0889 µm⁻¹, 0.870 µm⁻¹, 0.0851 µm⁻¹, 0.0833 µm⁻¹, 0.0816 µm⁻¹, 0.08 µm⁻¹, 0.0784 µm⁻¹, 0.0769 µm⁻¹, 0.0755 µm⁻¹, 0.0741 µm⁻¹, 0.0727 µm⁻¹, 0.0714 µm⁻¹, 0.0702 µm⁻¹, 0.0690 µm⁻¹, 0.0678 µm⁻¹, 0.0667 µm⁻¹, 0.0656 µm⁻¹, 0.0645 µm⁻¹, 0.0635 µm⁻¹, 0.0625 µm⁻¹, 0.0615 µm⁻¹, 0.0606 µm⁻¹, 0.0597 µm⁻¹, 0.0588 µm⁻¹, 0.0580 µm⁻¹, 0.0571 µm⁻¹, 0.0563 µm⁻¹, 0.0556 µm⁻¹, 0.0548 µm⁻¹, 0.0541 µm⁻¹, 0.0533 µm⁻¹, 0.0526 µm⁻¹, 0.0519 µm⁻¹, 0.0513 µm⁻¹, 0.0506 µm⁻¹, 0.05 µm⁻¹, 0.0494 µm⁻¹, 0.0488 µm⁻¹, 0.0482 µm⁻¹, 0.0476 µm⁻¹, 0.0471 µm⁻¹, 0.0465 µm⁻¹, 0.0460 µm⁻¹, 0.0455 µm⁻¹, 0.0450 µm⁻¹, 0.0444 µm⁻¹, 0.0440 µm⁻¹, 0.0435 µm⁻¹, 0.0430 µm⁻¹, 0.0426 µm⁻¹, 0.0421 µm⁻¹, 0.0417 µm⁻¹, 0.0412 µm⁻¹, 0.0408 µm⁻¹, 0.0404 µm⁻¹, 0.04 µm⁻¹, 0.0396 µm⁻¹, 0.0392 µm⁻¹, 0.0388 µm⁻¹, 0.0385 µm⁻¹; 0.0381 µm⁻¹, 0.0377 µm⁻¹, 0.0374 µm⁻¹, 0.037 µm⁻¹, 0.0367 µm⁻¹, 0.0364 µm⁻¹, 0.0360 µm⁻¹, 0.0357 µm⁻¹, 0.0354 µm⁻¹, 0.0351 µm⁻¹, 0.0348 µm⁻¹, 0.0345 µm⁻¹, 0.0342 µm⁻¹, 0.0339 µm⁻¹, 0.0336 µm⁻¹, 0.0333 µm⁻¹, 0.0331 µm⁻¹, 0.0328 µm⁻¹, 0.0325 µm⁻¹, 0.0323 µm⁻¹, 0.032 µm⁻¹, 0.0317 µm⁻¹, 0.0315 µm⁻¹, 0.0312 µm⁻¹, 0.031 µm⁻¹, 0.0308 µm⁻¹, 0.0305 µm⁻¹, 0.0303 µm⁻¹, 0.0301 µm⁻¹, 0.03 µm⁻¹, 0.0299 µm⁻¹, 0.0296 µm⁻¹, 0.0294 µm⁻¹, 0.0292 µm⁻¹, 0.029 µm⁻¹, 0.0288 µm⁻¹, 0.0286 µm⁻¹, 0.0284 µm⁻¹, 0.0282 µm⁻¹, 0.028 µm⁻¹, 0.0278 µm⁻¹, 0.0276 µm⁻¹, 0.0274 µm⁻¹, 0.0272 µm⁻¹; 0.0270 µm⁻¹, 0.0268 µm⁻¹, 0.02667 µm⁻¹, 0.0265 µm⁻¹, 0.0263 µm⁻¹, 0.0261 µm⁻¹, 0.026 µm⁻¹, 0.0258 µm⁻¹, 0.0256 µm⁻¹, 0.0255 µm⁻¹, 0.0253 µm⁻¹, 0.0252 µm⁻¹, 0.025 µm⁻¹, 0.0248 µm⁻¹, 0.0247 µm⁻¹, 0.0245 µm⁻¹, 0.0244 µm⁻¹, 0.0242 µm⁻¹, 0.0241 µm⁻¹, 0.024 µm⁻¹, 0.0238 µm⁻¹, 0.0237 µm⁻¹, 0.0235 µm⁻¹, 0.0234 µm⁻¹, 0.0233 µm⁻¹, 0.231 µm⁻¹, 0.023 µm⁻¹, 0.0229 µm⁻¹, 0.0227 µm⁻¹, 0.0226 µm⁻¹, 0.0225 µm⁻¹, 0.0223 µm⁻¹, 0.0222 µm⁻¹, 0.0221 µm⁻¹, 0.022 µm⁻¹, 0.0219 µm⁻¹, 0.0217 µm⁻¹, 0.0216 µm⁻¹, 0.0215 µm⁻¹, 0.0214 µm⁻¹, 0.0213 µm⁻¹, 0.0212 µm⁻¹, 0.0211 µm⁻¹, 0.021 µm⁻¹, 0.0209 µm⁻¹, 0.0208 µm⁻¹, 0.0207 µm⁻¹, 0.0206 µm⁻¹, 0.0205 µm⁻¹, 0.0204 µm⁻¹, 0.0203 µm⁻¹, 0.0202 µm⁻¹, 0.0201 µm⁻¹, 0.02 µm⁻¹, or 0.002 µm⁻¹.

According to one embodiment, the curvature of the spherical particle **2** has no deviation, meaning that said particle **2** has a perfect spherical shape. A perfect spherical shape prevents fluctuations of the intensity of the scattered light.

According to one embodiment, the unique curvature of the spherical particle **2** may have a deviation less or equal to 0.01%, 0.02%, 0.03%, 0.04%, 0.05%, 0.06%, 0.07%, 0.08%, 0.09%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 1.6%, 1.7%, 1.8%, 1.9%, 2%, 2.1%, 2.2%, 2.3%, 2.4%, 2.5%, 2.6%, 2.7%, 2.8%, 2.9%, 3%, 3.1%, 3.2%, 3.3%, 3.4%, 3.5%, 3.6%, 3.7%, 3.8%, 3.9%, 4%, 4.1%, 4.2%, 4.3%, 4.4%, 4.5%, 4.6%, 4.7%, 4.8%, 4.9%, 5%, 5.1%, 5.2%, 5.3%, 5.4%, 5.5%, 5.6%, 5.7%, 5.8%, 5.9%, 6%, 6.1%, 6.2%, 6.3%, 6.4%, 6.5%, 6.6%, 6.7%, 6.8%, 6.9%, 7%, 7.1%, 7.2%, 7.3%, 7.4%, 7.5%, 7.6%, 7.7%, 7.8%, 7.9%, 8%, 8.1%, 8.2%, 8.3%, 8.4%, 8.5%, 8.6%, 8.7%, 8.8%, 8.9%, 9%, 9.1%, 9.2%, 9.3%, 9.4%, 9.5%, 9.6%, 9.7%, 9.8%, 9.9%, or 10% along the surface of said particle **2.**

According to one embodiment, in a statistical set of particles **2,** said particles **2** are polydisperse.

According to one embodiment, in a statistical set of particles **2,** said particles **2** are monodisperse.

According to one embodiment, particles **2** in a same particle **1** are polydisperse.

According to one embodiment, particles **2** in a same particle **1** are monodisperse.

According to one embodiment, in a statistical set of particles **2,** said particles **2** have a narrow size distribution.

According to one embodiment, the particle **2** represents at least 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, 91%, 92%, 93%, 94%, 95%, 96%, 97%, 98%, or 99% by weight of the particle **1.**

According to one embodiment, the loading charge of the particle 2 in the particle 1 is at least 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, 91%, 92%, 93%, 94%, 95%, 96%, 97%, 98%, or 99%.

According to one embodiment, the loading charge of the particle **2** in the particle **1** is less than 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, 91%, 92%, 93%, 94%, 95%, 96%, 97%, 98%, or 99%.

According to one embodiment, the particles **2** are not encapsulated in particle **1** via physical entrapment or electrostatic attraction.

According to one embodiment, the particles **2** and the first material **11** are not bonded or linked by electrostatic attraction or a functionalized silane based coupling agent.

According to one embodiment, the particle **2** comprised in the particle **1** have a packing fraction of at least 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, or 95%.

According to one embodiment, the particles **2** comprised in the same particle **1** are not aggregated.

According to one embodiment, the particles **2** comprised in the same particle **1** do not touch, are not in contact.

According to one embodiment, the particles **2** comprised in the same particle **1** are separated by first material **11.**

According to one embodiment, the particles **2** comprised in the same particle **1** are aggregated.

According to one embodiment, the particles **2** comprised in the same particle **1** touch, are in contact.

According to one embodiment, the particle **2** comprised in the same particle **1** can be individually evidenced.

According to one embodiment, the particle **2** comprised in the same particle **1** can be individually evidenced by transmission electron microscopy or fluorescence scanning microscopy, or any other characterization means known by the person skilled in the art.

According to one embodiment, the plurality of particles **2** is uniformly dispersed in the first material **11.**

The uniform dispersion of the plurality of particles **2** in the first material **11** comprised in the particle **1** prevents the aggregation of said particles **2,** thereby preventing the degradation of their properties. For example, in the case of inorganic fluorescent particles, a uniform dispersion will allow the optical properties of said particles to be preserved, and quenching can be avoided.

According to one embodiment, the particles **2** comprised in a particle **1** are uniformly dispersed within the first material **11** comprised in said particle **1.**

According to one embodiment, the particles **2** comprised in a particle **1** are dispersed within the first material **11** comprised in said particle **1.**

According to one embodiment, the particles **2** comprised in a particle **1** are uniformly and evenly dispersed within the first material **11** comprised in said particle **1.**

According to one embodiment, the particles **2** comprised in a particle **1** are evenly dispersed within the first material **11** comprised in said particle **1.**

According to one embodiment, the particles **2** comprised in a particle **1** are homogeneously dispersed within the first material **11** comprised in said particle **1.**

According to one embodiment, the dispersion of particles **2** in the first material **11** does not have the shape of a ring, or a monolayer.

According to one embodiment, each particle **2** of the plurality of particles **2** is spaced from its adjacent particle **2** by an average minimal distance.

According to one embodiment, the average minimal distance between two particles **2** is controlled.

According to one embodiment, the average minimal distance is at least 1 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 300 µm, 400 µm, 500 µm, 600 µm, 700 µm, 800 µm, 900 µm, or 1 mm.

According to one embodiment, the average distance between two particles **2** in the same particle **1** is at least 1 nm, 1.5 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 300 µm, 400 µm, 500 µm, 600 µm, 700 µm, 800 µm, 900 µm, or 1 mm.

According to one embodiment, the average distance between two particles 2 in the same particle 1 may have a deviation less or equal to 0.01%, 0.02%, 0.03%, 0.04%, 0.05%, 0.06%, 0.07%, 0.08%, 0.09%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 1.6%, 1.7%, 1.8%, 1.9%, 2%, 2.1%, 2.2%, 2.3%, 2.4%, 2.5%, 2.6%, 2.7%, 2.8%, 2.9%, 3%, 3.1%, 3.2%, 3.3%, 3.4%, 3.5%, 3.6%, 3.7%, 3.8%, 3.9%, 4%, 4.1%, 4.2%, 4.3%, 4.4%, 4.5%, 4.6%, 4.7%, 4.8%, 4.9%, 5%, 5.1%, 5.2%, 5.3%, 5.4%, 5.5%, 5.6%, 5.7%, 5.8%, 5.9%, 6%, 6.1%, 6.2%, 6.3%, 6.4%, 6.5%, 6.6%, 6.7%, 6.8%, 6.9%, 7%, 7.1%, 7.2%, 7.3%, 7.4%, 7.5%, 7.6%, 7.7%, 7.8%, 7.9%, 8%, 8.1%, 8.2%, 8.3%, 8.4%, 8.5%, 8.6%, 8.7%, 8.8%, 8.9%, 9%, 9.1%, 9.2%, 9.3%, 9.4%, 9.5%, 9.6%, 9.7%, 9.8%, 9.9%, 10%, 15%, 20%, 25%, 30%, 35%, 40%, 45%, or 50%.

According to one embodiment, the particle **2** is hydrophobic.

According to one embodiment, the particle **2** is hydrophilic.

According to one embodiment, the particle **2** is ROHS compliant.

According to one embodiment, the particle **2** comprises less than 10 ppm, less than 20 ppm, less than 30 ppm, less than 40 ppm, less than 50 ppm, less than 100 ppm, less than 150 ppm, less than 200 ppm, less than 250 ppm, less than 300 ppm, less than 350 ppm, less than 400 ppm, less than 450 ppm, less than 500 ppm, less than 550 ppm, less than 600 ppm, less than 650 ppm, less than 700 ppm, less than 750 ppm, less than 800 ppm, less than 850 ppm, less than 900 ppm, less than 950 ppm, less than 1000 ppm in weight of cadmium.

According to one embodiment, the particle **2** comprises less than 10 ppm, less than 20 ppm, less than 30 ppm, less than 40 ppm, less than 50 ppm, less than 100 ppm, less than 150 ppm, less than 200 ppm, less than 250 ppm, less than 300 ppm, less than 350 ppm, less than 400 ppm, less than 450 ppm, less than 500 ppm, less than 550 ppm, less than 600 ppm, less than 650 ppm, less than 700 ppm, less than 750 ppm, less than 800 ppm, less than 850 ppm, less than 900 ppm, less than 950 ppm, less than 1000 ppm, less than 2000 ppm, less than 3000 ppm, less than 4000 ppm, less than 5000 ppm, less than 6000 ppm, less than 7000 ppm, less than 8000 ppm, less than 9000 ppm, less than 10000 ppm in weight of lead.

According to one embodiment, the particle **2** comprises less than 10 ppm, less than 20 ppm, less than 30 ppm, less than 40 ppm, less than 50 ppm, less than 100 ppm, less than 150 ppm, less than 200 ppm, less than 250 ppm, less than 300 ppm, less than 350 ppm, less than 400 ppm, less than 450 ppm, less than 500 ppm, less than 550 ppm, less than 600 ppm, less than 650 ppm, less than 700 ppm, less than 750 ppm, less than 800 ppm, less than 850 ppm, less than 900 ppm, less than 950 ppm, less than 1000 ppm, less than 2000 ppm, less than 3000 ppm, less than 4000 ppm, less than 5000 ppm, less than 6000 ppm, less than 7000 ppm, less than 8000 ppm, less than 9000 ppm, less than 10000 ppm in weight of mercury.

According to one embodiment, the particle **2** comprises heavier chemical elements than the main chemical element present in the second material **(21).** In this embodiment, said heavy chemical elements in the particle **2** will lower the mass concentration of chemical elements subject to ROHS standards, allowing said particle **2** to be ROHS compliant.

According to one embodiment, examples of heavy chemical elements include but are not limited to B, C, N, F, Na, Mg, Al, Si, P, S, Cl, K, Ca, Sc, Ti, V, Cr, Mn, Fe, Co, Ni, Cu, Zn, Ga, Ge, As, Se, Br, Rb, Sr, Y, Zr, Nb, Mo, Tc, Ru, Rh, Pd, Ag, Cd, In, Sn, Sb, Te, I, Cs, Ba, La, Hf, Ta, W, Re, Os, Ir, Pt, Au, Hg, Tl, Pb, Bi, Po, At, Ce, Pr, Nd, Pm, Sm, Eu, Gd, Tb, Dy, Ho, Er, Tm, Yb, Lu or a mixture of thereof.

According to one embodiment, each nanoparticle **3** is totally surrounded by or encapsulated in the second material **21.**

According to one embodiment, each nanoparticle **3** is partially surrounded by or encapsulated in the second material **21.**

According to one embodiment, the particle **2** comprises at least 95%, 90%, 85%, 80%, 75%, 70%, 65%, 60%, 55%, 50%, 45%, 40%, 35%, 30%, 25%, 20%, 15%, 10%, 5%, 1% or 0% of nanoparticles **3** on its surface.

According to one embodiment, the particle **2** does not comprise nanoparticles **3** on its surface. In this embodiment, said nanoparticles **3** are completely surrounded by the second material **21.**

According to one embodiment, at least 100%, 95%, 90%, 85%, 80%, 75%, 70%, 65%, 60%, 55%, 50%, 45%, 40%, 35%, 30%, 25%, 20%, 15%, 10%, 5%, or 1% of nanoparticles **3** are comprised in the second material **21.** In this embodiment, each of said nanoparticles **3** is completely surrounded by the second material **21.**

According to one embodiment, the particle **2** has an oxygen transmission rate ranging from 10⁻⁷ to 10 cm³.m⁻².day⁻¹, preferably from 10⁻⁷ to 1 cm³.m⁻².day⁻¹, more preferably from 10⁻⁷ to 10⁻¹ cm³.m⁻².day⁻¹, even more preferably from 10⁻⁷ to 10⁻⁴ cm³.m⁻².day⁻¹ at room temperature.

According to one embodiment, the particle **2** has a water vapor transmission rate ranging from 10⁻⁷ to 10 g.m⁻².day⁻¹, preferably from 10⁻⁷ to 1 g.m⁻².day⁻¹, more preferably from 10⁻⁷ to 10⁻¹ g.m⁻².day⁻¹, even more preferably from 10⁻⁷ to 10⁻⁴ g.m⁻².day⁻¹ at room temperature. A water vapor transmission rate of 10⁻⁶ g.m⁻².day⁻¹ is particularly adequate for a use on LED.

According to one embodiment, the particle **2** is a homostructure. In this embodiment, the particle **2** does not comprise a shell or a layer of a material surrounding (partially or totally) said particle **2.**

According to one embodiment, the particle **2** is not a core/shell structure wherein the core does not comprise nanoparticles **3** and the shell comprises nanoparticles **3.**

According to one embodiment, the particle **2** does not comprise an organic shell or an organic layer. In this embodiment, the particle **2** is not covered by any organic ligand or polymer shell.

According to one embodiment, the particle **2** does not comprise organic molecules or polymer chains.

According to one embodiment, the particle **2** is coated by an organic layer comprising organic molecules or polymer chains.

According to one embodiment, the particle **2** is coated by an organic layer comprising polymerizable groups. In this embodiment, polymerizable groups are capable of undergoing a polymerization reaction. Polymerizable groups are as described hereabove.

According to one embodiment, examples of polymerizable groups include but are not limited to: vinyl monomers, acrylate monomers, methacrylate monomers, ethylacrylate monomers, acrylamide monomers, methacrylamide monomers, ethyl acrylamide monomers, ethylene glycol monomers, epoxide monomers, glycidyl monomers, olefin monomers, norbornyl monomers, isocyanide monomers, and any of the above mention in di/tri functional group format, or a mixture thereof.

According to one embodiment illustrated in Fig. 6B, the particle **2** is a heterostructure, comprising a core **22** and at least one shell **23.**

According to one embodiment, the at least one shell **23** is not an organic shell. In this embodiment, the particle **2** is not covered by any organic ligand or by a polymeric shell.

According to one embodiment, the at least one shell **23** does not comprise an organic layer.

According to one embodiment, the shell **23** of the core/shell particle **2** comprises an inorganic material. In this embodiment, said inorganic material is the same or different than the second material **21** comprised in the core **22** of the core/shell particle **2.**

According to one embodiment, the shell **23** of the core/shell particle **2** consists of an inorganic material. In this embodiment, said inorganic material is the same or different than the second material **21** comprised in the core **22** of the core/shell particle **2.**

According to one embodiment, the core **22** of the core/shell particle **2** comprises at least one nanoparticle **3** as described herein and the shell **23** of the core/shell particle **2** does not comprise nanoparticles **3.**

According to one embodiment, the core **22** of the core/shell particle **2** comprises at least one nanoparticle **3** as described herein and the shell **23** of the core/shell particle **2** comprises at least one nanoparticle **3.**

According to one embodiment, the at least one nanoparticle **3** comprised in the core **22** of the core/shell particle **2** is identical to the at least one nanoparticle **3** comprised in the shell **23** of the core/shell particle **2.**

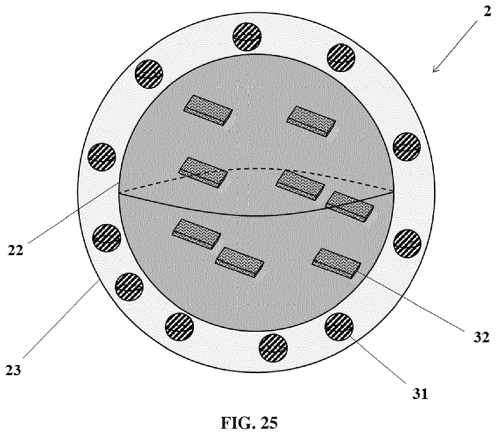

According to one embodiment illustrated in Fig. 25, the at least one nanoparticle **3** comprised in the core **22** of the core/shell particle **2** is different to the at least one nanoparticle **3** comprised in the shell **23** of the core/shell particle **2.** In this embodiment, the resulting core/shell particle **2** will exhibit different properties.

According to one embodiment, the core **22** of the core/shell particle **2** comprises at least one luminescent nanoparticle and the shell **23** of the core/shell particle **2** comprises at least one nanoparticle **3** selected in the group of magnetic nanoparticle, plasmonic nanoparticle, dielectric nanoparticle, piezoelectric nanoparticle, pyro-electric nanoparticle, ferro-electric nanoparticle, light scattering nanoparticle, electrically insulating nanoparticle, thermally insulating nanoparticle, or catalytic nanoparticle.

According to one embodiment, the shell **23** of the core/shell particle **2** comprises at least one luminescent nanoparticle and the core **22** of the core/shell particle **2** comprises at least one nanoparticle **3** selected in the group of magnetic nanoparticle, plasmonic nanoparticle, dielectric nanoparticle, piezoelectric nanoparticle, pyro-electric nanoparticle, ferro-electric nanoparticle, light scattering nanoparticle, electrically insulating nanoparticle, thermally insulating nanoparticle, or catalytic nanoparticle.

In a preferred embodiment, the core **22** of the core/shell particle **2** and the shell **23** of the core/shell particle **2** comprise at least two different luminescent nanoparticles, wherein said luminescent nanoparticles emit at different emission wavelengths. This means that the core **22** comprises at least one luminescent nanoparticle and the shell **23** comprises at least one luminescent nanoparticle, said luminescent nanoparticles having different emission wavelengths.

In a preferred embodiment, the core **22** of the core/shell particle **2** and the shell **23** of the core/shell particle **2** comprise at least two different luminescent nanoparticles, wherein at least one luminescent nanoparticle emits at a wavelength in the range from 500 to 560 nm, and at least one luminescent nanoparticle emits at a wavelength in the range from 600 to 2500 nm. In this embodiment, the core **22** of the core/shell particle **2** and the shell **23** of the core/shell particle **2** comprise at least one luminescent nanoparticle emitting in the green region of the visible spectrum and at least one luminescent nanoparticle emitting in the red region of the visible spectrum, thus the particle **2** paired with a blue LED will be a white light emitter.

In a preferred embodiment, the core **22** of the core/shell particle **2** and the shell **23** of the core/shell particle **2** comprise at least two different luminescent nanoparticles, wherein at least one luminescent nanoparticle emits at a wavelength in the range from 400 to 490 nm, and at least one luminescent nanoparticle emits at a wavelength in the range from 600 to 2500 nm. In this embodiment, the core **22** of the core/shell particle **2** and the shell **23** of the core/shell particle **2** comprise at least one luminescent nanoparticle emitting in the blue region of the visible spectrum and at least one luminescent nanoparticle emitting in the red region of the visible spectrum, thus the particle **2** will be a white light emitter.

In a preferred embodiment, the core **22** of the core/shell particle **2** and the shell **23** of the core/shell particle **2** comprise comprises at least two different luminescent nanoparticles, wherein at least one luminescent nanoparticle emits at a wavelength in the range from 400 to 490 nm, and at least one luminescent nanoparticle emits at a wavelength in the range from 500 to 560 nm. In this embodiment, the core **22** of the core/shell particle **2** and the shell **23** of the core/shell particle **2** comprise at least one luminescent nanoparticle emitting in the blue region of the visible spectrum and at least one luminescent nanoparticle emitting in the green region of the visible spectrum.

According to one embodiment, the core **22** of the core/shell particle **2** comprises at least one magnetic nanoparticle and the shell **23** of the core/shell particle **2** comprises at least one nanoparticle **3** selected in the group of luminescent nanoparticle, plasmonic nanoparticle, dielectric nanoparticle, piezoelectric nanoparticle, pyro-electric nanoparticle, ferro-electric nanoparticle, light scattering nanoparticle, electrically insulating nanoparticle, thermally insulating nanoparticle, or catalytic nanoparticle.

According to one embodiment, the core **22** of the core/shell particle **2** comprises at least one plasmonic nanoparticle and the shell **23** of the core/shell particle **2** comprises at least one nanoparticle **3** selected in the group of luminescent nanoparticle, magnetic nanoparticle, dielectric nanoparticle, piezoelectric nanoparticle, pyro-electric nanoparticle, ferro-electric nanoparticle, light scattering nanoparticle, electrically insulating nanoparticle, thermally insulating nanoparticle, or catalytic nanoparticle.

According to one embodiment, the core **22** of the core/shell particle **2** comprises at least one dielectric nanoparticle and the shell **23** of the core/shell particle **2** comprises at least one nanoparticle **3** selected in the group of luminescent nanoparticle, magnetic nanoparticle, plasmonic nanoparticle, piezoelectric nanoparticle, pyro-electric nanoparticle, ferro-electric nanoparticle, light scattering nanoparticle, electrically insulating nanoparticle, thermally insulating nanoparticle, or catalytic nanoparticle.

According to one embodiment, the core **22** of the core/shell particle **2** comprises at least one piezoelectric nanoparticle and the shell **23** of the core/shell particle **2** comprises at least one nanoparticle **3** selected in the group of luminescent nanoparticle, magnetic nanoparticle, dielectric nanoparticle, plasmonic nanoparticle, pyro-electric nanoparticle, ferro-electric nanoparticle, light scattering nanoparticle, electrically insulating nanoparticle, thermally insulating nanoparticle, or catalytic nanoparticle.

According to one embodiment, the core **22** of the core/shell particle **2** comprises at least one pyro-electric nanoparticle and the shell **23** of the core/shell particle **2** comprises at least one nanoparticle **3** selected in the group of luminescent nanoparticle, magnetic nanoparticle, dielectric nanoparticle, plasmonic nanoparticle, piezoelectric nanoparticle, ferro-electric nanoparticle, light scattering nanoparticle, electrically insulating nanoparticle, thermally insulating nanoparticle, or catalytic nanoparticle.

According to one embodiment, the core **22** of the core/shell particle **2** comprises at least one ferro-electric nanoparticle and the shell **23** of the core/shell particle **2** comprises at least one nanoparticle **3** selected in the group of luminescent nanoparticle, magnetic nanoparticle, dielectric nanoparticle, plasmonic nanoparticle, piezoelectric nanoparticle, pyro-electric nanoparticle, light scattering nanoparticle, electrically insulating nanoparticle, thermally insulating nanoparticle, or catalytic nanoparticle.

According to one embodiment, the core **22** of the core/shell particle **2** comprises at least one light scattering nanoparticle and the shell **23** of the core/shell particle **2** comprises at least one nanoparticle **3** selected in the group of luminescent nanoparticle, magnetic nanoparticle, dielectric nanoparticle, plasmonic nanoparticle, piezoelectric nanoparticle, pyro-electric nanoparticle, ferro-electric nanoparticle, electrically insulating nanoparticle, thermally insulating nanoparticle, or catalytic nanoparticle.

According to one embodiment, the core **22** of the core/shell particle **2** comprises at least one electrically insulating nanoparticle and the shell **23** of the core/shell particle **2** comprises at least one nanoparticle **3** selected in the group of luminescent nanoparticle, magnetic nanoparticle, dielectric nanoparticle, plasmonic nanoparticle, piezoelectric nanoparticle, pyro-electric nanoparticle, ferro-electric nanoparticle, light scattering nanoparticle, thermally insulating nanoparticle, or catalytic nanoparticle.

According to one embodiment, the core **22** of the core/shell particle **2** comprises at least one thermally insulating nanoparticle and the shell **23** of the core/shell particle **2** comprises at least one nanoparticle **3** selected in the group of luminescent nanoparticle, magnetic nanoparticle, dielectric nanoparticle, plasmonic nanoparticle, piezoelectric nanoparticle, pyro-electric nanoparticle, ferro-electric nanoparticle, light scattering nanoparticle, electrically insulating nanoparticle, or catalytic nanoparticle.

According to one embodiment, the core **22** of the core/shell particle **2** comprises at least one catalytic nanoparticle and the shell **23** of the core/shell particle **2** comprises at least one nanoparticle **3** selected in the group of luminescent nanoparticle, magnetic nanoparticle, dielectric nanoparticle, plasmonic nanoparticle, piezoelectric nanoparticle, pyro-electric nanoparticle, ferro-electric nanoparticle, light scattering nanoparticle, electrically insulating nanoparticle, or thermally insulating nanoparticle.

According to one embodiment, the shell **23** of the particle **2** has a thickness of at least 0.1 nm, 0.2 nm, 0.3 nm, 0.4 nm, 0.5 nm, 1 nm, 1.5 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm

According to one embodiment, the shell **23** of the particle **2** has a thickness homogeneous all along the core **22,** *i.e.,* the shell **23** of the particle **2** has a same thickness all along the core **22.**

According to one embodiment, the shell **23** of the particle **2** has a thickness heterogeneous along the core **22,** *i.e.,* said thickness varies along the core **22.**

According to one embodiment, the particle **2** is not a core/shell particle wherein the core is an aggregate of metallic particles and the shell comprises the second material **21.**

According to one embodiment, the particle **2** is a core/shell particle wherein the core is filled with solvent and the shell comprises nanoparticles **3** dispersed in a second material **21,** *i.e.,* said particle **2** is a hollow bead with a solvent filled core.

According to one embodiment, the particle **2** is optically transparent, *i.e.,* the particle **2** is transparent at wavelengths between 200 nm and 50 µm, between 200 nm and 10 µm, between 200 nm and 2500 nm, between 200 nm and 2000 nm, between 200 nm and 1500 nm, between 200 nm and 1000 nm, between 200 nm and 800 nm, between 400 nm and 700 nm, between 400 nm and 600 nm, or between 400 nm and 470 nm.

According to one embodiment, the particle **2** exhibits a shelf life of at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years.

According to one embodiment, the particle 2 exhibits a degradation of its specific property of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years.

According to one embodiment, the specific property of the particle **2** comprises one or more of the following: fluorescence, phosphorescence, chemiluminescence, capacity of increasing local electromagnetic field, absorbance, magnetization, magnetic coercivity, catalytic yield, catalytic properties, photovoltaic properties, photovoltaic yield, electrical polarization, thermal conductivity, electrical conductivity, permeability to molecular oxygen, permeability to molecular water, or any other properties.

According to one embodiment, the particle **2** exhibits a degradation of its specific property of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the particle **2** exhibits a degradation of its specific property of less than 90%, 80%, 70%, 60%, 50%, 40%, 30%, 25%, 20%, 10%, 5%, 4%, 3%, 2%, 1%, or 0% under 0%, 10%, 20%, 30%, 40%, 50%, 55%, 60%, 65%, 70%, 75%, 80%, 85%, 90%, 95%, or 99% of humidity.

According to one embodiment, the particle **2** exhibits a degradation of its specific property of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the particle **2** exhibits a degradation of its specific property of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0%, 10%, 20%, 30%, 40%, 50%, 55%, 60%, 65%, 70%, 75%, 80%, 85%, 90%, 95%, or 99% of humidity.

According to one embodiment, the particle 2 exhibits a degradation of its specific property of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the particle 2 exhibits a degradation of its specific property of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the particle 2 exhibits a degradation of its specific property of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂.

According to one embodiment, the particle **2** exhibits a degradation of its specific property of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the particle **2** exhibits a degradation of its specific property of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0%, 10%, 20%, 30%, 40%, 50%, 55%, 60%, 65%, 70%, 75%, 80%, 85%, 90%, 95%, or 99% of humidity.

According to one embodiment, the particle **2** exhibits a degradation of its specific property of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the particle **2** exhibits a degradation of its photoluminescence of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years.

Photoluminescence refers to fluorescence and/or phosphorescence.

According to one embodiment, the particle **2** exhibits a degradation of its photoluminescence of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the particle **2** exhibits a degradation of its photoluminescence of less than 90%, 80%, 70%, 60%, 50%, 40%, 30%, 25%, 20%, 10%, 5%, 4%, 3%, 2%, 1%, or 0% under 0%, 10%, 20%, 30%, 40%, 50%, 55%, 60%, 65%, 70%, 75%, 80%, 85%, 90%, 95%, or 99% of humidity.

According to one embodiment, the particle **2** exhibits a degradation of its photoluminescence of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the particle **2** exhibits a degradation of its photoluminescence of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0%, 10%, 20%, 30%, 40%, 50%, 55%, 60%, 65%, 70%, 75%, 80%, 85%, 90%, 95%, or 99% of humidity.

According to one embodiment, the particle **2** exhibits a degradation of its photoluminescence of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the particle **2** exhibits a degradation of its photoluminescence of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the particle **2** exhibits a degradation of its photoluminescence of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂.

According to one embodiment, the particle **2** exhibits a degradation of its photoluminescence of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the particle **2** exhibits a degradation of its photoluminescence of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0%, 10%, 20%, 30%, 40%, 50%, 55%, 60%, 65%, 70%, 75%, 80%, 85%, 90%, 95%, or 99% of humidity.

According to one embodiment, the particle **2** exhibits a degradation of its photoluminescence of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

In one embodiment, the particle **2** exhibits photoluminescence quantum yield (PLQY) decrease of less than 80%, 70%, 60%, 50%, 40%, 30%, 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination.

According to one embodiment, the light illumination is provided by blue, green, red, or UV light source such as laser, diode, fluorescent lamp or Xenon Arc Lamp. According to one embodiment, the photon flux or average peak pulse power of the illumination is comprised between 1 mW.cm⁻² and 100 kW.cm⁻², more preferably between 10 mW.cm⁻² and 100 W.cm⁻², and even more preferably between 10 mW.cm⁻² and 30 W.cm⁻².

According to one embodiment, the photon flux or average peak pulse power of the illumination is at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one embodiment, the particle **2** exhibits photoluminescence quantum yield (PQLY) decrease of less than 80%, 70%, 60%, 50%, 40%, 30%, 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one embodiment, the particle **2** exhibits FCE decrease of less than 80%, 70%, 60%, 50%, 40%, 30%, 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻¹, 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

According to one embodiment, the particle **2** exhibits a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years.

According to one embodiment, the particle **2** exhibits a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the particle **2** exhibits a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% under 0%, 10%, 20%, 30%, 40%, 50%, 55%, 60%, 65%, 70%, 75%, 80%, 85%, 90%, 95%, or 99% of humidity.

According to one embodiment, the particle **2** exhibits a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the particle **2** exhibits a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0%, 10%, 20%, 30%, 40%, 50%, 55%, 60%, 65%, 70%, 75%, 80%, 85%, 90%, 95%, or 99% of humidity.

According to one embodiment, the particle **2** exhibits a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the particle **2** exhibits a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the particle **2** exhibits a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂.

According to one embodiment, the particle **2** exhibits a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the particle **2** exhibits a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0%, 10%, 20%, 30%, 40%, 50%, 55%, 60%, 65%, 70%, 75%, 80%, 85%, 90%, 95%, or 99% of humidity.

According to one embodiment, the particle **2** exhibits a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the particle **2** exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days,20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years,4 years, 4.5 years, 5 years, 5.5 years, 6 years, 6.5 years, 7 years, 7.5 years, 8 years, 8.5 years,9 years, 9.5 years, or 10 years.

According to one embodiment, the particle **2** exhibits a degradation of its FCE of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the particle 2 exhibits a degradation of its FCE of less than 90%, 80%, 70%, 60%, 50%, 40%, 30%, 25%, 20%, 10%, 5%, 4%, 3%, 2%, 1%, or 0% under 0%, 10%, 20%, 30%, 40%, 50%, 55%, 60%, 65%, 70%, 75%, 80%, 85%, 90%, 95%, or 99% of humidity.

According to one embodiment, the particle **2** exhibits a degradation of its FCE of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the particle 2 exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days,20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years,4 years, 4.5 years, 5 years, 5.5 years, 6 years, 6.5 years, 7 years, 7.5 years, 8 years, 8.5 years,9 years, 9.5 years, or 10 years, under 0%, 10%, 20%, 30%, 40%, 50%, 55%, 60%, 65%, 70%, 75%, 80%, 85%, 90%, 95%, or 99% of humidity.

According to one embodiment, the particle **2** exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days,20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years,4 years, 4.5 years, 5 years, 5.5 years, 6 years, 6.5 years, 7 years, 7.5 years, 8 years, 8.5 years,9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the particle **2** exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days,20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years,4 years, 4.5 years, 5 years, 5.5 years, 6 years, 6.5 years, 7 years, 7.5 years, 8 years, 8.5 years,9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the particle **2** exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days,20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years,4 years, 4.5 years, 5 years, 5.5 years, 6 years, 6.5 years, 7 years, 7.5 years, 8 years, 8.5 years,9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂.

According to one embodiment, the particle **2** exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days,20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years,4 years, 4.5 years, 5 years, 5.5 years, 6 years, 6.5 years, 7 years, 7.5 years, 8 years, 8.5 years,9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the particle **2** exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days,20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years,4 years, 4.5 years, 5 years, 5.5 years, 6 years, 6.5 years, 7 years, 7.5 years, 8 years, 8.5 years,9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0%, 10%, 20%, 30%, 40%, 50%, 55%, 60%, 65%, 70%, 75%, 80%, 85%, 90%, 95%, or 99% of humidity.

According to one embodiment, the particle **2** exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days,20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years,4 years, 4.5 years, 5 years, 5.5 years, 6 years, 6.5 years, 7 years, 7.5 years, 8 years, 8.5 years,9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the photoluminescence of the particle **2** is preserved after encapsulation in the particle **1.**

According to one embodiment, the at least one nanoparticle **3** is a luminescent nanoparticle.

According to one embodiment, the luminescent nanoparticle is a fluorescent nanoparticle.

According to one embodiment, the luminescent nanoparticle is a phosphorescent nanoparticle.

According to one embodiment, the luminescent nanoparticle is a chemiluminescentparticle.

According to one embodiment, the luminescent nanoparticle is a triboluminescent nanoparticle.

According to one embodiment, the luminescent nanoparticle exhibits an emission spectrum with at least one emission peak, wherein said emission peak has a maximum emission wavelength ranging from 400 nm to 50 µm.

According to one embodiment, the luminescent nanoparticle exhibits an emission spectrum with at least one emission peak, wherein said emission peak has a maximum emission wavelength ranging from 400 nm to 500 nm. In this embodiment, the luminescent nanoparticle emits blue light.

According to one embodiment, the luminescent nanoparticle exhibits an emission spectrum with at least one emission peak, wherein said emission peak has a maximum emission wavelength ranging from 500 nm to 560 nm, more preferably ranging from 515 nm to 545 nm. In this embodiment, the luminescent nanoparticle emits green light.

According to one embodiment, the luminescent nanoparticle exhibits an emission spectrum with at least one emission peak, wherein said emission peak has a maximum emission wavelength ranging from 560 nm to 590 nm. In this embodiment, the luminescent nanoparticle emits yellow light.

According to one embodiment, the luminescent nanoparticle exhibits an emission spectrum with at least one emission peak, wherein said emission peak has a maximum emission wavelength ranging from 590 nm to 750 nm, more preferably ranging from 610 nm to 650 nm. In this embodiment, the luminescent nanoparticle emits red light.

According to one embodiment, the luminescent nanoparticle exhibits an emission spectrum with at least one emission peak, wherein said emission peak has a maximum emission wavelength ranging from 750 nm to 50 µm. In this embodiment, the luminescent nanoparticle emits near infra-red, mid-infra-red, or infra-red light.

According to one embodiment, the luminescent nanoparticle exhibits an emission spectrum with at least one emission peak having a full width half maximum lower than 90 nm, 80 nm, 70 nm, 60 nm, 50 nm, 40 nm, 30 nm, 25 nm, 20 nm, 15 nm, or 10 nm.

According to one embodiment, the luminescent nanoparticle exhibits emission spectra with at least one emission peak having a full width half maximum strictly lower than 40 nm, 30 nm, 25 nm, 20 nm, 15 nm, or 10 nm.

According to one embodiment, the luminescent nanoparticle exhibits an emission spectrum with at least one emission peak having a full width at quarter maximum lower than 90 nm, 80 nm, 70 nm, 60 nm, 50 nm, 40 nm, 30 nm, 25 nm, 20 nm, 15 nm, or 10 nm.

According to one embodiment, the luminescent nanoparticle exhibits emission spectra with at least one emission peak having a full width at quarter maximum strictly lower than 40 nm, 30 nm, 25 nm, 20 nm, 15 nm, or 10 nm.

According to one embodiment, the luminescent nanoparticle has a photoluminescence quantum yield (PLQY) of at least 5%, 10%, 15%, 20%, 25%, 30%, 35%, 40%, 45%, 50%, 55%, 60%, 65%, 70%, 75%, 80%, 85%, 90%, 95%, 99% or 100%.

According to one embodiment, the luminescent nanoparticles have an average fluorescence lifetime of at least 0.1 nanosecond, 0.2 nanosecond, 0.3 nanosecond, 0.4 nanosecond, 0.5 nanosecond, 0.6 nanosecond, 0.7 nanosecond, 0.8 nanosecond, 0.9 nanosecond, 1 nanosecond, 2 nanoseconds, 3 nanoseconds, 4 nanoseconds, 5 nanoseconds, 6 nanoseconds, 7 nanoseconds, 8 nanoseconds, 9 nanoseconds, 10 nanoseconds, 11 nanoseconds, 12 nanoseconds, 13 nanoseconds, 14 nanoseconds, 15 nanoseconds, 16 nanoseconds, 17 nanoseconds, 18 nanoseconds, 19 nanoseconds, 20 nanoseconds, 21 nanoseconds, 22 nanoseconds, 23 nanoseconds, 24 nanoseconds, 25 nanoseconds, 26 nanoseconds, 27 nanoseconds, 28 nanoseconds, 29 nanoseconds, 30 nanoseconds, 31 nanoseconds, 32 nanoseconds, 33 nanoseconds, 34 nanoseconds, 35 nanoseconds, 36 nanoseconds, 37 nanoseconds, 38 nanoseconds, 39 nanoseconds, 40 nanoseconds, 41 nanoseconds, 42 nanoseconds, 43 nanoseconds, 44 nanoseconds, 45 nanoseconds, 46 nanoseconds, 47 nanoseconds, 48 nanoseconds, 49 nanoseconds, 50 nanoseconds, 100 nanoseconds, 150 nanoseconds, 200 nanoseconds, 250 nanoseconds, 300 nanoseconds, 350 nanoseconds, 400 nanoseconds, 450 nanoseconds, 500 nanoseconds, 550 nanoseconds, 600 nanoseconds, 650 nanoseconds, 700 nanoseconds, 750 nanoseconds, 800 nanoseconds, 850 nanoseconds, 900 nanoseconds, 950 nanoseconds, or 1 µsecond.

In one embodiment, the nanoparticle **3** exhibits photoluminescence quantum yield (PQLY) decrease of less than 80%, 70%, 60%, 50%, 40%, 30%, 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under pulsed light with an average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻²,170 W.cm⁻², 180 W.cm⁻², 190 W.cm⁻², 200 W.cm⁻², 300 W.cm⁻², 400 W.cm⁻², 500 W.cm⁻²,600 W.cm⁻², 700 W.cm⁻², 800 W.cm⁻², 900 W.cm⁻², 1 kW.cm⁻², 50 kW.cm⁻², or 100 kW.cm⁻².

In one preferred embodiment, the nanoparticle **3** exhibits photoluminescence quantum yield (PQLY) decrease of less than 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under pulsed light or continuous light with an average peak pulse power or photon flux of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one embodiment, the nanoparticle **3** exhibits FCE decrease of less than 80%, 70%, 60%, 50%, 40%, 30%, 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000,20000,21000,22000, 23000,24000,25000,26000,27000,28000,29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under pulsed light with an average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻²,100 W.cm⁻², 110 W.cm⁻², 120 W.cm⁻², 130 W.cm⁻², 140 W.cm⁻², 150 W.cm⁻², 160 W.cm⁻²,170 W.cm⁻², 180 W.cm⁻², 190 W.cm⁻², 200 W.cm⁻², 300 W.cm⁻², 400 W.cm⁻², 500 W.cm⁻²,600 W.cm⁻², 700 W.cm⁻², 800 W.cm⁻², 900 W.cm⁻², 1 kW.cm⁻², 50 kW.cm⁻², or 100 kW.cm⁻².

In one preferred embodiment, the nanoparticle **3** exhibits FCE decrease of less than 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000,23000,24000,25000,26000, 27000,28000,29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under pulsed light or continuous light with an average peak pulse power or photon flux of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

According to one embodiment, the at least one nanoparticle **3** absorbs the incident light with wavelength lower than 50 µm, 40 µm, 30 µm, 20 µm, 10 µm, 1 µm, 950 nm, 900 nm, 850 nm, 800 nm, 750 nm, 700 nm, 650 nm, 600 nm, 550 nm, 500 nm, 450 nm, 400 nm, 350 nm, 300 nm, 250 nm, or lower than 200 nm.

According to one embodiment, the luminescent nanoparticle has an average fluorescence lifetime of at least 0.1 nanosecond, 0.2 nanosecond, 0.3 nanosecond, 0.4 nanosecond, 0.5 nanosecond, 0.6 nanosecond, 0.7 nanosecond, 0.8 nanosecond, 0.9 nanosecond, 1 nanosecond, 2 nanoseconds, 3 nanoseconds, 4 nanoseconds, 5 nanoseconds, 6 nanoseconds, 7 nanoseconds, 8 nanoseconds, 9 nanoseconds, 10 nanoseconds, 11 nanoseconds, 12 nanoseconds, 13 nanoseconds, 14 nanoseconds, 15 nanoseconds, 16 nanoseconds, 17 nanoseconds, 18 nanoseconds, 19 nanoseconds, 20 nanoseconds, 21 nanoseconds, 22 nanoseconds, 23 nanoseconds, 24 nanoseconds, 25 nanoseconds, 26 nanoseconds, 27 nanoseconds, 28 nanoseconds, 29 nanoseconds, 30 nanoseconds, 31 nanoseconds, 32 nanoseconds, 33 nanoseconds, 34 nanoseconds, 35 nanoseconds, 36 nanoseconds, 37 nanoseconds, 38 nanoseconds, 39 nanoseconds, 40 nanoseconds, 41 nanoseconds, 42 nanoseconds, 43 nanoseconds, 44 nanoseconds, 45 nanoseconds, 46 nanoseconds, 47 nanoseconds, 48 nanoseconds, 49 nanoseconds, 50 nanoseconds, 100 nanoseconds, 150 nanoseconds, 200 nanoseconds, 250 nanoseconds, 300 nanoseconds, 350 nanoseconds, 400 nanoseconds, 450 nanoseconds, 500 nanoseconds, 550 nanoseconds, 600 nanoseconds, 650 nanoseconds, 700 nanoseconds, 750 nanoseconds, 800 nanoseconds, 850 nanoseconds, 900 nanoseconds, 950 nanoseconds, or 1 µsecond.

According to one embodiment, the luminescent nanoparticle is a semiconductor nanoparticle.

According to one embodiment, the luminescent nanoparticle is a semiconductor nanocrystal.

According to one embodiment, the at least one nanoparticle 3 is electrically insulating.

According to one embodiment, the at least one nanoparticle 3 is electrically conductive.

According to one embodiment, the at least one nanoparticle 3 has an electrical conductivity at standard conditions ranging from 1×10⁻²⁰ to 10⁷ S/m, preferably from 1×10⁻¹⁵ to 5 S/m, more preferably from 1×10⁻⁷ to 1 S/m.

According to one embodiment, the at least one nanoparticle 3 has an electrical conductivity at standard conditions of at least 1×10⁻²⁰ S/m, 0.5×10⁻¹⁹ S/m, 1×10⁻¹⁹ S/m, 0.5×10⁻¹⁸ S/m, 1×10⁻¹⁸ S/m, 0.5×10⁻¹⁷ S/m, 1×10⁻¹⁷ S/m, 0.5×10⁻¹⁶ S/m, 1×10⁻¹⁶ S/m, 0.5×10⁻¹⁵ S/m, 1×10⁻¹⁵ S/m, 0.5×10⁻¹⁴ S/m, 1×10⁻¹⁴ S/m, 0.5×10⁻¹³ S/m, 1×10⁻¹³ S/m, 0.5×10⁻¹² S/m, 1×10⁻¹² S/m, 0.5×10⁻¹¹ S/m, 1×10⁻¹¹ S/m, 0.5×10⁻¹⁰ S/m, 1×10⁻¹⁰ S/m, 0.5×10⁻⁹ S/m, 1×10⁻⁹ S/m, 0.5×10⁻⁸ S/m, 1×10⁻⁸ S/m, 0.5×10⁻⁷ S/m, 1×10⁻⁷ S/m, 0.5×10⁻⁶ S/m, 1×10⁻⁶ S/m, 0.5×10⁻⁵ S/m, 1×10⁻⁵ S/m, 0.5×10⁻⁴ S/m, 1×10⁻⁴ S/m, 0.5×10⁻³ S/m, 1×10⁻³ S/m, 0.5×10⁻² S/m, 1×10⁻² S/m, 0.5×10⁻¹ S/m, 1×10⁻¹ S/m, 0.5 S/m, 1 S/m, 1.5 S/m, 2 S/m, 2.5 S/m, 3 S/m, 3.5 S/m, 4 S/m, 4.5 S/m, 5 S/m, 5.5 S/m, 6 S/m, 6.5 S/m, 7 S/m, 7.5 S/m, 8 S/m, 8.5 S/m, 9 S/m, 9.5 S/m, 10 S/m, 50 S/m, 10² S/m, 5×10² S/m, 10³ S/m, 5×10³ S/m, 10⁴ S/m, 5×10⁴ S/m, 10⁵ S/m, 5×10⁵ S/m, 10⁶ S/m, 5×10⁶ S/m, or 10⁷ S/m.

According to one embodiment, the electrical conductivity of the at least one nanoparticle 3 may be measured for example with an impedance spectrometer.

According to one embodiment, the at least one nanoparticle 3 is thermally conductive.

According to one embodiment, the at least one nanoparticle 3 has a thermal conductivity at standard conditions ranging from 0.1 to 450 W/(m.K), preferably from 1 to 200 W/(m.K), more preferably from 10 to 150 W/(m.K).

According to one embodiment, the at least one nanoparticle 3 has a thermal conductivity at standard conditions of at least 0.1 W/(m.K), 0.2 W/(m.K), 0.3 W/(m.K), 0.4 W/(m.K), 0.5 W/(m.K), 0.6 W/(m.K), 0.7 W/(m.K), 0.8 W/(m.K), 0.9 W/(m.K), 1 W/(m.K), 1.1 W/(m.K), 1.2 W/(m.K), 1.3 W/(m.K), 1.4 W/(m.K), 1.5 W/(m.K), 1.6 W/(m.K), 1.7 W/(m.K), 1.8 W/(m.K), 1.9 W/(m.K), 2 W/(m.K), 2.1 W/(m.K), 2.2 W/(m.K), 2.3 W/(m.K), 2.4 W/(m.K), 2.5 W/(m.K), 2.6 W/(m.K), 2.7 W/(m.K), 2.8 W/(m.K), 2.9 W/(m.K), 3 W/(m.K), 3.1 W/(m.K), 3.2 W/(m.K), 3.3 W/(m.K), 3.4 W/(m.K), 3.5 W/(m.K), 3.6 W/(m.K), 3.7 W/(m.K), 3.8 W/(m.K), 3.9 W/(m.K), 4 W/(m.K), 4.1 W/(m.K), 4.2 W/(m.K), 4.3 W/(m.K), 4.4 W/(m.K), 4.5 W/(m.K), 4.6 W/(m.K), 4.7 W/(m.K), 4.8 W/(m.K), 4.9 W/(m.K), 5 W/(m.K), 5.1 W/(m.K), 5.2 W/(m.K), 5.3 W/(m.K), 5.4 W/(m.K), 5.5 W/(m.K), 5.6 W/(m.K), 5.7 W/(m.K), 5.8 W/(m.K), 5.9 W/(m.K), 6 W/(m.K), 6.1 W/(m.K), 6.2 W/(m.K), 6.3 W/(m.K), 6.4 W/(m.K), 6.5 W/(m.K), 6.6 W/(m.K), 6.7 W/(m.K), 6.8 W/(m.K), 6.9 W/(m.K), 7 W/(m.K), 7.1 W/(m.K), 7.2 W/(m.K), 7.3 W/(m.K), 7.4 W/(m.K), 7.5 W/(m.K), 7.6 W/(m.K), 7.7 W/(m.K), 7.8 W/(m.K), 7.9 W/(m.K), 8 W/(m.K), 8.1 W/(m.K), 8.2 W/(m.K), 8.3 W/(m.K), 8.4 W/(m.K), 8.5 W/(m.K), 8.6 W/(m.K), 8.7 W/(m.K), 8.8 W/(m.K), 8.9 W/(m.K), 9 W/(m.K), 9.1 W/(m.K), 9.2 W/(m.K), 9.3 W/(m.K), 9.4 W/(m.K), 9.5 W/(m.K), 9.6 W/(m.K), 9.7 W/(m.K), 9.8 W/(m.K), 9.9 W/(m.K), 10 W/(m.K), 10.1 W/(m.K), 10.2 W/(m.K), 10.3 W/(m.K), 10.4 W/(m.K), 10.5 W/(m.K), 10.6 W/(m.K), 10.7 W/(m.K), 10.8 W/(m.K), 10.9 W/(m.K), 11 W/(m.K), 11.1 W/(m.K), 11.2 W/(m.K), 11.3 W/(m.K), 11.4 W/(m.K), 11.5 W/(m.K), 11.6 W/(m.K), 11.7 W/(m.K), 11.8 W/(m.K), 11.9 W/(m.K), 12 W/(m.K), 12.1 W/(m.K), 12.2 W/(m.K), 12.3 W/(m.K), 12.4 W/(m.K), 12.5 W/(m.K), 12.6 W/(m.K), 12.7 W/(m.K), 12.8 W/(m.K), 12.9 W/(m.K), 13 W/(m.K), 13.1 W/(m.K), 13.2 W/(m.K), 13.3 W/(m.K), 13.4 W/(m.K), 13.5 W/(m.K), 13.6 W/(m.K), 13.7 W/(m.K), 13.8 W/(m.K), 13.9 W/(m.K), 14 W/(m.K), 14.1 W/(m.K), 14.2 W/(m.K), 14.3 W/(m.K), 14.4 W/(m.K), 14.5 W/(m.K), 14.6 W/(m.K), 14.7 W/(m.K), 14.8 W/(m.K), 14.9 W/(m.K), 15 W/(m.K), 15.1 W/(m.K), 15.2 W/(m.K), 15.3 W/(m.K), 15.4 W/(m.K), 15.5 W/(m.K), 15.6 W/(m.K), 15.7 W/(m.K), 15.8 W/(m.K), 15.9 W/(m.K), 16 W/(m.K), 16.1 W/(m.K), 16.2 W/(m.K), 16.3 W/(m.K), 16.4 W/(m.K), 16.5 W/(m.K), 16.6 W/(m.K), 16.7 W/(m.K), 16.8 W/(m.K), 16.9 W/(m.K), 17 W/(m.K), 17.1 W/(m.K), 17.2 W/(m.K), 17.3 W/(m.K), 17.4 W/(m.K), 17.5 W/(m.K), 17.6 W/(m.K), 17.7 W/(m.K), 17.8 W/(m.K), 17.9 W/(m.K), 18 W/(m.K), 18.1 W/(m.K), 18.2 W/(m.K), 18.3 W/(m.K), 18.4 W/(m.K), 18.5 W/(m.K), 18.6 W/(m.K), 18.7 W/(m.K), 18.8 W/(m.K), 18.9 W/(m.K), 19 W/(m.K), 19.1 W/(m.K), 19.2 W/(m.K), 19.3 W/(m.K), 19.4 W/(m.K), 19.5 W/(m.K), 19.6 W/(m.K), 19.7 W/(m.K), 19.8 W/(m.K), 19.9 W/(m.K), 20 W/(m.K), 20.1 W/(m.K), 20.2 W/(m.K), 20.3 W/(m.K), 20.4 W/(m.K), 20.5 W/(m.K), 20.6 W/(m.K), 20.7 W/(m.K), 20.8 W/(m.K), 20.9 W/(m.K), 21 W/(m.K), 21.1 W/(m.K), 21.2 W/(m.K), 21.3 W/(m.K), 21.4 W/(m.K), 21.5 W/(m.K), 21.6 W/(m.K), 21.7 W/(m.K), 21.8 W/(m.K), 21.9 W/(m.K), 22 W/(m.K), 22.1 W/(m.K), 22.2 W/(m.K), 22.3 W/(m.K), 22.4 W/(m.K), 22.5 W/(m.K), 22.6 W/(m.K), 22.7 W/(m.K), 22.8 W/(m.K), 22.9 W/(m.K), 23 W/(m.K), 23.1 W/(m.K), 23.2 W/(m.K), 23.3 W/(m.K), 23.4 W/(m.K), 23.5 W/(m.K), 23.6 W/(m.K), 23.7 W/(m.K), 23.8 W/(m.K), 23.9 W/(m.K), 24 W/(m.K), 24.1 W/(m.K), 24.2 W/(m.K), 24.3 W/(m.K), 24.4 W/(m.K), 24.5 W/(m.K), 24.6 W/(m.K), 24.7 W/(m.K), 24.8 W/(m.K), 24.9 W/(m.K), 25 W/(m.K), 30 W/(m.K), 40 W/(m.K), 50 W/(m.K), 60 W/(m.K), 70 W/(m.K), 80 W/(m.K), 90 W/(m.K), 100 W/(m.K), 110 W/(m.K), 120 W/(m.K), 130 W/(m.K), 140 W/(m.K), 150 W/(m.K), 160 W/(m.K), 170 W/(m.K), 180 W/(m.K), 190 W/(m.K), 200 W/(m.K), 210 W/(m.K), 220 W/(m.K), 230 W/(m.K), 240 W/(m.K), 250 W/(m.K), 260 W/(m.K), 270 W/(m.K), 280 W/(m.K), 290 W/(m.K), 300 W/(m.K), 310 W/(m.K), 320 W/(m.K), 330 W/(m.K), 340 W/(m.K), 350 W/(m.K), 360 W/(m.K), 370 W/(m.K), 380 W/(m.K), 390 W/(m.K), 400 W/(m.K), 410 W/(m.K), 420 W/(m.K), 430 W/(m.K), 440 W/(m.K), or 450 W/(m.K).

According to one embodiment, the thermal conductivity of the at least one nanoparticle 3 may be measured by steady-state methods or transient methods.

According to one embodiment, the at least one nanoparticle 3 is thermally insulating.

According to one embodiment, the ligands attached to the surface of a nanoparticle 3 is in contact with the second material 21. In this embodiment, said nanoparticle 3 is linked to the second material 21 and the electrical charges from said nanoparticle 3 can be evacuated. This prevents reactions at the surface of the nanoparticles 3 that can be due to electrical charges.

According to one embodiment, the ligands at the surface of the nanoparticles 3 are C3 to C20 alkanethiol ligands such as for example propanethiol, butanethiol, pentanethiol, hexanethiol, heptanethiol, octanethiol, nonanethiol, decanethiol, undecanethiol, dodecanethiol, tridecanethiol, tetradecanethiol, pentadecanethiol, hexadecanethiol, heptadecanethiol, octadecanethiol, or a mixture thereof. In this embodiment, C3 to C20 alkanethiol ligands help control the hydrophobicity of the nanoparticles surface.

According to one embodiment, the at least one nanoparticle 3 is hydrophobic.

According to one embodiment, the at least one nanoparticle 3 is hydrophilic.

According to one embodiment, the at least one nanoparticle 3 has an average size of at least 0.5 nm, 1 nm, 2 nm, 3 nm, 4 nm, 5 nm, 6 nm, 7 nm, 8 nm, 9 nm, 10 nm, 11 nm, 12 nm, 13 nm, 14 nm, 15 nm, 16 nm, 17 nm, 18 nm, 19 nm, 20 nm, 21 nm, 22 nm, 23 nm, 24 nm, 25 nm, 26 nm, 27 nm, 28 nm, 29 nm, 30 nm, 31 nm, 32 nm, 33 nm, 34 nm, 35 nm, 36 nm, 37 nm, 38 nm, 39 nm, 40 nm, 41 nm, 42 nm, 43 nm, 44 nm, 45 nm, 46 nm, 47 nm, 48 nm, 49 nm, 50 nm, 55 nm, 60 nm, 65 nm, 70 nm, 75 nm, 80 nm, 85 nm, 90 nm, 95 nm, 100 nm, 105 nm, 110 nm, 115 nm, 120 nm, 125 nm, 130 nm, 135 nm, 140 nm, 145 nm, 150 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the largest dimension of the at least one nanoparticle 3 is at least 5 nm, 10 nm, 15 nm, 20 nm, 25 nm, 30 nm, 35 nm, 40 nm, 45 nm, 50 nm, 55 nm, 60 nm, 65 nm, 70 nm, 75 nm, 80 nm, 85 nm, 90 nm, 95 nm, 100 nm, 105 nm, 110 nm, 115 nm, 120 nm, 125 nm, 130 nm, 135 nm, 140 nm, 145 nm, 150 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the smallest dimension of the at least one nanoparticle 3 is at least 0.5 nm, 1 nm, 1.5 nm, 1.5 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 90 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm

According to one embodiment, the smallest dimension of the at least one nanoparticle **3** is smaller than the largest dimension of said nanoparticle **3** by a factor (aspect ratio) of at least 1.5; at least 2; at least 2.5; at least 3; at least 3.5; at least 4; at least 4.5; at least 5; at least 5.5; at least 6; at least 6.5; at least 7; at least 7.5; at least 8; at least 8.5; at least 9; at least 9.5; at least 10; at least 10.5; at least 11; at least 11.5; at least 12; at least 12.5; at least 13; at least 13.5; at least 14; at least 14.5; at least 15; at least 15.5; at least 16; at least 16.5; at least 17; at least 17.5; at least 18; at least 18.5; at least 19; at least 19.5; at least 20; at least 25; at least 30; at least 35; at least 40; at least 45; at least 50; at least 55; at least 60; at least 65; at least 70; at least 75; at least 80; at least 85; at least 90; at least 95; at least 100; at least 150; at least 200; at least 250; at least 300; at least 350; at least 400; at least 450; at least 500; at least 550; at least 600; at least 650; at least 700; at least 750; at least 800; at least 850; at least 900; at least 950; or at least 1000.

According to one embodiment, in a statistical ensemble of nanoparticles **3,** said nanoparticles **3** are polydisperse.

According to one embodiment, in a statistical ensemble of nanoparticles **3,** said nanoparticles **3** are monodisperse.

According to one embodiment, in a statistical ensemble of nanoparticles **3,** said nanoparticles **3** have a narrow size distribution.

According to one embodiment, the size distribution for the smallest dimension of a statistical set of nanoparticles **3** is inferior than 1%, 2%, 3%, 4%, 5%, 6%, 7%, 8%, 9%, 10%, 15%, 20%, 25%, 30%, 35%, or 40% of said smallest dimension.

According to one embodiment, the size distribution for the largest dimension of a statistical set of nanoparticles **3** is inferior than 1%, 2%, 3%, 4%, 5%, 6%, 7%, 8%, 9%, 10%, 15%, 20%, 25%, 30%, 35%, or 40% of said largest dimension.

According to one embodiment, the at least one nanoparticle **3** is hollow.

According to one embodiment, the at least one nanoparticle **3** is not hollow.

According to one embodiment, the at least one nanoparticle **3** is isotropic.

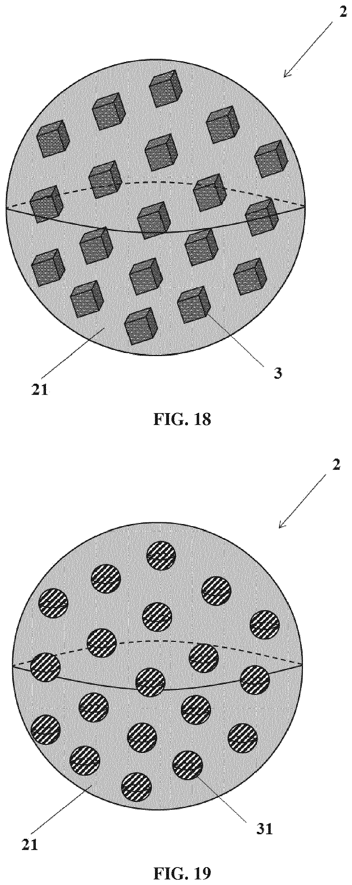

According to one embodiment, examples of shape of isotropic nanoparticle **3** include but are not limited to: sphere **31** (as illustrated in Fig. 2 and Fig. 19), faceted sphere, prism, polyhedron, or cubic shape.

According to one embodiment, the at least one nanoparticle **3** is not spherical.

According to one embodiment, the at least one nanoparticle **3** is anisotropic.

According to one embodiment, examples of shape of anisotropic nanoparticle **3** include but are not limited to: rod, wire, needle, bar, belt, cone, or polyhedron shape.

According to one embodiment, examples of branched shape of anisotropic nanoparticle **3** include but are not limited to: monopod, bipod, tripod, tetrapod, star, or octopod shape.

According to one embodiment, examples of complex shape of anisotropic nanoparticle **3** include but are not limited to: snowflake, flower, thorn, hemisphere, cone, urchin, filamentous particle, biconcave discoid, worm, tree, dendrite, necklace, or chain.

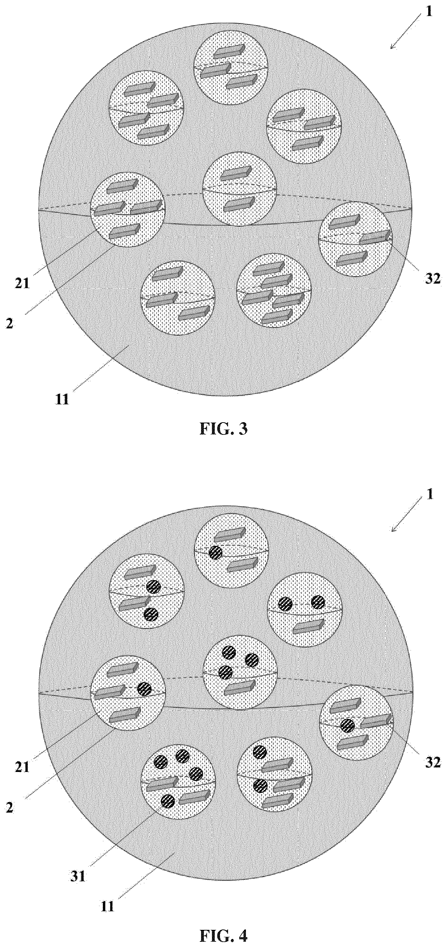

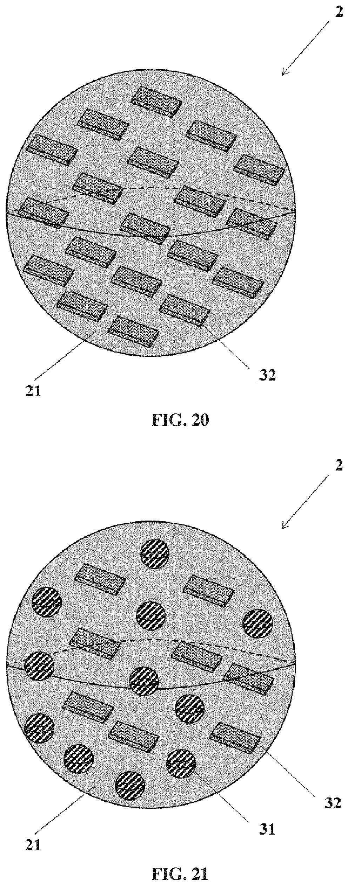

According to one embodiment, as illustrated in Fig. 3 and Fig. 20, the at least one nanoparticle **3** has a 2D shape **32.**

According to one embodiment, examples of shape of 2D nanoparticle **32** include but are not limited to: sheet, platelet, plate, ribbon, wall, plate triangle, square, pentagon, hexagon, disk or ring.

According to one embodiment, a nanoplatelet is different from a disk or a nanodisk.

According to one embodiment, nanosheets and nanoplatelets are not disks or nanodisks. In this embodiment, the section along the other dimensions than the thickness (width, length) of said nanosheets or nanoplatelets is square or rectangular, while it is circular or ovoidal for disks or nanodisks.

According to one embodiment, nanosheets and nanoplatelets are not disks or nanodisks. In this embodiment, none of the dimensions of said nanosheets and nanoplatelets can be defined as a diameter nor the size of a semi-major axis and a semi-minor axis contrarily to disks or nanodisks.

According to one embodiment, nanosheets and nanoplatelets are not disks or nanodisks. In this embodiment, the curvature at all points along the other dimensions than the thickness (length, width) of said nanosheets or nanoplatelets is below 10 µm⁻¹, while the curvature for disks or nanodisks is superior on at least one point.

According to one embodiment, nanosheets and nanoplatelets are not disks or nanodisks. In this embodiment, the curvature at at least one point along the other dimensions than the thickness (length, width) of said nanosheets or nanoplatelets is below 10 µm⁻¹, while the curvature for disks or nanodisks is superior than 10 µm⁻¹ at all points.

According to one embodiment, a nanoplatelet is different from a quantum dot, or a spherical nanocrystal. A quantum dot is spherical, thus is has a 3D shape and allow confinement of excitons in all three spatial dimensions, whereas the nanoplatelet has a 2D shape and allow confinement of excitons in one dimension and allow free propagation in the other two dimensions. This results in distinct electronic and optical properties, for example the typical photoluminescence decay time of semiconductor platelets is 1 order of magnitude faster than for spherical quantum dots, and the semiconductor platelets also show an exceptionally narrow optical feature with full width at half maximum (FWHM) much lower than for spherical quantum dots.

According to one embodiment, a nanoplatelet is different from a nanorod or nanowire. A nanorod (or nanowire) has a 1D shape and allow confinement of excitons two spatial dimensions, whereas the nanoplatelet has a 2D shape and allow confinement of excitons in one dimension and allow free propagation in the other two dimensions. This results in distinct electronic and optical properties.

According to one embodiment, to obtain a ROHS compliant particle **1** and/or particle **2,** said particle **1** and/or particle **2** rather comprises semiconductor nanoplatelets than semiconductor quantum dots. Indeed, a same emission peak position is obtained for semiconductor quantum dots with a diameter d, and semiconductor nanoplatelets with a thickness d/2; thus for the same emission peak position, a semiconductor nanoplatelet comprises less cadmium in weight than a semiconductor quantum dot. Furthermore, if a CdS core is comprised in a core/shell quantum dot or a core/shell (or core/crown) nanoplatelet, then there are more possibilities of shell layers without cadmium in the case of core/shell (or core/crown) nanoplatelet; thus a core/shell (or core/crown) nanoplatelet with a CdS core may comprise less cadmium in weight than a core/shell quantum dot with a CdS core. The lattice difference between CdS and nonCadmium shells is too important for the quantum dot to sustain. Finally, semiconductor nanoplatelets have better absorption properties than semiconductor quantum dots, thus resulting in less cadmium in weight needed in semiconductor nanoplatelets.

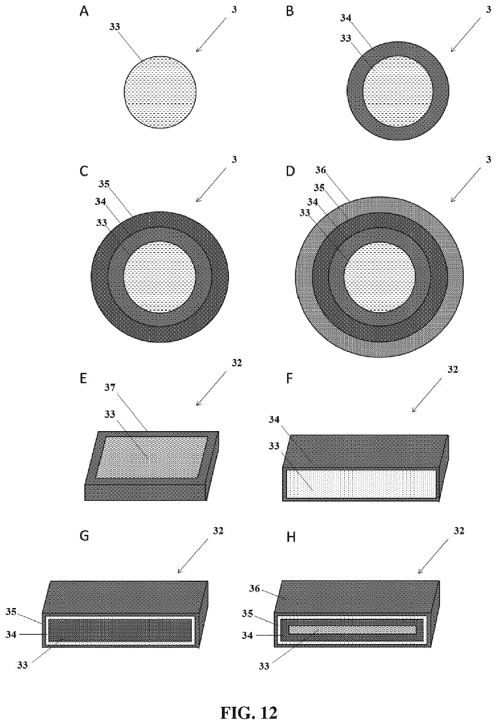

According to one embodiment, as illustrated in Fig. 12A, the at least one nanoparticle **3** is a core nanoparticle **33** without a shell.

According to one embodiment, the at least one nanoparticle **3** is atomically flat. In this embodiment, the atomically flat nanoparticle **3** may be evidenced by transmission electron microscopy or fluorescence scanning microscopy, energy-dispersive X-ray spectroscopy (EDS), X-Ray photoelectron spectroscopy (XPS), UV photoelectron spectroscopy (UPS), electron energy loss spectroscopy (EELS), photoluminescence or any other characterization means known by the person skilled in the art.

According to one embodiment, the at least one nanoparticle **3** comprises at least one atomically flat core. In this embodiment, the atomically flat core may be evidenced by transmission electron microscopy or fluorescence scanning microscopy, energy-dispersive X-ray spectroscopy (EDS), X-Ray photoelectron spectroscopy (XPS), UV photoelectron spectroscopy (UPS), electron energy loss spectroscopy (EELS), photoluminescence, or any other characterization means known by the person skilled in the art.

According to one embodiment, the at least one nanoparticle **3** is a core **33**/shell **34** nanoparticle, wherein the core **33** is partially or totally covered with at least one shell **34** comprising at least one layer of material.

According to one embodiment, as illustrated in Fig. 12B-C and Fig. 12F-G, the at least one nanoparticle **3** is a core **33**/shell **34** nanoparticle, wherein the core **33** is covered with at least one shell (**34, 35**).

According to one embodiment, the at least one shell (**34, 35**) has a thickness of at least 0.1 nm, 0.2 nm, 0.3 nm, 0.4 nm, 0.5 nm, 1 nm, 1.5 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, or 500 nm.

According to one embodiment, the at least one nanoparticle **3** is a core **33**/shell **34** nanoparticle, wherein the core **33** and the shell **34** are composed of the same material.

According to one embodiment, the at least one nanoparticle **3** is a core **33**/shell **34** nanoparticle, wherein the core **33** and the shell **34** are composed of at least two different materials.

According to one embodiment, the at least one nanoparticle **3** is a core **33**/shell **34** nanoparticle, wherein the core **33** is a luminescent core covered with at least one shell **34** selected in the group of magnetic material, plasmonic material, dielectric material, piezoelectric material, pyro-electric material, ferro-electric material, light scattering material, electrically insulating material, thermally insulating material or catalytic material.

According to one embodiment, the at least one nanoparticle **3** is a core **33**/shell **34** nanoparticle, wherein the core **33** is a magnetic core covered with at least one shell **34** selected in the group of luminescent material, plasmonic material, dielectric material, piezoelectric material, pyro-electric material, ferro-electric material, light scattering material, electrically insulating material, thermally insulating material or catalytic material.

According to one embodiment, the at least one nanoparticle **3** is a core **33**/shell **34** nanoparticle, wherein the core **33** is a plasmonic core covered with at least one shell **34** selected in the group of magnetic material, luminescent material, dielectric material, piezoelectric material, pyro-electric material, ferro-electric material, light scattering material, electrically insulating material, thermally insulating material or catalytic material.

According to one embodiment, the at least one nanoparticle **3** is a core **33**/shell **34** nanoparticle, wherein the core **33** is a dielectric core covered with at least one shell **34** selected in the group of magnetic material, plasmonic material, luminescent material, piezoelectric material, pyro-electric material, ferro-electric material, light scattering material, electrically insulating material, thermally insulating material or catalytic material.

According to one embodiment, the at least one nanoparticle **3** is a core **33**/shell **34** nanoparticle, wherein the core **33** is a piezoelectric core covered with at least one shell **34** selected in the group of magnetic material, plasmonic material, dielectric material, luminescent material, pyro-electric material, ferro-electric material, light scattering material, electrically insulating material, thermally insulating material or catalytic material.

According to one embodiment, the at least one nanoparticle **3** is a core **33**/shell **34** nanoparticle, wherein the core **33** is a pyro-electric core covered with at least one shell **34** selected in the group of magnetic material, plasmonic material, dielectric material, luminescent material, piezoelectric material, ferro-electric material, light scattering material, electrically insulating material, thermally insulating material or catalytic material.

According to one embodiment, the at least one nanoparticle **3** is a core **33**/shell **34** nanoparticle, wherein the core **33** is a ferro-electric core covered with at least one shell **34** selected in the group of magnetic material, plasmonic material, dielectric material, luminescent material, piezoelectric material, pyro-electric material, light scattering material, electrically insulating material, thermally insulating material or catalytic material.

According to one embodiment, the at least one nanoparticle **3** is a core **33**/shell **34** nanoparticle, wherein the core **33** is a light scattering core covered with at least one shell **34** selected in the group of magnetic material, plasmonic material, dielectric material, luminescent material, piezoelectric material, pyro-electric material, ferro-electric material, electrically insulating material, thermally insulating material or catalytic material.

According to one embodiment, the at least one nanoparticle **3** is a core **33**/shell **34** nanoparticle, wherein the core **33** is an electrically insulating core covered with at least one shell **34** selected in the group of magnetic material, plasmonic material, dielectric material, luminescent material, piezoelectric material, pyro-electric material, ferro-electric material, light scattering material, thermally insulating material or catalytic material.

According to one embodiment, the at least one nanoparticle **3** is a core **33**/shell **34** nanoparticle, wherein the core **33** is a thermally insulating core covered with at least one shell **34** selected in the group of magnetic material, plasmonic material, dielectric material, luminescent material, piezoelectric material, pyro-electric material, ferro-electric material, light scattering material, electrically insulating material or catalytic material.

According to one embodiment, the at least one nanoparticle **3** is a core **33**/shell **34** nanoparticle, wherein the core **33** is a catalytic core covered with at least one shell **34** selected in the group of magnetic material, plasmonic material, dielectric material, luminescent material, piezoelectric material, pyro-electric material, ferro-electric material, light scattering material, electrically insulating material or thermally insulating material.

According to one embodiment, the at least one nanoparticle **3** is a core **33**/shell **36** nanoparticle, wherein the core **33** is covered with an insulator shell **36.** In this embodiment, the insulator shell **36** prevents the aggregation of the cores **33.**

According to one embodiment, the insulator shell 36 has a thickness of at least 0.1 nm, 0.2 nm, 0.3 nm, 0.4 nm, 0.5 nm, 1 nm, 1.5 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm or 500 nm.

According to one embodiment, as illustrated in Fig. 12D and Fig. 12H, the at least one nanoparticle **3** is a core **33**/shell **(34, 35, 36)** nanoparticle, wherein the core **33** is covered with at least one shell **(34, 35)** and an insulator shell **36.**

According to one embodiment, the shells **(34, 35, 36)** covering the core **33** of the at least one nanoparticle **3** may be composed of the same material.

According to one embodiment, the shells **(34, 35, 36)** covering the core **33** of the at least one nanoparticle **3** may be composed of at least two different materials.

According to one embodiment, the shells **(34, 35, 36)** covering the core **33** of the at least one nanoparticle **3** may have the same thickness.

According to one embodiment, the shells **(34, 35, 36)** covering the core **33** of the at least one nanoparticle **3** may have different thickness.

According to one embodiment, each shell (**34, 35, 36**) covering the core **33** of the nanoparticle **3** has a thickness homogeneous all along the core **33,** *i.e*., each shell (**34, 35, 36**) has a same thickness all along the core **33.**

According to one embodiment, each shell (**34, 35, 36**) covering the core **33** of the nanoparticle **3** has a thickness heterogeneous along the core **33,** *i.e.,* said thickness varies along the core **33.**

According to one embodiment, the at least one nanoparticle **3** is a core **33**/insulator shell **36** nanoparticle, wherein examples of insulator shell **36** include but are not limited to: non-porous SiO₂, mesoporous SiO₂, non-porous MgO, mesoporous MgO, non-porous ZnO, mesoporous ZnO, non-porous Al₂O₃, mesoporous Al₂O₃, non-porous ZrO₂, mesoporous ZrO₂, non-porous TiO₂, mesoporous TiO₂, non-porous SnO₂, mesoporous SnO₂, or a mixture thereof. Said insulator shell **36** acts as a supplementary barrier against oxidation and can drain away the heat if it is a good thermal conductor.

According to one embodiment, as illustrated in Fig. 12E, the at least one nanoparticle **3** is a core **33**/crown **37** nanoparticle with a 2D structure, wherein the core **33** is covered with at least one crown **37.**

According to one embodiment, the at least one nanoparticle **3** is a core **33**/crown **37** nanoparticle, wherein the core **33** is covered with a crown **37** comprising at least one layer of material.

According to one embodiment, the at least one nanoparticle **3** is a core **33**/crown **37** nanoparticle, wherein the core **33** and the crown **37** are composed of the same material.

According to one embodiment, the at least one nanoparticle **3** is a core **33**/crown **37** nanoparticle, wherein the core **33** and the crown **37** are composed of at least two different materials.

According to one embodiment, the at least one nanoparticle **3** is a core **33**/crown **37** nanoparticle, wherein the core **33** is a luminescent core covered with at least one crown **37** selected in the group of magnetic material, plasmonic material, dielectric material, piezoelectric material, pyro-electric material, ferro-electric material, light scattering material, electrically insulating material, thermally insulating material, or catalytic material.

According to one embodiment, the at least one nanoparticle **3** is a core **33**/crown **37** nanoparticle, wherein the core **33** is a magnetic core covered with at least one crown **37** selected in the group of luminescent material, plasmonic material, dielectric material, piezoelectric material, pyro-electric material, ferro-electric material, light scattering material, electrically insulating material, thermally insulating material, or catalytic material.

According to one embodiment, the at least one nanoparticle **3** is a core **33**/crown **37** nanoparticle, wherein the core **33** is a plasmonic core covered with at least one crown **37** selected in the group of magnetic material, luminescent material, dielectric material, piezoelectric material, pyro-electric material, ferro-electric material, light scattering material, electrically insulating material, thermally insulating material, or catalytic material.

According to one embodiment, the at least one nanoparticle **3** is a core **33**/crown **37** nanoparticle, wherein the core **33** is a dielectric core covered with at least one crown **37** selected in the group of magnetic material, plasmonic material, luminescent material, piezoelectric material, pyro-electric material, ferro-electric material, light scattering material, electrically insulating material, thermally insulating material, or catalytic material.

According to one embodiment, the at least one nanoparticle **3** is a core **33**/crown **37** nanoparticle, wherein the core **33** is a piezoelectric core covered with at least one crown **37** selected in the group of magnetic material, plasmonic material, dielectric material, luminescent material, pyro-electric material, ferro-electric material, light scattering material, electrically insulating material, thermally insulating material, or catalytic material.

According to one embodiment, the at least one nanoparticle **3** is a core **33**/crown **37** nanoparticle, wherein the core **33** is a pyro-electric core covered with at least one crown **37** selected in the group of magnetic material, plasmonic material, dielectric material, luminescent material, piezoelectric material, ferro-electric material, light scattering material, electrically insulating material, thermally insulating material, or catalytic material.

According to one embodiment, the at least one nanoparticle **3** is a core **33**/crown **37** nanoparticle, wherein the core **33** is a ferro-electric core covered with at least one crown **37** selected in the group of magnetic material, plasmonic material, dielectric material, luminescent material, piezoelectric material, pyro-electric material, light scattering material, electrically insulating material, thermally insulating material, or catalytic material.

According to one embodiment, the at least one nanoparticle **3** is a core **33**/crown **37** nanoparticle, wherein the core **33** is a light scattering core covered with at least one crown **37** selected in the group of magnetic material, plasmonic material, dielectric material, luminescent material, piezoelectric material, pyro-electric material, ferro-electric material, electrically insulating material, thermally insulating material, or catalytic material.

According to one embodiment, the at least one nanoparticle **3** is a core **33**/crown **37** nanoparticle, wherein the core **33** is an electrically insulating core covered with at least one crown **37** selected in the group of magnetic material, plasmonic material, dielectric material, luminescent material, piezoelectric material, pyro-electric material, ferro-electric material, light scattering material, thermally insulating material, or catalytic material.

According to one embodiment, the at least one nanoparticle **3** is a core **33**/crown **37** nanoparticle, wherein the core **33** is a thermally insulating core covered with at least one crown **37** selected in the group of magnetic material, plasmonic material, dielectric material, luminescent material, piezoelectric material, pyro-electric material, ferro-electric material, light scattering material, electrically insulating material, or catalytic material.

According to one embodiment, the at least one nanoparticle **3** is a core **33**/crown **37** nanoparticle, wherein the core **33** is a catalytic core covered with at least one crown **37** selected in the group of magnetic material, plasmonic material, dielectric material, luminescent material, piezoelectric material, pyro-electric material, ferro-electric material, light scattering material, electrically insulating material, or thermally insulating material.

According to one embodiment, the at least one nanoparticle **3** is a core **33**/crown **37** nanoparticle, wherein the core **33** is covered with an insulator crown. In this embodiment, the insulator crown prevents the aggregation of the cores **33.**

According to one embodiment, the particle **2** comprises at least two nanoparticles **3** dispersed in the second material **21.**

According to one embodiment, the particle **2** comprises a plurality of nanoparticles **3** dispersed in the second material **21.**

According to one embodiment, the particle 2 comprises at least 1, at least 2, at least 3, at least 4, at least 5, at least 6, at least 7, at least 8, at least 9, at least 10, at least 11, at least 12, at least 13, at least 14, at least 15, at least 16, at least 17, at least 18, at least 19, at least 20, at least 21, at least 22, at least 23, at least 24, at least 25, at least 26, at least 27, at least 28, at least 29, at least 30, at least 31, at least 32, at least 33, at least 34, at least 35, at least 36, at least 37, at least 38, at least 39, at least 40, at least 41, at least 42, at least 43, at least 44, at least 45, at least 46, at least 47, at least 48, at least 49, at least 50, at least 51, at least 52, at least 53, at least 54, at least 55, at least 56, at least 57, at least 58, at least 59, at least 60, at least 61, at least 62, at least 63, at least 64, at least 65, at least 66, at least 67, at least 68, at least 69, at least 70, at least 71, at least 72, at least 73, at least 74, at least 75, at least 76, at least 77, at least 78, at least 79, at least 80, at least 81, at least 82, at least 83, at least 84, at least 85, at least 86, at least 87, at least 88, at least 89, at least 90, at least 91, at least 92, at least 93, at least 94, at least 95, at least 96, at least 97, at least 98, at least 99, at least 100, at least 200, at least 300, at least 400, at least 500, at least 600, at least 700, at least 800, at least 900, at least 1000, at least 1500, at least 2000, at least 2500, at least 3000, at least 3500, at least 4000, at least 4500, at least 5000, at least 5500, at least 6000, at least 6500, at least 7000, at least 7500, at least 8000, at least 8500, at least 9000, at least 9500, at least 10000, at least 15000, at least 20000, at least 25000, at least 30000, at least 35000, at least 40000, at least 45000, at least 50000, at least 55000, at least 60000, at least 65000, at least 70000, at least 75000, at least 80000, at least 85000, at least 90000, at least 95000, or at least 100000 nanoparticles **3** dispersed in the second material **21.**

According to one embodiment, the particle **2** comprises a combination of at least two different nanoparticles **3.** In this embodiment, the resulting particle **2** will exhibit different properties.

In a preferred embodiment, the particle **2** comprises at least two different nanoparticles **3,** wherein at least one nanoparticle **3** emits at a wavelength in the range from 500 to 560 nm, and at least one nanoparticle **3** emits at a wavelength in the range from 600 to 2500 nm. In this embodiment, the particle **2** comprises at least one nanoparticle **3** emitting in the green region of the visible spectrum and at least one nanoparticle **3** emitting in the red region of the visible spectrum, thus the particle **2** paired with a blue LED will be a white light emitter.

In a preferred embodiment, the particle **2** comprises at least two different nanoparticles **3,** wherein at least one nanoparticle **3** emits at a wavelength in the range from 400 to 490 nm, and at least one nanoparticle **3** emits at a wavelength in the range from 600 to 2500 nm. In this embodiment, the particle **2** comprises at least one nanoparticle **3** emitting in the blue region of the visible spectrum and at least one nanoparticle **3** emitting in the red region of the visible spectrum, thus the particle **2** will be a white light emitter.

In a preferred embodiment, the particle **2** comprises at least two different nanoparticles **3,** wherein at least one nanoparticle **3** emits at a wavelength in the range from 400 to 490 nm, and at least one nanoparticle **3** emits at a wavelength in the range from 500 to 560 nm. In this embodiment, the particle **2** comprises at least one nanoparticle **3** emitting in the blue region of the visible spectrum and at least one nanoparticle **3** emitting in the green region of the visible spectrum.

In a preferred embodiment, the particle **2** comprises three different nanoparticles **3,** wherein said nanoparticles **3** emit different emission wavelengths or color.

In a preferred embodiment, the particle **2** comprises at least three different nanoparticles **3,** wherein at least one nanoparticle **3** emits at a wavelength in the range from 400 to 490 nm, at least one nanoparticle **3** emits at a wavelength in the range from 500 to 560 nm and at least one nanoparticle **3** emits at a wavelength in the range from 600 to 2500 nm. In this embodiment, the particle **2** comprises at least one nanoparticle **3** emitting in the blue region of the visible spectrum, at least one nanoparticle **3** emitting in the green region of the visible spectrum and at least one nanoparticle **3** emitting in the red region of the visible spectrum

In a preferred embodiment, the particle **2** does not comprise any nanoparticle **3** on its surface. In this embodiment, the at least one nanoparticle **3** is completely surrounded by the second material **21.**

According to one embodiment, at least 100%, 95%, 90%, 85%, 80%, 75%, 70%, 65%, 60%, 55%, 50%, 45%, 40%, 35%, 30%, 25%, 20%, 15%, 10%, 5%, or 1% of nanoparticles **3** are comprised in the second material **21.** In this embodiment, each of said nanoparticles **3** is completely surrounded by the second material **21.**

According to one embodiment, the particle **2** comprises at least 100%, 95%, 90%, 85%, 80%, 75%, 70%, 65%, 60%, 55%, 50%, 45%, 40%, 35%, 30%, 25%, 20%, 15%, 10%, 5%, 1% or 0% of nanoparticles **3** on its surface.

According to one embodiment, the particle **2** comprises at least one nanoparticle **3** located on the surface of said particle **2.**

According to one embodiment, the particle **2** comprises at least one nanoparticle **3** dispersed in the second material **21,** *i.e*., totally surrounded by said second material **21;** and at least one nanoparticle **3** located on the surface of said particle **2.**

According to one embodiment, the particle **2** comprises at least one nanoparticle **3** dispersed in the second material **21,** wherein said at least one nanoparticle **3** emits at a wavelength in the range from 500 to 560 nm; and at least one nanoparticle **3** located on the surface of said particle **2,** wherein said at least one nanoparticle **3** emits at a wavelength in the range from 600 to 2500 nm.

According to one embodiment, the particle **2** comprises at least one nanoparticle **3** dispersed in the second material **21,** wherein said at least one nanoparticle **3** emits at a wavelength in the range from 600 to 2500 nm; and at least one nanoparticle **3** located on the surface of said particle **2,** wherein said at least one nanoparticle **3** emits at a wavelength in the range from 500 to 560 nm.

According to one embodiment, the at least one nanoparticle **3** is only located on the surface of said particle **2.** This embodiment is advantageous as the at least one nanoparticle **3** will be better excited by the incident light than if said nanoparticle **3** was dispersed in the second material **21.**

According to one embodiment, the at least one nanoparticle **3** located on the surface of said particle **2** may be chemically or physically adsorbed on said surface.

According to one embodiment, the at least one nanoparticle **3** located on the surface of said particle **2** may be adsorbed on said surface.

According to one embodiment, the at least one nanoparticle **3** located on the surface of said particle **2** may be adsorbed with a cement on said surface.

According to one embodiment, examples of cement include but are not limited to: polymers, silicone, oxides, or a mixture thereof.

According to one embodiment, the at least one nanoparticle **3** located on the surface of said particle **2** may have at least 1%, 2%, 3%, 4%, 5%, 6%, 7%, 8%, 9%, 10%, 15%, 20%, 25%, 30%, 35%, 40%, 45%, 50%, 55%, 60%, 65%, 70%, 75%, 80%, 85%, 90%, 95%, or 100% of its volume trapped in the second material **21.**

According to one embodiment, the plurality of nanoparticles **3** is uniformly spaced on the surface of the particle **2.**

According to one embodiment, each nanoparticle 3 of the plurality of nanoparticles **3** is spaced from its adjacent nanoparticle **3** by an average minimal distance.

According to one embodiment, the average minimal distance between two nanoparticles **3** is controlled.

According to one embodiment, the average minimal distance between two nanoparticles **3** on the surface of the particle 2 is at least 1 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 300 µm, 400 µm, 500 µm, 600 µm, 700 µm, 800 µm, 900 µm, or 1 mm.

According to one embodiment, the average distance between two nanoparticles 3 on the surface of the particle **2** is at least 1 nm, 1.5 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 300 µm, 400 µm, 500 µm, 600 µm, 700 µm, 800 µm, 900 µm, or 1 mm.

According to one embodiment, the average distance between two nanoparticles **3** on the surface of the particle **2** may have a deviation less or equal to 0.01%, 0.02%, 0.03%, 0.04%, 0.05%, 0.06%, 0.07%, 0.08%, 0.09%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 1.6%, 1.7%, 1.8%, 1.9%, 2%, 2.1%, 2.2%, 2.3%, 2.4%, 2.5%, 2.6%, 2.7%, 2.8%, 2.9%, 3%, 3.1%, 3.2%, 3.3%, 3.4%, 3.5%, 3.6%, 3.7%, 3.8%, 3.9%, 4%, 4.1%, 4.2%, 4.3%, 4.4%, 4.5%, 4.6%, 4.7%, 4.8%, 4.9%, 5%, 5.1%, 5.2%, 5.3%, 5.4%, 5.5%, 5.6%, 5.7%, 5.8%, 5.9%, 6%, 6.1%, 6.2%, 6.3%, 6.4%, 6.5%, 6.6%, 6.7%, 6.8%, 6.9%, 7%, 7.1%, 7.2%, 7.3%, 7.4%, 7.5%, 7.6%, 7.7%, 7.8%, 7.9%, 8%, 8.1%, 8.2%, 8.3%, 8.4%, 8.5%, 8.6%, 8.7%, 8.8%, 8.9%, 9%, 9.1%, 9.2%, 9.3%, 9.4%, 9.5%, 9.6%, 9.7%, 9.8%, 9.9%, 10%, 15%, 20%, 25%, 30%, 35%, 40%, 45%, or 50%.

According to one embodiment, a plurality of nanoparticles **3** is uniformly dispersed in the second material **21.**

The uniform dispersion of the plurality of nanoparticles **3** in the second material **21** comprised in the particle **2** prevents the aggregation of said nanoparticles **3,** thereby preventing the degradation of their properties. For example, in the case of inorganic fluorescent particles, a uniform dispersion will allow the optical properties of said particles to be preserved, and quenching can be avoided.

According to one embodiment, the nanoparticles **3** comprised in a particle **2** are uniformly dispersed within the second material **21** comprised in said particle **2.**

According to one embodiment, the nanoparticles **3** comprised in a particle **2** are dispersed within the second material **21** comprised in said particle **2.**

According to one embodiment, the nanoparticles **3** comprised in a particle **2** are uniformly and evenly dispersed within the second material **21** comprised in said particle **2.**

According to one embodiment, the nanoparticles **3** comprised in a particle **2** are evenly dispersed within the second material **21** comprised in said particle **2.**

According to one embodiment, the nanoparticles **3** comprised in a particle **2** are homogeneously dispersed within the second material **21** comprised in said particle **2.**

According to one embodiment, the dispersion of nanoparticles **3** in the second material **21** does not have the shape of a ring, or a monolayer.

According to one embodiment, each nanoparticle **3** of the plurality of nanoparticles **3** is spaced from its adjacent nanoparticle 3 by an average minimal distance.

According to one embodiment, the average minimal distance between two nanoparticles **3** is controlled.

According to one embodiment, the average minimal distance is at least 1 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 300 µm, 400 µm, 500 µm, 600 µm, 700 µm, 800 µm, 900 µm, or 1 mm.

According to one embodiment, the average distance between two nanoparticles 3 in the same particle 2 is at least 1 nm, 1.5 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 |im. 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 300 µm, 400 µm, 500 µm, 600 µm, 700 µm, 800 µm, 900 µm, or 1 mm

According to one embodiment, the average distance between two nanoparticles 3 in the same particle 2 may have a deviation less or equal to 0.01%, 0.02%, 0.03%, 0.04%, 0.05%, 0.06%, 0.07%, 0.08%, 0.09%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 1.6%, 1.7%, 1.8%, 1.9%, 2%, 2.1%, 2.2%, 2.3%, 2.4%, 2.5%, 2.6%, 2.7%, 2.8%, 2.9%, 3%, 3.1%, 3.2%, 3.3%, 3.4%, 3.5%, 3.6%, 3.7%, 3.8%, 3.9%, 4%, 4.1%, 4.2%, 4.3%, 4.4%, 4.5%, 4.6%, 4.7%, 4.8%, 4.9%, 5%, 5.1%, 5.2%, 5.3%, 5.4%, 5.5%, 5.6%, 5.7%, 5.8%, 5.9%, 6%, 6.1%, 6.2%, 6.3%, 6.4%, 6.5%, 6.6%, 6.7%, 6.8%, 6.9%, 7%, 7.1%, 7.2%, 7.3%, 7.4%, 7.5%, 7.6%, 7.7%, 7.8%, 7.9%, 8%, 8.1%, 8.2%, 8.3%, 8.4%, 8.5%, 8.6%, 8.7%, 8.8%, 8.9%, 9%, 9.1%, 9.2%, 9.3%, 9.4%, 9.5%, 9.6%, 9.7%, 9.8%, 9.9%, 10%, 15%, 20%, 25%, 30%, 35%, 40%, 45%, or 50%.

According to one embodiment, the at least one nanoparticle **3** is encapsulated into the second material **21** during the formation of said second material **21.** For example, said nanoparticle **3** are not inserted in nor put in contact with the second material **21** which have been previously obtained.

In a preferred embodiment, the particle **2** comprises at least one luminescent nanoparticle and at least one plasmonic nanoparticle.

According to one embodiment, the number of nanoparticles **3** comprised in the particle **2** depends mainly on the molar ratio or the mass ratio between the chemical species allowing to produce the second material **21** and the at least one nanoparticle **3.**

According to one embodiment, the at least one nanoparticle **3** represents at least 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, 91%, 92%, 93%, 94%, 95%, 96%, 97%, 98%, or 99% by weight of the particle **1.**

According to one embodiment, the loading charge of the at least one nanoparticle **3** in the particle **2** is at least 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, 91%, 92%, 93%, 94%, 95%, 96%, 97%, 98%, or 99%.

According to one embodiment, the loading charge of the at least one nanoparticle **3** in the particle **2** is less than 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, 91%, 92%, 93%, 94%, 95%, 96%, 97%, 98%, or 99%.

According to one embodiment, the nanoparticles **3** are not encapsulated in particle **2** via physical entrapment or electrostatic attraction.

According to one embodiment, the nanoparticles **3** and the second material **21** are not bonded or linked by electrostatic attraction or a functionalized silane based coupling agent.

According to one embodiment, the at least one nanoparticle **3** comprised in the particle **2** have a packing fraction of at least 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, or 95%.

According to one embodiment, the nanoparticles **3** comprised in the particle **2** are not aggregated.

According to one embodiment, the nanoparticles **3** comprised in the particle **2** do not touch, are not in contact.

According to one embodiment, the nanoparticles **3** comprised in the particle **2** are separated by second material **21.**

According to one embodiment, the at least one nanoparticle **3** comprised in the particle **2** can be individually evidenced.

According to one embodiment, the at least one nanoparticle **3** comprised in the particle **2** can be individually evidenced by transmission electron microscopy or fluorescence scanning microscopy, or any other characterization means known by the person skilled in the art.

According to one embodiment, as illustrated in Fig. 4 and Fig. 21, the particle **2** comprises a combination of at least two different nanoparticles **(31, 32).** In this embodiment, the particle **2,** thus the resulting particle **1** will exhibit different properties.

According to one embodiment, the particle **2** comprises at least one luminescent nanoparticle and at least one nanoparticle 3 selected in the group of magnetic nanoparticle, plasmonic nanoparticle, dielectric nanoparticle, piezoelectric nanoparticle, pyro-electric nanoparticle, ferro-electric nanoparticle, light scattering nanoparticle, electrically insulating nanoparticle, thermally insulating nanoparticle, or catalytic nanoparticle.

In a preferred embodiment, the particle **2** comprises at least two different luminescent nanoparticles, wherein said luminescent nanoparticles emit different emission wavelengths.

In a preferred embodiment, the particle **2** comprises at least two different luminescent nanoparticles, wherein at least one luminescent nanoparticle emits at a wavelength in the range from 500 to 560 nm, and at least one luminescent nanoparticle emits at a wavelength in the range from 600 to 2500 nm. In this embodiment, the particle **2** comprises at least one luminescent nanoparticle emitting in the green region of the visible spectrum and at least one luminescent nanoparticle emitting in the red region of the visible spectrum, thus the particle **1** paired with a blue LED will be a white light emitter.

In a preferred embodiment, the particle **2** comprises at least two different luminescent nanoparticles, wherein at least one luminescent nanoparticle emits at a wavelength in the range from 400 to 490 nm, and at least one luminescent nanoparticle emits at a wavelength in the range from 600 to 2500 nm. In this embodiment, the particle **2** comprises at least one luminescent nanoparticle emitting in the blue region of the visible spectrum and at least one luminescent nanoparticle emitting in the red region of the visible spectrum, thus the particle **1** will be a white light emitter.

In a preferred embodiment, the particle **2** comprises at least two different luminescent nanoparticles, wherein at least one luminescent nanoparticle emits at a wavelength in the range from 400 to 490 nm, and at least one luminescent nanoparticle emits at a wavelength in the range from 500 to 560 nm. In this embodiment, the particle **2** comprises at least one luminescent nanoparticle emitting in the blue region of the visible spectrum and at least one luminescent nanoparticle emitting in the green region of the visible spectrum.

In a preferred embodiment, the particle **2** comprises three different luminescent nanoparticles, wherein said luminescent nanoparticles emit at different emission wavelengths or color.

In a preferred embodiment, the particle **2** comprises at least three different luminescent nanoparticles, wherein at least one luminescent nanoparticle emits at a wavelength in the range from 400 to 490 nm, at least one luminescent nanoparticle emits at a wavelength in the range from 500 to 560 nm and at least one luminescent nanoparticle emits at a wavelength in the range from 600 to 2500 nm. In this embodiment, the particle **2** comprises at least one luminescent nanoparticle emitting in the blue region of the visible spectrum, at least one luminescent nanoparticle emitting in the green region of the visible spectrum and at least one luminescent nanoparticle emitting in the red region of the visible spectrum.

According to one embodiment, the particle **2** comprises at least one magnetic nanoparticle and at least one nanoparticle **3** selected in the group of luminescent nanoparticle, plasmonic nanoparticle, dielectric nanoparticle, piezoelectric nanoparticle, pyro-electric nanoparticle, ferro-electric nanoparticle, light scattering nanoparticle, electrically insulating nanoparticle, thermally insulating nanoparticle, or catalytic nanoparticle.

According to one embodiment, the particle **2** comprises at least one plasmonic nanoparticle and at least one nanoparticle **3** selected in the group of luminescent nanoparticle, magnetic nanoparticle, dielectric nanoparticle, piezoelectric nanoparticle, pyro-electric nanoparticle, ferro-electric nanoparticle, light scattering nanoparticle, electrically insulating nanoparticle, thermally insulating nanoparticle, or catalytic nanoparticle.

According to one embodiment, the particle **2** comprises at least one dielectric nanoparticle and at least one nanoparticle **3** selected in the group of luminescent nanoparticle, magnetic nanoparticle, plasmonic nanoparticle, piezoelectric nanoparticle, pyro-electric nanoparticle, ferro-electric nanoparticle, light scattering nanoparticle, electrically insulating nanoparticle, thermally insulating nanoparticle, or catalytic nanoparticle.

According to one embodiment, the particle **2** comprises at least one piezoelectric nanoparticle and at least one nanoparticle **3** selected in the group of luminescent nanoparticle, magnetic nanoparticle, dielectric nanoparticle, plasmonic nanoparticle, pyro-electric nanoparticle, ferro-electric nanoparticle, light scattering nanoparticle, electrically insulating nanoparticle, thermally insulating nanoparticle, or catalytic nanoparticle.

According to one embodiment, the particle **2** comprises at least one pyro-electric nanoparticle and at least one nanoparticle **3** selected in the group of luminescent nanoparticle, magnetic nanoparticle, dielectric nanoparticle, plasmonic nanoparticle, piezoelectric nanoparticle, ferro-electric nanoparticle, light scattering nanoparticle, electrically insulating nanoparticle, thermally insulating nanoparticle, or catalytic nanoparticle.

According to one embodiment, the particle **2** comprises at least one ferro-electric nanoparticle and at least one nanoparticle **3** selected in the group of luminescent nanoparticle, magnetic nanoparticle, dielectric nanoparticle, plasmonic nanoparticle, piezoelectric nanoparticle, pyro-electric nanoparticle, light scattering nanoparticle, electrically insulating nanoparticle, thermally insulating nanoparticle, or catalytic nanoparticle.

According to one embodiment, the particle **2** comprises at least one light scattering nanoparticle and at least one nanoparticle **3** selected in the group of luminescent nanoparticle, magnetic nanoparticle, dielectric nanoparticle, plasmonic nanoparticle, piezoelectric nanoparticle, pyro-electric nanoparticle, ferro-electric nanoparticle, electrically insulating nanoparticle, thermally insulating nanoparticle, or catalytic nanoparticle.

According to one embodiment, the particle **2** comprises at least one electrically insulating nanoparticle and at least one nanoparticle **3** selected in the group of luminescent nanoparticle, magnetic nanoparticle, dielectric nanoparticle, plasmonic nanoparticle, piezoelectric nanoparticle, pyro-electric nanoparticle, ferro-electric nanoparticle, light scattering nanoparticle, thermally insulating nanoparticle, or catalytic nanoparticle.

According to one embodiment, the particle **2** comprises at least one thermally insulating nanoparticle and at least one nanoparticle **3** selected in the group of luminescent nanoparticle, magnetic nanoparticle, dielectric nanoparticle, plasmonic nanoparticle, piezoelectric nanoparticle, pyro-electric nanoparticle, ferro-electric nanoparticle, light scattering nanoparticle, electrically insulating nanoparticle, or catalytic nanoparticle.

According to one embodiment, the particle **2** comprises at least one catalytic nanoparticle and at least one nanoparticle 3 selected in the group of luminescent nanoparticle, magnetic nanoparticle, dielectric nanoparticle, plasmonic nanoparticle, piezoelectric nanoparticle, pyro-electric nanoparticle, ferro-electric nanoparticle, light scattering nanoparticle, electrically insulating nanoparticle, or thermally insulating nanoparticle.

According to one embodiment, the particle **2** comprises at least one nanoparticle **3** without a shell and at least one nanoparticle **3** selected in the group of core **33**/shell **34** nanoparticles **3** and core **33**/insulator shell **36** nanoparticles **3.**

According to one embodiment, the particle **2** comprises at least one core **33**/shell **34** nanoparticle **3** and at least one nanoparticle **3** selected in the group of nanoparticles **3** without a shell and core **33**/insulator shell **36** nanoparticles **3.**

According to one embodiment, the particle **2** comprises at least one core **33**/insulator shell **36** nanoparticle **3** and at least one nanoparticle **3** selected in the group of nanoparticles **3** without a shell and core **33**/shell **34** nanoparticles **3.**

According to one embodiment, the at least one nanoparticle **3** is ROHS compliant.

According to one embodiment, the at least one nanoparticle **3** comprises less than 10 ppm, less than 20 ppm, less than 30 ppm, less than 40 ppm, less than 50 ppm, less than 100 ppm, less than 150 ppm, less than 200 ppm, less than 250 ppm, less than 300 ppm, less than 350 ppm, less than 400 ppm, less than 450 ppm, less than 500 ppm, less than 550 ppm, less than 600 ppm, less than 650 ppm, less than 700 ppm, less than 750 ppm, less than 800 ppm, less than 850 ppm, less than 900 ppm, less than 950 ppm, less than 1000 ppm in weight of cadmium.

According to one embodiment, the at least one nanoparticle **3** comprises less than 10 ppm, less than 20 ppm, less than 30 ppm, less than 40 ppm, less than 50 ppm, less than 100 ppm, less than 150 ppm, less than 200 ppm, less than 250 ppm, less than 300 ppm, less than 350 ppm, less than 400 ppm, less than 450 ppm, less than 500 ppm, less than 550 ppm, less than 600 ppm, less than 650 ppm, less than 700 ppm, less than 750 ppm, less than 800 ppm, less than 850 ppm, less than 900 ppm, less than 950 ppm, less than 1000 ppm, less than 2000 ppm, less than 3000 ppm, less than 4000 ppm, less than 5000 ppm, less than 6000 ppm, less than 7000 ppm, less than 8000 ppm, less than 9000 ppm, less than 10000 ppm in weight of lead.

According to one embodiment, the at least one nanoparticle **3** comprises less than 10 ppm, less than 20 ppm, less than 30 ppm, less than 40 ppm, less than 50 ppm, less than 100 ppm, less than 150 ppm, less than 200 ppm, less than 250 ppm, less than 300 ppm, less than 350 ppm, less than 400 ppm, less than 450 ppm, less than 500 ppm, less than 550 ppm, less than 600 ppm, less than 650 ppm, less than 700 ppm, less than 750 ppm, less than 800 ppm, less than 850 ppm, less than 900 ppm, less than 950 ppm, less than 1000 ppm, less than 2000 ppm, less than 3000 ppm, less than 4000 ppm, less than 5000 ppm, less than 6000 ppm, less than 7000 ppm, less than 8000 ppm, less than 9000 ppm, less than 10000 ppm in weight of mercury.

According to one embodiment, the at least one nanoparticle **3** in the second material **21** exhibits a degradation of their specific property of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years.

According to one embodiment, the at least one nanoparticle **3** in the second material **21** exhibits a degradation of their specific property of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the at least one nanoparticle **3** in the second material **21** exhibits a degradation of their specific property of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 10%, 20%, 30%, 40%, 50%, 55%, 60%, 65%, 70%, 75%, 80%, 85%, 90%, 95%, or 99% of humidity.

According to one embodiment, the at least one nanoparticle **3** in the second material **21** exhibits a degradation of their specific property of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the at least one nanoparticle **3** in the second material **21** exhibits a degradation of their specific property of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂.

According to one embodiment, the at least one nanoparticle **3** in the second material **21** exhibits a degradation of their specific property of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the at least one nanoparticle **3** in the second material **21** exhibits a degradation of their specific property of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0%, 10%, 20%, 30%, 40%, 50%, 55%, 60%, 65%, 70%, 75%, 80%, 85%, 90%, 95%, or 99% of humidity.

According to one embodiment, the at least one nanoparticle **3** in the second material **21** exhibits a degradation of their specific property of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the specific property of the at least one nanoparticle **3** comprises one or more of the following: fluorescence, phosphorescence, chemiluminescence, capacity of increasing local electromagnetic field, absorbance, magnetization, magnetic coercivity, catalytic yield, catalytic properties, photovoltaic properties, photovoltaic yield, electrical polarization, thermal conductivity, electrical conductivity, permeability to molecular oxygen, permeability to molecular water, or any other properties.

According to one embodiment, the at least one nanoparticle **3** in the second material **21** exhibits a degradation of their photoluminescence of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years.

According to one embodiment, the at least one nanoparticle **3** in the second material **21** exhibits a degradation of their photoluminescence of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the at least one nanoparticle **3** in the second material **21** exhibits a degradation of their photoluminescence of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 10%, 20%, 30%, 40%, 50%, 55%, 60%, 65%, 70%, 75%, 80%, 85%, 90%, 95%, or 99% of humidity.

According to one embodiment, the at least one nanoparticle **3** in the second material **21** exhibits a degradation of their photoluminescence of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the at least one nanoparticle **3** in the second material **21** exhibits a degradation of their photoluminescence of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂.

According to one embodiment, the at least one nanoparticle **3** in the second material **21** exhibits a degradation of their photoluminescence of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the at least one nanoparticle **3** in the second material **21** exhibits a degradation of their photoluminescence of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0%, 10%, 20%, 30%, 40%, 50%, 55%, 60%, 65%, 70%, 75%, 80%, 85%, 90%, 95%, or 99% of humidity.

According to one embodiment, the at least one nanoparticle **3** in the second material **21** exhibits a degradation of their photoluminescence of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the at least one nanoparticle **3** in the second material **21** exhibits a degradation of their photoluminescence quantum yield (PLQY) of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years.

According to one embodiment, the at least one nanoparticle **3** in the second material **21** exhibits a degradation of their photoluminescence quantum yield (PLQY) of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the at least one nanoparticle **3** in the second material **21** exhibits a degradation of their photoluminescence quantum yield (PLQY) of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 10%, 20%, 30%, 40%, 50%, 55%, 60%, 65%, 70%, 75%, 80%, 85%, 90%, 95%, or 99% of humidity.

According to one embodiment, the at least one nanoparticle **3** in the second material **21** exhibits a degradation of their photoluminescence quantum yield (PLQY) of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the at least one nanoparticle **3** in the second material **21** exhibits a degradation of their photoluminescence quantum yield (PLQY) of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂.

According to one embodiment, the at least one nanoparticle **3** in the second material **21** exhibits a degradation of their photoluminescence quantum yield (PLQY) of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the at least one nanoparticle **3** in the second material **21** exhibits a degradation of their photoluminescence quantum yield (PLQY) of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0%, 10%, 20%, 30%, 40%, 50%, 55%, 60%, 65%, 70%, 75%, 80%, 85%, 90%, 95%, or 99% of humidity.

According to one embodiment, the at least one nanoparticle **3** in the second material **21** exhibits a degradation of their photoluminescence quantum yield (PLQY) of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the at least one nanoparticle **3** in the second material **21** exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years.

According to one embodiment, the at least one nanoparticle **3** in the second material **21** exhibits a degradation of its FCE of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the at least one nanoparticle **3** in the second material **21** exhibits a degradation of its FCE of less than 90%, 80%, 70%, 60%, 50%, 40%, 30%, 25%, 20%, 10%, 5%, 4%, 3%, 2%, 1%, or 0% under 0%, 10%, 20%, 30%, 40%, 50%, 55%, 60%, 65%, 70%, 75%, 80%, 85%, 90%, 95%, or 99% of humidity.

According to one embodiment, the at least one nanoparticle **3** in the second material **21** exhibits a degradation of its FCE of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the at least one nanoparticle **3** in the second material **21** exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0%, 10%, 20%, 30%, 40%, 50%, 55%, 60%, 65%, 70%, 75%, 80%, 85%, 90%, 95%, or 99% of humidity.

According to one embodiment, the at least one nanoparticle **3** in the second material **21** exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the at least one nanoparticle **3** in the second material **21** exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the at least one nanoparticle **3** in the second material **21** exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂.

According to one embodiment, the at least one nanoparticle **3** in the second material **21** exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the at least one nanoparticle **3** in the second material **21** exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0%, 10%, 20%, 30%, 40%, 50%, 55%, 60%, 65%, 70%, 75%, 80%, 85%, 90%, 95%, or 99% of humidity.

According to one embodiment, the at least one nanoparticle **3** in the second material **21** exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the at least one nanoparticle **3** is a colloidal nanoparticle.

According to one embodiment, the at least one nanoparticle **3** is dispersible in aqueous solvents, organic solvents and/or mixture thereof. According to one embodiment, the nanoparticles **3** are colloidal nanoparticles.

According to one embodiment, the nanoparticle **3** is an electrically charged nanoparticle.

According to one embodiment, the nanoparticle **3** is not electrically charged nanoparticle.

According to one embodiment, the nanoparticle **3** is not positively charged nanoparticle.

According to one embodiment, the nanoparticle **3** is not negatively charged nanoparticle.

According to one embodiment, the at least one nanoparticle **3** is an inorganic nanoparticle.

According to one embodiment, the nanoparticle **3** comprises an inorganic material. Said inorganic material is the same or different from the second material **21.**

According to one embodiment, the particle **1** comprises at least one inorganic nanoparticle and at least one organic nanoparticle.

According to one embodiment, the at least one nanoparticle **3** is not a ZnO nanoparticle.

According to one embodiment, the at least one nanoparticle **3** is not a metal nanoparticle.

According to one embodiment, the particle **1** does not comprise only metal nanoparticles.

According to one embodiment, the particle **1** does not comprise only magnetic nanoparticles.

According to one embodiment, the inorganic nanoparticle is a colloidal nanoparticle.

According to one embodiment, the inorganic nanoparticle is amorphous.

According to one embodiment, the inorganic nanoparticle is crystalline.

According to one embodiment, the inorganic nanoparticle is totally crystalline.

According to one embodiment, the inorganic nanoparticle is partially crystalline.

According to one embodiment, the inorganic nanoparticle is monocrystalline.

According to one embodiment, the inorganic nanoparticle is polycrystalline. In this embodiment, each inorganic nanoparticle comprises at least one grain boundary.

According to one embodiment, the inorganic nanoparticle is a nanocrystal.

According to one embodiment, the inorganic nanoparticle is composed of a material selected in the group of metals, halides, chalcogenides, phosphides, sulfides, metalloids, metallic alloys, ceramics such as for example oxides, carbides, nitrides, glasses, enamels, ceramics, stones, precious stones, pigments, cements and/or inorganic polymers. Said inorganic nanoparticles are prepared using protocols known to the person skilled in the art.

According to one embodiment, the inorganic nanoparticle is composed of a material selected in the group of metals, halides, chalcogenides, phosphides, sulfides, metalloids, metallic alloys, ceramics such as for example oxides, carbides, or nitrides. Said inorganic nanoparticles are prepared using protocols known to the person skilled in the art.

According to one embodiment, the inorganic nanoparticle is selected in the group of metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof. Said nanoparticles are prepared using protocols known to the person skilled in the art.

According to one embodiment, the inorganic nanoparticle is selected from metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof, preferably is a semiconductor nanocrystal.

According to one embodiment, a chalcogenide is a chemical compound consisting of at least one chalcogen anion selected in the group of O, S, Se, Te, Po, and at least one or more electropositive element.

According to one embodiment, examples of chalcogenide nanoparticles include but are not limited to: CdO, CdS, CdSe, CdTe, ZnO, ZnS, ZnSe, ZnTe, HgO, HgS, HgSe, HgTe, CuO, Cu₂O, CuS, Cu₂S, CuSe, CuTe, Ag₂O, Ag₂S, Ag₂Se, Ag₂Te, Au₂S, PdO, PdS, Pd₄S, PdSe, PdTe, PtO, PtS, PtS₂, PtSe, PtTe, RhO₂, Rh₂O₃, RhS2, Rh₂S₃, RhSe₂, Rh₂Se₃, RhTe₂, IrO₂, IrS₂, Ir₂S₃, IrSe₂, IrTe₂, RuO₂, RuS₂, OsO, OsS, OsSe, OsTe, MnO, MnS, MnSe, MnTe, ReO₂, ReS₂, Cr₂O₃, Cr₂S₃, MoO₂, MoS₂, MoSe₂, MoTe₂, WO₂, WS₂, WSe₂, V₂O₅, V₂S₃, Nb₂O₅, NbS₂, NbSe₂, HfO₂, HfS₂, TiO₂, ZrO₂, ZrS₂, ZrSe₂, ZrTe₂, Sc₂O₃, Y₂O₃, Y₂S₃, SiO₂, GeO₂, GeS, GeS₂, GeSe, GeSe₂, GeTe, SnO₂, SnS, SnS₂, SnSe, SnSe₂, SnTe, PbO, PbS, PbSe, PbTe, MgO, MgS, MgSe, MgTe, CaO, CaS, SrO, Al₂O₃, Ga₂O₃, Ga₂S₃, Ga₂Se₃, In₂O₃, In₂S₃, In₂Se₃, In₂Te₃, La₂O₃, La₂S₃, CeO₂, CeS₂, Pr₆O₁₁, Nd₂O₃, NdS₂, La₂O₃, Tl₂O, Sm₂O₃, SmS₂, Eu₂O₃, EuS₂, Bi₂O₃, Sb₂O₃, PoO₂, SeO₂, Cs₂O, Tb₄O₇, TbS₂, Dy₂O₃, Ho₂O3, Er₂O3, ErS2, Tm₂O₃, Yb₂O₃, Lu₂O₃, CuInS₂, CuInSe₂, AgInS₂, AgInSe2, Fe₂O₃, Fe₃O₄, FeS, FeS2, Co₃S₄, CoSe, Co₃O₄, NiO, NiSe₂, NiSe, Ni₃Se₄, Gd₂O₃, BeO, TeO₂, Na₂O, BaO, K₂O, Ta₂O₅, Li₂O, Tc₂O₇, As₂O₃, B₂O₃, P₂O₅, P₂O₃, P₄O₇, P₄O₈, P₄O₉, P₂O₆, PO, or a mixture thereof.

According to one embodiment, examples of phosphide nanoparticles include but are not limited to: InP, Cd₃P₂, Zn₃P₂, AlP, GaP, TIP, or a mixture thereof.

According to one embodiment, the at least one nanoparticle **3** is an inorganic semiconductor or insulator which can be coated with organic compounds.

According to one embodiment, the inorganic semiconductor or insulator can be, for instance, group IV semiconductors (for instance, Carbon, Silicon, Germanium), group III-V compound semiconductors (for instance, Gallium Nitride, Indium Phosphide, Gallium Arsenide), II-VI compound semiconductors (for instance, Cadmium Selenide, Zinc Selenide, Cadmium Sulfide, Mercury Telluride), inorganic oxides (for instance, Indium Tin Oxide, Aluminum Oxide, Titanium Oxide, Silicon Oxide), and other chalcogenides.

According to one embodiment, the nanoparticle **3** is an inorganic semiconductor or insulator which can be coated with organic compounds.

According to one embodiment, the inorganic semiconductor or insulator can be, for instance, group IV semiconductors (for instance, Carbon, Silicon, Germanium), group III-V compound semiconductors (for instance, Gallium Nitride, Indium Phosphide, Gallium Arsenide), II-VI compound semiconductors (for instance, Cadmium Selenide, Zinc Selenide, Cadmium Sulfide, Mercury Telluride), inorganic oxides (for instance, Indium Tin Oxide, Aluminum Oxide, Titanium Oxide, Silicon Oxide), and other chalcogenides.

According to one embodiment, the inorganic nanoparticle is a semiconductor nanocrystal.

According to one embodiment, the semiconductor nanocrystal comprises a material of formula MₓN_{y}E_{z}A_{w}, wherein: M is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; N is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; E is selected from the group consisting of O, S, Se, Te, C, N, P, As, Sb, F, Cl, Br, I, or a mixture thereof; A is selected from the group consisting of O, S, Se, Te, C, N, P, As, Sb, F, Cl, Br, I, or a mixture thereof; x, y, z and w are independently a decimal number from 0 to 5; x, y, z and w are not simultaneously equal to 0; x and y are not simultaneously equal to 0; z and w may not be simultaneously equal to 0.

According to one embodiment, the semiconductor nanocrystal comprises a core comprising a material of formula MₓN_{y}E_{z}A_{w}, wherein: M is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; N is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; E is selected from the group consisting of O, S, Se, Te, C, N, P, As, Sb, F, Cl, Br, I, or a mixture thereof; A is selected from the group consisting of O, S, Se, Te, C, N, P, As, Sb, F, Cl, Br, I, or a mixture thereof; x, y, z and w are independently a decimal number from 0 to 5; x, y, z and w are not simultaneously equal to 0; x and y are not simultaneously equal to 0; z and w may not be simultaneously equal to 0.

According to one embodiment, the semiconductor nanocrystal comprises a material of formula MₓN_{y}E_{z}A_{w}, wherein M and/or N is selected from the group consisting of Ib, IIa, IIb, IIIa, IIIb, IVa, IVb, Va, Vb, VIb, VIIb, VIII, or mixtures thereof; E and/or A is selected from the group consisting of Va, VIa, VIIa, or mixtures thereof; x, y, z and w are independently a decimal number from 0 to 5; x, y, z and w are not simultaneously equal to 0; x and y are not simultaneously equal to 0; z and w may not be simultaneously equal to 0.

According to one embodiment, the semiconductor nanocrystal comprises a material of formula MₓE_{y}, wherein M is selected from group consisting of Cd, Zn, Hg, Ge, Sn, Pb, Cu, Ag, Fe, In, Al, Ti, Mg, Ga, Tl, Mo, Pd, W, Cs, Pb, or a mixture thereof; x and y are independently a decimal number from 0 to 5, x and y are not simultaneously equal to 0.

According to one embodiment, the semiconductor nanocrystal comprises a material of formula MₓE_{y}, wherein E is selected from group consisting of S, Se, Te, O, P, C, N, As, Sb, F, Cl, Br, I, or a mixture thereof; x and y are independently a decimal number from 0 to 5, x and y are not simultaneously equal to 0.

According to one embodiment, the semiconductor nanocrystal is selected from the group consisting of a IIb-VIa, IVa-VIa, Ib-IIIa-VIa, IIb-IVa-Va, Ib-VIa, VIII-VIa, IIb-Va, IIIa-VIa, IVb-VIa, IIa-VIa, IIIa-Va, IIIa-VIa, VIb-VIa, and Va-VIa semiconductor.

According to one embodiment, the semiconductor nanocrystal comprises a material MₓN_{y}E_{z}A_{w} selected from the group consisting of CdS, CdSe, CdTe, ZnS, ZnSe, ZnTe, HgS, HgSe, HgTe, HgO, GeS, GeSe, GeTe, SnS, SnSe, SnTe, PbS, PbSe, PbTe, GeS₂, GeSe₂, SnS₂, SnSe₂, CuInS₂, CuInSe₂, AgInS₂, AgInSe₂, CuS, Cu₂S, Ag₂S, Ag₂Se, Ag₂Te, FeS, FeS₂, InP, Cd₃P₂, Zn₃P₂, CdO, ZnO, FeO, Fe₂O₃, Fe₃O₄, Al₂O₃, TiO₂, MgO, MgS, MgSe, MgTe, AlN, AlP, AlAs, AlSb, GaN, GaP, GaAs, GaSb, InN, InP, InAs, InSb, TIN, TIP, TIAs, TISb, MOS₂, PdS, Pd₄S, WS₂, CsPbCl₃, PbBr₃, CsPbBr₃, CH₃NH₃PbI₃, CH₃NH₃PbCl₃, CH₃NH₃PbBr₃, CsPbI₃, FAPbBr₃ (with FA formamidinium), or a mixture thereof.

According to one embodiment, the inorganic nanoparticle is a semiconductor nanoplatelet, nanosheet, nanoribbon, nanowire, nanodisk, nanocube, nanoring, magic size cluster, or sphere such as for example quantum dot.

According to one embodiment, the inorganic nanoparticle is a semiconductor nanoplatelet, nanosheet, nanoribbon, nanowire, nanodisk, nanocube, magic size cluster, or nanoring.

According to one embodiment, the inorganic nanoparticle comprises an initial nanocrystal.

According to one embodiment, the inorganic nanoparticle comprises an initial colloidal nanocrystal.

According to one embodiment, the inorganic nanoparticle comprises an initial nanoplatelet.

According to one embodiment, the inorganic nanoparticle comprises an initial colloidal nanoplatelet.

According to one embodiment, the inorganic nanoparticle is a core nanoparticle, wherein the core is not partially or totally covered with at least one shell comprising at least one layer of inorganic material.

According to one embodiment, the inorganic nanoparticle is a core nanocrystal, wherein the core is not partially or totally covered with a shell comprising at least one layer of inorganic material.

According to one embodiment, the inorganic nanoparticle is a core/shell nanoparticle, wherein the core is partially or totally covered with at least one shell comprising at least one layer of inorganic material.

According to one embodiment, the inorganic nanoparticle is a core 33/shell 34 nanocrystal, wherein the core 33 is partially or totally covered with at least one shell 34 comprising at least one layer of inorganic material.

According to one embodiment, the core/shell semiconductor nanocrystal comprises at least one shell 34 comprising a material of formula MₓN_{y}E_{z}A_{w}, wherein: M is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; N is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; E is selected from the group consisting of O, S, Se, Te, C, N, P, As, Sb, F, Cl, Br, I, or a mixture thereof; A is selected from the group consisting of O, S, Se, Te, C, N, P, As, Sb, F, Cl, Br, I, or a mixture thereof; and x, y, z and w are independently a decimal number from 0 to 5; x, y, z and w are not simultaneously equal to 0; x and y are not simultaneously equal to 0; z and w may not be simultaneously equal to 0.

According to one embodiment, the core/shell semiconductor nanocrystal comprises two shells (34, 35) comprising a material of formula MₓN_{y}E_{z}A_{w}, wherein: M is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; N is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; E is selected from the group consisting of O, S, Se, Te, C, N, P, As, Sb, F, Cl, Br, I, or a mixture thereof; A is selected from the group consisting of O, S, Se, Te, C, N, P, As, Sb, F, Cl, Br, I, or a mixture thereof; and x, y, z and w are independently a decimal number from 0 to 5; x, y, z and w are not simultaneously equal to 0; x and y are not simultaneously equal to 0; z and w may not be simultaneously equal to 0.

According to one embodiment, the shell **34** comprises a different material than the material of core **33.**

According to one embodiment, the shell **34** comprises the same material than the material of core **33.**

According to one embodiment, the shells **(34, 35)** comprise different materials.

According to one embodiment, the shells **(34, 35)** comprise the same material.

According to one embodiment, the core/shell semiconductor nanocrystal comprises at least one shell comprising a material of formula MₓN_{y}E_{z}A_{w}, wherein M, N, E and A are as described hereabove.

According to one embodiment, examples of core/shell semiconductor nanocrystals include but are not limited to: CdSe/CdS, CdSe/CdₓZn₁₋ₓS, CdSe/CdS/ZnS, CdSe/ZnS/CdS, CdSe/ZnS, CdSe/CdₓZn₁₋ₓS/ZnS, CdSe/ZnS/CdₓZn₁₋ₓS, CdSe/CdS/CdₓZn₁₋ₓS, CdSe/ZnSe/ZnS, CdSe/ZnSe/CdₓZn₁₋ₓS, CdSeₓS₁₋ₓ/CdS, CdSeₓS₁₋ₓ/CdZnS, CdSeₓS₁₋ₓ/CdS/ZnS, CdSeₓS₁₋ₓ/ZnS/CdS, CdSeₓS₁₋ₓ/ZnS, CdSeₓS₁₋ₓ/CdₓZn₁₋ₓS/ZnS, CdSeₓS₁₋ₓ/ZnS/CdₓZn₁₋ₓS, CdSeₓS₁₋ₓ/CdS/CdₓZn₁₋ₓS, CdSeₓS₁₋ₓ/ZnSe/ZnS, CdSeₓS₁₋ₓ/ZnSe/CdₓZn₁₋ₓS, InP/CdS, InP/CdS/ZnSe/ZnS, InP/CdₓZn₁₋ₓS, InP/CdS/ZnS, InP/ZnS/CdS, InP/ZnS, InP/CdₓZn₁₋ₓS/ZnS, InP/ZnS/CdₓZn₁₋ₓS, InP/CdS/CdₓZn₁₋ₓS, InP/ZnSe, InP/ZnSe/ZnS, InP/ZnSe/CdₓZn₁₋ₓS, InP/ZnSeₓS₁₋ₓ, InP/GaP/ZnS, InₓZn₁₋ₓP/ZnS, InₓZn₁₋ₓP/ZnS, InP/GaP/ZnSe, InP/ZnS/ZnSe, InP/GaP/ZnSe/ZnS, InP/ZnS/ZnSe/ZnS, wherein x is a decimal number from 0 to 1.

According to one embodiment, the core/shell semiconductor nanocrystal is ZnS rich, *i.e.*, the last monolayer of the shell is a ZnS monolayer.

According to one embodiment, the core/shell semiconductor nanocrystal is CdS rich, *i.e.*, the last monolayer of the shell is a CdS monolayer.

According to one embodiment, the core/shell semiconductor nanocrystal is CdₓZn₁₋ₓS rich, *i.e.*, the last monolayer of the shell is a CdₓZn₁₋ₓS monolayer, wherein x is a decimal number from 0 to 1.

According to one embodiment, the last atomic layer of the semiconductor nanocrystal is a cation-rich monolayer of cadmium, zinc or indium.

According to one embodiment, the last atomic layer of the semiconductor nanocrystal is an anion-rich monolayer of sulfur, selenium or phosphorus.

According to one embodiment, the inorganic nanoparticle is a core/crown semiconductor nanocrystal.

According to one embodiment, the core/crown semiconductor nanocrystal comprises at least one crown **37** comprising a material of formula MₓN_{y}E_{z}A_{w}, wherein: M is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; N is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; E is selected from the group consisting of O, S, Se, Te, C, N, P, As, Sb, F, Cl, Br, I, or a mixture thereof; A is selected from the group consisting of O, S, Se, Te, C, N, P, As, Sb, F, Cl, Br, I, or a mixture thereof; and x, y, z and w are independently a decimal number from 0 to 5; x, y, z and w are not simultaneously equal to 0; x and y are not simultaneously equal to 0; z and w may not be simultaneously equal to 0.

According to one embodiment, the core/crown semiconductor nanocrystal comprises at least one crown comprising a material of formula MₓN_{y}E_{z}A_{w}, wherein M, N, E and A are as described hereabove.

According to one embodiment, the crown **37** comprises a different material than the material of core **33.**

According to one embodiment, the crown **37** comprises the same material than the material of core **33.**

According to one embodiment, the semiconductor nanocrystal is atomically flat. In this embodiment, the atomically flat semiconductor nanocrystal may be evidenced by transmission electron microscopy or fluorescence scanning microscopy, energy-dispersive X-ray spectroscopy (EDS), X-Ray photoelectron spectroscopy (XPS), UV photoelectron spectroscopy (UPS), electron energy loss spectroscopy (EELS), photoluminescence or any other characterization means known by the person skilled in the art.

According to one embodiment, the semiconductor nanocrystal comprises an atomically flat core. In this embodiment, the atomically flat core may be evidenced by transmission electron microscopy or fluorescence scanning microscopy, energy-dispersive X-ray spectroscopy (EDS), X-Ray photoelectron spectroscopy (XPS), UV photoelectron spectroscopy (UPS), electron energy loss spectroscopy (EELS), photoluminescence or any other characterization means known by the person skilled in the art.

According to one embodiment, the semiconductor nanocrystal is a semiconductor nanoplatelet.

According to one embodiment, the nanoparticles 3 comprise at least 1%, 5%, 10%, 15%, 20%, 25%, 30%, 35%, 40%, 45%, 50%, 55%, 60%, 65%, 70%, 75%, 80%, 85%, 90%, 95%, or 100% of semiconductor nanoplatelets.

According to one embodiment, the inorganic nanoparticles comprise at least 1%, 5%, 10%, 15%, 20%, 25%, 30%, 35%, 40%, 45%, 50%, 55%, 60%, 65%, 70%, 75%, 80%, 85%, 90%, 95%, or 100% of semiconductor nanoplatelets.

According to one embodiment, the semiconductor nanocrystals comprise at least 1%, 5%, 10%, 15%, 20%, 25%, 30%, 35%, 40%, 45%, 50%, 55%, 60%, 65%, 70%, 75%, 80%, 85%, 90%, 95%, or 100% of semiconductor nanoplatelets.

According to one embodiment, the particle **1** comprises at least 1%, 5%, 10%, 15%, 20%, 25%, 30%, 35%, 40%, 45%, 50%, 55%, 60%, 65%, 70%, 75%, 80%, 85%, 90%, 95%, or 100% of semiconductor nanoplatelets.

According to one embodiment, the particle **2** comprises at least 1%, 5%, 10%, 15%, 20%, 25%, 30%, 35%, 40%, 45%, 50%, 55%, 60%, 65%, 70%, 75%, 80%, 85%, 90%, 95%, or 100% of semiconductor nanoplatelets.

According to one embodiment, the semiconductor nanoplatelet is atomically flat. In this embodiment, the atomically flat nanoplatelet may be evidenced by transmission electron microscopy or fluorescence scanning microscopy, energy-dispersive X-ray spectroscopy (EDS), X-Ray photoelectron spectroscopy (XPS), UV photoelectron spectroscopy (UPS), electron energy loss spectroscopy (EELS), photoluminescence or any other characterization means known by the person skilled in the art.

According to one embodiment, the semiconductor nanocrystal comprises an initial nanoplatelet.

According to one embodiment, the semiconductor nanocrystal comprises an initial colloidal nanoplatelet.

According to one embodiment, the semiconductor nanoplatelet is quasi-2D.

According to one embodiment, the semiconductor nanoplatelet comprises an atomically flat core. In this embodiment, the atomically flat core may be evidenced by transmission electron microscopy or fluorescence scanning microscopy, energy-dispersive X-ray spectroscopy (EDS), X-Ray photoelectron spectroscopy (XPS), UV photoelectron spectroscopy (UPS), electron energy loss spectroscopy (EELS), photoluminescence, or any other characterization means known by the person skilled in the art.

According to one embodiment, the semiconductor nanoplatelet is 2D-shaped.

According to one embodiment, the semiconductor nanoplatelet has a thickness tuned at the atomic level.

According to one embodiment, the semiconductor nanoplatelet comprises an initial nanocrystal.

According to one embodiment, the semiconductor nanoplatelet comprises an initial colloidal nanocrystal.

According to one embodiment, the semiconductor nanoplatelet comprises an initial nanoplatelet.

According to one embodiment, the semiconductor nanoplatelet comprises an initial colloidal nanoplatelet.

According to one embodiment, the core **33** of the semiconductor nanoplatelet is an initial nanoplatelet.

According to one embodiment, the initial nanoplatelet comprises a material of formula MₓN_{y}E_{z}A_{w}, wherein M, N, E and A are as described hereabove.

According to one embodiment, the thickness of the initial nanoplatelet comprises an alternate of atomic layers of M and E.

According to one embodiment, the thickness of the initial nanoplatelet comprises an alternate of atomic layers of M, N, A and E.

According to one embodiment, a semiconductor nanoplatelet comprises an initial nanoplatelet partially or completely covered with at least one layer of additional material.

According to one embodiment, the at least one layer of additional material comprises a material of formula MₓN_{y}E_{z}A_{w}, wherein M, N, E and A are as described hereabove.

According to one embodiment, a semiconductor nanoplatelet comprises an initial nanoplatelet partially or completely covered on a least one facet by at least one layer of additional material.

In one embodiment wherein several layers cover all or part of the initial nanoplatelet, these layers can be composed of the same material or composed of different materials.

In one embodiment wherein several layers cover all or part of the initial nanoplatelet, these layers can be composed such as to form a gradient of materials.

In one embodiment, the initial nanoplatelet is an inorganic colloidal nanoplatelet.

In one embodiment, the initial nanoplatelet comprised in the semiconductor nanoplatelet has preserved its 2D structure.

In one embodiment, the material covering the initial nanoplatelet is inorganic.

In one embodiment, at least one part of the semiconductor nanoplatelet has a thickness greater than the thickness of the initial nanoplatelet.

In one embodiment, the semiconductor nanoplatelet comprises the initial nanoplatelet totally covered with at least one layer of material.

In one embodiment, the semiconductor nanoplatelet comprises the initial nanoplatelet totally covered with a first layer of material, said first layer being partially or completely covered with at least a second layer of material.

In one embodiment, the initial nanoplatelet has a thickness of at least 0.3 nm, 0.4 nm, 0.5 nm, 0.6 nm, 0.7 nm, 0.8 nm, 0.9 nm, 1.0 nm, 1.1 nm, 1.2 nm, 1.3 nm, 1.4 nm, 1.5 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 90 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, or 500 nm.

According to one embodiment, the thickness of the initial nanoplatelet is smaller than at least one of the lateral dimensions (length or width) of the initial nanoplatelet by a factor (aspect ratio) of at least 1.5; of at least 2; at least 2.5; at least 3; at least 3.5; at least 4; at least 4.5; at least 5; at least 5.5; at least 6; at least 6.5; at least 7; at least 7.5; at least 8; at least 8.5; at least 9; at least 9.5; at least 10; at least 10.5; at least 11; at least 11.5; at least 12; at least 12.5; at least 13; at least 13.5; at least 14; at least 14.5; at least 15; at least 15.5; at least 16; at least 16.5; at least 17; at least 17.5; at least 18; at least 18.5; at least 19; at least 19.5; at least 20; at least 25; at least 30; at least 35; at least 40; at least 45; at least 50; at least 55; at least 60; at least 65; at least 70; at least 75; at least 80; at least 85; at least 90; at least 95; at least 100; at least 150; at least 200; at least 250; at least 300; at least 350; at least 400; at least 450; at least 500; at least 550; at least 600; at least 650; at least 700; at least 750; at least 800; at least 850; at least 900; at least 950; or at least 1000.

In one embodiment, the initial nanoplatelet has lateral dimensions of at least 2 nm, 3 nm, 4 nm, 5 nm, 6 nm, 7 nm, 8 nm, 9 nm, 10 nm, 15 nm, 20 nm, 25 nm, 30 nm, 35 nm, 40 nm, 45 nm, 50 nm, 55 nm, 60 nm, 65 nm, 70 nm, 75 nm, 80 nm, 85 nm, 90 nm, 95 nm, 100 nm, 105 nm, 110 nm, 115 nm, 120 nm, 125 nm, 130 nm, 135 nm, 140 nm, 145 nm, 150 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm

According to one embodiment, the semiconductor nanoplatelet has a thickness of at least 0.3 nm, 0.4 nm, 0.5 nm, 0.6 nm, 0.7 nm, 0.8 nm, 0.9 nm, 1.0 nm, 1.1 nm, 1.2 nm, 1.3 nm, 1.4 nm, 1.5 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 90 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, or 500 nm.

According to one embodiment, the semiconductor nanoplatelet has lateral dimensions of at least 2 nm, 3 nm, 4 nm, 5 nm, 6 nm, 7 nm, 8 nm, 9 nm, 10 nm, 15 nm, 20 nm, 25 nm, 30 nm, 35 nm, 40 nm, 45 nm, 50 nm, 55 nm, 60 nm, 65 nm, 70 nm, 75 nm, 80 nm, 85 nm, 90 nm, 95 nm, 100 nm, 105 nm, 110 nm, 115 nm, 120 nm, 125 nm, 130 nm, 135 nm, 140 nm, 145 nm, 150 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the thickness of the semiconductor nanoplatelet is smaller than at least one of the lateral dimensions (length or width) of the semiconductor nanoplatelet by a factor (aspect ratio) of at least 1.5; of at least 2; at least 2.5; at least 3; at least 3.5; at least 4; at least 4.5; at least 5; at least 5.5; at least 6; at least 6.5; at least 7; at least 7.5; at least 8; at least 8.5; at least 9; at least 9.5; at least 10; at least 10.5; at least 11; at least 11.5; at least 12; at least 12.5; at least 13; at least 13.5; at least 14; at least 14.5; at least 15; at least 15.5; at least 16; at least 16.5; at least 17; at least 17.5; at least 18; at least 18.5; at least 19; at least 19.5; at least 20; at least 25; at least 30; at least 35; at least 40; at least 45; at least 50; at least 55; at least 60; at least 65; at least 70; at least 75; at least 80; at least 85; at least 90; at least 95; at least 100; at least 150; at least 200; at least 250; at least 300; at least 350; at least 400; at least 450; at least 500; at least 550; at least 600; at least 650; at least 700; at least 750; at least 800; at least 850; at least 900; at least 950; or at least 1000.

According to one embodiment, the semiconductor nanoplatelet is obtained by a process of growth in the thickness of at least one face of at least one initial nanoplatelet by deposition of a film or a layer of material on the surface of the at least one initial nanoplatelet; or a process lateral growth of at least one face of at least one initial nanoplatelet by deposition of a film or a layer of material on the surface of the at least one initial nanoplatelet; or any methods known by the person skilled in the art.

In one embodiment, the semiconductor nanoplatelet can comprise the initial nanoplatelet and 1, 2, 3, 4, 5 or more layers covering all or part of the initial nanoplatelet, said layers begin of same composition as the initial nanoplatelet or being of different composition than the initial nanoplatelet or being of different composition one another.

In one embodiment, the semiconductor nanoplatelet can comprise the initial nanoplatelet and at least 1, 2, 3, 4, 5 or more layers in which the first deposited layer covers all or part of the initial nanoplatelet and the at least second deposited layer covers all or part of the previously deposited layer, said layers being of same composition as the initial nanoplatelet or being of different composition than the initial nanoplatelet and possibly of different compositions one another.

According to one embodiment, the semiconductor nanoplatelet has a thickness quantified by a MₓN_{y}E_{z}A_{w} monolayer, wherein M, N, E and A are as described hereabove.

According to one embodiment, the core **33** of the semiconductor nanoplatelet has a thickness of at least 1 MₓN_{y}E_{z}A_{w} monolayer, at least 2 MₓN_{y}E_{z}A_{w} monolayers, at least 3 MₓN_{y}E_{z}A_{w} monolayers, at least 4 MₓN_{y}E_{z}A_{w} monolayers, at least 5 MₓN_{y}E_{z}A_{w} monolayers, wherein M, N, E and A are as described hereabove.

According to one embodiment, the shell **34** of the semiconductor nanoplatelet has a thickness quantified by a MₓN_{y}E_{z}A_{w} monolayer, wherein M, N, E and A are as described hereabove, wherein M, N, E and A are as described hereabove.

According to one embodiment, the photoluminescence of the at least one nanoparticle **3** is preserved after encapsulation in the particle **2** and after encapsulation of said particle **2** in the particle **1.**

According to one embodiment, the size ratio between the particle **1** and the particle **2** ranges from 10 to 2 000, preferably from 10 to 1 500, more preferably from 10 to 1 000, even more preferably from 10 to 500.

According to one embodiment, the size ratio between the particle **1** and the at least one nanoparticle **3** ranges from 12 to 100 000, preferably from 50 to 50 000, more preferably from 100 to 10 000, even more preferably from 200 to 1 000.

According to one embodiment, the size ratio between the particle **2** and the at least one nanoparticle **3** ranges from 1.25 to 1 000, preferably from 2 to 500, more preferably from 5 to 250, even more preferably from 5 to 100.

According to one embodiment, the particle **1** and/or the particle **2** are functionalized.

A functionalized particle **1** and/or the particle **2** can then be dispersed in a host material or a liquid vehicle of an ink for further use.

Some applications, for example biological applications, require particles to be functionalized with a biocompatible agent for example.

According to one embodiment, the particle **1** and/or the particle **2** are functionalized with a specific-binding component, wherein said specific-binding component includes but is not limited to: antigens, steroids, vitamins, drugs, haptens, metabolites, toxins, environmental pollutants, amino acids, peptides, proteins, antibodies, polysaccharides, nucleotides, nucleosides, oligonucleotides, psoralens, hormones, nucleic acids, nucleic acid polymers, carbohydrates, lipids, phospholipids, lipoproteins, lipopolysaccharides, liposomes, lipophilic polymers, synthetic polymers, polymeric microparticles, biological cells, virus and combinations thereof. Preferred peptides include, but are not limited to: neuropeptides, cytokines, toxins, protease substrates, and protein kinase substrates. Preferred protein conjugates include enzymes, antibodies, lectins, glycoproteins, histones, albumins, lipoproteins, avidin, streptavidin, protein A, protein G, phycobiliproteins and other fluorescent proteins, hormones, toxins and growth factors. Preferred nucleic acid polymers are single- or multi-stranded, natural or synthetic DNA or RNA oligonucleotides, or DNA/RNA hybrids, or incorporating an unusual linker such as morpholine derivatized phosphides, or peptide nucleic acids such as N-(2-aminoethyl)glycine units, where the nucleic acid contains fewer than 50 nucleotides, more typically fewer than 25 nucleotides. The functionalization of the particle **1** and/or the particle **2** canbe made using techniques known in the art.

According to one embodiment, the liquid vehicle surrounds, encapsulates and/or covers partially or totally at least one particle. In this embodiment, particle refers to particle **1,** particle **2** and/or nanophosphor nanoparticle.

"Liquid vehicle" or "ink vehicle," as used herein, refers to the vehicle in which the particles of the invention are placed to form the ink. In this embodiment, particle refers to particle **1,** particle **2** and/or nanophosphor nanoparticle. In this embodiment, particles can be functionalized or not.

According to one embodiment, the ink further comprises a plurality of particles. In this embodiment, particle refers to particle **1**, particle **2** and/or nanophosphor nanoparticle.

According to one embodiment, the ink comprises at least two liquid vehicles. In this embodiment, the liquid vehicles may be different or identical.

According to one embodiment, the ink comprises a plurality of liquid vehicles.

According to one embodiment, the plurality of particles is uniformly dispersed in the liquid vehicle. In this embodiment, particle refers to particle **1**, particle **2** and/or nanophosphor nanoparticle.

According to one embodiment, the loading charge of particles in the liquid vehicle is at least 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, 91%, 92%, 93%, 94%, 95%, 96%, 97%, 98%, or 99%. In this embodiment, particle refers to particle **1**, particle **2** and/or nanophosphor nanoparticle.

According to one embodiment, the loading charge of particles in the liquid vehicle is less than 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, 91%, 92%, 93%, 94%, 95%, 96%, 97%, 98%, or 99%. In this embodiment, particle refers to particle **1**, particle **2** and/or nanophosphor nanoparticle.

According to one embodiment, the particles dispersed in the liquid vehicle have a packing fraction of at least 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, or 95%. In this embodiment, particle refers to particle **1**, particle **2** and/or nanophosphor nanoparticle.

According to one embodiment, the particles dispersed in the liquid vehicle have a packing fraction of less than 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, or 95%. In this embodiment, particle refers to particle **1**, particle **2** and/or nanophosphor nanoparticle.

According to one embodiment, the particles in the liquid vehicle are adjoigning, are in contact. In this embodiment, particle refers to particle **1**, particle **2** and/or nanophosphor nanoparticle.

According to one embodiment, in the same liquid vehicle, the particles are not aggregated. In this embodiment, particle refers to particle **1**, particle **2** and/or nanophosphor nanoparticle.

According to one embodiment, the particles in the liquid vehicle do not touch, are not in contact. In this embodiment, particle refers to particle **1**, particle **2** and/or nanophosphor nanoparticle.

According to one embodiment, the particles are separated by the liquid vehicle. In this embodiment, particle refers to particle **1**, particle **2** and/or nanophosphor nanoparticle.

According to one embodiment, the particles in the liquid vehicle can be individually evidenced for example by conventional microscopy, transmission electron microscopy, scanning transmission electron microscopy, scanning electron microscopy, or fluorescence scanning microscopy.

According to one embodiment, in the liquid vehicle, each particle of the plurality of particles is spaced from its adjacent particle by an average minimal distance. In this embodiment, particle refers to particle **1**, particle **2** and/or nanophosphor nanoparticle.

According to one embodiment, the average minimal distance between two particles in the liquid vehicle is controlled. In this embodiment, particle refers to particle **1**, particle **2** and/or nanophosphor nanoparticle.

According to one embodiment, the average minimal distance between two particles in the liquid vehicle or in a statistical set of particles is at least 1 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 300 µm, 400 µm, 500 µm, 600 µm, 700 µm, 800 µm, 900 µm, or 1 mm. In this embodiment, particle refers to particle 1, particle 2 and/or nanophosphor nanoparticle.

According to one embodiment, the average distance between two particles in the liquid vehicle or in a statistical set of particles is at least 1 nm, 1.5 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 300 µm, 400 µm, 500 µm, 600 µm, 700 µm, 800 µm, 900 µm, or 1 mm. In this embodiment, particle refers to particle **1**, particle **2** and/or nanophosphor nanoparticle.

According to one embodiment, the average distance between two particles in the liquid vehicle or in a statistical set of particles may have a deviation less or equal to 0.01%, 0.02%, 0.03%, 0.04%, 0.05%, 0.06%, 0.07%, 0.08%, 0.09%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 1.6%, 1.7%, 1.8%, 1.9%, 2%, 2.1%, 2.2%, 2.3%, 2.4%, 2.5%, 2.6%, 2.7%, 2.8%, 2.9%, 3%, 3.1%, 3.2%, 3.3%, 3.4%, 3.5%, 3.6%, 3.7%, 3.8%, 3.9%, 4%, 4.1%, 4.2%, 4.3%, 4.4%, 4.5%, 4.6%, 4.7%, 4.8%, 4.9%, 5%, 5.1%, 5.2%, 5.3%, 5.4%, 5.5%, 5.6%, 5.7%, 5.8%, 5.9%, 6%, 6.1%, 6.2%, 6.3%, 6.4%, 6.5%, 6.6%, 6.7%, 6.8%, 6.9%, 7%, 7.1%, 7.2%, 7.3%, 7.4%, 7.5%, 7.6%, 7.7%, 7.8%, 7.9%, 8%, 8.1%, 8.2%, 8.3%, 8.4%, 8.5%, 8.6%, 8.7%, 8.8%, 8.9%, 9%, 9.1%, 9.2%, 9.3%, 9.4%, 9.5%, 9.6%, 9.7%, 9.8%, 9.9%, or 10%. In this embodiment, particle refers to particle **1**, particle **2** and/or nanophosphor nanoparticle.

According to one embodiment, the ink does not comprise optically transparent void regions.

According to one embodiment, the ink does not comprise void regions surrounding the at least one particle. In this embodiment, particle refers to particle **1**, particle **2** and/or nanophosphor nanoparticle.

According to one embodiment, the ink is free of oxygen.

According to one embodiment, the ink is free of water.

According to one embodiment, the ink further comprises scattering particles dispersed in the liquid vehicle. Examples of scattering particles include but are not limited to: SiO₂, ZrO₂, ZnO, MgO, SnO₂, TiO₂, Ag, Au, alumina, barium sulfate, PTFE, barium titanate and the like.

In one embodiment, the ink further comprises thermal conductor particles dispersed in the liquid vehicle. Examples of thermal conductor particles include but are not limited to: SiO₂, ZrO₂, ZnO, MgO, SnO₂, TiO₂, CaO, alumina, barium sulfate, PTFE, barium titanate and the like. In this embodiment, the thermal conductivity of the liquid vehicle is increased.

According to one embodiment, the ink exhibits an emission spectrum with at least one emission peak, wherein said emission peak has a maximum emission wavelength ranging from 400 nm to 50 µm.

According to one embodiment, the ink exhibits an emission spectrum with at least one emission peak, wherein said emission peak has a maximum emission wavelength ranging from 400 nm to 500 nm. In this embodiment, the ink emits blue light.

According to one embodiment, the ink exhibits an emission spectrum with at least one emission peak, wherein said emission peak has a maximum emission wavelength ranging from 500 nm to 560 nm, more preferably ranging from 515 nm to 545 nm. In this embodiment, the ink emits green light.

According to one embodiment, the ink exhibits an emission spectrum with at least one emission peak, wherein said emission peak has a maximum emission wavelength ranging from 560 nm to 590 nm. In this embodiment, the ink emits yellow light.

According to one embodiment, the ink exhibits an emission spectrum with at least one emission peak, wherein said emission peak has a maximum emission wavelength ranging from 590 nm to 750 nm, more preferably ranging from 610 nm to 650 nm. In this embodiment, the ink emits red light.

According to one embodiment, the ink exhibits an emission spectrum with at least one emission peak, wherein said emission peak has a maximum emission wavelength ranging from 750 nm to 50 µm. In this embodiment, the ink emits near infra-red, mid-infra-red, or infra-red light.

According to one embodiment, the ink exhibits emission spectra with at least one emission peak having a full width half maximum lower than 90 nm, 80 nm, 70 nm, 60 nm, 50 nm, 40 nm, 30 nm, 25 nm, 20 nm, 15 nm, or 10 nm.

According to one embodiment, the ink exhibits emission spectra with at least one emission peak having a full width at quarter maximum lower than 90 nm, 80 nm, 70 nm, 60 nm, 50 nm, 40 nm, 30 nm, 25 nm, 20 nm, 15 nm, or 10 nm.

According to one embodiment, the ink has a photoluminescence quantum yield (PLQY) of at least 5%, 10%, 15%, 20%, 25%, 30%, 35%, 40%, 45%, 50%, 55%, 60%, 65%, 70%, 75%, 80%, 85%, 90%, 95%, 99% or 100%.

In one embodiment, the ink exhibits photoluminescence quantum yield (PLQY) decrease of less than 80%, 70%, 60%, 50%, 40%, 30%, 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination.

According to one embodiment, the light illumination is provided by blue, green, red, or UV light source such as laser, diode, fluorescent lamp or Xenon Arc Lamp. According to one embodiment, the photon flux or average peak pulse power of the illumination is comprised between 1 mW.cm⁻² and 100 kW.cm⁻² and more preferably between 10 mW.cm⁻² and 100 W.cm⁻², and even more preferably between 10 mW.cm⁻² and 30 W.cm⁻².

According to one embodiment, the photon flux or average peak pulse power of the illumination is at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one embodiment, the ink exhibits photoluminescence quantum yield (PQLY) decrease of less than 80%, 70%, 60%, 50%, 40%, 30%, 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one embodiment, the ink exhibits FCE decrease of less than 80%, 70%, 60%, 50%, 40%, 30%, 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

According to one embodiment, the liquid vehicle is free of oxygen.

According to one embodiment, the liquid vehicle is free of water.

According to one embodiment, the liquid vehicle limits or prevents the degradation of the chemical and physical properties of the particle of the invention from molecular oxygen, water and/or high temperature. In this embodiment, particle of the invention refers to particle **1**, particle **2** and/or nanophosphor nanoparticle.

According to one embodiment, the liquid vehicle is optically transparent at wavelengths between 200 nm and 50 µm, between 200 nm and 10 µm, between 200 nm and 2500 nm, between 200 nm and 2000 nm, between 200 nm and 1500 nm, between 200 nm and 1000 nm, between 200 nm and 800 nm, between 400 nm and 700 nm, between 400 nm and 600 nm, or between 400 nm and 470 nm.

According to one embodiment, the liquid vehicle has a refractive index ranging from 1.0 to 3.0, from 1.2 to 2.6, from 1.4 to 2.0.

According to one embodiment, the liquid vehicle has a refractive index of at least 1.0, 1.1, 1.2, 1.3, 1.4, 1.5, 1.6, 1.7, 1.8, 1.9, 2.0, 2.1, 2.2, 2.3, 2.4, 2.5, 2.6, 2.7, 2.8, 2.9, or 3.0.

According to one embodiment, the liquid vehicle has a refractive index distinct from the refractive index of the material comprised in the particle of the invention or from the refractive index of the particle of the invention. This embodiment allows for a wider scattering of light. This embodiment also allows to have a difference in light scattering as a function of the wavelength, in particular to increase the scattering of the excitation light with respect to the scattering of the emitted light, as the wavelength of the excitation light is lower than the wavelength of the emitted light. In this embodiment, particle of the invention refers to particle **1**, particle **2** and/or nanophosphor nanoparticle.

According to one embodiment, the liquid vehicle has a difference of refractive index with the refractive index of the material comprised in the particle of the invention or with the refractive index of the particle of the invention of at least 0.02, 0.025, 0.03, 0.035, 0.04, 0.045, 0.05, 0.055, 0.06, 0.065, 0.07, 0.075, 0.08, 0.085, 0.09, 0.095, 0.1, 0.11, 0.115, 0.12, 0.125, 0.13, 0.135, 0.14, 0.145, 0.15, 0.155, 0.16, 0.165, 0.17, 0.175, 0.18, 0.185, 0.19, 0.195, 0.2, 0.25, 0.3, 0.35, 0.4, 0.45, 0.5, 0.55, 0.6, 0.65, 0.7, 0.75, 0.8, 0.85, 0.9, 0.95, 1, 1.1, 1.15, 1.2, 1.25, 1.3, 1.35, 1.4, 1.45, 1.5, 1.55, 1.6, 1.65, 1.7, 1.75, 1.8, 1.85, 1.9, 1.95, or 2. In this embodiment, particle of the invention refers to particle **1**, particle **2** and/or nanophosphor nanoparticle.

According to one embodiment, the liquid vehicle has a refractive index superior or equal to the refractive index of the material comprised in the particle of the invention. In this embodiment, particle of the invention refers to particle **1**, particle **2** and/or nanophosphor nanoparticle.

According to one embodiment, the liquid vehicle has a refractive index inferior to the refractive index of the material comprised in the particle of the invention. In this embodiment, particle of the invention refers to particle **1**, particle **2** and/or nanophosphor nanoparticle.

According to one embodiment, the particle of the invention in the liquid vehicle is configured to scatter light.

According to one embodiment, the liquid vehicle has a haze factor ranging from 1% to 100%.

According to one embodiment, the liquid vehicle has a haze factor of at least 1%, 2%, 3%, 4%, 5%, 10%, 15%, 20%, 25%, 30%, 35%, 40%, 45%, 50%, 55%, 60%, 65%, 70%, 75%, 80%, 85%, 90%, 95%, or 100%.

The haze factor is calculated by the ratio between the intensity of light scattered by the material beyond the viewing angle and the total intensity transmitted by the material when illuminated with a light source.

According to one embodiment, the viewing angle used to measure the haze factor ranges from 0° to 20°.

According to one embodiment, the viewing angle used to measure the haze factor is at least 0°, 1°, 2°, 3°, 4°, 5°, 6°, 7°, 8°, 9°, 10°, 11°, 12°, 13°, 14°, 15°, 16°, 17°, 18°, 19°, or 20°.

According to one embodiment, the particle of the invention in the liquid vehicle is configured to serve as a waveguide. In this embodiment, the refractive index of the particle of the invention is higher than the refractive index of the liquid vehicle. In this embodiment, particle of the invention refers to particle **1**, particle **2** and/or nanophosphor nanoparticle.

According to one embodiment, the particle of the invention has a spherical shape. The spherical shape may permit to the light to circulate in said particle without leaving said particle such as to operate as a waveguide. The spherical shape may permit to the light to have whispering-gallery wave modes. Furthermore, a perfect spherical shape prevents fluctuations of the intensity of the scattered light. In this embodiment, particle of the invention refers to particle **1**, particle **2** and/or nanophosphor nanoparticle.

According to one embodiment, the particle of the invention in the liquid vehicle is configured to generate multiple reflections of light inside said particle. In this embodiment, particle of the invention refers to particle **1**, particle **2** and/or nanophosphor nanoparticle.

According to one embodiment, the liquid vehicle has a refractive index equal to the refractive index of the material comprised in the particle of the invention. In this embodiment, scattering of light is prevented.

According to one embodiment, the at least one liquid vehicle comprises a liquid including but not limited to: 1-methoxy-2-propanol, 2-pyrrolidinone, C4 to C8 1,2-alkanediol, aliphatic or alicycle ketone, methyl ethyl ketone, C1-C4 alkanol such as for example methanol, ethanol, methanol propanol, or isopropanol, ketones, esters, ether of ethylene glycol or propylene glycol, acetals, acrylic resin, polyvinyl acetate, polyvinyl alcohol, polyamide resin, polyurethane resin, epoxy resin, alkyd ester, nitrated cellulose, ethyl cellulose, sodium carboxymethyl cellulose, alkyds, maleics, cellulose derivatives, formaldehyde, rubber resin, phenolics, propyl acetate, glycol ether, aliphatic hydrocarbon, acetate, ester. acrylic, cellulose ester, nitrocellulose, modified resin, alkoxylated alcohol, 2-pyrrolidone, a homolog of 2-pyrrolidone, glycol, water, or a mixture thereof.

In an embodiment, the liquid vehicle includes water and effective amounts of one or more of: derivatized 2-pyrrolidinone(s), glycerol polyoxyethyl ether(s), diol(s), or combinations thereof. In one non-limiting example, the liquid vehicle includes water and a derivatized 2-pyrrolidinone (*e.g*., 1-(2-hydroxyethyl)-2-pyrrolidinone). In another non-limiting example, the liquid vehicle includes derivatized 2-pyrrolidinone(s), glycerol polyoxyethyl ether(s), diol(s), and non-ionic and/or anionic surfactants.

In one embodiment, the liquid vehicle may also include water soluble polymers, buffers, biocides, sequestering agents, viscosity modifiers, surface-active agents, chelating agents, pH adjusting agents, resins, and/or combinations thereof.

According to one embodiment, the at least one liquid vehicle comprises a liquid at a level of at least 1%, 2%, 3%, 4%, 5%, 6%, 7%, 8%, 9%, 10%, 15%, 20%, 25%, 30%, 35%, 40%, 45%, 50%, 55%, 60%, 65%, 70%, 75%, 80%, 85%, 90%, or 95% in weight compared to the total weight of the liquid vehicle.

According to one embodiment, the liquid vehicle is a thermal insulator.

According to one embodiment, the liquid vehicle is a thermal conductor.

According to one embodiment, the liquid vehicle has a thermal conductivity at standard conditions ranging from 0.1 to 450 W/(m.K), preferably from 1 to 200 W/(m.K), more preferably from 10 to 150 W/(m.K).

According to one embodiment, the liquid vehicle has a thermal conductivity at standard conditions of at least 0.1 W/(m.K), 0.2 W/(m.K), 0.3 W/(m.K), 0.4 W/(m.K), 0.5 W/(m.K), 0.6 W/(m.K), 0.7 W/(m.K), 0.8 W/(m.K), 0.9 W/(m.K), 1 W/(m.K), 1.1 W/(m.K), 1.2 W/(m.K), 1.3 W/(m.K), 1.4 W/(m.K), 1.5 W/(m.K), 1.6 W/(m.K), 1.7 W/(m.K), 1.8 W/(m.K), 1.9 W/(m.K), 2 W/(m.K), 2.1 W/(m.K), 2.2 W/(m.K), 2.3 W/(m.K), 2.4 W/(m.K), 2.5 W/(m.K), 2.6 W/(m.K), 2.7 W/(m.K), 2.8 W/(m.K), 2.9 W/(m.K), 3 W/(m.K), 3.1 W/(m.K), 3.2 W/(m.K), 3.3 W/(m.K), 3.4 W/(m.K), 3.5 W/(m.K), 3.6 W/(m.K), 3.7 W/(m.K), 3.8 W/(m.K), 3.9 W/(m.K), 4 W/(m.K), 4.1 W/(m.K), 4.2 W/(m.K), 4.3 W/(m.K), 4.4 W/(m.K), 4.5 W/(m.K), 4.6 W/(m.K), 4.7 W/(m.K), 4.8 W/(m.K), 4.9 W/(m.K), 5 W/(m.K), 5.1 W/(m.K), 5.2 W/(m.K), 5.3 W/(m.K), 5.4 W/(m.K), 5.5 W/(m.K), 5.6 W/(m.K), 5.7 W/(m.K), 5.8 W/(m.K), 5.9 W/(m.K), 6 W/(m.K), 6.1 W/(m.K), 6.2 W/(m.K), 6.3 W/(m.K), 6.4 W/(m.K), 6.5 W/(m.K), 6.6 W/(m.K), 6.7 W/(m.K), 6.8 W/(m.K), 6.9 W/(m.K), 7 W/(m.K), 7.1 W/(m.K), 7.2 W/(m.K), 7.3 W/(m.K), 7.4 W/(m.K), 7.5 W/(m.K), 7.6 W/(m.K), 7.7 W/(m.K), 7.8 W/(m.K), 7.9 W/(m.K), 8 W/(m.K), 8.1 W/(m.K), 8.2 W/(m.K), 8.3 W/(m.K), 8.4 W/(m.K), 8.5 W/(m.K), 8.6 W/(m.K), 8.7 W/(m.K), 8.8 W/(m.K), 8.9 W/(m.K), 9 W/(m.K), 9.1 W/(m.K), 9.2 W/(m.K), 9.3 W/(m.K), 9.4 W/(m.K), 9.5 W/(m.K), 9.6 W/(m.K), 9.7 W/(m.K), 9.8 W/(m.K), 9.9 W/(m.K), 10 W/(m.K), 10.1 W/(m.K), 10.2 W/(m.K), 10.3 W/(m.K), 10.4 W/(m.K), 10.5 W/(m.K), 10.6 W/(m.K), 10.7 W/(m.K), 10.8 W/(m.K), 10.9 W/(m.K), 11 W/(m.K), 11.1 W/(m.K), 11.2 W/(m.K), 11.3 W/(m.K), 11.4 W/(m.K), 11.5 W/(m.K), 11.6 W/(m.K), 11.7 W/(m.K), 11.8 W/(m.K), 11.9 W/(m.K), 12 W/(m.K), 12.1 W/(m.K), 12.2 W/(m.K), 12.3 W/(m.K), 12.4 W/(m.K), 12.5 W/(m.K), 12.6 W/(m.K), 12.7 W/(m.K), 12.8 W/(m.K), 12.9 W/(m.K), 13 W/(m.K), 13.1 W/(m.K), 13.2 W/(m.K), 13.3 W/(m.K), 13.4 W/(m.K), 13.5 W/(m.K), 13.6 W/(m.K), 13.7 W/(m.K), 13.8 W/(m.K), 13.9 W/(m.K), 14 W/(m.K), 14.1 W/(m.K), 14.2 W/(m.K), 14.3 W/(m.K), 14.4 W/(m.K), 14.5 W/(m.K), 14.6 W/(m.K), 14.7 W/(m.K), 14.8 W/(m.K), 14.9 W/(m.K), 15 W/(m.K), 15.1 W/(m.K), 15.2 W/(m.K), 15.3 W/(m.K), 15.4 W/(m.K), 15.5 W/(m.K), 15.6 W/(m.K), 15.7 W/(m.K), 15.8 W/(m.K), 15.9 W/(m.K), 16 W/(m.K), 16.1 W/(m.K), 16.2 W/(m.K), 16.3 W/(m.K), 16.4 W/(m.K), 16.5 W/(m.K), 16.6 W/(m.K), 16.7 W/(m.K), 16.8 W/(m.K), 16.9 W/(m.K), 17 W/(m.K), 17.1 W/(m.K), 17.2 W/(m.K), 17.3 W/(m.K), 17.4 W/(m.K), 17.5 W/(m.K), 17.6 W/(m.K), 17.7 W/(m.K), 17.8 W/(m.K), 17.9 W/(m.K), 18 W/(m.K), 18.1 W/(m.K), 18.2 W/(m.K), 18.3 W/(m.K), 18.4 W/(m.K), 18.5 W/(m.K), 18.6 W/(m.K), 18.7 W/(m.K), 18.8 W/(m.K), 18.9 W/(m.K), 19 W/(m.K), 19.1 W/(m.K), 19.2 W/(m.K), 19.3 W/(m.K), 19.4 W/(m.K), 19.5 W/(m.K), 19.6 W/(m.K), 19.7 W/(m.K), 19.8 W/(m.K), 19.9 W/(m.K), 20 W/(m.K), 20.1 W/(m.K), 20.2 W/(m.K), 20.3 W/(m.K), 20.4 W/(m.K), 20.5 W/(m.K), 20.6 W/(m.K), 20.7 W/(m.K), 20.8 W/(m.K), 20.9 W/(m.K), 21 W/(m.K), 21.1 W/(m.K), 21.2 W/(m.K), 21.3 W/(m.K), 21.4 W/(m.K), 21.5 W/(m.K), 21.6 W/(m.K), 21.7 W/(m.K), 21.8 W/(m.K), 21.9 W/(m.K), 22 W/(m.K), 22.1 W/(m.K), 22.2 W/(m.K), 22.3 W/(m.K), 22.4 W/(m.K), 22.5 W/(m.K), 22.6 W/(m.K), 22.7 W/(m.K), 22.8 W/(m.K), 22.9 W/(m.K), 23 W/(m.K), 23.1 W/(m.K), 23.2 W/(m.K), 23.3 W/(m.K), 23.4 W/(m.K), 23.5 W/(m.K), 23.6 W/(m.K), 23.7 W/(m.K), 23.8 W/(m.K), 23.9 W/(m.K), 24 W/(m.K), 24.1 W/(m.K), 24.2 W/(m.K), 24.3 W/(m.K), 24.4 W/(m.K), 24.5 W/(m.K), 24.6 W/(m.K), 24.7 W/(m.K), 24.8 W/(m.K), 24.9 W/(m.K), 25 W/(m.K), 30 W/(m.K), 40 W/(m.K), 50 W/(m.K), 60 W/(m.K), 70 W/(m.K), 80 W/(m.K), 90 W/(m.K), 100 W/(m.K), 110 W/(m.K), 120 W/(m.K), 130 W/(m.K), 140 W/(m.K), 150 W/(m.K), 160 W/(m.K), 170 W/(m.K), 180 W/(m.K), 190 W/(m.K), 200 W/(m.K), 210 W/(m.K), 220 W/(m.K), 230 W/(m.K), 240 W/(m.K), 250 W/(m.K), 260 W/(m.K), 270 W/(m.K), 280 W/(m.K), 290 W/(m.K), 300 W/(m.K), 310 W/(m.K), 320 W/(m.K), 330 W/(m.K), 340 W/(m.K), 350 W/(m.K), 360 W/(m.K), 370 W/(m.K), 380 W/(m.K), 390 W/(m.K), 400 W/(m.K), 410 W/(m.K), 420 W/(m.K), 430 W/(m.K), 440 W/(m.K), or 450 W/(m.K).

According to one embodiment, the liquid vehicle is electrically insulator.

According to one embodiment, the liquid vehicle is electrically conductive.

According to one embodiment, the liquid vehicle has an electrical conductivity at standard conditions ranging from 1×10⁻²⁰ to 10⁷ S/m, preferably from 1×10⁻¹⁵ to 5 S/m, more preferably from 1×10⁻⁷ to 1 S/m.

According to one embodiment, the liquid vehicle has an electrical conductivity at standard conditions of at least 1×10⁻²⁰ S/m, 0.5×10⁻¹⁹ S/m, 1×10⁻¹⁹ S/m, 0.5×10⁻¹⁸ S/m, 1×10⁻¹⁸ S/m, 0.5×10⁻¹⁷ S/m, 1×10⁻¹⁷ S/m, 0.5×10⁻¹⁶ S/m, 1×10⁻¹⁶ S/m, 0.5×10⁻¹⁵ S/m, 1×10⁻¹⁵ S/m, 0.5×10⁻¹⁴ S/m, 1×10⁻¹⁴ S/m, 0.5×10⁻¹³ S/m, 1×10⁻¹³ S/m, 0.5 ×10⁻¹² S/m, 1×10⁻¹² S/m, 0.5×10⁻¹¹ S/m, 1×10⁻¹¹ S/m, 0.5 ×10⁻¹⁰ S/m, 1×10⁻¹⁰ S/m, 0.5×10⁻⁹ S/m, 1×10⁻⁹ S/m, 0.5×10⁻⁸ S/m, 1×10⁻⁸ S/m, 0.5×10⁻⁷ S/m, 1×10⁻⁷ S/m, 0.5×10⁻⁶ S/m, 1×10⁻⁶ S/m, 0.5×10⁻⁵ S/m, 1×10⁻⁵ S/m, 0.5×10⁻⁴ S/m, 1×10⁻⁴ S/m, 0.5×10⁻³ S/m, 1×10⁻³ S/m, 0.5×10⁻² S/m, 1×10⁻² S/m, 0.5×10⁻¹ S/m, 1×10⁻¹ S/m, 0.5 S/m, 1 S/m, 1.5 S/m, 2 S/m, 2.5 S/m, 3 S/m, 3.5 S/m, 4 S/m, 4.5 S/m, 5 S/m, 5.5 S/m, 6 S/m, 6.5 S/m, 7 S/m, 7.5 S/m, 8 S/m, 8.5 S/m, 9 S/m, 9.5 S/m, 10 S/m, 50 S/m, 10² S/m, 5×10² S/m, 10³ S/m, 5×10³ S/m, 10⁴ S/m, 5×10⁴ S/m, 10⁵ S/m, 5×10⁵ S/m, 10⁶ S/m, 5×10⁶ S/m, or 10⁷ S/m.

According to one embodiment, the electrical conductivity of the liquid vehicle may be measured for example with an impedance spectrometer.

According to one embodiment, the liquid vehicle can be cured into a shape of a film, thereby generating a film.

According to one embodiment, the liquid vehicle comprises a film-forming material. In this embodiment, the film-forming material is a polymer or an inorganic material as described hereabove.

According to one embodiment, the liquid vehicle comprises at least 1%, 2%, 3%, 4%, 5%, 6%, 7%, 8%, 9%, 10%, 15%, 20%, 25%, 30%, 35%, 40%, 45%, 50%, 55%, 60%, 65%, 70%, 75%, 80%, 85%, 90%, 95%, or 100% of a film-forming material.

According to one embodiment, the film-forming material is stable in the liquid vehicle.

According to one embodiment, the film-forming material is dispersed or dissolved in the liquid vehicle.

According to one embodiment, the film-forming material is present in an amount of from about 0.1 % by weight to about 10.0% by weight based on the total weight of the ink.

According to one embodiment, the ink comprises one or more materials useful in forming at least one of a hole transport layer, a hole injection layer, an electron transport layer, an electron injection layer, and an emissive layer, of a light-emitting device.

According to one embodiment, the ink comprises a material that is cured or otherwise processed to form a layer on a support.

According to one embodiment, the liquid vehicle has a maximum boiling point that is substantially lower than the evaporation or sublimation temperature of the film-forming material.

According to one embodiment, the liquid vehicle has a maximum boiling point that is at least 70°C, 65°C, 60°C, 55°C, 50°C, 45°C, 40°C, 35°C, 30°C, 25°C, 20°C, 15°C, or 10°C lower than the evaporation or sublimation temperature of the film-forming material.

According to one embodiment, the liquid vehicle and/or the organic solvent has a maximum boiling point that is at least 50°C, 60°C, 65°C, 70°C, 75°C, 80°C, 85°C, 90°C, 95°C, 100°C, 110°C, 120°C, 130°C, 135°C, 140°C, 145°C, 150°C, 155°C, 160°C, 165°C, 170°C, 175°C, 180°C, 185°C, 190°C, 195°C, 200°C, 210°C, 220°C, 230°C, 235°C, 240°C, 245°C, 250°C, 255°C, 260°C, 265°C, 270°C, 275°C, or 280°C lower than the evaporation or sublimation temperature of the film-forming material.

According to one embodiment, the liquid vehicle has high purity and the maximum boiling point and purity are such that when heated to a temperature below or equal to the maximum boiling point of the liquid vehicle, the liquid vehicle substantially completely and rapidly evaporates while the film-forming material remains stable.

According to one embodiment, the liquid vehicle is highly pure such that it contains 2000 ppm or less in impurities, by weight, based on the total weight of the liquid vehicle.

According to one embodiment, the liquid vehicle is inert with respect to inkjet and/or thermal printing printhead materials.

According to one embodiment, the liquid vehicle is polymeric.

According to one embodiment, the film-forming material is polymeric.

According to one embodiment, the liquid vehicle comprises a monomer or a polymer as described hereafter.

According to one embodiment, the liquid vehicle and/or the film-forming material can polymerize by heating it (*i.e.*, by thermal curing) and/or by exposing it to UV light (*i.e.*, by UV curing). Examples of UV curing processes which can be contemplated in the present invention are described, *e.g*., in WO2017063968, WO2017063983 and WO2017162579.

According to one embodiment, the polymeric liquid vehicle and/or the film-forming material includes but is not limited to: silicone based polymers, polydimethylsiloxanes (PDMS), polyethylene terephthalate, polyesters, polyacrylates, polymethacrylates, polycarbonate, poly(vinyl alcohol), polyvinylpyrrolidone, polyvinylpyridine, polysaccharides, poly(ethylene glycol), melamine resins, a phenol resin, an alkyl resin, an epoxy resin, a polyurethane resin, a maleic resin, a polyamide resin, an alkyl resin, a maleic resin, terpenes resins, an acrylic resin or acrylate based resin such as PMMA, copolymers forming the resins, co-polymers, block co-polymers, polymerizable monomers comprising an UV initiator or thermic initiator, or a mixture thereof.

According to one embodiment, the polymeric liquid vehicle and/or the film-forming material includes but is not limited to: thermosetting resin, photosensitive resin, photoresist resin, photocurable resin, or dry-curable resin. The thermosetting resin and the photocurable resin are cured using heat and light, respectively. For the use of the dry hard resin, the resin is cured by applying heat to a solvent in which the particle of the invention is dispersed. In this embodiment, particle of the invention refers to particle **1**, particle **2** and/or nanophosphor nanoparticle.

When a thermosetting resin or a photocurable resin is used, the composition of the resulting ink is equal to the composition of the raw material of the ink. However, when a dry-curable resin is used, the composition of the resulting ink may be different from the composition of the raw material of the ink. During the dry-curing by heat, the solvent is partially evaporated. Thus, the volume ratio of particle of the invention in the raw material of the ink may be lower than the volume ratio of said particle in the resulting ink. In this embodiment, particle of the invention refers to particle 1, particle 2 and/or nanophosphor nanoparticle.

Upon curing of the resin, a volume contraction is caused. According to one embodiment, a least 2%, 3%, 4%, 5%, 6%, 7%, 8%, 9%, 10%, 15%, or 20%, of contraction are aroused from a thermosetting resin or a photocurable resin. According to one embodiment, a dry-curable resin is contracted by at least 0.1%, 0.2%, 0.3%, 0.4%, 0.5%, 0.6%, 0.7%, 0.8%, 0.9%, 1%, 1.5%, 2%, 2.5%, 3%, 3.5%, 4%, 4.5%, 5%, 5.5%, 6%, 6.5%, 7%, 7.5%, 8%, 8.5%, 9%, 9.5%, 10%, 15%, or 20%. The contraction of the resin may cause movement of the particles of the invention, which may be lower the degree of dispersion of the particles of the invention in the ink. However, embodiments of the present invention can maintain high dispersibility by preventing the movement of said particles by introducing other particles in said ink. In this embodiment, particle of the invention refers to particle **1**, particle **2** and/or nanophosphor nanoparticle.

In one embodiment, the liquid vehicle and/or the film-forming material may be a polymerizable formulation which can include monomers, oligomers, polymers, or mixture thereof.

In one embodiment, the polymerizable formulation may further comprise a crosslinking agent, a scattering agent, a photo initiator or a thermal initiator.

In one embodiment, the polymerizable formulation includes but is not limited to: monomers, oligomers or polymers made from an alkyl methacrylates or an alkyl acrylates such as acrylic acid, methacrylic acid, crotonic acid, acrylonitrile, acrylic esters substituted with methoxy, ethoxy, propoxy, butoxy, and similar derivatives for example, methyl acrylate, ethyle acrylate, propyl acrylate, butyl acrylate, isobutyl acrylate, lauryl acrylate, norbornyl acrylate, 2-ethyl hexyl acrylate, 2-hydroxyethyl acrylate, 4-hydroxybutyl acrylate, benzyl acrylate, phenyl acrylate, isobornyle acrylate, hydroxypropyl acrylate, fluorinated acrylic monomers, chlorinated acrylic monomers, methacrylic acid, methyl methacrylate, n-butyl methacrylate, isobutyl methacrylate, 2-ethyl hexyl methacrylate, 2-hydroxyethyl methacrylate, 4-hydroxybutyl methacrylate, benzyl methacrylate, phenyl methacrylate, lauryl methacrylate, norbornyl methacrylate, isobornyle methacrylate, hydroxypropyl methacrylate, fluorinated methacrylic monomers, chlorinated methacrylic monomers, alkyl crotonates, allyl crotonates, glycidyl methacrylate and related esters.

In another embodiment, the polymerizable formulation includes but is not limited to: monomers, oligomers or polymers made from an alkyl acrylamide or alkyl methacrylamide such as acrylamide, Alkylacrylamide, Ntert-Butylacrylamide, Diacetone acrylamide, N,N-Diethylacrylamide, N-(Isobutoxymethyl)acrylamide, N-(3-Methoxypropyl)acrylamide, N-Diphenylmethylacrylamide, N-Ethylacrylamide, N-Hydroxyethyl acrylamide, N-(Isobutoxymethyl)acrylamide, N-Isopropylacrylamide, N-(3-Methoxypropyl)acrylamide, N-Phenylacrylamide, N-[Tris(hydroxymethyl)methyl]acrylamide, N,N-Diethylmethacrylamide, N,NDimethylacrylamide, N-[3-(Dimethylamino)propyl]methacrylamide, N-(Hydroxymethyl)acrylamide, 2-Hydroxypropyl methacrylamide, N-Isopropylmethacrylamide, Methacrylamide, N-(Triphenylmethyl)methacrylamide, poly (3,4-ethylenedioxythiopene), poly(ethylene dioxythiophene)/poly(styrene sulfonic acid) (PEDOT/PSS), an aqueous solution of polyaniline/camphor sulfonic acid (PANI/CSA), PTPDES, Et-PIT- DEK, PPBA, and similar derivatives.

In one embodiment, the polymerizable formulation includes but is not limited to: monomers, oligomers or polymers made from alpha-olefins, dienes such as butadiene and chloroprene; styrene, alpha-methyl styrene, and the like; heteroatom substituted alpha-olefins, for example, vinyl acetate, vinyl alkyl ethers for example, ethyl vinyl ether, vinyltrimethylsilane, vinyl chloride, tetrafluoroethylene, chlorotrifiuoroethylene, cyclic and polycyclic olefin compounds for example, cyclopentene, cyclohexene, cycloheptene, cyclooctene, and cyclic derivatives up to C20; polycyclic derivates for example, norbornene, and similar derivatives up to C20; cyclic vinyl ethers for example, 2, 3-dihydrofuran, 3,4-dihydropyran, and similar derivatives; allylic alcohol derivatives for example, vinylethylene carbonate, disubstituted olefins such as maleic and fumaric compounds for example, maleic anhydride, diethylfumarate, and the like, and mixtures thereof.

In one embodiment, examples of crosslinking agent include but are not limited to: di-acrylate, tri-acrylate, tetra-acrylate, di-methacrylate, tri-methacrylate and tetra- methacrylate monomers derivatives and the like. Another example of crosslinking agent includes but is not limited to: monomers, oligomers or polymers made from di- or trifunctional monomers such as allyl methacrylate, diallyl maleate, 1,3-butanediol dimethacrylate, 1,4-butanediol dimethacrylate, 1,6-hexanediol dimethacrylate, pentaerythritol triacrylate, trimethylolpropane triacrylate, Ethylene glycol dimethacrylate, Triethylene glycol dimethacrylate, N,N-methylenebis(acrylamide), N,N'-Hexamethylenebis(methacrylamide), and divinyl benzene.

In one embodiment, the polymerizable formulation may further comprise scattering particles Examples of scattering particles include but are not limited to: SiO₂, ZrO₂, ZnO, MgO, SnO₂, TiO₂, Ag, Au, alumina, barium sulfate, PTFE, barium titanate and the like.

In one embodiment, the polymerizable formulation may further comprise a thermal conductor. Examples of thermal conductor include but are not limited to: SiO₂, ZrO₂, ZnO, MgO, SnO₂, TiO₂, CaO, alumina, barium sulfate, PTFE, barium titanate and the like. In this embodiment, the thermal conductivity of the liquid vehicle is increased.

In one embodiment, the polymerizable formulation may further comprise a photo initiator. Examples of photo initiator include but are not limited to: α-hydroxyketone, phenylglyoxylate, benzyldimethyl-ketal, α-aminoketone, monoacylphosphine oxides, bisacylphosphine oxides, phosphine oxide, benzophenone and derivatives, polyvinyl cinnamate, metallocene or iodonium salt derivatives, 1-hydroxycyclohexyl phenyl ketone, thioxanthones (such as isopropylthioxanthone), 2-hydroxy-2-methyl-1-phenylpropan-1-one, 2-benzyl-2-dimethylamino-(4-morpholinophenyl)butan-1-one, benzil dimethylketal, bis(2,6- dimethylbenzoyl)-2,4,4-trimethylpentylphosphine oxide, 2,4,6-trimethylbenzoyldiphenylphosphine oxide, 2-methyl-1-[4-(methylthio)phenyl]-2-morpholinopropan-1-one, 2,2-dimethoxy-1,2-diphenylethan-1-one or 5,7-diiodo-3-butoxy-6-fluorone and the like. Other examples of photo initiators include, without limitation, Irgacure^{™} 184, Irgacure^{™} 500, Irgacure^{™} 907, Irgacure^{™} 369, Irgacure^{™} 1700, Irgacure^{™} 651 , Irgacure^{™} 819, Irgacure^{™} 1000, Irgacure^{™} 1300, Irgacure^{™} 1870, Darocur^{™} 1 173, Darocur^{™} 2959, Darocur^{™} 4265 and Darocur^{™} ITX (available from Ciba Specialty Chemicals), Lucerin^{™} TPO (available from BASF AG), Esacure^{™} KT046, Esacure^{™} KIP150, Esacure^{™} KT37 and Esacure^{™} EDB (available from Lamberti), H-Nu^{™} 470 and H-Nu^{™} 470X (available from Spectra Group Ltd) and the like.

In one embodiment, the polymerizable formulation may further comprise a thermal initiator. Examples of thermal initiator include but are limited to: peroxide compounds, azo compounds such as azobisisobutyronitrile (AIBN) and 4,4-Azobis(4-cyanovaleric acid), potassium and ammonium persulfate, tert-Butyl peroxide, benzoyl peroxide and the like.

In one embodiment, the polymeric liquid vehicle and/or the film-forming material may be a polymerized solid made from an alkyl methacrylates or an alkyl acrylates such as acrylic acid, methacrylic acid, crotonic acid, acrylonitrile, acrylic esters substituted with methoxy, ethoxy, propoxy, butoxy, and similar derivatives for example, methyl acrylate, ethyle acrylate, propyl acrylate, butyl acrylate, isobutyl acrylate, lauryl acrylate, norbornyl acrylate, 2-ethyl hexyl acrylate, 2-hydroxyethyl acrylate, 4-hydroxybutyl acrylate, benzyl acrylate, phenyl acrylate, isobornyle acrylate, hydroxypropyl acrylate, fluorinated acrylic monomers, chlorinated acrylic monomers, methacrylic acid, methyl methacrylate, nbutyl methacrylate, isobutyl methacrylate, 2-ethyl hexyl methacrylate, 2-hydroxyethyl methacrylate, 4-hydroxybutyl methacrylate, benzyl methacrylate, phenyl methacrylate, lauryl methacrylate, norbornyl methacrylate, isobornyle methacrylate, hydroxypropyl methacrylate, fluorinated methacrylic monomers, chlorinated methacrylic monomers, alkyl crotonates, allyl crotonates, glycidyl methacrylate and related esters.

In one embodiment, the polymeric liquid vehicle and/or the film-forming material may be a polymerized solid made from an alkyl acrylamide or alkyl methacrylamide such as acrylamide, Alkylacrylamide, Ntert- Butylacrylamide, Diacetone acrylamide, N,N-Diethylacrylamide, N- Isobutoxymethyl)acrylamide, N-(3-Methoxypropyl)acrylamide, NDiphenylmethylacrylamide, N-Ethylacrylamide, N-Hydroxyethyl acrylamide, N-(Isobutoxymethyl)acrylamide, N-Isopropylacrylamide, N-(3- Methoxypropyl)acrylamide, N-Phenylacrylamide, N- [Tris(hydroxymethyl)methyl]acrylamide, N,N-Diethylmethacrylamide, N,NDimethylacrylamide, N-[3-(Dimethylamino)propyl]methacrylamide, N- (Hydroxymethyl)acrylamide, 2-Hydroxypropyl methacrylamide, NIsopropylmethacrylamide, Methacrylamide, N-(Triphenylmethyl)methacrylamide and similar derivatives.

In one embodiment, the polymeric liquid vehicle and/or the film-forming material may be a polymerized solid made from alpha-olefins, dienes such as butadiene and chloroprene; styrene, alpha-methyl styrene, and the like; heteroatom substituted alpha-olefins, for example, vinyl acetate, vinyl alkyl ethers for example, ethyl vinyl ether, vinyltrimethylsilane, vinyl chloride, tetrafluoroethylene, chlorotrifiuoroethylene, cyclic and polycyclic olefin compounds for example, cyclopentene, cyclohexene, cycloheptene, cyclooctene, and cyclic derivatives up to C20; polycyclic derivates for example, norbornene, and similar derivatives up to C20; cyclic vinyl ethers for example, 2, 3-dihydrofuran, 3,4-dihydropyran, and similar derivatives; allylic alcohol derivatives for example, vinylethylene carbonate, disubstituted olefins such as maleic and fumaric compounds for example, maleic anhydride, diethylfumarate, and the like, and mixtures thereof.

In one embodiment, the polymeric liquid vehicle and/or the film-forming material may be PMMA, Poly(lauryl methacrylate), glycolized poly(ethylene terephthalate), Poly(maleic anhydride -altoctadecene), or mixtures thereof.

In one embodiment, the polymeric liquid vehicle and/or the film-forming material may comprise a copolymer of vinyl chloride and a hydroxyfunctional monomer. Such copolymer is described, e.g., in WO2017102574. In such embodiment, examples of hydroxyfunctional monomers include, without limitation, 2-hydroxypropyl acrylate, 1-hydroxy-2-propyl acrylate, 3-methyl-3-buten-1-ol, 2-methyl-2-propenoic acid 2-hydroxypropyl ester, 2-hydroxy-3-chloropropyl methacrylate, N-methylolmethacrylamide, 2-hydroxyethyl methacrylate, poly(ethylene oxide) monomethacrylate, glycerine monomethacrylate, 1 ,2-propylene glycol methacrylate, 2,3-hydroxypropyl methacrylate, 2-hydroxyethyl acrylate, vinyl alcohol, N-methylolacrylamid, 2-propenoic acid 5-hydroxypentyl ester, 2-methyl-2- propenoic acid, 3-chloro-2-hydroxypropyl ester, 1-hydroxy-2-propenoic acid, 1-methylethyl ester, 2-hydroxyethyl allyl ether, 4-hydroxybutyl acrylate, 1,4-butanediol monovinyl ether, poly(e-caprolactone) hydroxyethyl methacrylate ester, poly(ethylene oxide) monomethacrylate, 2-methyl-2-propenoic acid, 2,5-dihydroxypentyl ester, 2-methyl-2-propenoic acid, 5,6-dihydroxyhexyl ester, 1,6-hexanediol monomethacrylate, 1,4-dideoxy-pentitol, 5-(2-methyl-2-propenoate), 2-propenoic acid, 2,4-dihydroxybutyl ester, 2-propenoic acid, 3,4-dihydroxybutyl ester, 2-methyi-2-propenoic acid, 2-hydroxy butyl ester, 3-hydroxypropyl methacrylate, 2-propenoic acid, 2,4-dihydroxybutyl ester and isopropenyl alcohol. Examples of copolymers of vinyl chloride and a hydroxyfunctional monomer include, without limitation, chloroethylene-vinyl acetate-vinyl alcohol copolymer, vinyl alcohol-vinyl chloride copolymer, 2-hydroxypropyl acrylate-vinyl chloride polymer, propanediol monoacrylate-vinyl chloride copolymer, vinyl acetate-vinyl chloride-2-hydroxypropyl acrylate copolymer, hydroxyethyl acrylate-vinyl chloride copolymer and 2-hydroxyethyl methacrylate-vinyl chloride copolymer.

In another embodiment, the ink may further comprise at least one solvent.

According to this embodiment, the solvent is one that allows the solubilization of the particles of the invention and polymeric liquid vehicle and/or the film-forming material such as for example, pentane, hexane, heptane, tetradecane, 1,2-hexanediol, 1,5-pentanediol, cyclohexane, petroleum ether, toluene, benzene, xylene, chlorobenzene, carbon tetrachloride, chloroform, dichloromethane, 1,2-dichloroethane, THF (tetrahydrofuran), acetonitrile, acetone, ethanol, methanol, ethyl acetate, ethylene glycol, diglyme (diethylene glycol dimethyl ether), diethyl ether, DME (1,2-dimethoxy-ethane, glyme), DMF (dimethylformamide), NMF (N-methylformamide), FA (Formamide), DMSO (dimethyl sulfoxide), 1,4-Dioxane, triethyl amine, alkoxy alcohol, alkyl alcohol, alkyl benzene, alkyl benzoate, alkyl naphthalene, amyl octanoate, anisole, aryl alcohol, benzyl alcohol, butyl benzene, butyrophenon, cis-decalin, dipropylene glycol methyl ether, dodecyl benzene, propylene glycol methyl ether acetate (PGMEA), mesitylene, methoxy propanol, methylbenzoate, methyl naphthalene, methyl pyrrolidinone, phenoxy ethanol, 1,3- propanediol, pyrrolidinone, trans-decalin, valerophenone, or mixture thereof. In this embodiment, particle of the invention refers to particle 1, particle 2 and/or nanophosphor nanoparticle.

According to one embodiment, the ink comprises at least two solvents as described hereabove. In this embodiment, the solvents are miscible together.

According to one embodiment, the ink comprises a blend of solvents as described hereabove. In this embodiment, the solvents are miscible together.

According to one embodiment, the ink comprises a plurality of solvents as described hereabove. In this embodiment, the solvents are miscible together.

According to one embodiment, the solvent comprised in the ink is miscible with water.

In another embodiment, the ink comprises a blend of solvents such as for example: a blend of benzyl alcohol and butyl benzene, a blend of benzyl alcohol and anisole, a blend of benzyl alcohol and mesitylene, a blend of butyl benzene and anisole, a blend of butyl benzene and mesitylene, a blend of anisole and mesitylene, a blend of dodecyl benzene and cis-decalin, a blend of dodecyl benzene and benzyl alcohol, a blend of dodecyl benzene and butyl benzene, a blend of dodecyl benzene and anisole, a blend of dodecyl benzene and mesitylene, a blend of cis- decalin and benzyl alcohol, a blend of cis-decalin and butyl benzene, a blend of cis-decalin and anisole, a blend of cis-decalin and mesitylene, a blend of trans-decalin and benzyl alcohol, a blend of trans-decalin and butyl benzene, a blend of trans-decalin and anisole, a blend of trans-decalin and mesitylene, a blend of methyl pyrrolidinone and anisole, a blend of methylbenzoate and anisole, a blend of methyl pyrrolidinone and methyl naphthalene, a blend of methyl pyrrolidinone and methoxy propanol, a blend of methyl pyrrolidinone and phenoxy ethanol, a blend of methyl pyrrolidinone and amyl octanoate, a blend of methyl pyrrolidinone and trans-decalin, a blend of methyl pyrrolidinone and mesitylene, a blend of methyl pyrrolidinone and butyl benzene, a blend of methyl pyrrolidinone and dodecyl benzene, a blend of methyl pyrrolidinone and benzyl alcohol, a blend of anisole and methyl naphthalene, a blend of anisole and methoxy propanol, a blend of anisole and phenoxy ethanol, a blend of anisole and amyl octanoate, a blend of methylbenzoate and methyl naphthalene, a blend of methylbenzoate and methoxy propanol, a blend of methylbenzoate and phenoxy ethanol, a blend of methylbenzoate and amyl octanoate, a blend of methylbenzoate and cis-decalin, a blend of methylbenzoate and trans-decalin, a blend of methylbenzoate and mesitylene, a blend of methylbenzoate and butyl benzene, a blend of methylbenzoate and dodecyl benzene, a blend of methylbenzoate and benzyl alcohol, a blend of methyl naphthalene and methoxy propanol, a blend of methyl naphthalene and phenoxy ethanol, a blend of methyl naphthalene and amyl octanoate, a blend of methyl naphthalene and cis-decalin, a blend of methyl naphthalene and trans-decalin, a blend of methyl naphthalene and mesitylene, a blend of methyl naphthalene and butyl benzene, a blend of methyl naphthalene and dodecyl benzene, a blend of methyl naphthalene and benzyl alcohol, a blend of methoxy propanol and phenoxy ethanol, a blend of methoxy propanol and amyl octanoate, a blend of methoxy propanol and cis-decalin, a blend of methoxy propanol and trans-decalin, a blend of methoxy propanol and mesitylene, a blend of methoxy propanol and butyl benzene, a blend of methoxy propanol and dodecyl benzene, a blend of methoxy propanol and benzyl alcohol, a blend of phenoxy ethanol and amyl octanoate, a blend of phenoxy propanol and mesitylene, a blend of phenoxy propanol and butyl benzene, a blend of phenoxy propanol and dodecyl benzene, a blend of phenoxy propanol and benzyl alcohol, a blend of amyl octanoate and cis-decalin, a blend of amyl octanoate and trans-decalin, a blend of amyl octanoate and mesitylene, a blend of amyl octanoate and butyl benzene, a blend of amyl octanoate and dodecyl benzene, a blend of amyl octanoate and benzyl alcohol, or a combination thereof.

According to one embodiment, the ink comprises a blend of valerophenon and dipropyleneglycol methyl ether, a blend of valerophenon and butyrophenon, a blend of dipropyleneglycol methyl ether and butyrophenon, a blend of dipropyleneglycol methyl ether and 1,3-propanediol, a blend of butyrophenon and 1,3-propanediol, a blend of dipropyleneglycol methyl ether, 1,3-propanediol, and water, or a combination thereof.

According to one embodiment, the ink comprises a blend of three, four, five, or more solvents can be used for the vehicle. For example, the vehicle can comprise a blend of three, four, five, or more solvents selected from pyrrolidinone, methyl pyrrolidinone, anisole, alkyl benzoate, methylbenzoate, alkyl naphthalene, methyl naphthalene, alkoxy alcohol, methoxy propanol, phenoxy ethanol, amyl octanoate, cis-decalin, trans-decalin, mesitylene, alkyl benzene, butyl benzene, dodecyl benzene, alkyl alcohol, aryl alcohol, benzyl alcohol, butyrophenon, dipropylene glycol methyl ether, valerophenon, and 1,3-propanediol. According to one embodiment, the ink comprises three or more solvents selected from cis-decalin, trans-decalin, benzyl alcohol, butyl benzene, anisole, mesitylene, and dodecyl benzene.

In some embodiments, each of the solvents in each of the blends listed above is present in an amount of at least 5% by weight based on the total weight of the liquid vehicle, for example, at least 10% by weight, at least 15% by weight, at least 20% by weight, at least 25% by weight, at least 30% by weight, at least 35% by weight, or at least 40% by weight. In some embodiments, each of the solvents in each of the blends listed can comprise 50% by weight of the liquid vehicle based on the total weight of the liquid vehicle.

In another embodiment, the ink comprises the particles of the invention and a polymeric liquid vehicle, and does not comprise a solvent. In this embodiment, said particles and liquid vehicle can be mixed by extrusion. In this embodiment, particle of the invention refers to particle 1, particle 2 and/or nanophosphor nanoparticle.

In another embodiment, the ink comprises infrared emitting particles of the invention, *i.e.,* having a maximum emission wavelength ranging from 750 nm to 50 µm. In this embodiment, the particles emit near infra-red, mid-infra-red, or infra-red light.

In another embodiment, the ink comprises red emitting particles of the invention, *i.e.,* having a maximum emission wavelength ranging from 590 nm to 750 nm, more preferably ranging from 610 nm to 650 nm.

In another embodiment, the ink comprises yellow emitting particles of the invention, *i.e.,* having a maximum emission wavelength ranging from 560 nm to 590 nm.

In another embodiment, the ink comprises green emitting particles of the invention, *i.e.,* having a maximum emission wavelength ranging from 500 nm to 560 nm, more preferably ranging from 515 nm to 545 nm.

In another embodiment, the ink comprises blue emitting particles of the invention, *i.e.,* having a maximum emission wavelength ranging from 400 nm to 500 nm.

According to another embodiment, the liquid vehicle and/or the film-forming material is inorganic.

According to one embodiment, the liquid vehicle and/or the film-forming material does not comprise glass.

According to one embodiment, the liquid vehicle and/or the film-forming material does not comprise vitrified glass.

According to one embodiment, examples of inorganic liquid vehicle and/or the film-forming material include but are not limited to: materials obtainable by sol-gel process, metal oxides such as for example SiO₂, Al₂O₃, TiO₂, ZrO₂, ZnO, MgO, SnO₂, IrO₂, or a mixture thereof. Said liquid vehicle and/or the film-forming material acts as a supplementary barrier against oxidation and can drain away the heat if it is a good thermal conductor.

According to one embodiment, the liquid vehicle and/or the film-forming material is composed of a material selected in the group of metals, halides, chalcogenides, phosphides, sulfides, metalloids, metallic alloys, ceramics such as for example oxides, carbides, nitrides, glasses, enamels, ceramics, stones, precious stones, pigments, cements and/or inorganic polymers. Said liquid vehicle and/or the film-forming material is prepared using protocols known to the person skilled in the art.

According to one embodiment, a chalcogenide is a chemical compound consisting of at least one chalcogen anion selected in the group of O, S, Se, Te, Po, and at least one or more electropositive element.

According to one embodiment, the metallic liquid vehicle and/or the film-forming material is selected in the group of gold, silver, copper, vanadium, platinum, palladium, ruthenium, rhenium, yttrium, mercury, cadmium, osmium, chromium, tantalum, manganese, zinc, zirconium, niobium, molybdenum, rhodium, tungsten, iridium, nickel, iron, or cobalt.

According to one embodiment, examples of carbide liquid vehicle and/or the film-forming material include but are not limited to: SiC, WC, BC, MoC, TiC, Al₄C₃, LaC₂, FeC, CoC, HfC, SiₓC_{y}, WₓC_{y}, BₓC_{y}, MoₓC_{y}, TiₓC_{y}, AlₓC_{y}, LaₓC_{y}, FeₓC_{y}, CoₓC_{y}, HfₓC_{y}, or a mixture thereof; x and y are independently a decimal number from 0 to 5, at the condition that x and y are not simultaneously equal to 0, and x ≠ 0.

According to one embodiment, examples of oxide liquid vehicle and/or the film-forming material include but are not limited to: SiO₂, Al₂O₃, TiO₂, ZrO₂, ZnO, MgO, SnO₂, Nb₂O₅, CeO₂, BeO, IrO₂, CaO, Sc₂O₃, NiO, Na₂O, BaO, K₂O, PbO, Ag₂O, V₂O₅, TeO₂, MnO, B₂O₃, P₂O₅, P₂O₃, P₄O₇, P₄O₈, P₄O₉, P₂O₆, PO, GeO₂, As₂O₃, Fe₂O₃, Fe₃O₄, Ta₂O₅, Li₂O, SrO, Y₂O₃, HfO₂, WO₂, MoO₂, Cr₂O₃, Tc₂O₇, ReO₂, RuO₂, Co₃O₄, OsO, RhO₂, Rh₂O₃, PtO, PdO, CuO, Cu₂O, CdO, HgO, Tl₂O, Ga₂O₃, In₂O₃, Bi₂O₃, Sb₂O₃, PoO₂, SeO₂, Cs₂O, La₂O₃, Pr₆O₁₁, Nd₂O₃, La₂O₃, Sm₂O₃, Eu₂O₃, Tb₄O₇, Dy₂O₃, Ho₂O₃, Er₂O₃, Tm₂O₃, Yb₂O₃, Lu₂O₃, Gd₂O₃, or a mixture thereof.

According to one embodiment, examples of oxide liquid vehicle and/or the film-forming material include but are not limited to: silicon oxide, aluminium oxide, titanium oxide, copper oxide, iron oxide, silver oxide, lead oxide, calcium oxide, magnesium oxide, zinc oxide, tin oxide, beryllium oxide, zirconium oxide, niobium oxide, cerium oxide, iridium oxide, scandium oxide, nickel oxide, sodium oxide, barium oxide, potassium oxide, vanadium oxide, tellurium oxide, manganese oxide, boron oxide, phosphorus oxide, germanium oxide, osmium oxide, rhenium oxide, platinum oxide, arsenic oxide, tantalum oxide, lithium oxide, strontium oxide, yttrium oxide, hafnium oxide, tungsten oxide, molybdenum oxide, chromium oxide, technetium oxide, rhodium oxide, ruthenium oxide, cobalt oxide, palladium oxide, cadmium oxide, mercury oxide, thallium oxide, gallium oxide, indium oxide, bismuth oxide, antimony oxide, polonium oxide, selenium oxide, cesium oxide, lanthanum oxide, praseodymium oxide, neodymium oxide, samarium oxide, europium oxide, terbium oxide, dysprosium oxide, erbium oxide, holmium oxide, thulium oxide, ytterbium oxide, lutetium oxide, gadolinium oxide, mixed oxides, mixed oxides thereof or a mixture thereof.

According to one embodiment, examples of nitride liquid vehicle and/or the film-forming material include but are not limited to: TiN, Si₃N₄, MoN, VN, TaN, Zr₃N₄, HfN, FeN, NbN, GaN, CrN, AlN, InN, TiₓN_{y}, SiₓN_{y}, MoₓN_{y}, VₓN_{y}, TaₓN_{y}, ZrₓN_{y}, HfₓN_{y}, FeₓN_{y}, NbₓN_{y}, GaₓN_{y}, CrₓN_{y}, AlₓN_{y}, InₓN_{y}, or a mixture thereof; x and y are independently a decimal number from 0 to 5, at the condition that x and y are not simultaneously equal to 0, and x ≠ 0.

According to one embodiment, examples of sulfide liquid vehicle and/or the film-forming material include but are not limited to: Si_{y}Sₓ, Al_{y}Sₓ, Ti_{y}Sₓ, Zr_{y}Sₓ, Zn_{y}Sₓ, Mg_{y}Sₓ, Sn_{y}Sₓ, Nb_{y}Sₓ, Ce_{y}Sₓ, Be_{y}Sₓ, Ir_{y}Sₓ, Ca_{y}Sₓ, Sc_{y}Sₓ, Ni_{y}Sₓ, Na_{y}Sₓ, Ba_{y}Sₓ, K_{y}Sₓ, Pb_{y}Sₓ, Ag_{y}Sₓ, V_{y}Sₓ, Te_{y}Sₓ, Mn_{y}Sₓ, B_{y}Sₓ, P_{y}Sₓ, Ge_{y}Sₓ, As_{y}Sₓ, Fe_{y}Sₓ, Ta_{y}Sₓ, Li_{y}Sₓ, Sr_{y}Sₓ, Y_{y}Sₓ, Hf_{y}Sₓ, W_{y}Sₓ, Mo_{y}Sₓ, Cr_{y}Sₓ, Tc_{y}Sₓ, Re_{y}Sₓ, Ru_{y}Sₓ, Co_{y}Sₓ, Os_{y}Sₓ, Rh_{y}Sₓ, Pt_{y}Sₓ, Pd_{y}Sₓ, Cu_{y}Sₓ, Au_{y}Sₓ, Cd_{y}Sₓ, Hg_{y}Sₓ, Tl_{y}Sₓ, Ga_{y}Sₓ, In_{y}Sₓ, Bi_{y}Sₓ, Sb_{y}Sₓ, Po_{y}Sₓ, Se_{y}Sₓ, Cs_{y}Sₓ, mixed sulfides, mixed sulfides thereof or a mixture thereof; x and y are independently a decimal number from 0 to 10, at the condition that x and y are not simultaneously equal to 0, and x ≠ 0.

According to one embodiment, examples of halide liquid vehicle and/or the film-forming material include but are not limited to: BaF₂, LaF₃, CeF₃, YF₃, CaF₂, MgF₂, PrF₃, AgCl, MnCl₂, NiCl₂, Hg₂Cl₂, CaCl₂, CsPbCl₃, AgBr, PbBr₃, CsPbBr₃, AgI, CuI, PbI, HgI₂, BiI₃, CH₃NH₃PbI₃, CH₃NH₃PbCl₃, CH₃NH₃PbBr₃, CsPbI₃, FAPbBr₃ (with FA formamidinium), or a mixture thereof.

According to one embodiment, examples of chalcogenide liquid vehicle and/or the film-forming material include but are not limited to: CdO, CdS, CdSe, CdTe, ZnO, ZnS, ZnSe, ZnTe, HgO, HgS, HgSe, HgTe, CuO, Cu₂O, CuS, Cu₂S, CuSe, CuTe, Ag₂O, Ag₂S, Ag₂Se, Ag₂Te, Au₂S, PdO, PdS, Pd₄S, PdSe, PdTe, PtO, PtS, PtS₂, PtSe, PtTe, RhO₂, Rh₂O₃, RhS2, Rh₂S₃, RhSe₂, Rh₂Se₃, RhTe₂, IrO₂, IrS₂, Ir₂S₃, IrSe₂, IrTe₂, RuO₂, RuS₂, OsO, OsS, OsSe, OsTe, MnO, MnS, MnSe, MnTe, ReO₂, ReS₂, Cr₂O₃, Cr₂S₃, MoO₂, MoS₂, MoSe₂, MoTe₂, WO₂, WS₂, WSe₂, V₂O₅, V₂S₃, Nb₂O₅, NbS₂, NbSe₂, HfO₂, HfS₂, TiO₂, ZrO₂, ZrS₂, ZrSe₂, ZrTe₂, Sc₂O₃, Y₂O₃, Y₂S₃, SiO₂, GeO₂, GeS, GeS₂, GeSe, GeSe₂, GeTe, SnO₂, SnS, SnS₂, SnSe, SnSe₂, SnTe, PbO, PbS, PbSe, PbTe, MgO, MgS, MgSe, MgTe, CaO, CaS, SrO, Al₂O₃, Ga₂O₃, Ga₂S₃, Ga₂Se₃, In₂O₃, In₂S₃, In₂Se₃, In₂Te₃, La₂O₃, La₂S₃, CeO₂, CeS₂, Pr₆O₁₁, Nd₂O₃, NdS₂, La₂O₃, Tl₂O, Sm₂O₃, SmS₂, Eu₂O₃, EuS₂, Bi₂O₃, Sb₂O₃, PoO₂, SeO₂, Cs₂O, Tb₄O₇, TbS2, Dy₂O₃, Ho₂O₃, Er₂O₃, ErS2, Tm₂O₃, Yb₂O₃, Lu₂O₃, CuInS₂, CuInSe₂, AgInS₂, AgInSe₂, Fe₂O₃, Fe₃O₄, FeS, FeS₂, Co₃S₄, CoSe, Co₃O₄, NiO, NiSe₂, NiSe, Ni₃Se₄, Gd₂O₃, BeO, TeO₂, Na₂O, BaO, K₂O, Ta₂O₅, Li₂O, Tc₂O₇, As₂O₃, B₂O₃, P₂O₅, P₂O₃, P₄O₇, P₄O₈, P₄O₉, P₂O₆, PO, or a mixture thereof.

According to one embodiment, examples of phosphide liquid vehicle and/or the film-forming material include but are not limited to: InP, Cd₃P₂, Zn₃P₂, AlP, GaP, TIP, or a mixture thereof.

According to one embodiment, examples of metalloid liquid vehicle and/or the film-forming material include but are not limited to: Si, B, Ge, As, Sb, Te, or a mixture thereof.

According to one embodiment, examples of metallic alloy liquid vehicle and/or the film-forming material include but are not limited to: Au-Pd, Au-Ag, Au-Cu, Pt-Pd, Pt-Ni, Cu-Ag, Cu-Sn, Ru-Pt, Rh-Pt, Cu-Pt, Ni-Au, Pt-Sn, Pd-V, Ir-Pt, Au-Pt, Pd-Ag, Cu-Zn, Cr-Ni, Fe-Co, Co-Ni, Fe-Ni or a mixture thereof.

According to one embodiment, the ink comprises garnets.

According to one embodiment, examples of garnets include but are not limited to: Y₃Al₅O₁₂, Y₃Fe₂(FeO₄)₃, Y₃Fe₅O₁₂, Y₄Al₂O₉, YAlO₃, Fe₃Al₂(SiO₄)₃, Mg₃Al₂(SiO₄)₃, Mn₃Al₂(SiO₄)₃, Ca₃Fe₂(SiO₄)₃, Ca₃Al₂(SiO₄)₃, Ca₃Cr₂(SiO₄)₃, Al₅Lu₃O₁₂, GAL, GaYAG, or a mixture thereof.

According to one embodiment, the ink comprises or consists of a thermal conductive material wherein said thermal conductive material includes but is not limited to: Al_{y}Oₓ, Ag_{y}Oₓ, Cu_{y}Oₓ, Fe_{y}Oₓ, Si_{y}Oₓ, Pb_{y}Oₓ, Ca_{y}Oₓ, Mg_{y}Oₓ, Zn_{y}Oₓ, Sn_{y}Oₓ, Ti_{y}Oₓ, Be_{y}Oₓ, CdS, ZnS, ZnSe, CdZnS, CdZnSe, Au, Na, Fe, Cu, Al, Ag, Mg, mixed oxides, mixed oxides thereof or a mixture thereof; x and y are independently a decimal number from 0 to 10, at the condition that x and y are not simultaneously equal to 0, and x ≠ 0.

According to one embodiment, the ink comprises or consists of a thermal conductive material wherein said thermal conductive material includes but is not limited to: Al₂O₃, Ag₂O, Cu₂O, CuO, Fe₃O₄, FeO, SiO₂, PbO, CaO, MgO, ZnO, SnO₂, TiO₂, BeO, CdS, ZnS, ZnSe, CdZnS, CdZnSe, Au, Na, Fe, Cu, Al, Ag, Mg, mixed oxides, mixed oxides thereof or a mixture thereof.

According to one embodiment, the ink and/or liquid vehicle and/or the film-forming material comprise or consists of a thermal conductive material wherein said thermal conductive material includes but is not limited to: aluminium oxide, silver oxide, copper oxide, iron oxide, silicon oxide, lead oxide, calcium oxide, magnesium oxide, zinc oxide, tin oxide, titanium oxide, beryllium oxide, zinc sulfide, cadmium sulfide, zinc selenium, cadmium zinc selenium, cadmium zinc sulfide, gold, sodium, iron, copper, aluminium, silver, magnesium, mixed oxides, mixed oxides thereof or a mixture thereof.

According to one embodiment, the liquid vehicle and/or the film-forming material comprises organic molecules in small amounts of 0 mole%, 1 mole%, 5 mole%, 10 mole%, 15 mole%, 20 mole%, 25 mole%, 30 mole%, 35 mole%, 40 mole%, 45 mole%, 50 mole%, 55 mole%, 60 mole%, 65 mole%, 70 mole%, 75 mole%, 80 mole% relative to the majority element of said liquid vehicle and/or the film-forming material.

According to one embodiment, the liquid vehicle and/or the film-forming material comprises a polymeric material as described hereabove, an inorganic material vehicle as described hereabove, or a mixture thereof.

According to one embodiment, the ink comprises at least one liquid vehicle.

According to one embodiment, the ink comprises at least two liquid vehicles. In this embodiment, the liquid vehicles can be identical or different from each other.

According to one embodiment, the ink comprises a plurality of liquid vehicles. In this embodiment, the liquid vehicles can be identical or different from each other.

In one embodiment, the ink comprises at least one population of particles of the invention. In one embodiment, a population of particles is defined by the maximum emission wavelength. In this embodiment, particle of the invention refers to particle 1, particle 2 and/or nanophosphor nanoparticle.

In one embodiment, the ink comprises two populations of particles of the invention emitting different colors or wavelengths. In this embodiment, particle of the invention refers to particle 1, particle 2 and/or nanophosphor nanoparticle.

In one embodiment, the concentration of the at least two populations of said particles comprised in the ink and emitting different colors or wavelengths, is controlled to predetermine the light intensity of each secondary light emitted by each of the least two populations of said particles, after excitation by an incident light.

In one embodiment, the ink comprises particles of the invention which emit green light and red light upon downconversion of a blue light source. In this embodiment, the ink is configured to transmit a predetermined intensity of the blue light from the light source and to emit a predetermined intensity of secondary green and red lights, allowing to emit a resulting tri-chromatic white light. In this embodiment, particle of the invention refers to particle 1, particle 2 and/or nanophosphor nanoparticle.

According to one embodiment, the ink comprises at least one particle of the invention comprising at least one nanoparticle 3 that emits green light upon downconversion of a blue light source. In this embodiment, particle of the invention refers to particle 1, particle 2 and/or nanophosphor nanoparticle.

According to one embodiment, the ink comprises at least one particle of the invention comprising at least one nanoparticles 3 that emits orange light upon downconversion of a blue light source. In this embodiment, particle of the invention refers to particle 1, particle 2 and/or nanophosphor nanoparticle.

According to one embodiment, the ink comprises at least one particle of the invention comprising at least one nanoparticles 3 that emits yellow light upon downconversion of a blue light source. In this embodiment, particle of the invention refers to particle 1, particle 2 and/or nanophosphor nanoparticle.

According to one embodiment, the ink comprises at least one particle of the invention comprising at least one nanoparticles 3 that emits purple light upon downconversion of a blue light source. In this embodiment, particle of the invention refers to particle 1, particle 2 and/or nanophosphor nanoparticle.

In one embodiment, the ink comprises two populations of particles of the invention, a first population with a maximum emission wavelength between 500 nm and 560 nm, more preferably between 515 nm and 545 nm and a second population with a maximum emission wavelength between 600 nm and 2500 nm, more preferably between 610 nm and 650 nm. In this embodiment, particle of the invention refers to particle 1, particle 2 and/or nanophosphor nanoparticle.

In one embodiment, the ink comprises three populations of particles of the invention, a first population of said particles with a maximum emission wavelength between 440 and 499 nm, more preferably between 450 and 495 nm, a second population of said particles with a maximum emission wavelength between 500 nm and 560 nm, more preferably between 515 nm and 545 nm and a third population of said particles with a maximum emission wavelength between 600 nm and 2500 nm, more preferably between 610 nm and 650 nm. In this embodiment, particle of the invention refers to particle 1, particle 2 and/or nanophosphor nanoparticle.

In one embodiment, the ink is splitted in several areas, each of them comprises a different population of particles of the invention emitting different colors or wavelengths.

According to one embodiment, the ink absorbs at least 5%, 10%, 15%, 20%, 25%, 30%, 35%, 40%, 45%, 50%, 55%, 60%, 65%, 70%, 75%, 80%, 85%, 90%, 95%, or 100% of the incident light.

According to one embodiment, the ink absorbs the incident light with wavelength lower than 50 µm, 40 µm, 30 µm, 20 µm, 10 µm, 1 µm, 950 nm, 900 nm, 850 nm, 800 nm, 750 nm, 700 nm, 650 nm, 600 nm, 550 nm, 500 nm, 450 nm, 400 nm, 350 nm, 300 nm, 250 nm, or lower than 200 nm.

According to one embodiment, the ink transmits at least 5%, 10%, 15%, 20%, 25%, 30%, 35%, 40%, 45%, 50%, 55%, 60%, 65%, 70%, 75%, 80%, 85%, 90%, 95%, or 100% of the incident light.

According to one embodiment, the ink scatters at least 5%, 10%, 15%, 20%, 25%, 30%, 35%, 40%, 45%, 50%, 55%, 60%, 65%, 70%, 75%, 80%, 85%, 90%, 95%, or 100% of the incident light.

According to one embodiment, the ink backscatters at least 5%, 10%, 15%, 20%, 25%, 30%, 35%, 40%, 45%, 50%, 55%, 60%, 65%, 70%, 75%, 80%, 85%, 90%, 95%, or 100% of the incident light.

According to one embodiment, the ink transmits a part of the incident light and emits at least one secondary light. In this embodiment, the resulting light is a combination of the remaining transmitted incident light.

According to one embodiment, the ink has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 300 nm, 350 nm, 400 nm, 450 nm, 455 nm, 460 nm, 470 nm, 480 nm, 490 nm, 500 nm, 510 nm, 520 nm, 530 nm, 540 nm, 550 nm, 560 nm, 570 nm, 580 nm, 590 nm, or 600 nm.

According to one embodiment, the ink has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 300 nm.

According to one embodiment, the ink has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 350 nm.

According to one embodiment, the ink has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 400 nm.

According to one embodiment, the ink has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 450 nm.

According to one embodiment, the ink has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 455 nm.

According to one embodiment, the ink has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 460 nm.

According to one embodiment, the ink has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 470 nm.

According to one embodiment, the ink has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 480 nm.

According to one embodiment, the ink has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 490 nm.

According to one embodiment, the ink has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 500 nm.

According to one embodiment, the ink has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 510 nm.

According to one embodiment, the ink has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 520 nm.

According to one embodiment, the ink has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 530 nm.

According to one embodiment, the ink has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 540 nm.

According to one embodiment, the ink has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 550 nm.

According to one embodiment, the ink has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 560 nm.

According to one embodiment, the ink has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 570 nm.

According to one embodiment, the ink has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 580 nm.

According to one embodiment, the ink has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 590 nm.

According to one embodiment, the ink has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 600 nm.

According to one embodiment, the increase in absorption efficiency of incident light by the ink is at least of 1%, 2%, 3%, 4%, 5%, 6%, 7%, 8%, 9%, 10%, 20%, 30%, 40%, 50%, 55%, 60%, 65%, 70%, 75%, 80%, 85%, 90%, 95%, or 100% compared to bare nanoparticles 3.

Bare nanoparticles 3 refers here to nanoparticles 3 that are not encapsulated in a second material 21.

According to one embodiment, the increase in emission efficiency of secondary light by the ink is less than 1%, 2%, 3%, 4%, 5%, 6%, 7%, 8%, 9%, 10%, 20%, 30%, 40%, 50%, 55%, 60%, 65%, 70%, 75%, 80%, 85%, 90%, 95%, or 100% compared to bare nanoparticles 3.

According to one embodiment, the ink exhibits a degradation of its photoluminescence of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years.

According to one embodiment, the ink exhibits a degradation of its photoluminescence of less than 90%, 80%, 70%, 60%, 50%, 40%, 30%, 25%, 20%, 15%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the ink exhibits a degradation of its photoluminescence of less than 90%, 80%, 70%, 60%, 50%, 40%, 30%, 25%, 20%, 15%, 10%, 5%, 4%, 3%, 2%, 1%, or 0% under 0%, 10%, 20%, 30%, 40%, 50%, 55%, 60%, 65%, 70%, 75%, 80%, 85%, 90%, 95%, or 99% of humidity.

According to one embodiment, the ink exhibits a degradation of its photoluminescence of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0%, 10%, 20%, 30%, 40%, 50%, 55%, 60%, 65%, 70%, 75%, 80%, 85%, 90%, 95%, or 99% of humidity.

According to one embodiment, the ink exhibits a degradation of its photoluminescence of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the ink exhibits a degradation of its photoluminescence of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the ink exhibits a degradation of its photoluminescence of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂.

According to one embodiment, the ink exhibits a degradation of its photoluminescence of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the ink exhibits a degradation of its photoluminescence of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0%, 10%, 20%, 30%, 40%, 50%, 55%, 60%, 65%, 70%, 75%, 80%, 85%, 90%, 95%, or 99% of humidity.

According to one embodiment, the ink exhibits a degradation of its photoluminescence of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the ink exhibits a degradation of its photoluminescence quantum yield (PLQY) of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years.

According to one embodiment, the ink exhibits a degradation of its photoluminescence quantum yield (PLQY) of less than 90%, 80%, 70%, 60%, 50%, 40%, 30%, 25%, 20%, 15%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the ink exhibits a degradation of its photoluminescence quantum yield (PLQY) of less than 90%, 80%, 70%, 60%, 50%, 40%, 30%, 25%, 20%, 15%, 10%, 5%, 4%, 3%, 2%, 1%, or 0% under 0%, 10%, 20%, 30%, 40%, 50%, 55%, 60%, 65%, 70%, 75%, 80%, 85%, 90%, 95%, or 99% of humidity.

According to one embodiment, the ink exhibits a degradation of its photoluminescence quantum yield (PLQY) of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0%, 10%, 20%, 30%, 40%, 50%, 55%, 60%, 65%, 70%, 75%, 80%, 85%, 90%, 95%, or 99% of humidity.

According to one embodiment, the ink exhibits a degradation of its photoluminescence quantum yield (PLQY) of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the ink exhibits a degradation of its photoluminescence quantum yield (PLQY) of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the ink exhibits a degradation of its photoluminescence quantum yield (PLQY) of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂.

According to one embodiment, the ink exhibits a degradation of its photoluminescence quantum yield (PLQY) of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the ink exhibits a degradation of its photoluminescence quantum yield (PLQY) of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0%, 10%, 20%, 30%, 40%, 50%, 55%, 60%, 65%, 70%, 75%, 80%, 85%, 90%, 95%, or 99% of humidity.

According to one embodiment, the ink exhibits a degradation of its photoluminescence quantum yield (PLQY) of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the ink exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years,4 years, 4.5 years, 5 years, 5.5 years, 6 years, 6.5 years, 7 years, 7.5 years, 8 years, 8.5 years,9 years, 9.5 years, or 10 years.

According to one embodiment, the ink exhibits a degradation of its FCE of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the ink exhibits a degradation of its FCE of less than 90%, 80%, 70%, 60%, 50%, 40%, 30%, 25%, 20%, 10%, 5%, 4%, 3%, 2%, 1%, or 0% under 0%, 10%, 20%, 30%, 40%, 50%, 55%, 60%, 65%, 70%, 75%, 80%, 85%, 90%, 95%, or 99% of humidity.

According to one embodiment, the ink exhibits a degradation of its FCE of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the ink exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years,4 years, 4.5 years, 5 years, 5.5 years, 6 years, 6.5 years, 7 years, 7.5 years, 8 years, 8.5 years,9 years, 9.5 years, or 10 years, under 0%, 10%, 20%, 30%, 40%, 50%, 55%, 60%, 65%, 70%, 75%, 80%, 85%, 90%, 95%, or 99% of humidity.

According to one embodiment, the ink exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the ink exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the ink exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂.

According to one embodiment, the ink exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the ink exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0%, 10%, 20%, 30%, 40%, 50%, 55%, 60%, 65%, 70%, 75%, 80%, 85%, 90%, 95%, or 99% of humidity.

According to one embodiment, the ink exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

In another embodiment, the ink may further comprise at least one population of converters having phosphor properties. Examples of converter having phosphor properties include, but are not limited to: garnets (LuAG, GAL, YAG, GaYAG), silicates, oxynitrides/oxycarbidonitrides, nintrides/carbidonitrides, Mn4⁺ red phosphors (PFS/KFS), quantum dots.

According to one embodiment, particles of the invention are incorporated in the liquid vehicle at a level ranging from 100 ppm to 500 000 ppm in weight. In this embodiment, particle of the invention refers to particle 1, particle 2 and/or nanophosphor nanoparticle.

According to one embodiment, particlesof the invention are incorporated in the liquid vehicle at a level of at least 100 ppm, 200 ppm, 300 ppm, 400 ppm, 500 ppm, 600 ppm, 700 ppm, 800 ppm, 900 ppm, 1000 ppm, 1100 ppm, 1200 ppm, 1300 ppm, 1400 ppm, 1500 ppm, 1600 ppm, 1700 ppm, 1800 ppm, 1900 ppm, 2000 ppm, 2100 ppm, 2200 ppm, 2300 ppm, 2400 ppm, 2500 ppm, 2600 ppm, 2700 ppm, 2800 ppm, 2900 ppm, 3000 ppm, 3100 ppm, 3200 ppm, 3300 ppm, 3400 ppm, 3500 ppm, 3600 ppm, 3700 ppm, 3800 ppm, 3900 ppm, 4000 ppm, 4100 ppm, 4200 ppm, 4300 ppm, 4400 ppm, 4500 ppm, 4600 ppm, 4700 ppm, 4800 ppm, 4900 ppm, 5000 ppm, 5100 ppm, 5200 ppm, 5300 ppm, 5400 ppm, 5500 ppm, 5600 ppm, 5700 ppm, 5800 ppm, 5900 ppm, 6000 ppm, 6100 ppm, 6200 ppm, 6300 ppm, 6400 ppm, 6500 ppm, 6600 ppm, 6700 ppm, 6800 ppm, 6900 ppm, 7000 ppm, 7100 ppm, 7200 ppm, 7300 ppm, 7400 ppm, 7500 ppm, 7600 ppm, 7700 ppm, 7800 ppm, 7900 ppm, 8000 ppm, 8100 ppm, 8200 ppm, 8300 ppm, 8400 ppm, 8500 ppm, 8600 ppm, 8700 ppm, 8800 ppm, 8900 ppm, 9000 ppm, 9100 ppm, 9200 ppm, 9300 ppm, 9400 ppm, 9500 ppm, 9600 ppm, 9700 ppm, 9800 ppm, 9900 ppm, 10000 ppm, 10500 ppm, 11000 ppm, 11500 ppm, 12000 ppm, 12500 ppm, 13000 ppm, 13500 ppm, 14000 ppm, 14500 ppm, 15000 ppm, 15500 ppm, 16000 ppm, 16500 ppm, 17000 ppm, 17500 ppm, 18000 ppm, 18500 ppm, 19000 ppm, 19500 ppm, 20000 ppm, 30000 ppm, 40000 ppm, 50000 ppm, 60000 ppm, 70000 ppm, 80000 ppm, 90000 ppm, 100000 ppm, 110000 ppm, 120000 ppm, 130000 ppm, 140000 ppm, 150000 ppm, 160000 ppm, 170000 ppm, 180000 ppm, 190000 ppm, 200000 ppm, 210000 ppm, 220000 ppm, 230000 ppm, 240000 ppm, 250000 ppm, 260000 ppm, 270000 ppm, 280000 ppm, 290000 ppm, 300000 ppm, 310000 ppm, 320000 ppm, 330000 ppm, 340000 ppm, 350000 ppm, 360000 ppm, 370000 ppm, 380000 ppm, 390000 ppm, 400000 ppm, 410000 ppm, 420000 ppm, 430000 ppm, 440000 ppm, 450000 ppm, 460000 ppm, 470000 ppm, 480000 ppm, 490000 ppm, or 500 000 ppm in weight. In this embodiment, particle of the invention refers to particle 1, particle 2 and/or nanophosphor nanoparticle.

According to one embodiment, the ink comprises less than 95%, 90%, 80%, 70%, 60%, 50%, 40%, 30%, 20%, preferably 10% in weight of particles of the invention. In this embodiment, particle of the invention refers to particle 1, particle 2 and/or nanophosphor nanoparticle.

According to one embodiment, the loading charge of particles of the invention in the ink is at least 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, 91%, 92%, 93%, 94%, 95%, 96%, 97%, 98%, or 99%. In this embodiment, particle of the invention refers to particle 1, particle 2 and/or nanophosphor nanoparticle.

According to one embodiment, the loading charge of particles of the invention in the ink is less than 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, 91%, 92%, 93%, 94%, 95%, 96%, 97%, 98%, or 99%. In this embodiment, particle of the invention refers to particle 1, particle 2 and/or nanophosphor nanoparticle.

According to one embodiment, the particles of the invention dispersed in the ink have a packing fraction of at least 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, or 95%. In this embodiment, particle of the invention refers to particle 1, particle 2 and/or nanophosphor nanoparticle.

According to one embodiment, the particles of the invention dispersed in the ink have a packing fraction of less than 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, or 95%. In this embodiment, particle of the invention refers to particle 1, particle 2 and/or nanophosphor nanoparticle.

According to one embodiment, the ink is ROHS compliant.

According to one embodiment, the ink comprises less than 10 ppm, less than 20 ppm, less than 30 ppm, less than 40 ppm, less than 50 ppm, less than 100 ppm, less than 150 ppm, less than 200 ppm, less than 250 ppm, less than 300 ppm, less than 350 ppm, less than 400 ppm, less than 450 ppm, less than 500 ppm, less than 550 ppm, less than 600 ppm, less than 650 ppm, less than 700 ppm, less than 750 ppm, less than 800 ppm, less than 850 ppm, less than 900 ppm, less than 950 ppm, less than 1000 ppm in weight of cadmium.

According to one embodiment, the ink comprises less than 10 ppm, less than 20 ppm, less than 30 ppm, less than 40 ppm, less than 50 ppm, less than 100 ppm, less than 150 ppm, less than 200 ppm, less than 250 ppm, less than 300 ppm, less than 350 ppm, less than 400 ppm, less than 450 ppm, less than 500 ppm, less than 550 ppm, less than 600 ppm, less than 650 ppm, less than 700 ppm, less than 750 ppm, less than 800 ppm, less than 850 ppm, less than 900 ppm, less than 950 ppm, less than 1000 ppm, less than 2000 ppm, less than 3000 ppm, less than 4000 ppm, less than 5000 ppm, less than 6000 ppm, less than 7000 ppm, less than 8000 ppm, less than 9000 ppm, less than 10000 ppm in weight of lead.

According to one embodiment, the ink comprises less than 10 ppm, less than 20 ppm, less than 30 ppm, less than 40 ppm, less than 50 ppm, less than 100 ppm, less than 150 ppm, less than 200 ppm, less than 250 ppm, less than 300 ppm, less than 350 ppm, less than 400 ppm, less than 450 ppm, less than 500 ppm, less than 550 ppm, less than 600 ppm, less than 650 ppm, less than 700 ppm, less than 750 ppm, less than 800 ppm, less than 850 ppm, less than 900 ppm, less than 950 ppm, less than 1000 ppm, less than 2000 ppm, less than 3000 ppm, less than 4000 ppm, less than 5000 ppm, less than 6000 ppm, less than 7000 ppm, less than 8000 ppm, less than 9000 ppm, less than 10000 ppm in weight of mercury.

According to one embodiment, the ink comprise heavier chemical elements or materials based on heavier chemical elements than the main chemical element present in the liquid vehicle and/or the material of the particle of the invention. In this embodiment, said heavy chemical elements in the ink will lower the mass concentration of chemical elements subject to ROHS standards, allowing said ink to be ROHS compliant. In this embodiment, particle of the invention refers to particle 1, particle 2 and/or nanophosphor nanoparticle.

According to one embodiment, examples of heavy elements include but are not limited to B, C, N, F, Na, Mg, Al, Si, P, S, Cl, K, Ca, Sc, Ti, V, Cr, Mn, Fe, Co, Ni, Cu, Zn, Ga, Ge, As, Se, Br, Rb, Sr, Y, Zr, Nb, Mo, Tc, Ru, Rh, Pd, Ag, Cd, In, Sn, Sb, Te, I, Cs, Ba, La, Hf, Ta, W, Re, Os, Ir, Pt, Au, Hg, Tl, Pb, Bi, Po, At, Ce, Pr, Nd, Pm, Sm, Eu, Gd, Tb, Dy, Ho, Er, Tm, Yb, Lu or a mixture of thereof.

According to one embodiment, the ink further comprises a variety of components such as those typically used in inkjet liquid vehicles, such as, but not limited to solvents, cosolvents, surface tension adjusting agents, spreading modifier, charge-transporting agents, surfactants, biocides, buffers, viscosity modifiers, sequestering agents, crosslinking photoinitiator, crosslinking agent, colorants, pigments, stabilizing agents, humectants, scatterers, fillers, extenders, water, and mixtures thereof.

According to one embodiment, examples of the surfactant include but are not limited to: carboxylic acids such as for example oleic acid, acetic acid, octanoic acid; thiols such as octanethiol, hexanethiol, butanethiol; 4-mercaptobenzoic acid; Triton X100, amines such as for example oleylamine, 1,6-hexanediamine, octylamine; phosphonic acids; antibodies; or a mixture thereof.

According to one embodiment, the spreading modifier comprises an alkoxylated aliphatic diacrylate monomer, an alkoxylated aliphatic dimethacrylate monomer, or a mixture thereof.

According to one embodiment, the spreading modifier has a viscosity in the range from about 10 to about 25 centipoise at 25°C and a surface tension in the range from about 25 to about 45 dynes/cm at 25°C.

According to one embodiment, the ink comprises from 10 wt. % to 80 wt. % of a spreading modifier.

According to one embodiment, the ink comprises 4-10 wt. % of pentaerythritol tetraacrylate, pentaerythritol tetramethacrylate, or a combination thereof.

According to one embodiment, the ink comprises polyethylene glycol.

According to one embodiment, the ink comprises dimethacrylate monomer, monoacrylate monomer, polyethylene glycol diacrylate monomer, diacrylate monomer, or a mixture thereof.

According to one embodiment, the monomer has a number average molecular weight in the range from about 100 g/mole to about 1000 g/mole; from about 150 g/mole to about 800 g/mole; from about 200 g/mole to about 600 g/mole; from about 200 g/mole to about 500 g/mole; from about 250 g/mole to about 450 g/mole.

According to one embodiment, the ink comprises a multifunctional methacrylate crosslinking agent, multifunctional acrylate crosslinking agent, or a mixture thereof.

According to one embodiment, the ink comprises 0.5 wt% to 20 wt% of a multifunctional methacrylate crosslinking agent, multifunctional acrylate crosslinking agent.

According to one embodiment, the ink comprises a crosslinking photoinitiator.

According to one embodiment, the ink comprises 0.05 wt% to 20 wt% of crosslinking photoinitiator.

According to one embodiment, the ink comprises a multifunctional crosslinking agent.

According to one embodiment, the ink comprises 0.05 wt% to 20 wt% of multifunctional crosslinking agent.

According to one embodiment, the ink comprises at least one pigment.

According to one embodiment, the pigment has an average size ranging from 10 nm to 1 µm.

According to one embodiment, the ink comprises at least 0.1%, 0.2%, 0.3%, 0.4%, 0.5%, 0.6%, 0.7%, 0.8%, 0.9%, 1%, 2%, 3%, 4%, 5%, 6%, 7%, 8%, 9%, 10%, 15%, 20%, 25%, 30%, 35%, 40%, 45%, or 50% of a pigment.

According to one embodiment, the pigment substantially insoluble in the liquid vehicle.

According to one embodiment, the pigment substantially soluble in the liquid vehicle.

According to one embodiment, the ink further comprises particles of various shapes and materials added to the ink composition for the purpose of providing refractive index adjustment and/or substantially reducing the water vapor permeation through said ink. In this embodiment, the ink further comprises particles such as for example metal oxide nanoparticles, such as zirconium oxide, aluminum oxide, titanium oxide, and hafnium oxide; graphene nanostructures, such as graphene nanoribbons and graphene platelets; or a mixture thereof. In this embodiment, said particles have a size between 5 nm to 50 nm. In this embodiment, the loading of said particles in the ink is ranging from 0.1%wt to 2.0 %wt.

According to one embodiment, the ink has a viscosity and a surface tension at inkjet jetting temperatures that enable reliable delivery from an inkjet printhead while leaving little or no residue on the printhead.

Methods for measuring viscosities and surface tensions are well known and include the use of commercially available rheometers (*e.g.,* a DV-I Prime Brookfield rheometer) and tensiometers (*e.g.,* a SITA bubble pressure tensiometer).

According to one embodiment, the ink has a density of at least 0.90, 0.95, 1.00, 1.05, 1.10, 1.15, 1.20, 1.25, 1.30, 1.35, 1.40, 1.45, 1.50, 1.55, 1.60, 1.65, 1.70, 1.75, 1.80, 1.85, 1.90 1.95, or 2.00.

According to one embodiment, the density of the ink is tuned to obtaine a homogeneous layer and a desired thickness when the ink is deposited on a support.

According to one embodiment, the ink exhibits a viscosity of at least 0.5 mPa.s, 1.0 mPa.s, 2.0 mPa.s, 3.0 mPa.s, 4.0 mPa.s, 5.0 mPa.s, 6.0 mPa.s, 7.0 mPa.s, 8.0 mPa.s, 9.0 mPa.s, 10.0 mPa.s, 11.0 mPa.s, 12.0 mPa.s, 13.0 mPa.s, 14.0 mPa.s, 15.0 mPa.s, 16.0 mPa.s, 17.0 mPa.s, 18.0 mPa.s, 19.0 mPa.s, 20.0 mPa.s, 21.0 mPa.s, 22.0 mPa.s, 23.0 mPa.s, 24.0 mPa.s, 25.0 mPa.s, 26.0 mPa.s, 27.0 mPa.s, 28.0 mPa.s, 29.0 mPa.s, or 30.0 mPa.s, at 25°C.

According to one embodiment, the ink exhibits a viscosity of at least 0.5 mPa.s, 1.0 mPa.s, 2.0 mPa.s, 3.0 mPa.s, 4.0 mPa.s, 5.0 mPa.s, 6.0 mPa.s, 7.0 mPa.s, 8.0 mPa.s, 9.0 mPa.s, 10.0 mPa.s, 11.0 mPa.s, 12.0 mPa.s, 13.0 mPa.s, 14.0 mPa.s, 15.0 mPa.s, 16.0 mPa.s, 17.0 mPa.s, 18.0 mPa.s, 19.0 mPa.s, 20.0 mPa.s, 21.0 mPa.s, 22.0 mPa.s, 23.0 mPa.s, 24.0 mPa.s, 25.0 mPa.s, 26.0 mPa.s, 27.0 mPa.s, 28.0 mPa.s, 29.0 mPa.s, or 30.0 mPa.s.

According to one embodiment, the ink exhibits a viscosity of at least 0.5 centipoise, 1.0 centipoise, 2.0 centipoise, 3.0 centipoise, 4.0 centipoise, 5.0 centipoise, 6.0 centipoise, 7.0 centipoise, 8.0 centipoise, 9.0 centipoise, 10.0 centipoise, 11.0 centipoise, 12.0 centipoise, 13.0 centipoise, 14.0 centipoise, 15.0 centipoise, 16.0 centipoise, 17.0 centipoise, 18.0 centipoise, 19.0 centipoise, 20.0 centipoise, 21.0 centipoise, 22.0 centipoise, 23.0 centipoise, 24.0 centipoise, 25.0 centipoise, 26.0 centipoise, 27.0 centipoise, 28.0 centipoise, 29.0 centipoise, or 30.0 centipoise, at 25°C.

According to one embodiment, the ink exhibits a viscosity of at least 0.5 centipoise, 1.0 centipoise, 2.0 centipoise, 3.0 centipoise, 4.0 centipoise, 5.0 centipoise, 6.0 centipoise, 7.0 centipoise, 8.0 centipoise, 9.0 centipoise, 10.0 centipoise, 11.0 centipoise, 12.0 centipoise, 13.0 centipoise, 14.0 centipoise, 15.0 centipoise, 16.0 centipoise, 17.0 centipoise, 18.0 centipoise, 19.0 centipoise, 20.0 centipoise, 21.0 centipoise, 22.0 centipoise, 23.0 centipoise, 24.0 centipoise, 25.0 centipoise, 26.0 centipoise, 27.0 centipoise, 28.0 centipoise, 29.0 centipoise, or 30.0 centipoise.

According to one embodiment, the ink exhibits a Reynolds number of at least 1, 2, 3, 4, 5, 6, 7, 8, 9, 10, 11, 12, 13, 14, 15, 16, 17, 18, 19, 20, 30, 40, 50, 60, 70, 80, 90, 100, 110, 120, 130, 140, 150, 160, 170, 180, 190, 200, 300, 400, 500, 600, 700, 800, 900, or 1000.

According to one embodiment, the ink flow exhibits a Reynolds number of at least 1, 2, 3, 4, 5, 6, 7, 8, 9, 10, 11, 12, 13, 14, 15, 16, 17, 18, 19, 20, 30, 40, 50, 60, 70, 80, 90, 100, 110, 120, 130, 140, 150, 160, 170, 180, 190, 200, 300, 400, 500, 600, 700, 800, 900, or 1000.

According to one embodiment, the ink exhibits an Ohnesorge number of at least 0.01, 0.02, 0.03, 0.04, 0.05, 0.06, 0.07, 0.08, 0.09, 0.1, 0.15, 0.2, 0.25, 0.3, 0.35, 0.4, 0.45, 0.5, 0.55, 0.6, 0.65, 0.7, 0.75, 0.8, 0.85, 0.9, 0.95, 1, 2, 3, 4, 5, 6, 7, 8, 9, 10.

According to one embodiment, the ink drops exhibit an Ohnesorge number of at least 0.01, 0.02, 0.03, 0.04, 0.05, 0.06, 0.07, 0.08, 0.09, 0.1, 0.15, 0.2, 0.25, 0.3, 0.35, 0.4, 0.45, 0.5, 0.55, 0.6, 0.65, 0.7, 0.75, 0.8, 0.85, 0.9, 0.95, 1, 2, 3, 4, 5, 6, 7, 8, 9, 10.

According to one embodiment, the viscosity of the ink is tuned to obtaine a homogeneous layer and a desired thickness when the ink is deposited on a support.

According to one embodiment, the ink deposited on a support forms a continouous layer, *i.e.,* without cracks or interruptions.

According to one embodiment, the ink deposited on a support forms a layer with a varying thickness along its length.

According to one embodiment, the ink deposited on a support forms a layer with a homogeneous or uniform thickness along its length.

In one embodiment, the support as described herein can be heated or cooled down by an external system.

According to one embodiment, the ink has a viscosity and a surface tension at inkjet jetting temperatures, for example, at 25°C, that enable delivery from an inkjet printhead.

According to one embodiment, the liquid vehicle can exhibit properties that provide a substantially uniformly thick film of the ink.

According to one embodiment, the ink exhibits a surface tension of at least 20.0 dynes/cm, 25 dynes/cm, 30 dynes/cm, 35 dynes/cm, 40.0 dynes/cm, 45 dynes/cm, 50.0 dynes/cm, 55 dynes/cm, or 60.0 dynes/cm, at 25°C.

According to one embodiment, the liquid vehicle is miscible with water.

According to one embodiment, the liquid vehicle comprises water.

According to one embodiment, the liquid vehicle comprises at least one surfactant.

According to one embodiment, the ink comprises at least 1 wt%, 2 wt%, 3 wt%, 4 wt%, 5 wt%, 6 wt%, 7 wt%, 8 wt%, 9 wt%, 10 wt%, 15 wt%, 20 wt%, 25 wt%, 30 wt%, 35 wt%, 40 wt%, 45 wt%, 50 wt%, 55 wt%, 60 wt%, 65 wt%, 70 wt%, 75 wt%, 80 wt%, 85 wt%, 90 wt%, 95 wt%, or 99 wt% of solvent as described hereabove.

According to one embodiment, the ink comprises at least 1 wt%, 2 wt%, 3 wt%, 4 wt%, 5 wt%, 6 wt%, 7 wt%, 8 wt%, 9 wt%, 10 wt%, 15 wt%, 20 wt%, 25 wt%, 30 wt%, 35 wt%, 40 wt%, 45 wt%, 50 wt%, 55 wt%, 60 wt%, 65 wt%, 70 wt%, 75 wt%, 80 wt%, 85 wt%, 90 wt%, 95 wt%, or 99 wt% of liquid vehicle as described hereabove.

According to one embodiment, the ink comprises at least 0.01 wt%, 0.02 wt%, 0.03 wt%, 0.04 wt%, 0.05 wt%, 0.06 wt%, 0.07 wt%, 0.08 wt%, 0.09 wt%, 0.1 wt%, 0.2 wt%, 0.3 wt%, 0.4 wt%, 0.5 wt%, 0.6 wt%, 0.7 wt%, 0.8 wt%, 0.9 wt%, 1 wt%, 2 wt%, 3 wt%, 4 wt%, 5 wt%, 6 wt%, 7 wt%, 8 wt%, 9 wt%, 10 wt%, 15 wt%, 20 wt%, 25 wt%, 30 wt%, 35 wt%, 40 wt%, 45 wt%, 50 wt%, 55 wt%, 60 wt%, 65 wt%, 70 wt%, 75 wt%, 80 wt%, 85 wt%, 90 wt%, 95 wt%, or 99 wt% of particle of the invention. In this embodiment, particle of the invention refers to particle **1,** particle **2** and/or nanophosphor nanoparticle.

According to one embodiment, in the ink, the weight ratio between the liquid vehicle and the particle of the invention is at least 0.01%, 0.02%, 0.03%, 0.04%, 0.05%, 0.06%, 0.07%, 0.08%, 0.09%, 0.1%, 0.2%, 0.3%, 0.4%, 0.5%, 0.6%, 0.7%, 0.8%, 0.9%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, or 50%. In this embodiment, particle of the invention refers to particle **1,** particle **2** and/or nanophosphor nanoparticle.as described hereabove.

According to one embodiment, the ink comprises particles of the invention, polyethylene glycol dimethacrylate monomer, monoacrylate monomer, a multifunctional methacrylate crosslinking agent and a crosslinking photoinitiator. In this embodiment, particle of the invention refers to particle **1,** particle **2** and/or nanophosphor nanoparticle as described hereabove.

According to one embodiment, the ink comprises particles of the invention, water and 1,2-hexanediol. In this embodiment, particle of the invention refers to particle **1,** particle **2** and/or nanophosphor nanoparticle as described hereabove.

According to one embodiment, the ink comprises particles of the invention, polyethylene glycol diacrylate monomer, multifunctional acrylate crosslinking agent, spreading modifier comprising an alkoxylated aliphatic diacrylate monomer. In this embodiment, particle of the invention refers to particle **1,** particle **2** and/or nanophosphor nanoparticle.as described hereabove.

According to one embodiment, the ink comprises a liquid vehicle consisting essentially of up to 16 wt % of 1,2-hexanediol or 1,5-pentanediol; a balance of water; and from about 0.01 wt. % to about 10 wt. % of particles of the invention. In this embodiment, particle of the invention refers to particle **1,** particle **2** and/or nanophosphor nanoparticle.as described hereabove.

According to one embodiment, the ink comprises particles of the invention, a mixed solvent of chlorobenzene and cyclohexane, Triton X-100 as an additive. In this embodiment, particle of the invention refers to particle **1,** particle **2** and/or nanophosphor nanoparticle.as described hereabove.

According to one embodiment, the ink comprises particles of the invention, Ebecyl, TiO₂. In this embodiment, particle of the invention refers to particle **1,** particle **2** and/or nanophosphor nanoparticle.as described hereabove.

According to one embodiment, the ink comprises particles of the invention; 40 wt% to 60 wt% polyethylene glycol dimethacrylate monomer, polyethylene glycol diacrylate monomer, or a combination thereof, wherein the polyethylene glycol dimethacrylate monomer and the polyethylene glycol diacrylate monomer have number average molecular weights in the range from about 230 g/mole to about 430 g mole; 25 wt% to 50 wt% monoacrylate monomer, monomethacrylate monomer, or a combination thereof, having a viscosity in the range from about 10 cps to about 27 cps at 22 °C; 4 wt% to 10 wt% multifunctional acrylate crosslinking agent, a multifunctional methacrylate crosslinking agent, or a combination thereof; and 0.1 wt% to 10 wt% crosslinking photoinitiator.

According to one embodiment, the ink comprises particles of the invention; 40 wt% to 60 wt% polyethylene glycol dimethacrylate monomer, polyethylene glycol diacrylate monomer, or a combination thereof, wherein the polyethylene glycol dimethacrylate monomer and the polyethylene glycol diacrylate monomer have number average molecular weights in the range from about 230 g/mole to about 430 g mole; 25 wt% to 50 wt% monoacrylate monomer, monomethacrylate monomer, or a combination thereof, having a viscosity in the range from about 10 cps to about 27 cps at 22 °C; 4 wt% to 10 wt% multifunctional acrylate crosslinking agent, a multifunctional methacrylate crosslinking agent, or a combination thereof; and 0.1 wt% to 10 wt% crosslinking photoinitiator, the ink composition having a surface tension of between about 32 dynes/cm and about 45 dynes/cm at 22 °C.

According to one embodiment, the ink comprises particles of the invention; from 30 wt% to 50 wt% of a polyethylene glycol dimethacrylate monomer, a polyethylene glycol diacrylate monomer, or a combination thereof, wherein the polyethylene glycol dimethacrylate monomer and the polyethylene glycol diacrylate monomer have number average molecular weights in the range from 230 g/mole to 430 g/mole; from 4 wt% to 10 wt% of a multifunctional acrylate crosslinking agent, a multifunctional methacrylate crosslinking agent, or a combination thereof; and from 40 wt% to 60 wt% of a spreading modifier comprising an alkoxylated aliphatic diacrylate monomer, an alkoxylated aliphatic dimethacrylate monomer, or a combination thereof, and having a viscosity in the range from 14 cps to 18 cps at 22°C and a surface tension in the range from 35 dynes/cm to 39 dynes/cm at 22°C.

According to one embodiment, from 30 wt% to 50 wt% of the ink comprises a monomer selected from the group consisting of a polyethylene glycol dimethacrylate monomer, a polyethylene glycol diacrylate monomer, and a combination thereof, wherein the polyethylene glycol dimethacrylate monomer and the polyethylene glycol diacrylate monomer have number average molecular weights in the range from 230 g/mole to 430 g/mole; from 4 wt% to 10 wt% of the ink comprises a crosslinking agent selected from the group consisting of a multifunctional acrylate crosslinking agent, a multifunctional methacrylate crosslinking agent, and a combination thereof; and from 40 wt% to 60 wt% of the ink comprises a spreading modifier selected from the group consisting of an alkoxylated aliphatic diacrylate monomer, an alkoxylated aliphatic dimethacrylate monomer, and a combination thereof.

According to one embodiment, from 30 wt% to 50 wt% of the ink comprises a monomer selected from the group consisting of a polyethylene glycol dimethacrylate monomer, a polyethylene glycol diacrylate monomer, and a combination thereof, wherein the polyethylene glycol dimethacrylate monomer and the polyethylene glycol diacrylate monomer have number average molecular weights in the range from 230 g/mole to 430 g/mole; from 4 wt% to 10 wt% of the ink comprises a crosslinking agent selected from the group consisting of a multifunctional acrylate crosslinking agent, a multifunctional methacrylate crosslinking agent, and a combination thereof; and from 40 wt% to 60 wt% of the ink comprises a spreading modifier selected from the group consisting of an alkoxylated aliphatic diacrylate monomer, an alkoxylated aliphatic dimethacrylate monomer, and a combination thereof, the ink having a viscosity in the range from 14 cps to 18 cps at 22°C and a surface tension in the range from 35 dynes/cm to 39 dynes/cm at 22°C.

According to one embodiment, the ink comprises particles of the invention; 75-95 wt% of a polyethylene glycol dimethacrylate monomer, a polyethylene glycol diacrylate monomer, or a combination thereof, wherein the polyethylene glycol dimethacrylate monomer and the polyethylene glycol diacrylate monomer have number average molecular weights in the range from about 230 g/mole to about 430 g/mole; 4-10 wt% of pentaerythritol tetraacrylate, pentaerythritol tetramethacrylate, or a combination thereof; and 1-15 wt% of a spreading modifier having a viscosity in the range from about 14 to about 18 cps at 22°C and a surface tension in the range from about 35 to about 39 dynes/cm at 22°C.

According to one embodiment, the ink comprises materials configured to limit or prevent the coffee-ring effect.

According to one embodiment, the ink is formulated to leave little or no residue in the pores of a thermal printing printhead that comprises pores. In this embodiment at least 50000 cycles of printing can be performed without clogging the pores of said printhead. Microscopic examination, for example, at 20X magnification, can be used to visually inspect for residue and/or residue build-up on the printhead.

According to one embodiment, the ink is formulated to leave no mark of abrasion on a printhead.

According to one embodiment, the ink may be used in a light source.

According to one embodiment, the ink may be used as a color filter.

According to one embodiment, the ink may be used in a color filter.

According to one embodiment, the ink may be used in addition to a color filter.

According to one embodiment, the ink is deposited on a support by drop-casting, spin coating, dip coating, inkjet printing, spray, plating, electroplating, or any other means known by the person skilled in the art.

According to one embodiment, the ink is deposited on a support by inkjet printing: thermal, piezoelectric or other inkjet printing methods.

According to one embodiment, the deposited ink has a thickness between 30 nm and 10 cm, more preferably between 100 nm and 1 cm, even more preferably between 100 nm and 1 mm.

According to one embodiment, the deposited ink has a thickness of at least 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µηι, 4 µm, 4.1 µm, 4.2 µm, 4.3 µm, 4.4 µm, 4.5 µm, 4.6 µm, 4.7 µm, 4.8 µm, 4.9 µm, 5 µm, 5.1 µm, 5.2 µm, 5.3 µm, 5.4 µm, 5.5 µm, 5.5 µm, 5.6 µm, 5.7 µm, 5.8 µm, 5.9 µm, 6 µm, 6.5 µηι, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, 1 mm, 1.1 mm, 1.2 mm, 1.3 mm, 1.4 mm, 1.5 mm, 1.6 mm, 1.7 mm, 1.8 mm, 1.9 mm, 2 mm, 2.1 mm, 2.2 mm, 2.3 mm, 2.4 mm, 2.5 mm, 2.6 mm, 2.7 mm, 2.8 mm, 2.9 mm, 3 mm, 3.1 mm, 3.2 mm, 3.3 mm, 3.4 mm, 3.5 mm, 3.6 mm, 3.7 mm, 3.8 mm, 3.9 mm, 4 mm, 4.1 mm, 4.2 mm, 4.3 mm, 4.4 mm, 4.5 mm, 4.6 mm, 4.7 mm, 4.8 mm, 4.9 mm, 5 mm, 5.1 mm, 5.2 mm, 5.3 mm, 5.4 mm, 5.5 mm, 5.6 mm, 5.7 mm, 5.8 mm, 5.9 mm, 6 mm, 6.1 mm, 6.2 mm, 6.3 mm, 6.4 mm, 6.5 mm, 6.6 mm, 6.7 mm, 6.8 mm, 6.9 mm, 7 mm, 7.1 mm, 7.2 mm, 7.3 mm, 7.4 mm, 7.5 mm, 7.6 mm, 7.7 mm, 7.8 mm, 7.9 mm, 8 mm, 8.1 mm, 8.2 mm, 8.3 mm, 8.4 mm, 8.5 mm, 8.6 mm, 8.7 mm, 8.8 mm, 8.9 mm, 9 mm, 9.1 mm, 9.2 mm, 9.3 mm, 9.4 mm, 9.5 mm, 9.6 mm, 9.7 mm, 9.8 mm, 9.9 mm, 1 cm, 1.1 cm, 1.2 cm, 1.3 cm, 1.4 cm, 1.5 cm, 1.6 cm, 1.7 cm, 1.8 cm, 1.9 cm, 2 cm, 2.1 cm, 2.2 cm, 2.3 cm, 2.4 cm, 2.5 cm, 2.6 cm, 2.7 cm, 2.8 cm, 2.9 cm, 3 cm, 3.1 cm, 3.2 cm, 3.3 cm, 3.4 cm, 3.5 cm, 3.6 cm, 3.7 cm, 3.8 cm, 3.9 cm, 4 cm, 4.1 cm, 4.2 cm, 4.3 cm, 4.4 cm, 4.5 cm, 4.6 cm, 4.7 cm, 4.8 cm, 4.9 cm, 5 cm, 5.1 cm, 5.2 cm, 5.3 cm, 5.4 cm, 5.5 cm, 5.6 cm, 5.7 cm, 5.8 cm, 5.9 cm, 6 cm, 6.1 cm, 6.2 cm, 6.3 cm, 6.4 cm, 6.5 cm, 6.6 cm, 6.7 cm, 6.8 cm, 6.9 cm, 7 cm, 7.1 cm, 7.2 cm, 7.3 cm, 7.4 cm, 7.5 cm, 7.6 cm, 7.7 cm, 7.8 cm, 7.9 cm, 8 cm, 8.1 cm, 8.2 cm, 8.3 cm, 8.4 cm, 8.5 cm, 8.6 cm, 8.7 cm, 8.8 cm, 8.9 cm, 9 cm, 9.1 cm, 9.2 cm, 9.3 cm, 9.4 cm, 9.5 cm, 9.6 cm, 9.7 cm, 9.8 cm, 9.9 cm, or 10 cm.

According to one embodiment, the support is a solar panel, or a panel.

In one embodiment, the support can be a substrate, a LED, a LED array, a vessel, a tube or a container. Preferably the support is optically transparent at wavelengths between 200 nm and 50 µm, between 200 nm and 10 µm, between 200 nm and 2500 nm, between 200 nm and 2000 nm, between 200 nm and 1500 nm, between 200 nm and 1000 nm, between 200 nm and 800 nm, between 400 nm and 700 nm, between 400 nm and 600 nm, or between 400 nm and 470 nm.

LED used herein includes LED, LED chip **5** and microsized LED **6.**

In one embodiment, the support can be a fabric, a piece of clothes, wood, plastic, ceramic, glass, steel, metal, or any active surfaces.

In one embodiment, active surfaces are interactive surfaces.

In one embodiment, active surfaces are surfaces destined to be included in an optoelectronic device, or a display device.

In one embodiment, the support is reflective.

In one embodiment, the support comprises a material allowing to reflect the light such as for example a metal like aluminium, silver, a glass, a polymer or a plastic.

In one embodiment, the support is thermally conductive.

According to one embodiment, the support has a thermal conductivity at standard conditions ranging from 0.5 to 450 W/(m.K), preferably from 1 to 200 W/(m.K), more preferably from 10 to 150 W/(m.K).

According to one embodiment, the support has a thermal conductivity at standard conditions of at least 0.1 W/(m.K), 0.2 W/(m.K), 0.3 W/(m.K), 0.4 W/(m.K), 0.5 W/(m.K), 0.6 W/(m.K), 0.7 W/(m.K), 0.8 W/(m.K), 0.9 W/(m.K), 1 W/(m.K), 1.1 W/(m.K), 1.2 W/(m.K), 1.3 W/(m.K), 1.4 W/(m.K), 1.5 W/(m.K), 1.6 W/(m.K), 1.7 W/(m.K), 1.8 W/(m.K), 1.9 W/(m.K), 2 W/(m.K), 2.1 W/(m.K), 2.2 W/(m.K), 2.3 W/(m.K), 2.4 W/(m.K), 2.5 W/(m.K), 2.6 W/(m.K), 2.7 W/(m.K), 2.8 W/(m.K), 2.9 W/(m.K), 3 W/(m.K), 3.1 W/(m.K), 3.2 W/(m.K), 3.3 W/(m.K), 3.4 W/(m.K), 3.5 W/(m.K), 3.6 W/(m.K), 3.7 W/(m.K), 3.8 W/(m.K), 3.9 W/(m.K), 4 W/(m.K), 4.1 W/(m.K), 4.2 W/(m.K), 4.3 W/(m.K), 4.4 W/(m.K), 4.5 W/(m.K), 4.6 W/(m.K), 4.7 W/(m.K), 4.8 W/(m.K), 4.9 W/(m.K), 5 W/(m.K), 5.1 W/(m.K), 5.2 W/(m.K), 5.3 W/(m.K), 5.4 W/(m.K), 5.5 W/(m.K), 5.6 W/(m.K), 5.7 W/(m.K), 5.8 W/(m.K), 5.9 W/(m.K), 6 W/(m.K), 6.1 W/(m.K), 6.2 W/(m.K), 6.3 W/(m.K), 6.4 W/(m.K), 6.5 W/(m.K), 6.6 W/(m.K), 6.7 W/(m.K), 6.8 W/(m.K), 6.9 W/(m.K), 7 W/(m.K), 7.1 W/(m.K), 7.2 W/(m.K), 7.3 W/(m.K), 7.4 W/(m.K), 7.5 W/(m.K), 7.6 W/(m.K), 7.7 W/(m.K), 7.8 W/(m.K), 7.9 W/(m.K), 8 W/(m.K), 8.1 W/(m.K), 8.2 W/(m.K), 8.3 W/(m.K), 8.4 W/(m.K), 8.5 W/(m.K), 8.6 W/(m.K), 8.7 W/(m.K), 8.8 W/(m.K), 8.9 W/(m.K), 9 W/(m.K), 9.1 W/(m.K), 9.2 W/(m.K), 9.3 W/(m.K), 9.4 W/(m.K), 9.5 W/(m.K), 9.6 W/(m.K), 9.7 W/(m.K), 9.8 W/(m.K), 9.9 W/(m.K), 10 W/(m.K), 10.1 W/(m.K), 10.2 W/(m.K), 10.3 W/(m.K), 10.4 W/(m.K), 10.5 W/(m.K), 10.6 W/(m.K), 10.7 W/(m.K), 10.8 W/(m.K), 10.9 W/(m.K), 11 W/(m.K), 11.1 W/(m.K), 11.2 W/(m.K), 11.3 W/(m.K), 11.4 W/(m.K), 11.5 W/(m.K), 11.6 W/(m.K), 11.7 W/(m.K), 11.8 W/(m.K), 11.9 W/(m.K), 12 W/(m.K), 12.1 W/(m.K), 12.2 W/(m.K), 12.3 W/(m.K), 12.4 W/(m.K), 12.5 W/(m.K), 12.6 W/(m.K), 12.7 W/(m.K), 12.8 W/(m.K), 12.9 W/(m.K), 13 W/(m.K), 13.1 W/(m.K), 13.2 W/(m.K), 13.3 W/(m.K), 13.4 W/(m.K), 13.5 W/(m.K), 13.6 W/(m.K), 13.7 W/(m.K), 13.8 W/(m.K), 13.9 W/(m.K), 14 W/(m.K), 14.1 W/(m.K), 14.2 W/(m.K), 14.3 W/(m.K), 14.4 W/(m.K), 14.5 W/(m.K), 14.6 W/(m.K), 14.7 W/(m.K), 14.8 W/(m.K), 14.9 W/(m.K), 15 W/(m.K), 15.1 W/(m.K), 15.2 W/(m.K), 15.3 W/(m.K), 15.4 W/(m.K), 15.5 W/(m.K), 15.6 W/(m.K), 15.7 W/(m.K), 15.8 W/(m.K), 15.9 W/(m.K), 16 W/(m.K), 16.1 W/(m.K), 16.2 W/(m.K), 16.3 W/(m.K), 16.4 W/(m.K), 16.5 W/(m.K), 16.6 W/(m.K), 16.7 W/(m.K), 16.8 W/(m.K), 16.9 W/(m.K), 17 W/(m.K), 17.1 W/(m.K), 17.2 W/(m.K), 17.3 W/(m.K), 17.4 W/(m.K), 17.5 W/(m.K), 17.6 W/(m.K), 17.7 W/(m.K), 17.8 W/(m.K), 17.9 W/(m.K), 18 W/(m.K), 18.1 W/(m.K), 18.2 W/(m.K), 18.3 W/(m.K), 18.4 W/(m.K), 18.5 W/(m.K), 18.6 W/(m.K), 18.7 W/(m.K), 18.8 W/(m.K), 18.9 W/(m.K), 19 W/(m.K), 19.1 W/(m.K), 19.2 W/(m.K), 19.3 W/(m.K), 19.4 W/(m.K), 19.5 W/(m.K), 19.6 W/(m.K), 19.7 W/(m.K), 19.8 W/(m.K), 19.9 W/(m.K), 20 W/(m.K), 20.1 W/(m.K), 20.2 W/(m.K), 20.3 W/(m.K), 20.4 W/(m.K), 20.5 W/(m.K), 20.6 W/(m.K), 20.7 W/(m.K), 20.8 W/(m.K), 20.9 W/(m.K), 21 W/(m.K), 21.1 W/(m.K), 21.2 W/(m.K), 21.3 W/(m.K), 21.4 W/(m.K), 21.5 W/(m.K), 21.6 W/(m.K), 21.7 W/(m.K), 21.8 W/(m.K), 21.9 W/(m.K), 22 W/(m.K), 22.1 W/(m.K), 22.2 W/(m.K), 22.3 W/(m.K), 22.4 W/(m.K), 22.5 W/(m.K), 22.6 W/(m.K), 22.7 W/(m.K), 22.8 W/(m.K), 22.9 W/(m.K), 23 W/(m.K), 23.1 W/(m.K), 23.2 W/(m.K), 23.3 W/(m.K), 23.4 W/(m.K), 23.5 W/(m.K), 23.6 W/(m.K), 23.7 W/(m.K), 23.8 W/(m.K), 23.9 W/(m.K), 24 W/(m.K), 24.1 W/(m.K), 24.2 W/(m.K), 24.3 W/(m.K), 24.4 W/(m.K), 24.5 W/(m.K), 24.6 W/(m.K), 24.7 W/(m.K), 24.8 W/(m.K), 24.9 W/(m.K), 25 W/(m.K), 30 W/(m.K), 40 W/(m.K), 50 W/(m.K), 60 W/(m.K), 70 W/(m.K), 80 W/(m.K), 90 W/(m.K), 100 W/(m.K), 110 W/(m.K), 120 W/(m.K), 130 W/(m.K), 140 W/(m.K), 150 W/(m.K), 160 W/(m.K), 170 W/(m.K), 180 W/(m.K), 190 W/(m.K), 200 W/(m.K), 210 W/(m.K), 220 W/(m.K), 230 W/(m.K), 240 W/(m.K), 250 W/(m.K), 260 W/(m.K), 270 W/(m.K), 280 W/(m.K), 290 W/(m.K), 300 W/(m.K), 310 W/(m.K), 320 W/(m.K), 330 W/(m.K), 340 W/(m.K), 350 W/(m.K), 360 W/(m.K), 370 W/(m.K), 380 W/(m.K), 390 W/(m.K), 400 W/(m.K), 410 W/(m.K), 420 W/(m.K), 430 W/(m.K), 440 W/(m.K), or 450 W/(m.K).

According to one embodiment, the substrate comprises GaN, GaSb, GaAs, GaAsP, GaP, InP, SiGe, InGaN, GaAlN, GaAlPN, AlN, AlGaAs, AlGaP, AlGaInP, AlGaN, AlGaInN, ZnSe, Si, SiC, diamond, boron nitride.

According to one embodiment, the substrate comprises Au, Ag, Pt, Ru, Ni, Co, Cr, Cu, Sn, Rh Pd, Mn, Ti or a mixture thereof.

According to one embodiment, the substrate comprises silicon oxide, aluminium oxide, titanium oxide, copper oxide, iron oxide, silver oxide, lead oxide, calcium oxide, magnesium oxide, zinc oxide, tin oxide, beryllium oxide, zirconium oxide, niobium oxide, cerium oxide, iridium oxide, scandium oxide, nickel oxide, sodium oxide, barium oxide, potassium oxide, vanadium oxide, tellurium oxide, manganese oxide, boron oxide, phosphorus oxide, germanium oxide, osmium oxide, rhenium oxide, platinum oxide, arsenic oxide, tantalum oxide, lithium oxide, strontium oxide, yttrium oxide, hafnium oxide, tungsten oxide, molybdenum oxide, chromium oxide, technetium oxide, rhodium oxide, ruthenium oxide, cobalt oxide, palladium oxide, cadmium oxide, mercury oxide, thallium oxide, gallium oxide, indium oxide, bismuth oxide, antimony oxide, polonium oxide, selenium oxide, cesium oxide, lanthanum oxide, praseodymium oxide, neodymium oxide, samarium oxide, europium oxide, terbium oxide, dysprosium oxide, erbium oxide, holmium oxide, thulium oxide, ytterbium oxide, lutetium oxide, gadolinium oxide, mixed oxides, mixed oxides thereof or a mixture thereof.

A second object of the invention relates to an ink comprising at least one particle **2** (as illustrated in Fig. 18) comprising a plurality of nanoparticles **3** encapsulated in a material **21;** and at least one liquid vehicle; wherein said particle **2** has a surface roughness less or equal to 5% of the largest dimension of said particle **2.**

According to one embodiment, the particle **2** is as described hereabove.

According to one embodiment, in an ink comprising a plurality of particles **2,** said particles **2** are poly disperse.

According to one embodiment, in an ink comprising a plurality of particles **2,** said particles **2** are monodisperse.

According to one embodiment, in an ink comprising a plurality of particles **2,** said particles **2** have a narrow size distribution.

According to one embodiment, in an ink comprising a plurality of particles **2,** said particles **2** are not aggregated in the liquid vehicle.

According to one embodiment, in an ink comprising a plurality of particles **2,** said particles **2** are not in contact in the liquid vehicle.

According to one embodiment, in an ink comprising a plurality of particles **2,** said particles **2** are individually dispersed in the liquid vehicle.

According to one embodiment, in an ink comprising a plurality of particles **2,** said particles **2** are aggregated in the liquid vehicle.

According to one embodiment, in an ink comprising a plurality of particles **2,** said particles **2** are in contact in the liquid vehicle.

According to one embodiment, the nanoparticles **3** are as described hereabove.

According to one embodiment, the material **21** is the second material **21** as described hereabove.

According to one embodiment, the liquid vehicle is as described hereabove.

According to one embodiment, the ink is as described hereabove.

According to one embodiment, the ink is deposited on a support by inkjet printing: thermal, piezoelectric or other inkjet printing methods.

In one embodiment, the support is as described hereabove.

In one embodiment, the multilayered system is as described hereabove.

A fourth object of the invention relates to an ink comprising at least one particle **1** (illustrated in figure 1) comprising a first material **11** and at least one liquid vehicle; wherein the particle **1** comprises at least one particle **2** comprising a second material **21** and at least one nanoparticle 3 dispersed in said second material **21;** and wherein said particle **1** has a surface roughness less or equal to 5% of the largest dimension of said particle **1.**

According to one embodiment, the particle **1** is as described hereabove.

According to one embodiment, the particle **2** is as described hereabove.

According to one embodiment, the nanoparticles **3** are as described hereabove.

According to one embodiment, the first material **11** and the second material **21** are as described hereabove.

According to one embodiment, the liquid vehicle is as described hereabove.

According to one embodiment, the ink is as described hereabove.

According to one embodiment, the ink is deposited on a support by inkjet printing: thermal, piezoelectric or other inkjet printing methods.

In one embodiment, the support is as described hereabove.

In one embodiment, the multilayered system is as described hereabove.

In a preferred embodiment, examples of the ink include but are not limited to:
- an ink comprising particles of the invention in PMMA, MMA or PS;
- an ink comprising: 40 wt.% to 60 wt. % polyethylene glycol dimethacrylate monomer, or polyethylene glycol diacrylate monomer (number average molecular weights in the range from about 230 g/mole to about 430 g mole); 25 wt.% to 50 wt.% monoacrylate monomer, or monomethacrylate monomer (viscosity in the range from about 10 cps to about 27 cps at 22 °C); 4 wt.% to 10 wt. % multifunctional acrylate crosslinking agent, or a multifunctional methacrylate crosslinking agent; and 0.1 wt.% to 10 wt.% crosslinking photoinitiator; and 0.01 wt.% to 50 wt.% particles of the invention;
- an ink comprising: from 30 wt. % to 50 wt. % of a polyethylene glycol dimethacrylate monomer, or a polyethylene glycol diacrylate monomer (number average molecular weights in the range from 230 g/mole to 430 g/mole); from 4 wt. % to 10 wt. % of a multifunctional acrylate crosslinking agent, or a multifunctional methacrylate crosslinking agent; from 40 wt. % to 60 wt. % of a spreading modifier comprising an alkoxylated aliphatic diacrylate monomer, or an alkoxylated aliphatic dimethacrylate monomer (viscosity in the range from 14 cps to 18 cps at 22°C and surface tension in the range from 35 dynes/cm to 39 dynes/cm at 22°C); and 0.01 wt.% to 50 wt.% particles of the invention;

- an ink comprising: from 30 wt. % to 50 wt. % of a monomer selected from the group consisting of a polyethylene glycol dimethacrylate monomer, a polyethylene glycol diacrylate monomer (number average molecular weights in the range from 230 g/mole to 430 g/mole); from 4 wt. % to 10 wt. % of a crosslinking agent selected from the group consisting of a multifunctional acrylate crosslinking agent, a multifunctional methacrylate crosslinking agent; from 40 wt. % to 60 wt. % of a spreading modifier selected from the group consisting of an alkoxylated aliphatic diacrylate monomer, an alkoxylated aliphatic dimethacrylate monomer; and 0.01 wt.% to 50 wt.% particles of the invention;
- an ink comprising: 75-95 wt. % of a polyethylene glycol dimethacrylate monomer, or a polyethylene glycol diacrylate monomer (number average molecular weights in the range from about 230 g/mole to about 430 g/mole); 4-10 wt. % of pentaerythritol tetraacrylate, or pentaerythritol tetramethacrylate; 1-15 wt. % of a spreading modifier (viscosity in the range from about 14 to about 18 cps at 22°C and surface tension in the range from about 35 to about 39 dynes/cm at 22°C); and 0.01 wt.% to 50 wt.% particles of the invention;
- an ink comprising: particles **1,** di(meth)acrylate monomers; wherein said particles **1** comprise particles **2** comprising quantum dots or semiconductor nanoplatelets;
- an ink comprising: particles **2,** di(meth)acrylate monomers; wherein said particles **2** comprise quantum dots or semiconductor nanoplatelets;
- an ink comprising: particles **1,** a combination of di(meth)acrylate and mono(meth)acrylate monomers; wherein said particles **1** comprise particles **2** comprising quantum dots or semiconductor nanoplatelets;
- an ink comprising: particles **2,** a combination of di(meth)acrylate and mono(meth)acrylate monomers; wherein said particles **2** comprise quantum dots or semiconductor nanoplatelets;
- 70 wt. % to 96 wt. % di(meth)acrylate monomers or a combination of di(meth)acrylate monomers and mono(meth)acrylate monomers; 4 wt. % to 10 wt. % multifunctional (meth)acrylate crosslinking agent; and 0.1 wt. % to 5 wt. % particles of the invention;
- particles of the invention in combination with plasmonic scattering particles such as Ag or Au particles dispersed in a liquid vehicle;
- particles of the invention in combination with scattering particles dispersed in a liquid vehicle.

According to a preferred embodiment, examples of particle of the invention include but are not limited to: semiconductor nanoparticles encapsulated in an inorganic material, semiconductor nanocrystals encapsulated in an inorganic material, semiconductor nanoplatelets encapsulated in an inorganic material, perovskite nanoparticles encapsulated in an inorganic material, phosphor nanoparticles encapsulated in an inorganic material, semiconductor nanoplatelets coated with grease and then in an inorganic material such as for example Al₂O₃, or a mixture thereof. In this embodiment, grease can refer to lipids as, for example, long apolar carbon chain molecules; phosphlipid molecules that possess a charged end group; polymers such as block copolymers or copolymers, wherein one portion of polymer has a domain of long apolar carbon chains, either part of the backbone or part of the polymeric sidechain; or long hydrocarbon chains that have a terminal functional group that includes carboxylates, sulfates, phosphonates or thiols.

According to a preferred embodiment, examples of particle of the invention include but are not limited to: CdSe/CdZnS@SiO₂, CdSe/CdZnS@SiₓCd_{y}Zn_{z}O_{w}, CdSe/CdZnS@Al₂O₃, InP/ZnS@Al₂O₃, CH₅N₂-PbBr₃@Al₂O₃, CdSe/CdZnS-Au@SiO₂, Fe₃O₄@Al₂O₃-CdSe/CdZnS@SiO₂, CdS/ZnS@Al₂O₃, CdSeS/CdZnS@Al₂O₃, CdSe/CdS/ZnS@Al₂O₃, InP/ZnSe/ZnS@Al₂O₃, CuInS₂/ZnS@Al₂O₃, CuInSe₂/ZnS@Al₂O₃, CdSe/CdS/ZnS@SiO₂, CdSeS/ZnS@Al₂O₃, CdSeS/CdZnS@SiO₂, InP/ZnS@SiO₂, CdSeS/CdZnS@SiO₂, InP/ZnSe/ZnS@SiO₂, Fe₃O₄@Al₂O₃, CdSe/CdZnS@ZnO, CdSe/CdZnS@ZnO, CdSe/CdZnS@Al₂O₃@MgO, CdSe/CdZnS-Fe₃O₄@SiO₂, phosphor nanoparticles@Al₂O₃, phosphor nanoparticles@ZnO, phosphor nanoparticles@ SiO₂, phosphor nanoparticles@HfO₂, CdSe/CdZnS@HfO₂, CdSeS/CdZnS@HfO₂, InP/ZnS@HfO₂, CdSeS/CdZnS@HfO₂, InP/ZnSe/ZnS@HfO₂, CdSe/CdZnS-Fe₃O₄@HfO₂, CdSe/CdS/ZnS@SiO₂, or a mixture thereof; wherein phosphor nanoparticles include but are not limited to: Yttrium aluminium garnet particles (YAG, Y₃Al₅O₁₂), (Ca,Y)-α-SiAlON:Eu particles, ((Y,Gd)₃(Al,Ga)₅O₁₂:Ce) particles, CaAlSiN₃:Eu particles, sulfide-based phosphor particles, PFS:Mn⁴⁺ particles (potassium fluorosilicate).

According to a preferred embodiment, examples of particle of the invention include but are not limited to: semiconductor nanoparticles encapsulated in an inorganic material dispersed in Al₂O₃, HfO₂, Si_{0.8}Hf_{0.2}O₂, ZnS, ZnO, MgO, or SiO₂; semiconductor nanocrystals encapsulated in an inorganic material dispersed in Al₂O₃, HfO₂, Si_{0.8}Hf_{0.2}O₂, ZnS, ZnO, MgO, or SiO₂; semiconductor nanoplatelets encapsulated in an inorganic material dispersed in Al₂O₃, HfO₂, Si_{0.8}Hf_{0.2}O₂, ZnS, ZnO, MgO, or SiO₂; perovskite nanoparticles encapsulated in an inorganic material dispersed in Al₂O₃, HfO₂, Si_{0.8}Hf_{0.2}O₂, ZnS, ZnO, MgO, or SiO₂; phosphor nanoparticles encapsulated in an inorganic material dispersed in Al₂O₃, HfO₂, Si_{0.8}Hf_{0.2}O₂, ZnS, ZnO, MgO, or SiO₂; semiconductor nanoplatelets coated with grease dispersed in Al₂O₃, HfO₂, Si_{0.8}Hf_{0.2}O₂, ZnS, ZnO, MgO, or SiO₂; or a mixture thereof. In this embodiment, grease can refer to lipids as, for example, long apolar carbon chain molecules; phosphlipid molecules that possess a charged end group; polymers such as block copolymers or copolymers, wherein one portion of polymer has a domain of long apolar carbon chains, either part of the backbone or part of the polymeric sidechain; or long hydrocarbon chains that have a terminal functional group that includes carboxylates, sulfates, phosphonates or thiols.

According to a preferred embodiment, examples of particle of the invention include but are not limited to: CdSe/CdZnS@SiO₂@Al₂O₃, CdSe/CdZnS@SiₓCd_{y}ZnO_{w}@Al₂O₃, CdSe/CdZnS-Au@SiO₂@Al₂O₃, CdSeS/CdZnS@SiO₂@Al₂O₃, InP/ZnSe/ZnS@SiO₂@Al₂O₃, CdSeS/CdZnS@SiO₂@Al₂O₃, phosphor nanoparticles@SiO₂@Al₂O₃, Fe₃O₄@SiO₂@Al₂O₃, InP/ZnS4SiO₂@Al₂O₃, CdSe/CdZnS-Au@SiO₂@Al₂O₃, CdSe/CdS/ZnS@SiO₂@Al₂O₃; CdSe/CdZnS@SiO₂@ZnO, CdSe/CdZnS@SiₓCd_{y}Zn_{z}O_{w}@ZnO, CdSe/CdZnS-Au@SiO₂@ZnO, CdSeS/CdZnS@SiO₂@ZnO, InP/ZnSe/ZnS@SiO₂@ZnO, CdSeS/CdZnS@SiO₂@ZnO, phosphor nanoparticle@SiO₂@ZnO, Fe₃O₄@SiO₂@ZnO, InP/ZnS@SiO₂@ZnO, CdSe/CdZnS-Au@SiO₂@ZnO, CdSe/CdS/ZnS@SiO₂@ZnO; CdSe/CdZnS@SiO₂@HfO₂, CdSe/CdZnS@SiₓCd_{y}Zn_{z}O_{w}@HfO₂, CdSe/CdZnS-Au@SiO₂@HfO₂, CdSeS/CdZnS@SiO₂@HfO₂, InP/ZnSe/ZnS@SiO₂@HfO₂, CdSeS/CdZnS@SiO₂@HfO₂, phosphor nanoparticles@SiO₂@HfO₂, Fe₃O₄@SiO₂@HfO₂, InP/ZnS@SiO₂@HfO₂, CdSe/CdZnS-Au@SiO₂@HfO₂, CdSe/CdS/ZnS@SiO₂@HfO₂; CdSe/CdZnS@SiO₂@MgO, CdSe/CdZnS@SiₓCd_{y}Zn_{z}O_{w}@MgO, CdSe/CdZnS-Au@SiO₂@MgO, CdSeS/CdZnS@SiO₂@MgO, InP/ZnSe/ZnS@SiO₂@MgO, CdSeS/CdZnS@SiO₂@MgO, phosphor nanoparticles@SiO₂@MgO, Fe₃O@SiO₂@MgO, InP/ZnS@SiO₂@MgO, CdSe/CdZnS-Au@SiO₂@MgO, CdSe/CdS/ZnS@SiO₂@MgO;CdSe/CdZnS@Al₂O₃@SiO₂, InP/ZnS@Al₂O₃@SiO₂, CH₅N₂-PbBr₃@AlO₃@SiO₂, CdS/ZnS@Al₂O₃@SiO₂, CdSeS/CdZnS@Al₂O₃@SiO₂, CdSeS/ZnS@Al₂O₃@SiO₂, Fe₃O₄@Al₂O₃@SiO₂, CdSe/CdZnS- phosphor nanoparticles@Al₂O₃@SiO₂; CdSe/CdZnS@Al₂O₃@ZnO, InP/ZnS@Al₂O₃@ZnO, CH₅N₂-PbBr₃@Al₂O₃@ZnO, CdS/ZnS@Al₂O₃@ZnO, CdSeS/CdZnS@Al₂O₃@ZnO, CdSeS/ZnS@Al₂O₃@ZnO, Fe₃O₄@Al₂O₃@ZnO, CdSe/CdZnS- phosphor nanoparticles@Al₂O₃@ZnO; CdSe/CdZnS@Al₂O₃@HfO₂, InP/ZnS@Al₂O₃@HfO₂, CH₅N₂-PbBr₃@Al₂O₃@HfO₂, CdS/ZnS@Al₂O₃@HfO₂, CdSeS/CdZnS@Al₂O₃@HfO₂, CdSeS/ZnS@Al₂O₃@HfO₂, Fe₃O₄@Al₂O₃@HfO₂, CdSe/CdZnS- phosphor nanoparticles@Al₂O₃@HfO₂; CdSe/CdZnS@Al₂O₃@MgO, InP/ZnS@Al₂O₃@MgO, CH₅N₂-PbBr₃@Al₂O₃@MgO, CdS/ZnS@Al₂O₃@MgO, CdSeS/CdZnS@Al₂O₃@MgO, CdSeS/ZnS@Al₂O₃@MgO, Fe₃O₄@Al₂O₃@MgO, CdSe/CdZnS- phosphor nanoparticles@Al₂O₃@MgO; CdSe/CdZnS@ZnO@Al₂O₃, CdSe/CdZnS@ZnO@Al₂O₃, phosphor nanoparticles@ZnO@Al₂O₃; CdSe/CdZnS@ZnO@HfO₂, CdSe/CdZnS@ZnO@HfO₂, phosphor nanoparticles@ZnO@HfO₂; CdSe/CdZnS@ZnO@SiO₂, CdSe/CdZnS@ZnO@SiO₂, phosphor nanoparticles@ZnO@SiO₂; CdSe/CdZnS@ZnO@MgO, CdSe/CdZnS@ZnO@MgO, phosphor nanoparticles@ZnO@MgO; phosphor nanoparticles@HfO₂@Al₂O₃, CdSe/CdZnS@HfO₂@Al₂O₃, CdSeS/CdZnS@HfO₂@Al₂O₃, InP/ZnS@HfO₂@Al₂O₃, CdSeS/CdZnS@HfO₂@Al₂O₃, InP/ZnSe/ZnS@HfO₂@Al₂O₃, CdSe/CdZnS-Fe₃O₄@HfO₂@Al₂O₃; phosphor nanoparticles@HfO₂@SiO₂, CdSe/CdZnS@HfO₂@SiO₂, CdSeS/CdZnS@HfO₂@SiO₂, InP/ZnS@HfO₂@SiO₂, CdSeS/CdZnS@HfO₂@SiO₂, InP/ZnSe/ZnS@HfO₂@SiO₂, CdSe/CdZnS-Fe₃O₄@HfO₂@SiO₂; phosphor nanoparticles@HfO₂@ZnO, CdSe/CdZnS@HfO₂@ZnO, CdSeS/CdZnS@HfO₂@ZnO, InP/ZnS@HfO₂@ZnO, CdSeS/CdZnS@HfO₂@ZnO, InP/ZnSe/ZnS@HfO₂@ZnO, CdSe/CdZnS-Fe₃O₄@HfO₂@ZnO; phosphor nanoparticles@HfO₂@MgO, CdSe/CdZnS@HfO₂@MgO, CdSeS/CdZnS@HfO₂@MgO, InP/ZnS@HfO₂@MgO, CdSeS/CdZnS@HfO₂@MgO, InP/ZnSe/ZnS@HfO₂@MgO, CdSe/CdZnS-Fe₃O₄@HfO₂@MgO; InP/GaP/ZnSe/ZnS@Al₂O₃@HfO₂; InP/ZnS/ZnSe/ZnS@Al₂O₃@HfO₂; CdSe/CdZnS@HfO₂@Si_{0.8}Hf_{0.2}O₂; CdSe/CdZnS@Al₂O₃@HfO₂; CdSe/CdZnS@Al₂O₃ and SnO₂ particles encapsulated in Al₂O₃; phosphor particles@Al₂O₃@HfO₂ CdSe/CdZnS@HfO₂@Al₂O₃; CdSe/CdZnS@HfO₂ and SnO₂ particles encapsulated in Al₂O₃; phosphor particles@HfO₂@Al₂O₃; CdSe/CdZnS@HfO₂@SiO₂ comprising SnO₂ nanoparticles; semiconductor nanoplatelets@Al₂O₃@SiO₂; semiconductor nanoplatelets@HfO₂@SiO₂; semiconductor nanoplatelets@Al₂O₃@SiO₂; CdSe/CdZnS@HfO₂@SiO₂; or a mixture thereof; wherein phosphor nanoparticles include but are not limited to: Yttrium aluminium garnet particles (YAG, Y₃Al₅O₁₂), (Ca,Y)-α-SiAlON:Eu particles, ((Y,Gd)₃(Al,Ga)₅O₁₂:Ce) particles, CaAlSiN₃:Eu particles, sulfide-based phosphor particles, PFS:Mn4⁺ particles (potassium fluorosilicate).

According to one embodiment, the particle **1** does not comprise a spacer layer between the nanoparticles **3** and the material (**11, 21**).

According to one embodiment, the particle 1 does not comprise one core/shell nanoparticle wherein the core is luminescent and emits red light, and the shell is a spacer layer between the nanoparticles **3** and the material (**11, 21**).

According to one embodiment, the particle **1** does not comprise a core/shell nanoparticle and a plurality of nanoparticles **3,** wherein the core is luminescent and emits red light, and the shell is a spacer layer between the nanoparticles **3** and the material (**11, 21**).

According to one embodiment, the particle **1** does not comprise at least one luminescent core, a spacer layer, an encapsulation layer and a plurality of quantum dots, wherein the luminescent core emits red light, and the spacer layer is situated between said luminescent core and the material (**11, 21**).

According to one embodiment, the particle **1** does not comprise a luminescent core sourrounded by a spacer layer and emitting red light.

According to one embodiment, the particle **1** does not comprise nanoparticles covering or surrounding a luminescent core.

According to one embodiment, the particle **1** does not comprise nanoparticles covering or surrounding a luminescent core emitting red light.

According to one embodiment, the particle **1** does not comprise a luminescent core made by a specific material selected from the group consisting of silicate phosphor, aluminate phosphor, phosphate phosphor, sulfide phosphor, nitride phosphor, nitrogen oxide phosphor, and combination of aforesaid two or more materials; wherein said luminescent core is covered by a spacer layer.

Another object of the invention relates to a pattern comprising at least one ink deposited by inkjet printing on a support.

Said ink comprising:
i. at least one particle **1** comprising a first material **11** and at least one liquid vehicle; wherein the particle **1** comprises at least one particle **2** comprising a second material **21** and at least one nanoparticle **3** dispersed in said second material **21;** and wherein the first material **11** and the second material **21** have an attenuation coefficient less or equal to 1×10⁻² cm⁻¹ at 460 nm.; or
ii. at least one particle **2** comprising a plurality of nanoparticles **3** encapsulated in a material **21;** and at least one liquid vehicle; wherein said particle **2** has a surface roughness less or equal to 5% of the largest dimension of said particle **2;** or
iii. at least one phosphor nanoparticle; and at least one liquid vehicle; wherein the phosphor nanoparticle has a size ranging from 0.1 µm to 50 µm; or
iv. at least one particle **1** comprising a first material **11** and at least one liquid vehicle; wherein the particle **1** comprises at least one particle **2** comprising a second material **21** and at least one nanoparticle **3** dispersed in said second material **21;** and wherein said particle **1** has a surface roughness less or equal to 5% of the largest dimension of said particle **1.**

According to one embodiment, the particle **1** is as described hereabove.

According to one embodiment, the particle **2** is as described hereabove.

According to one embodiment, the nanoparticles **3** are as described hereabove.

According to one embodiment, the first material **11** and/or the second material **21** are as described hereabove.

According to one embodiment, the liquid vehicle is as described hereabove.

According to one embodiment, the ink is as described hereabove.

According to one embodiment, the support is as described hereabove.

According to one embodiment, the at least one phosphor nanoparticle is as described hereabove.

According to one embodiment, the support is a LED chip or microsized LED.

According to one embodiment, the ink is deposited on a support by inkjet printing: thermal, piezoelectric or other inkjet printing methods.

According to one embodiment, the pattern is formed by deposition of an ink on a support by inkjet printing: thermal, piezoelectric or other inkjet printing methods.

According to one embodiment, the pattern is formed by deposition of an ink on a support by spin coating, inkjet printing (thermal, piezoelectric or other inkjet printing methods), slot die coating, nozzle printing, contact printing, gravure printing, and any solution printing technology.

According to one embodiment, the pattern is fluorescent.

According to one embodiment, the pattern is phosphorescent.

According to one embodiment, the pattern is luminescent.

According to one embodiment, the pattern is electroluminescent.

According to one embodiment, the pattern is chemiluminescent.

According to one embodiment, the pattern is triboluminescent.

According to one embodiment, the features of the light emission of pattern are sensible to external pressure variations. In this embodiment, "sensible" means that the features of the light emission can be modified by external pressure variations.

According to one embodiment, the wavelength emission peak of pattern is sensible to external pressure variations. In this embodiment, "sensible" means that the wavelength emission peak can be modified by external pressure variations, *i.e.,* external pressure variations can induce a wavelength shift.

According to one embodiment, the FWHM of pattern is sensible to external pressure variations. In this embodiment, "sensible" means that the FWHM can be modified by external pressure variations, *i.e.,* FWHM can be reduced or increased.

According to one embodiment, the PLQY of pattern is sensible to external pressure variations. In this embodiment, "sensible" means that the PLQY can be modified by external pressure variations, *i.e.,* PLQY can be reduced or increased.

According to one embodiment, the features of the light emission of pattern are sensible to external temperature variations.

According to one embodiment, the wavelength emission peak of pattern is sensible to external temperature variations. In this embodiment, "sensible" means that the wavelength emission peak can be modified by external temperature variations, *i.e.,* external temperature variations can induce a wavelength shift.

According to one embodiment, the FWHM of pattern is sensible to external temperature variations. In this embodiment, "sensible" means that the FWHM can be modified by external temperature variations, *i.e.,* FWHM can be reduced or increased.

According to one embodiment, the PLQY of pattern is sensible to external temperature variations. In this embodiment, "sensible" means that the PLQY can be modified by external temperature variations, *i.e.,* PLQY can be reduced or increased.

According to one embodiment, the features of the light emission of pattern are sensible to external variations of pH.

According to one embodiment, the wavelength emission peak of pattern is sensible to external variations of pH. In this embodiment, "sensible" means that the wavelength emission peak can be modified by external variations of pH, *i.e.,* external variations of pH can induce a wavelength shift.

According to one embodiment, the FWHM of pattern is sensible to e external variations of pH. In this embodiment, "sensible" means that the FWHM can be modified by external variations of pH, i.e., FWHM can be reduced or increased.

According to one embodiment, the PLQY of pattern is sensible to external variations of pH. In this embodiment, "sensible" means that the PLQY can be modified by external variations of pH, *i.e.,* PLQY can be reduced or increased.

According to one embodiment, the pattern is a thermal insulator.

According to one embodiment, the pattern is a thermal conductor.

According to one embodiment, the pattern is an electrical conductor.

According to one embodiment, the pattern is an electrical insulator.

According to one embodiment, the pattern absorbs the incident light with wavelength lower than 50 µm, 40 µm, 30 µm, 20 µm, 10 µm, 1 µm, 950 nm, 900 nm, 850 nm, 800 nm, 750 nm, 700 nm, 650 nm, 600 nm, 550 nm, 500 nm, 450 nm, 400 nm, 350 nm, 300 nm, 250 nm, or lower than 200 nm.

According to one embodiment, the pattern exhibits an emission spectrum with at least one emission peak, wherein said emission peak has a maximum emission wavelength ranging from 400 nm to 50 µm.

According to one embodiment, the pattern exhibits an emission spectrum with at least one emission peak, wherein said emission peak has a maximum emission wavelength ranging from 400 nm to 500 nm. In this embodiment, the pattern emits blue light.

According to one embodiment, the pattern exhibits an emission spectrum with at least one emission peak, wherein said emission peak has a maximum emission wavelength ranging from 500 nm to 560 nm, more preferably ranging from 515 nm to 545 nm. In this embodiment, the pattern emits green light.

According to one embodiment, the pattern exhibits an emission spectrum with at least one emission peak, wherein said emission peak has a maximum emission wavelength ranging from 560 nm to 590 nm. In this embodiment, the pattern emits yellow light.

According to one embodiment, the pattern exhibits an emission spectrum with at least one emission peak, wherein said emission peak has a maximum emission wavelength ranging from 590 nm to 750 nm, more preferably ranging from 610 nm to 650 nm. In this embodiment, the pattern emits red light.

According to one embodiment, the pattern exhibits an emission spectrum with at least one emission peak, wherein said emission peak has a maximum emission wavelength ranging from 750 nm to 50 µm. In this embodiment, the pattern emits near infra-red, mid-infra-red, or infra-red light.

According to one embodiment, the pattern exhibits emission spectra with at least one emission peak having a full width half maximum lower than 90 nm, 80 nm, 70 nm, 60 nm, 50 nm, 40 nm, 30 nm, 25 nm, 20 nm, 15 nm, or 10 nm.

According to one embodiment, the pattern exhibits emission spectra with at least one emission peak having a full width at quarter maximum lower than 90 nm, 80 nm, 70 nm, 60 nm, 50 nm, 40 nm, 30 nm, 25 nm, 20 nm, 15 nm, or 10 nm.

According to one embodiment, the pattern has a photoluminescence quantum yield (PLQY) of at least 5%, 10%, 15%, 20%, 25%, 30%, 35%, 40%, 45%, 50%, 55%, 60%, 65%, 70%, 75%, 80%, 85%, 90%, 95%, 99% or 100%.

In one embodiment, the pattern exhibits photoluminescence quantum yield (PLQY) decrease of less than 80%, 70%, 60%, 50%, 40%, 30%, 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination.

According to one embodiment, the light illumination is provided by blue, green, red, or UV light source such as laser, diode, fluorescent lamp or Xenon Arc Lamp. According to one embodiment, the photon flux or average peak pulse power of the illumination is comprised between 1 mW.cm⁻² and 100 kW.cm⁻² and more preferably between 10 mW.cm⁻² and 100 W.cm⁻², and even more preferably between 10 mW.cm⁻² and 30 W.cm⁻².

According to one embodiment, the photon flux or average peak pulse power of the illumination is at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one embodiment, the pattern exhibits photoluminescence quantum yield (PQLY) decrease of less than 80%, 70%, 60%, 50%, 40%, 30%, 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one embodiment, the pattern exhibits FCE decrease of less than 80%, 70%, 60%, 50%, 40%, 30%, 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one embodiment, the pattern is a film.

In one embodiment, the pattern is a light emitting material as described hereabove.

In one embodiment, the pattern is a geometrical pattern.

In one embodiment, the pattern is made of a stack of two films, each of them comprises a different population of inks emitting different colors or wavelengths.

In one embodiment, the pattern is made of a stack of a plurality of films, each of them comprises a different population of inks emitting different colors or wavelengths.

According to one embodiment, the pattern has a thickness between 30 nm and 10 cm, more preferably between 100 nm and 1 cm, even more preferably between 100 nm and 1 mm.

According to one embodiment, the pattern has a thickness of at least 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.1 µm, 4.2 µm, 4.3 µm, 4.4 µm, 4.5 µm, 4.6 µm, 4.7 µm, 4.8 µm, 4.9 µm, 5 µm, 5.1 µm,5.2 µm,5.3 µm,5.4 µm, 5.5 µm, 5.5 µm, 5.6 µm, 5.7 µm, 5.8 µm, 5.9 µm, 6 µm, 6.5 µm, 7 µm, 7.5 µm, 8 nm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm,80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, 1 mm, 1.1 mm, 1.2 mm, 1.3 mm, 1.4 mm, 1.5 mm, 1.6 mm, 1.7 mm, 1.8 mm, 1.9 mm, 2 mm, 2.1 mm, 2.2 mm, 2.3 mm, 2.4 mm, 2.5 mm, 2.6 mm, 2.7 mm, 2.8 mm, 2.9 mm, 3 mm, 3.1 mm, 3.2 mm, 3.3 mm, 3.4 mm, 3.5 mm, 3.6 mm, 3.7 mm, 3.8 mm, 3.9 mm, 4 mm, 4.1 mm, 4.2 mm, 4.3 mm, 4.4 mm, 4.5 mm, 4.6 mm, 4.7 mm, 4.8 mm, 4.9 mm, 5 mm, 5.1 mm, 5.2 mm, 5.3 mm, 5.4 mm, 5.5 mm, 5.6 mm, 5.7 mm, 5.8 mm, 5.9 mm, 6 mm, 6.1 mm, 6.2 mm, 6.3 mm, 6.4 mm, 6.5 mm, 6.6 mm, 6.7 mm, 6.8 mm, 6.9 mm, 7 mm, 7.1 mm, 7.2 mm, 7.3 mm, 7.4 mm, 7.5 mm, 7.6 mm, 7.7 mm, 7.8 mm, 7.9 mm, 8 mm, 8.1 mm, 8.2 mm, 8.3 mm, 8.4 mm, 8.5 mm, 8.6 mm, 8.7 mm, 8.8 mm, 8.9 mm, 9 mm, 9.1 mm, 9.2 mm, 9.3 mm, 9.4 mm, 9.5 mm, 9.6 mm, 9.7 mm, 9.8 mm, 9.9 mm, 1 cm, 1.1 cm, 1.2 cm, 1.3 cm, 1.4 cm, 1.5 cm, 1.6 cm, 1.7 cm, 1.8 cm, 1.9 cm, 2 cm, 2.1 cm, 2.2 cm, 2.3 cm, 2.4 cm, 2.5 cm, 2.6 cm, 2.7 cm, 2.8 cm, 2.9 cm, 3 cm, 3.1 cm, 3.2 cm, 3.3 cm, 3.4 cm, 3.5 cm, 3.6 cm, 3.7 cm, 3.8 cm, 3.9 cm, 4 cm, 4.1 cm, 4.2 cm, 4.3 cm, 4.4 cm, 4.5 cm, 4.6 cm, 4.7 cm, 4.8 cm, 4.9 cm, 5 cm, 5.1 cm, 5.2 cm, 5.3 cm, 5.4 cm, 5.5 cm, 5.6 cm, 5.7 cm, 5.8 cm, 5.9 cm, 6 cm, 6.1 cm, 6.2 cm, 6.3 cm, 6.4 cm, 6.5 cm, 6.6 cm, 6.7 cm, 6.8 cm, 6.9 cm, 7 cm, 7.1 cm, 7.2 cm, 7.3 cm, 7.4 cm, 7.5 cm, 7.6 cm, 7.7 cm, 7.8 cm, 7.9 cm, 8 cm, 8.1 cm, 8.2 cm, 8.3 cm, 8.4 cm, 8.5 cm, 8.6 cm, 8.7 cm, 8.8 cm, 8.9 cm, 9 cm, 9.1 cm, 9.2 cm, 9.3 cm, 9.4 cm, 9.5 cm, 9.6 cm, 9.7 cm, 9.8 cm, 9.9 cm, or 10 cm.

According to one embodiment, the pattern absorbs at least 5%, 10%, 15%, 20%, 25%, 30%, 35%, 40%, 45%, 50%, 55%, 60%, 65%, 70%, 75%, 80%, 85%, 90%, 95%, or 100% of the incident light.

According to one embodiment, the pattern absorbs the incident light with wavelength lower than 50 µm, 40 µm, 30 µm, 20 µm, 10 µm, 1 µm, 950 nm, 900 nm, 850 nm, 800 nm, 750 nm, 700 nm, 650 nm, 600 nm, 550 nm, 500 nm, 450 nm, 400 nm, 350 nm, 300 nm, 250 nm, or lower than 200 nm.

According to one embodiment, the pattern transmits at least 5%, 10%, 15%, 20%, 25%, 30%, 35%, 40%, 45%, 50%, 55%, 60%, 65%, 70%, 75%, 80%, 85%, 90%, 95%, or 100% of the incident light.

According to one embodiment, the pattern scatters at least 5%, 10%, 15%, 20%, 25%, 30%, 35%, 40%, 45%, 50%, 55%, 60%, 65%, 70%, 75%, 80%, 85%, 90%, 95%, or 100% of the incident light.

According to one embodiment, the pattern backscatters at least 5%, 10%, 15%, 20%, 25%, 30%, 35%, 40%, 45%, 50%, 55%, 60%, 65%, 70%, 75%, 80%, 85%, 90%, 95%, or 100% of the incident light.

According to one embodiment, the pattern transmits a part of the incident light and emits at least one secondary light. In this embodiment, the resulting light is a combination of the remaining transmitted incident light.

According to one embodiment, the pattern has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 300 nm, 350 nm, 400 nm, 450 nm, 455 nm, 460 nm, 470 nm, 480 nm, 490 nm, 500 nm, 510 nm, 520 nm, 530 nm, 540 nm, 550 nm, 560 nm, 570 nm, 580 nm, 590 nm, or 600 nm.

According to one embodiment, the pattern has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 300 nm.

According to one embodiment, the pattern has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 350 nm.

According to one embodiment, the pattern has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 400 nm.

According to one embodiment, the pattern has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 450 nm.

According to one embodiment, the pattern has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 455 nm.

According to one embodiment, the pattern has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 460 nm.

According to one embodiment, the pattern has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 470 nm.

According to one embodiment, the pattern has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 480 nm.

According to one embodiment, the pattern has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 490 nm.

According to one embodiment, the pattern has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 500 nm.

According to one embodiment, the pattern has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 510 nm.

According to one embodiment, the pattern has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 520 nm.

According to one embodiment, the pattern has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 530 nm.

According to one embodiment, the pattern has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 540 nm.

According to one embodiment, the pattern has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 550 nm.

According to one embodiment, the pattern has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 560 nm.

According to one embodiment, the pattern has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 570 nm.

According to one embodiment, the pattern has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 580 nm.

According to one embodiment, the pattern has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 590 nm.

According to one embodiment, the pattern has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 600 nm.

According to one embodiment, the pattern exhibits a degradation of its photoluminescence of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years.

According to one embodiment, the pattern exhibits a degradation of its photoluminescence of less than 90%, 80%, 70%, 60%, 50%, 40%, 30%, 25%, 20%, 15%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the pattern exhibits a degradation of its photoluminescence of less than 90%, 80%, 70%, 60%, 50%, 40%, 30%, 25%, 20%, 15%, 10%, 5%, 4%, 3%, 2%, 1%, or 0% under 0%, 10%, 20%, 30%, 40%, 50%, 55%, 60%, 65%, 70%, 75%, 80%, 85%, 90%, 95%, or 99% of humidity.

According to one embodiment, the pattern exhibits a degradation of its photoluminescence of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0%, 10%, 20%, 30%, 40%, 50%, 55%, 60%, 65%, 70%, 75%, 80%, 85%, 90%, 95%, or 99% of humidity.

According to one embodiment, the pattern exhibits a degradation of its photoluminescence of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the pattern exhibits a degradation of its photoluminescence of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the pattern exhibits a degradation of its photoluminescence of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂.

According to one embodiment, the pattern exhibits a degradation of its photoluminescence of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the pattern exhibits a degradation of its photoluminescence of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0%, 10%, 20%, 30%, 40%, 50%, 55%, 60%, 65%, 70%, 75%, 80%, 85%, 90%, 95%, or 99% of humidity.

According to one embodiment, the pattern exhibits a degradation of its photoluminescence of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the pattern exhibits a degradation of its photoluminescence quantum yield (PLQY) of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years.

According to one embodiment, the pattern exhibits a degradation of its photoluminescence quantum yield (PLQY) of less than 90%, 80%, 70%, 60%, 50%, 40%, 30%, 25%, 20%, 15%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the pattern exhibits a degradation of its photoluminescence quantum yield (PLQY) of less than 90%, 80%, 70%, 60%, 50%, 40%, 30%, 25%, 20%, 15%, 10%, 5%, 4%, 3%, 2%, 1%, or 0% under 0%, 10%, 20%, 30%, 40%, 50%, 55%, 60%, 65%, 70%, 75%, 80%, 85%, 90%, 95%, or 99% of humidity.

According to one embodiment, the pattern exhibits a degradation of its photoluminescence quantum yield (PLQY) of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0%, 10%, 20%, 30%, 40%, 50%, 55%, 60%, 65%, 70%, 75%, 80%, 85%, 90%, 95%, or 99% of humidity.

According to one embodiment, the pattern exhibits a degradation of its photoluminescence quantum yield (PLQY) of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the pattern exhibits a degradation of its photoluminescence quantum yield (PLQY) of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the pattern exhibits a degradation of its photoluminescence quantum yield (PLQY) of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂.

According to one embodiment, the pattern exhibits a degradation of its photoluminescence quantum yield (PLQY) of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the pattern exhibits a degradation of its photoluminescence quantum yield (PLQY) of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0%, 10%, 20%, 30%, 40%, 50%, 55%, 60%, 65%, 70%, 75%, 80%, 85%, 90%, 95%, or 99% of humidity.

According to one embodiment, the pattern exhibits a degradation of its photoluminescence quantum yield (PLQY) of less than 90%, 80%, 70%, 60%, 50%, 40%, 30%, 25%, 20%, 15%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the pattern exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years.

According to one embodiment, the pattern exhibits a degradation of its FCE of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the pattern exhibits a degradation of its FCE of less than 90%, 80%, 70%, 60%, 50%, 40%, 30%, 25%, 20%, 10%, 5%, 4%, 3%, 2%, 1%, or 0% under 0%, 10%, 20%, 30%, 40%, 50%, 55%, 60%, 65%, 70%, 75%, 80%, 85%, 90%, 95%, or 99% of humidity.

According to one embodiment, the pattern exhibits a degradation of its FCE of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the pattern exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0%, 10%, 20%, 30%, 40%, 50%, 55%, 60%, 65%, 70%, 75%, 80%, 85%, 90%, 95%, or 99% of humidity.

According to one embodiment, the pattern exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the pattern exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the pattern exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂.

According to one embodiment, the pattern exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the pattern exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0%, 10%, 20%, 30%, 40%, 50%, 55%, 60%, 65%, 70%, 75%, 80%, 85%, 90%, 95%, or 99% of humidity.

According to one embodiment, the pattern exhibits a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the pattern is ROHS compliant.

According to one embodiment, the pattern comprises less than 10 ppm, less than 20 ppm, less than 30 ppm, less than 40 ppm, less than 50 ppm, less than 100 ppm, less than 150 ppm, less than 200 ppm, less than 250 ppm, less than 300 ppm, less than 350 ppm, less than 400 ppm, less than 450 ppm, less than 500 ppm, less than 550 ppm, less than 600 ppm, less than 650 ppm, less than 700 ppm, less than 750 ppm, less than 800 ppm, less than 850 ppm, less than 900 ppm, less than 950 ppm, less than 1000 ppm in weight of cadmium. According to one embodiment, the pattern comprises less than 10 ppm, less than 20 ppm, less than 30 ppm, less than 40 ppm, less than 50 ppm, less than 100 ppm, less than 150 ppm, less than 200 ppm, less than 250 ppm, less than 300 ppm, less than 350 ppm, less than 400 ppm, less than 450 ppm, less than 500 ppm, less than 550 ppm, less than 600 ppm, less than 650 ppm, less than 700 ppm, less than 750 ppm, less than 800 ppm, less than 850 ppm, less than 900 ppm, less than 950 ppm, less than 1000 ppm, less than 2000 ppm, less than 3000 ppm, less than 4000 ppm, less than 5000 ppm, less than 6000 ppm, less than 7000 ppm, less than 8000 ppm, less than 9000 ppm, less than 10000 ppm in weight of lead.

According to one embodiment, the pattern comprises less than 10 ppm, less than 20 ppm, less than 30 ppm, less than 40 ppm, less than 50 ppm, less than 100 ppm, less than 150 ppm, less than 200 ppm, less than 250 ppm, less than 300 ppm, less than 350 ppm, less than 400 ppm, less than 450 ppm, less than 500 ppm, less than 550 ppm, less than 600 ppm, less than 650 ppm, less than 700 ppm, less than 750 ppm, less than 800 ppm, less than 850 ppm, less than 900 ppm, less than 950 ppm, less than 1000 ppm, less than 2000 ppm, less than 3000 ppm, less than 4000 ppm, less than 5000 ppm, less than 6000 ppm, less than 7000 ppm, less than 8000 ppm, less than 9000 ppm, less than 10000 ppm in weight of mercury.

Another object of the invention relates to a particle **1** deposited on a support by inkjet printing; wherein the particle **1** comprises a first material **11,** and at least one particle **2** comprising a second material **21** and at least one nanoparticle **3** dispersed in said second material 21; and wherein the first material **11** and the second material **21** have an attenuation coefficient less or equal to 1×10⁻² cm⁻¹ at 460 nm.

Another object of the invention relates to a particle **2** deposited on a support by inkjet printing; wherein said particle **2** comprises a plurality of nanoparticles **3** encapsulated in a material **21;** and wherein said particle **2** has a surface roughness less or equal to 5% of the largest dimension of said particle **2.**

According to one embodiment, the particle **2** is as described hereabove.

According to one embodiment, the second material **21** is as described hereabove.

According to one embodiment, the nanoparticles **3** are as described hereabove.

According to one embodiment, the support is as described hereabove.

In one embodiment, the particle **2** on a support is encapsulated into a multilayered system. In one embodiment, the multilayer system comprises at least two, at least three layers.

Another object of the invention relates to a particle **1** deposited on a support by inkjet printing; wherein the particle **1** comprises a first material **11** and at least one particle **2** comprising a second material **21** and at least one nanoparticle **3** dispersed in said second material **21;** and wherein said particle **1** has a surface roughness less or equal to 5% of the largest dimension of said particle **1.**

According to one embodiment, the particle **1** is as described hereabove.

According to one embodiment, the first material **11** is as described hereabove.

According to one embodiment, the particle **2** is as described hereabove.

According to one embodiment, the second material **21** is as described hereabove.

According to one embodiment, the nanoparticle **3** is as described hereabove.

According to one embodiment, the support is as described hereabove.

Another object of the invention relates to an optoelectronic device comprising at least one ink comprising at least one particle **1** comprising a first material **11** and at least one liquid vehicle; wherein the particle **1** comprises at least one particle **2** comprising a second material **21** and at least one nanoparticle **3** dispersed in said second material **21;** and wherein the first material **11** and the second material **21** have an attenuation coefficient less or equal to 1×10⁻² cm⁻¹ at 460 nm.

According to one embodiment, the particle **1** is as described hereabove.

According to one embodiment, the particle **2** is as described hereabove.

According to one embodiment, the nanoparticles **3** are as described hereabove.

According to one embodiment, the first material **11** and/or the second material **21** are as described hereabove.

According to one embodiment, the liquid vehicle is as described hereabove.

According to one embodiment, the ink is as described hereabove.

According to one embodiment, the optoelectronic device further comprises a pattern as described hereabove.

According to one embodiment, the optoelectronic device comprises: an optoelectronic device substrate; and a crosslinked polymer film on the optoelectronic device substrate, the crosslinked polymer film comprising the ink as described hereabove.

According to one embodiment, the optoelectronic device comprises at least one cut-on filter layer. In this embodiment, said layer is a global cut-on filter, a local cut-on filter, or a mixture thereof. This embodiment is particularly advantageous as said cut-on filter layer prevents the excitation of the particles of the invention comprised in the ink by ambient light. A local cut-on filter blocks only a particular part of the optical spectrum. A local cut-on filter which blocks only this particular part of the optical spectrum can, in conjunction with a global cut-on filter, eliminate (or significantly reduce) the excitation of the particles of the invention by ambient light

According to one embodiment, the cut-on filter is a resin that can filter blue light.

According to one embodiment, the optoelectronic device is a display device, a LCD display device, a diode, a light emitting diode (LED), a laser, a photodetector, a transistor, a supercapacitor, a barcode, a LED, a microLED, an array of LED, an array of microLED, or an IR camera.

LED used herein includes LED, LED chip 5 and microsized LED 6.

According to one embodiment, the optoelectronic device comprises at least one LED and at least one ink.

According to one embodiment, a pixel comprises at least one LED.

According to one embodiment, a pixel comprises at least 1, 2, 3, 4, 5, 10, 20, 30, 40, 50, 60, 70, 80, 90, 100, 500, 1000, 5000, 10000, 50000, 100000, 150000, 200000, 250000, 300000, 350000, 400000, 450000, 500000, 550000, 600000, 650000, 750000, 800000, 850000, 900000, 950000, 10⁶, 10⁷, 10⁸, 10⁹, 10¹⁰, 10¹¹, or 10¹² LEDs.

According to one embodiment, the ink is deposited on top of a LED chip 5 or a microsized LED 6.

According to one embodiment, the ink is deposited on top of at least one LED of a LED array or a microsized LED 6 array.

According to one embodiment, the ink is deposited and patterned on top of at least one LED of a LED array or a microsized LED 6 array.

According to one embodiment, the ink is deposited and patterned on top of a LED, at least one LED of a LED array, a microsized LED 6 or at least one LED of a microsized LED **6** array using an inkjet printing technique, a lift-off technique, lithography, or a direct etching of the ink.

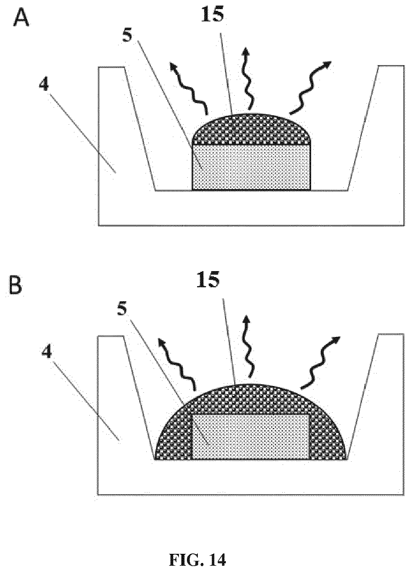

In one embodiment, as illustrated in Fig. 14A, the ink **15** covers the LED chip **5.**

In one embodiment, as illustrated in Fig. 14B, the ink **15** covers and surrounds partially or totally the LED chip **5.**

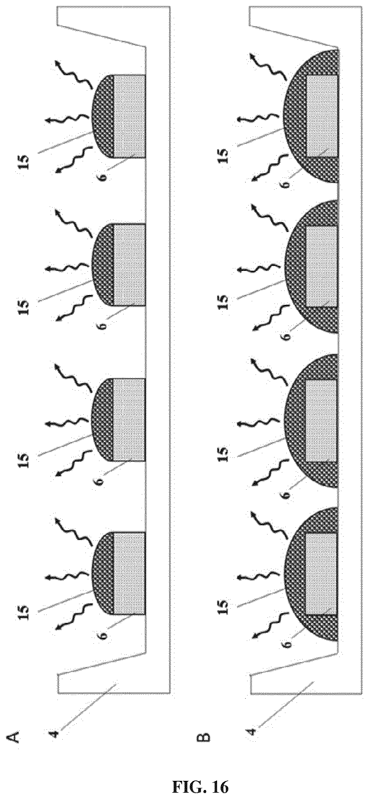

In one embodiment, as illustrated in Fig. 16A, the ink **15** covers a pixel of a microsized LED **6** array without overlapping between the pixels of said microsized LED **6** array.

In one embodiment, the ink covers partially a pixel of a microsized LED 6 array without overlapping between the pixels of said microsized LED 6 array.

In one embodiment, as illustrated in Fig. 16B, the ink **15** covers and surrounds partially or totally a pixel of a microsized LED 6 array without overlapping between the pixels of said microsized LED 6 array.

In one embodiment, the ink covers a microsized LED **6** array without overlapping between the pixels of said microsized LED **6** array.

In one embodiment, the ink covers partially a microsized LED **6** array without overlapping between the pixels of said microsized LED **6** array.

In one embodiment, the ink covers and surrounds partially or totally a microsized LED **6** array without overlapping between the pixels of said microsized LED **6** array.

In one embodiment, one ink comprising one population of particles **1** and/or particles **2** is deposited on a microsized LED 6 array. In one embodiment, a population of particles is defined by the maximum emission wavelength.

In one embodiment, at least one ink comprising at least one population of particles **1** and/or particles **2** is deposited on a pixel or a sub-pixel of a microsized LED **6** array.

In one embodiment, the at least one ink as described here is deposited on a pixel, a sub-pixel, a microsized LED, a LED, or an array of LEDs by drop-casting, spin coating, dip coating, inkjet printing, lithography, spray, plating, electroplating, or any other means known by the person skilled in the art.

In one embodiment, at least one ink comprising two populations of particles **1** and/or particles **2** emitting different colors or wavelengths are deposited on a microsized LED **6** array.

In one embodiment, two inks each comprising one population of particles **1** and/or particles **2** emitting different colors or wavelengths are deposited on a microsized LED **6** array.

In one embodiment, at least one ink comprising two populations of particles **1** and/or particles **2** which emit green light and red light upon downconversion of a blue light source are deposited on a microsized LED **6** array.

In one embodiment, two inks each comprising one population of particles **1** and/or particles **2** which emit green light and red light upon downconversion of a blue light source are deposited on a microsized LED **6** array.

In one embodiment, the two populations of particles **1** and/or particles **2** comprise a first population with a maximum emission wavelength between 500 nm and 560 nm, more preferably between 515 nm and 545 nm and a second population with a maximum emission wavelength between 600 nm and 2500 nm, more preferably between 610 nm and 650 nm.

In one embodiment, the LED chip **5** or the microsized LED **6** is a blue LED with a wavelength ranging from 400 nm to 470 nm such as for instance a gallium nitride based diode.

In one embodiment, the LED chip **5** or the microsized LED **6** is a blue LED with a wavelength ranging from 400 nm to 470 nm. In one embodiment, the LED chip **5** or the microsized LED 6 has an emission peak at about 405 nm. In one embodiment, the LED chip **5** or the microsized LED **6** has an emission peak at about 447 nm. In one embodiment, the LED chip **5** or the microsized LED **6** has an emission peak at about 455 nm.

In one embodiment, the LED chip **5** or the microsized LED **6** is a UV LED with a wavelength ranging from 200 nm to 400 nm. In one embodiment, the LED chip **5** or the microsized LED **6** has an emission peak at about 253 nm. In one embodiment, the LED chip **5** or the microsized LED **6** has an emission peak at about 365 nm. In one embodiment, the LED chip **5** or the microsized LED **6** has an emission peak at about 395 nm.

In one embodiment, the LED chip **5** or the microsized LED **6** is a green LED with a wavelength ranging from 500 nm to 560 nm. In one embodiment, the LED chip **5** or the microsized LED 6 has an emission peak at about 515 nm. In one embodiment, the LED chip **5** or the microsized LED 6 has an emission peak at about 525 nm. In one embodiment, the LED chip **5** or the microsized LED **6** has an emission peak at about 540 nm.

In one embodiment, the LED chip **5** or the microsized LED **6** is a red LED with a wavelength ranging from 750 to 850 nm. In one embodiment, the LED chip **5** or the microsized LED **6** has an emission peak at about 755 nm. In one embodiment, the LED chip **5** or the microsized LED **6** has an emission peak at about 800 nm. In one embodiment, the LED chip **5** or the microsized LED 6 has an emission peak at about 850 nm.

In one embodiment, the LED chip **5** or the microsized LED 6 has a photon flux or average peak pulse power between 1 µW.cm⁻² and 1 kW.cm⁻² and more preferably between 1 mW.cm⁻² and 100 W.cm⁻², and even more preferably between 1 mW.cm⁻² and 30 W.cm⁻².

In one embodiment, the LED chip **5** or the microsized LED **6** has a photon flux or average peak pulse power of at least 1 µW.cm⁻², 10 µW.cm⁻². 100 µW.cm⁻², 500 µW.cm⁻². 1 mW.cm⁻², 10 mW.cm⁻², 100 mW.cm⁻², 500 mW.cm⁻², 1 W.cm⁻², 10 W.cm⁻², 100 W.cm⁻², 500 W.cm⁻², or 1 kW.cm⁻².

In one embodiment, the LED chip **5** is a GaN, GaSb, GaAs, GaAsP, GaP, InP, SiGe, InGaN, GaAlN, GaAlPN, AlN, AlGaAs, AlGaP, AlGaInP, AlGaN, AlGaInN, ZnSe, Si, SiC, diamond, boron nitride diode.

In one embodiment, the microsized LED **6** is a GaN, GaSb, GaAs, GaAsP, GaP, InP, SiGe, InGaN, GaAIN, GaAIPN, AlN, AlGaAs, AlGaP, AlGaInP, AlGaN, AlGaInN, ZnSe, Si, SiC, diamond, boron nitride diode.

In one embodiment, a LED array comprises an array of GaN diodes, GaSb diodes, GaAs diodes, GaAsP diodes, GaP diodes, InP diodes, SiGe diodes, InGaN diodes, GaAlN diodes, GaAlPN diodes, AlN diodes, AlGaAs diodes, AlGaP diodes, AlGaInP diodes, AlGaN diodes, AlGaInN diodes, ZnSe diodes, Si diodes, SiC diodes, diamond diodes, boron nitride diodes or a mixture thereof.

According to one embodiment, a pixel comprises at least one microsized LED **6.**

According to one embodiment, at least one pixel comprises a unique microsized LED **6.**

According to one embodiment, at least one pixel comprises one microsized LED **6.** In this embodiment, the microsized LED **6** and the one pixel are combined.

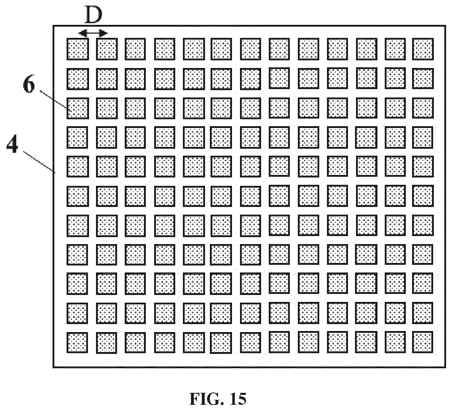

According to one embodiment, as illustrated in Fig. 15, the pixel pitch **D** is at least 1 µm, 2 µm, 3 µm, 4 µm, 5 µm, 6 µm, 7 µm, 8 µm, 9 µm, 10 µm, 11 µm, 12 µm, 13 µm, 14 µm, 15 µm, 16 µm, 17 µm, 18 µm, 19 µm, 20 µm, 21 µm, 22 µm, 23 µm, 24 µm, 25 µm, 26 µm, 27 µm, 28 µm, 29 µm, 30 µm, 31 µm, 32 µm, 33 µm, 34 µm, 35 µm, 36 µm, 37 µm, 38 µm, 39 µm, 40 µm, 41 µm, 42 µm, 43 µm, 44 µm, 45 µm, 46 µm, 47 µm, 48 µm, 49 µm, 50 µm, 51 µm, 52 µm, 53 µm, 54 µm, 55 µm, 56 µm, 57 µm, 58 µm, 59 µm, 60 µm, 61 µm, 62 µm, 63 µm, 64 µm, 65 µm, 66 µm, 67 µm, 68 µm, 69 µm, 70 µm, 71 µm, 72 µm, 73 µm, 74 µm, 75 µm, 76 µm, 77 µm, 78 µm, 79 µm, 80 µm, 81 µm, 82 µm, 83 µm, 84 µm, 85 µm, 86 µm, 87 µm, 88 µm, 89 µm, 90 µm, 91 µm, 92 µm, 93 µm, 94 µm, 95 µm, 96 µm, 97 µm, 98 µm, 99 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, 1 mm, 1.1 mm, 1.2 mm, 1.3 mm, 1.4 mm, 1.5 mm, 1.6 mm, 1.7 mm, 1.8 mm, 1.9 mm, 2 mm, 2.1 mm, 2.2 mm, 2.3 mm, 2.4 mm, 2.5 mm, 2.6 mm, 2.7 mm, 2.8 mm, 2.9 mm, 3 mm, 3.1 mm, 3.2 mm, 3.3 mm, 3.4 mm, 3.5 mm, 3.6 mm, 3.7 mm, 3.8 mm, 3.9 mm, 4 mm, 4.1 mm, 4.2 mm, 4.3 mm, 4.4 mm, 4.5 mm, 4.6 mm, 4.7 mm, 4.8 mm, 4.9 mm, 5 mm, 5.1 mm, 5.2 mm, 5.3 mm, 5.4 mm, 5.5 mm, 5.6 mm, 5.7 mm, 5.8 mm, 5.9 mm, 6 mm, 6.1 mm, 6.2 mm, 6.3 mm, 6.4 mm, 6.5 mm, 6.6 mm, 6.7 mm, 6.8 mm, 6.9 mm, 7 mm, 7.1 mm, 7.2 mm, 7.3 mm, 7.4 mm, 7.5 mm, 7.6 mm, 7.7 mm, 7.8 mm, 7.9 mm, 8 mm, 8.1 mm, 8.2 mm, 8.3 mm, 8.4 mm, 8.5 mm, 8.6 mm, 8.7 mm, 8.8 mm, 8.9 mm, 9 mm, 9.1 mm, 9.2 mm, 9.3 mm, 9.4 mm, 9.5 mm, 9.6 mm, 9.7 mm, 9.8 mm, 9.9 mm, 1 cm, 1.1 cm, 1.2 cm, 1.3 cm, 1.4 cm, 1.5 cm, 1.6 cm, 1.7 cm, 1.8 cm, 1.9 cm, 2 cm, 2.1 cm, 2.2 cm, 2.3 cm, 2.4 cm, 2.5 cm, 2.6 cm, 2.7 cm, 2.8 cm, 2.9 cm, 3 cm, 3.1 cm, 3.2 cm, 3.3 cm, 3.4 cm, 3.5 cm, 3.6 cm, 3.7 cm, 3.8 cm, 3.9 cm, 4 cm, 4.1 cm, 4.2 cm, 4.3 cm, 4.4 cm, 4.5 cm, 4.6 cm, 4.7 cm, 4.8 cm, 4.9 cm, 5 cm, 5.1 cm, 5.2 cm, 5.3 cm, 5.4 cm, 5.5 cm, 5.6 cm, 5.7 cm, 5.8 cm, 5.9 cm, 6 cm, 6.1 cm, 6.2 cm, 6.3 cm, 6.4 cm, 6.5 cm, 6.6 cm, 6.7 cm, 6.8 cm, 6.9 cm, 7 cm, 7.1 cm, 7.2 cm, 7.3 cm, 7.4 cm, 7.5 cm, 7.6 cm, 7.7 cm, 7.8 cm, 7.9 cm, 8 cm, 8.1 cm, 8.2 cm, 8.3 cm, 8.4 cm, 8.5 cm, 8.6 cm, 8.7 cm, 8.8 cm, 8.9 cm, 9 cm, 9.1 cm, 9.2 cm, 9.3 cm, 9.4 cm, 9.5 cm, 9.6 cm, 9.7 cm, 9.8 cm, 9.9 cm, or 10 cm.

According to one embodiment, the pixel pitch **D** is smaller than 10 µm.

According to one embodiment, the pixel size is at least 1 µm, 2 µm, 3 µm, 4 µm, 5 µm, 6 µm, 7 µm, 8 µm, 9 µm, 10 µm, 11 µm, 12 µm, 13 µm, 14 µm, 15 µm, 16 µm, 17 µm, 18 µm, 19 µm, 20 µm, 21 µm, 22 µm, 23 µm, 24 µm, 25 µm, 26 µm, 27 µm, 28 µm, 29 µm, 30 µm, 31 µm, 32 µm, 33 µm, 34 µm, 35 µm, 36 µm, 37 µm, 38 µm, 39 µm, 40 µm, 41 µm, 42 µm, 43 µm, 44 µm, 45 µm, 46 µm, 47 µm, 48 µm, 49 µm, 50 µm, 51 µm, 52 µm, 53 µm, 54 µm, 55 µm, 56 µm, 57 µm, 58 µm, 59 µm, 60 µm, 61 µm, 62 µm, 63 µm, 64 µm, 65 µm, 66 µm, 67 µm, 68 µm, 69 µm, 70 µm, 71 µm, 72 µm, 73 ¡till, 74 µm, 75 µm, 76 µm, 77 µm, 78 µm, 79 µm, 80 µm, 81 µm, 82 µm, 83 µm, 84 µm, 85 µm, 86 µm, 87 µm, 88 µm, 89 µm, 90 µm, 91 µm, 92 µm, 93 µm, 94 µm, 95 µm, 96 µm, 97 µm, 98 µm, 99 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, 1 mm, 1.1 mm, 1.2 mm, 1.3 mm, 1.4 mm, 1.5 mm, 1.6 mm, 1.7 mm, 1.8 mm, 1.9 mm, 2 mm, 2.1 mm, 2.2 mm, 2.3 mm, 2.4 mm, 2.5 mm, 2.6 mm, 2.7 mm, 2.8 mm, 2.9 mm, 3 mm, 3.1 mm, 3.2 mm, 3.3 mm, 3.4 mm, 3.5 mm, 3.6 mm, 3.7 mm, 3.8 mm, 3.9 mm, 4 mm, 4.1 mm, 4.2 mm, 4.3 mm, 4.4 mm, 4.5 mm, 4.6 mm, 4.7 mm, 4.8 mm, 4.9 mm, 5 mm, 5.1 mm, 5.2 mm, 5.3 mm, 5.4 mm, 5.5 mm, 5.6 mm, 5.7 mm, 5.8 mm, 5.9 mm, 6 mm, 6.1 mm, 6.2 mm, 6.3 mm, 6.4 mm, 6.5 mm, 6.6 mm, 6.7 mm, 6.8 mm, 6.9 mm, 7 mm, 7.1 mm, 7.2 mm, 7.3 mm, 7.4 mm, 7.5 mm, 7.6 mm, 7.7 mm, 7.8 mm, 7.9 mm, 8 mm, 8.1 mm, 8.2 mm, 8.3 mm, 8.4 mm, 8.5 mm, 8.6 mm, 8.7 mm, 8.8 mm, 8.9 mm, 9 mm, 9.1 mm, 9.2 mm, 9.3 mm, 9.4 mm, 9.5 mm, 9.6 mm, 9.7 mm, 9.8 mm, 9.9 mm, 1 cm, 1.1 cm, 1.2 cm, 1.3 cm, 1.4 cm, 1.5 cm, 1.6 cm, 1.7 cm, 1.8 cm, 1.9 cm, 2 cm, 2.1 cm, 2.2 cm, 2.3 cm, 2.4 cm, 2.5 cm, 2.6 cm, 2.7 cm, 2.8 cm, 2.9 cm, 3 cm, 3.1 cm, 3.2 cm, 3.3 cm, 3.4 cm, 3.5 cm, 3.6 cm, 3.7 cm, 3.8 cm, 3.9 cm, 4 cm, 4.1 cm, 4.2 cm, 4.3 cm, 4.4 cm, 4.5 cm, 4.6 cm, 4.7 cm, 4.8 cm, 4.9 cm, 5 cm, 5.1 cm, 5.2 cm, 5.3 cm, 5.4 cm, 5.5 cm, 5.6 cm, 5.7 cm, 5.8 cm, 5.9 cm, 6 cm, 6.1 cm, 6.2 cm, 6.3 cm, 6.4 cm, 6.5 cm, 6.6 cm, 6.7 cm, 6.8 cm, 6.9 cm, 7 cm, 7.1 cm, 7.2 cm, 7.3 cm, 7.4 cm, 7.5 cm, 7.6 cm, 7.7 cm, 7.8 cm, 7.9 cm, 8 cm, 8.1 cm, 8.2 cm, 8.3 cm, 8.4 cm, 8.5 cm, 8.6 cm, 8.7 cm, 8.8 cm, 8.9 cm, 9 cm, 9.1 cm, 9.2 cm, 9.3 cm, 9.4 cm, 9.5 cm, 9.6 cm, 9.7 cm, 9.8 cm, 9.9 cm, or 10 cm.

According to one embodiment, the optoelectronic device comprises LEDs, microLEDs, at least one array of LED or at least one array of microLED, on which at least one ink is deposited. According to one embodiment, red emitting ink, and green emitting ink are deposited alternatively on LEDs, microLEDs, at least one array of LED or at least one array of microLED, preferably blue LEDs, microLEDs, at least one array of LED or at least one array of microLED thus creating an alternance of red-green emitting pixels. According to one embodiment, red emitting ink, green emitting ink, no ink are deposited alternatively on LEDs, microLEDs, at least one array of LED or at least one array of microLED, preferably blue LEDs, microLEDs, at least one array of LED or at least one array of microLED, thus creating an alternance of blue-red-green emitting pixels.

According to one embodiment, the at least one ink deposited on LEDs, microLEDs, at least one array of LED or at least one array of microLED is covered with an auxiliary layer as described herein, preferably a blue absorbing resin so that only red and green secondary light can be emitted.

According to one embodiment, the optoelectronic device comprises at least one ink deposited on at least one array of LED, at least one array of microLED, or a pixel.

According to one embodiment, after deposition, the at least one ink is coated with an auxiliary layer as described here above. In this embodiment, the auxiliary layer limits or prevents the degradation of the chemical and physical properties of the at least one ink from molecular oxygen, ozone, water and/or high temperature.

According to one embodiment, after deposition, the ink is coated with a protective layer as described here above. In this embodiment, the protective layer limits or prevents the degradation of the chemical and physical properties of the at least one ink from molecular oxygen, ozone, water and/or high temperature.

In one embodiment, the ink exhibits photoluminescence quantum yield (PLQY) decrease of less than 90%, 80%, 70%, 60%, 50%, 40%, 30%, 25%, 20%, 15%, 10%, 5%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination.

According to one embodiment, the light illumination is provided by blue, green, red, or UV light source such as laser, diode, fluorescent lamp or Xenon Arc Lamp. According to one embodiment, the photon flux or average peak pulse power of the illumination is comprised between 1 mW.cm⁻² and 100 kW.cm⁻² and more preferably between 10 mW.cm⁻² and 100 W.cm⁻², and even more preferably between 10 mW.cm⁻² and 30 W.cm⁻².

According to one embodiment, the photon flux or average peak pulse power of the illumination is at least 1 mW.cm⁻², 50 mW.cm⁻², 100 mW.cm⁻², 500 mW.cm⁻², 1 W.cm⁻² , 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻² , 300 W.cm⁻² , 400 W.cm⁻² , 500 W.cm⁻², 600 W.cm⁻² , 700 W.cm⁻², 800 W.cm⁻², 900 W.cm⁻², 1 kW.cm⁻², 50 kW.cm⁻², or 100 kW.cm⁻².

In one embodiment, the ink exhibits photoluminescence quantum yield (PQLY) decrease of less than 90%, 80%, 70%, 60%, 50%, 40%, 30%, 25%, 20%, 15%, 10%, 5%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻² , 30 W.cm⁻² , 40 W.cm⁻² , 50 W.cm⁻², 60 W.cm⁻² 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻² , 200 W.cm⁻² , 300 W.cm⁻² , 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one embodiment, the optoelectronic device exhibits a decrease of the intensity of at least one emission peak of less than 90%, 80%, 70%, 60%, 50%, 40%, 30%, 25%, 20%, 15%, 10%, 5%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination.

In one embodiment, the optoelectronic device exhibits a decrease of the intensity of at least one emission peak of less than 90%, 80%, 70%, 60%, 50%, 40%, 30%, 25%, 20%, 15%, 10%, 5%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻² , 20 W.cm⁻², 30 W.cm⁻², 40 W.cm⁻², 50 W.cm⁻² , 60 W.cm⁻² , 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻² , 600 W.cm⁻², 700 W.cm⁻², 800 W.cm⁻², 900 W.cm⁻², 1 kW.cm⁻², 50 kW.cm⁻², or 100 kW.cm⁻².

In one embodiment, the optoelectronic device exhibits a decrease of the intensity of at least one emission peak of less than 90%, 80%, 70%, 60%, 50%, 40%, 30%, 25%, 20%, 15%, 10%, 5%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

In one embodiment, the optoelectronic device exhibits a decrease of the intensity of at least one emission peak of less than 90%, 80%, 70%, 60%, 50%, 40%, 30%, 25%, 20%, 15%, 10%, 5%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under a humidity of at least 0%, 10%, 20%, 30%, 40%, 50%, 55%, 60%, 65%, 70%, 75%, 80%, 85%, 90%, 95%, or 100%.

In one embodiment, the optoelectronic device exhibits a decrease of the intensity of at least one emission peak of less than 90%, 80%, 70%, 60%, 50%, 40%, 30%, 25%, 20%, 15%, 10%, 5%, or 0% under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻² , 50 W.cm⁻² , 60 W.cm⁻² , 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻² , 300 W.cm⁻² , 400 W.cm⁻² , 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one embodiment, the optoelectronic device exhibits a decrease of the intensity of at least one emission peak of less than 90%, 80%, 70%, 60%, 50%, 40%, 30%, 25%, 20%, 15%, 10%, 5%, or 0% under a humidity of at least 0%, 10%, 20%, 30%, 40%, 50%, 55%, 60%, 65%, 70%, 75%, 80%, 85%, 90%, 95%, or 100%, under light illumination with a photon flux or average peak pulse power of at least 1 mW.cm⁻², 50 mW.cm⁻², 100 mW.cm⁻², 500 mW.cm⁻², 1 W.cm⁻² , 5 W.cm⁻², 10 W.cm⁻², 20 W.cm⁻² , 30 W.cm⁻², 40 W.cm⁻², 50 W.cm⁻², 60 W.cm⁻² , 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻² , 200 W.cm⁻² , 300 W.cm⁻², 400 W.cm⁻² , 500 W.cm⁻² , 600 W.cm⁻² , 700 W.cm⁻², 800 W.cm⁻², 900 W.cm⁻², 1 kW.cm⁻², 50 kW.cm⁻², or 100 kW.cm⁻².

In one embodiment, the optoelectronic device exhibits a decrease of the intensity of at least one emission peak of less than 90%, 80%, 70%, 60%, 50%, 40%, 30%, 25%, 20%, 15%, 10%, 5%, or 0% under a humidity of at least 0%, 10%, 20%, 30%, 40%, 50%, 55%, 60%, 65%, 70%, 75%, 80%, 85%, 90%, 95%, or 100%, under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

In one embodiment, the optoelectronic device exhibits a decrease of the intensity of at least one emission peak of less than 90%, 80%, 70%, 60%, 50%, 40%, 30%, 25%, 20%, 15%, 10%, 5%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻² , 20 W.cm⁻² , 30 W.cm⁻² , 40 W.cm⁻² , 50 W.cm⁻² , 60 W.cm⁻² , 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻² , 200 W.cm⁻², 300 W.cm⁻² , 400 W.cm⁻² , 500 W.cm⁻² , 600 W.cm⁻², 700 W.cm⁻², 800 W.cm⁻², 900 W.cm⁻², 1 kW.cm⁻², 50 kW.cm⁻², or 100 kW.cm⁻², under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

In one embodiment, the optoelectronic device exhibits a decrease of the intensity of at least one emission peak of less than 90%, 80%, 70%, 60%, 50%, 40%, 30%, 25%, 20%, 15%, 10%, 5%, or 0% under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻² , 20 W.cm⁻² , 30 W.cm⁻² , 40 W.cm⁻², 50 W.cm⁻² , 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻² , 600 W.cm⁻², 700 W.cm⁻², 800 W.cm⁻², 900 W.cm⁻², 1 kW.cm⁻², 50 kW.cm⁻², or 100 kW.cm⁻², under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under a humidity of at least 0%, 10%, 20%, 30%, 40%, 50%, 55%, 60%, 65%, 70%, 75%, 80%, 85%, 90%, 95%, or 100%.

In one embodiment, the optoelectronic device exhibits a decrease of the intensity of at least one emission peak of less than 90%, 80%, 70%, 60%, 50%, 40%, 30%, 25%, 20%, 15%, 10%, 5%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under a humidity of at least 0%, 10%, 20%, 30%, 40%, 50%, 55%, 60%, 65%, 70%, 75%, 80%, 85%, 90%, 95%, or 100%.

In one embodiment, the optoelectronic device exhibits a decrease of the intensity of at least one emission peak of less than 90%, 80%, 70%, 60%, 50%, 40%, 30%, 25%, 20%, 15%, 10%, 5%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻² , 20 W.cm⁻² , 30 W.cm⁻² , 40 W.cm⁻² , 50 W.cm⁻² , 60 W.cm⁻² , 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻² , 200 W.cm⁻², 300 W.cm⁻² , 400 W.cm⁻², 500 W.cm⁻² , 600 W.cm⁻², 700 W.cm⁻², 800 W.cm⁻², 900 W.cm⁻², 1 kW.cm⁻², 50 kW.cm⁻², or 100 kW.cm⁻², and under a humidity of at least 0%, 10%, 20%, 30%, 40%, 50%, 55%, 60%, 65%, 70%, 75%, 80%, 85%, 90%, 95%, or 100%.

In one embodiment, the optoelectronic device exhibits a shift of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination.

In one embodiment, the optoelectronic device exhibits a shift of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻² , 20 W.cm⁻², 30 W.cm⁻², 40 W.cm⁻² , 50 W.cm⁻² , 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻² , 300 W.cm⁻² , 400 W.cm⁻², 500 W.cm⁻² , 600 W.cm⁻², 700 W.cm⁻², 800 W.cm⁻², 900 W.cm⁻², 1 kW.cm⁻², 50 kW.cm⁻², or 100 kW.cm⁻².

In one embodiment, the optoelectronic device exhibits a shift of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

In one embodiment, the optoelectronic device exhibits a shift of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under a humidity of at least 0%, 10%, 20%, 30%, 40%, 50%, 55%, 60%, 65%, 70%, 75%, 80%, 85%, 90%, 95%, or 100%.

In one embodiment, the optoelectronic device exhibits a shift of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, under light illumination with a photon flux or average peak pulse power of at least 1 mW.cm⁻², 50 mW.cm⁻², 100 mW.cm⁻², 500 mW.cm⁻², 1 W.cm⁻² , 5 W.cm⁻², 10 W.cm⁻², 20 W.cm⁻² , 30 W.cm⁻² , 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻² , 200 W.cm⁻² , 300 W.cm⁻² , 400 W.cm⁻² , 500 W.cm⁻², 600 W.cm⁻² , 700 W.cm⁻², 800 W.cm⁻², 900 W.cm⁻², 1 kW.cm⁻², 50 kW.cm⁻², or 100 kW.cm⁻².

In one embodiment, the optoelectronic device exhibits a shift of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm under a humidity of at least 0%, 10%, 20%, 30%, 40%, 50%, 55%, 60%, 65%, 70%, 75%, 80%, 85%, 90%, 95%, or 100%, under light illumination with a photon flux or average peak pulse power of at least 1 mW.cm⁻², 50 mW.cm⁻², 100 mW.cm⁻², 500 mW.cm⁻², 1 W.cm⁻² , 5 W.cm⁻², 10 W.cm⁻², 20 W.cm⁻², 30 W.cm⁻², 40 W.cm⁻², 50 W.cm⁻², 60 W.cm⁻² , 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻² , 200 W.cm⁻² , 300 W.cm⁻², 400 W.cm⁻² , 500 W.cm⁻² , 600 W.cm⁻² , 700 W.cm⁻², 800 W.cm⁻², 900 W.cm⁻², 1 kW.cm⁻², 50 kW.cm⁻², or 100 kW.cm⁻².

In one embodiment, the optoelectronic device exhibits a shift of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm under a humidity of at least 0%, 10%, 20%, 30%, 40%, 50%, 55%, 60%, 65%, 70%, 75%, 80%, 85%, 90%, 95%, or 100%, under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

In one embodiment, the optoelectronic device exhibits a shift of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻² , 20 W.cm⁻² , 30 W.cm⁻² , 40 W.cm⁻² , 50 W.cm⁻² , 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻² , 200 W.cm⁻² , 300 W.cm⁻² , 400 W.cm⁻², 500 W.cm⁻² , 600 W.cm⁻², 700 W.cm⁻², 800 W.cm⁻², 900 W.cm⁻², 1 kW.cm⁻², 50 kW.cm⁻², or 100 kW.cm⁻², under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

In one embodiment, the optoelectronic device exhibits a shift of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻² , 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻² , 600 W.cm⁻², 700 W.cm⁻², 800 W.cm⁻², 900 W.cm⁻², 1 kW.cm⁻², 50 kW.cm⁻², or 100 kW.cm⁻², under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under a humidity of at least 0%, 10%, 20%, 30%, 40%, 50%, 55%, 60%, 65%, 70%, 75%, 80%, 85%, 90%, 95%, or 100%.

In one embodiment, the optoelectronic device exhibits a shift of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under a humidity of at least 0%, 10%, 20%, 30%, 40%, 50%, 55%, 60%, 65%, 70%, 75%, 80%, 85%, 90%, 95%, or 100%.

In one embodiment, the optoelectronic device exhibits a shift of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻² , 20 W.cm⁻² , 30 W.cm⁻² , 40 W.cm⁻² , 50 W.cm⁻² , 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻² , 200 W.cm⁻² , 300 W.cm⁻² , 400 W.cm⁻², 500 W.cm⁻² , 600 W.cm⁻², 700 W.cm⁻², 800 W.cm⁻², 900 W.cm⁻², 1 kW.cm⁻², 50 kW.cm⁻², or 100 kW.cm⁻², and under a humidity of at least 0%, 10%, 20%, 30%, 40%, 50%, 55%, 60%, 65%, 70%, 75%, 80%, 85%, 90%, 95%, or 100%.

In one embodiment, the optoelectronic device exhibits an increase of the full width half maximum of at least one emission peak of less than 60 nm, 55 nm, 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000,21000,22000,23000,24000, 25000,26000,27000,28000,29000, 30000, 31000, 32000, 33000, 34000, 35000, 36000, 37000, 38000, 39000, 40000,41000,42000,43000,44000,45000,46000,47000, 48000,49000, or 50000 hours under light illumination.

In one embodiment, the optoelectronic device exhibits an increase of the full width half maximum of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000,23000,24000,25000,26000, 27000,28000,29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻² , 20 W.cm⁻² , 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻² , 200 W.cm⁻², 300 W.cm⁻², 400 W.cm⁻², 500 W.cm⁻² , 600 W.cm⁻², 700 W.cm⁻², 800 W.cm⁻², 900 W.cm⁻², 1 kW.cm⁻², 50 kW.cm⁻², or 100 kW.cm⁻².

In one embodiment, the optoelectronic device exhibits an increase of the full width half maximum of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

In one embodiment, the optoelectronic device exhibits an increase of the full width half maximum of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000,23000,24000,25000,26000, 27000,28000,29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under a humidity of at least 0%, 10%, 20%, 30%, 40%, 50%, 55%, 60%, 65%, 70%, 75%, 80%, 85%, 90%, 95%, or 100%.

In one embodiment, the optoelectronic device exhibits an increase of the full width half maximum of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, under light illumination with a photon flux or average peak pulse power of at least 1 mW.cm⁻², 50 mW.cm⁻², 100 mW.cm⁻², 500 mW.cm⁻², 1 W.cm⁻² , 5 W.cm⁻², 10 W.cm⁻² , 20 W.cm⁻² , 30 W.cm⁻² , 40 W.cm⁻² , 50 W.cm⁻² , 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻² , 200 W.cm⁻² , 300 W.cm⁻², 400 W.cm⁻² , 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one embodiment, the optoelectronic device exhibits an increase of the full width half maximum of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm under a humidity of at least 0%, 10%, 20%, 30%, 40%, 50%, 55%, 60%, 65%, 70%, 75%, 80%, 85%, 90%, 95%, or 100%, under light illumination with a photon flux or average peak pulse power of at least 1 mW.cm⁻², 50 mW.cm⁻², 100 mW.cm⁻², 500 mW.cm⁻², 1 W.cm⁻² , 5 W.cm⁻², 10 W.cm⁻², 20 W.cm⁻², 30 W.cm⁻², 40 W.cm⁻² , 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻² , 300 W.cm⁻² , 400 W.cm⁻² , 500 W.cm⁻², 600 W.cm⁻² , 700 W.cm⁻², 800 W.cm⁻², 900 W.cm⁻², 1 kW.cm⁻², 50 kW.cm⁻², or 100 kW.cm⁻².

In one embodiment, the optoelectronic device exhibits an increase of the full width half maximum of at least one emission peak of less than 90%, 80%, 70%, 60%, 50%, 40%, 30%, 25%, 20%, 15%, 10%, 5%, or 0% under a humidity of at least 0%, 10%, 20%, 30%, 40%, 50%, 55%, 60%, 65%, 70%, 75%, 80%, 85%, 90%, 95%, or 100%, under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

In one embodiment, the optoelectronic device exhibits an increase of the full width half maximum of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000,23000,24000,25000,26000, 27000,28000,29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻² , 5 W.cm⁻², 10 W.cm⁻² , 20 W.cm⁻² , 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻² , 200 W.cm⁻², 300 W.cm⁻², 400 W.cm⁻², 500 W.cm⁻² , 600 W.cm⁻² , 700 W.cm⁻², 800 W.cm⁻², 900 W.cm⁻², 1 kW.cm⁻², 50 kW.cm⁻², or 100 kW.cm⁻², under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

In one embodiment, the optoelectronic device exhibits an increase of the full width half maximum of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm under light illumination with a photon flux or average peak pulse power of at least 1 mW.cm⁻², 50 mW.cm⁻², 100 mW.cm⁻², 500 mW.cm⁻², 1 W.cm⁻² , 5 W.cm⁻², 10 W.cm⁻², 20 W.cm⁻², 30 W.cm⁻², 40 W.cm⁻² , 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻² , 300 W.cm⁻² , 400 W.cm⁻² , 500 W.cm⁻² , 600 W.cm⁻² , 700 W.cm⁻², 800 W.cm⁻², 900 W.cm⁻², 1 kW.cm⁻² 50 kW.cm⁻², or 100 kW.cm⁻², under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under a humidity of at least 0%, 10%, 20%, 30%, 40%, 50%, 55%, 60%, 65%, 70%, 75%, 80%, 85%, 90%, 95%, or 100%.

In one embodiment, the optoelectronic device exhibits an increase of the full width half maximum of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000,23000,24000,25000,26000, 27000,28000,29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C and under a humidity of at least 0%, 10%, 20%, 30%, 40%, 50%, 55%, 60%, 65%, 70%, 75%, 80%, 85%, 90%, 95%, or 100%.

In one embodiment, the optoelectronic device exhibits an increase of the full width half maximum of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000,23000,24000,25000,26000, 27000,28000,29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻² , 20 W.cm⁻² , 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻² , 200 W.cm⁻², 300 W.cm⁻², 400 W.cm⁻², 500 W.cm⁻² , 600 W.cm⁻², 700 W.cm⁻², 800 W.cm⁻², 900 W.cm⁻², 1 kW.cm⁻², 50 kW.cm⁻², or 100 kW.cm⁻² and under a humidity of at least 0%, 10%, 20%, 30%, 40%, 50%, 55%, 60%, 65%, 70%, 75%, 80%, 85%, 90%, 95%, or 100%.

Another object of the invention relates to an optoelectronic device comprising at least one ink comprising at least one particle **2** comprising a plurality of nanoparticles **3** encapsulated in a material **21**; and at least one liquid vehicle; wherein said particle **2** has a surface roughness less or equal to 5% of the largest dimension of said particle **2.**

According to one embodiment, the optoelectronic device is as described hereabove.

According to one embodiment, the particle **2** is as described hereabove.

According to one embodiment, the nanoparticles **3** are as described hereabove.

According to one embodiment, the material **21** is the second material **21** as described hereabove.

According to one embodiment, the liquid vehicle is as described hereabove.

According to one embodiment, the ink is as described hereabove.

According to one embodiment, the optoelectronic device further comprises a light emitting material as described hereabove.

According to one embodiment, the optoelectronic device further comprises a pattern as described hereabove.

Another object of the invention relates to an optoelectronic device comprising at least one ink comprising at least one phosphor nanoparticle; and at least one liquid vehicle; wherein the phosphor nanoparticle has a size ranging from 0.1 µm to 50 µm.

According to one embodiment, the pattern is as described hereabove.

According to one embodiment, the at least one phosphor nanoparticle is as described hereabove.

According to one embodiment, the ink is as described hereabove.

According to one embodiment, the liquid vehicle is as described hereabove.

According to one embodiment, the optoelectronic device further comprises a light emitting material as described hereabove.

According to one embodiment, the optoelectronic device further comprises a pattern as described hereabove. Another object of the invention relates to an optoelectronic device comprising at least one ink comprising at least one particle **1** comprising a first material **11** and at least one liquid vehicle; wherein the particle **1** comprises at least one particle **2** comprising a second material **21** and at least one nanoparticle **3** dispersed in said second material **21**; and wherein said particle **1** has a surface roughness less or equal to 5% of the largest dimension of said particle **1.**

According to one embodiment, the particle **1** is as described hereabove.

According to one embodiment, the particle **2** is as described hereabove.

According to one embodiment, the nanoparticles **3** are as described hereabove.

According to one embodiment, the first material **11** and/or the second material **21** are as described hereabove. According to one embodiment, the liquid vehicle is as described hereabove.

According to one embodiment, the ink is as described hereabove.

According to one embodiment, the optoelectronic device further comprises a light emitting material as described hereabove.

According to one embodiment, the optoelectronic device further comprises a pattern as described hereabove. Another object of the invention relates to a method for depositing an ink on a support.

Said ink comprising:
i. at least one particle **1** comprising a first material **11** and at least one liquid vehicle; wherein the particle **1** comprises at least one particle **2** comprising a second material **21** and at least one nanoparticle **3** dispersed in said second material **21**; and wherein the first material **11** and the second material **21** have an attenuation coefficient less or equal to 1×10⁻² cm⁻¹ at 460 nm.; or
ii. at least one particle **2** comprising a plurality of nanoparticles **3** encapsulated in a material **21**; and at least one liquid vehicle; wherein said particle **2** has a surface roughness less or equal to 5% of the largest dimension of said particle **2**; or
iii. at least one phosphor nanoparticle; and at least one liquid vehicle; wherein the phosphor nanoparticle has a size ranging from 0.1 µm to 50 µm; or
iv. at least one particle **1** comprising a first material **11** and at least one liquid vehicle; wherein the particle **1** comprises at least one particle **2** comprising a second material **21** and at least one nanoparticle **3** dispersed in said second material **21**; and wherein said particle **1** has a surface roughness less or equal to 5% of the largest dimension of said particle **1.**

According to one embodiment, the method comprises:
- printing the ink on a support using inkjet printing; and
- evaporating the solvent and/or the liquid vehicle.

According to one embodiment, the evaporating step can be performed by heating, by using an inert gas stream, simply by evaporation over a period of time under air, under controlled atmosphere or under vacuum, or by any means known by those skilled in the art.

According to one embodiment, the method comprises:
- ejecting a predetermined amount of droplets of ink from a printing nozzle of a printhead, said droplets being ejected in the direction of a support;
- removing the liquid vehicle from the ink; and
- optionally further heating of the substantially dry ink in the printhead, causing the ink to leave the printhead by a process of sublimation and/or melting and evaporation.

According to one embodiment, the removing step can be performed by the application of heat from a heater in thermal communication with the printhead containing or retaining the ink.

According to one embodiment, the droplets can be formed using gravity, pressure, mechanical pushing of the ink, electrically stimulated droplet ejection or electrohydrodynamic ejection, or any means for forming droplets known in the art.

According to one embodiment, the droplets can be formed by pushing, *i.e*., a high pressure build-up is created within ink so that the ink is pushed out of the printing nozzle.

According to one embodiment, the droplets can be formed by pulling with an electrically stimulated droplet ejection known also as electrohydrodynamic ejection, *i.e*., localised pressure build-up is created outside of the ink thanks to the application of an electrical field so that the ink is pulled from the nozzle. This embodiment is particularly advantageous as droplets formed this way are more than 100 times smaller than droplets formed using gravity or mechanical pushing, and enable sub-100 nm printing. The continued downward acceleration overturns air drag even for ultra-small droplet and the placement precision is more than 100 times higher. Electrohydrodynamic ejection allows applicability with a very wide range of liquids with a single print head. Additionally, it is possible to adjust ejection flow rate (*i.e.*, ejection frequency) by many orders of magnitude, with the same ink and the same print head.

According to one embodiment, the optional heating step is particularly performed with a printhead presenting pores as to prevent the clogging of said pores.

According to one embodiment, the method further comprises a curing step.

According to one embodiment, the method further comprises successive printing steps. In this embodiment, a plurality of inks can be printed on a same or on a plurality of supports.

According to one embodiment, the method comprises depositing a red emitting ink on a support using a first printing nozzle, depositing a green emitting ink on a support using a second printing nozzle and depositing a blue emitting ink on a support using a third printing nozzle. The support is as described hereabove.

According to one embodiment, a plurality of inks can be inkjet printed onto a plurality of supports simultaneously, or in rapid succession, with or without a controlled delay between successive printing steps. In this embodiment, a substrate tray that holds the substrates in place and that moves with respect to the inkjet printhead during the printing steps can be used.

According to one embodiment, the printhead is an inkjet printhead.

According to one embodiment, the printhead is an inkjet thermal or piezoelectric printhead.

According to one embodiment, during movement of the printhead over the support, the ink, without liquid vehicle, can be deposited on the support in a desired pattern, avoiding the dangers a liquid vehicle or solvent might pose to already-deposited layers on the support.

According to one embodiment, the printing nozzle has a size of at least 1 µm, 1.5 µm, 2.5 µm, 3 µm, 3.5 µm, 4 µm, 4.1 µm, 4.2 µm, 4.3 µm, 4.4 µm, 4.5 µm, 4.6 µm, 4.7 µm, 4.8 µm, 4.9 µm, 5 µm, 5.1 µm, 5.2 µm, 5.3 µm, 5.4 µm, 5.5 µm, 5.5 µm, 5.6 µm, 5.7 µm, 5.8 µm, 5.9 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, 1 mm, 1.1 mm, 1.2 mm, 1.3 mm, 1.4 mm, 1.5 mm, 1.6 mm, 1.7 mm, 1.8 mm, 1.9 mm, or 2 mm.

According to one embodiment, the printing nozzle has a size superior or equal to the size of the particles comprised in the ink.

### BRIEF DESCRIPTION OF THE DRAWINGS

**Figure 1** illustrates a particle **1** comprising a first material **11** and particles **2**; wherein each particle **2** comprises a second material **21** and at least one nanoparticle **3** dispersed in said second material **21.**
**Figure 2** illustrates a particle **1** comprising a first material **11** and particles **2**; wherein each particle **2** comprises a second material **21** and at least one spherical nanoparticle **31** dispersed in said second material **21.**
**Figure 3** illustrates a particle 1 comprising a first material **11** and particles **2**; wherein each particle **2** comprises a second material **21** and at least one 2D nanoparticle **32** dispersed in said second material **21.**
**Figure 4** illustrates a particle 1 comprising a first material **11** and particles **2**; wherein each particle **2** comprises a second material **21,** at least one spherical nanoparticle **31** and at least one 2D nanoparticle **32** dispersed in said second material **21.**
**Figure 5** illustrates a particle **1** comprising different particles **2.**
**Figure 6** illustrates a heterostructured particle **1.**
**Figure 6A** illustrates a heterostructured particle **1**, wherein the core **12** of the particle **1** comprises at least one particle **2** and the shell **13** of the particle **1** does not comprise particles **2.**
**Figure 6B** illustrates a heterostructured particle **1**, wherein the at least one particle **2** is a heterostructure.
**Figure 6C** illustrates a heterostructured particle **1**, wherein the core **12** of the particle **1** comprises at least one particle **2** and the shell **13** of the particle **1** comprises at least one particle **2.**
**Figure 6D** illustrates a heterostructured particle **1**, wherein the core **12** of the particle **1** comprises at least one particle **2** and the shell **13** of the particle **1** comprises at least one nanoparticle **3.**
**Figure 7** illustrates a particle **1** with at least one nanoparticle **2** located on its surface.
**Figure 7A** illustrates a particle **1** with at least one nanoparticle **2** adsorbed with a cement on its surface.
**Figure 7B** illustrates a particle **1** with at least one nanoparticle **2** located on its surface, wherein the at least one particle **2** has some of its volume trapped in the first material **11.**
**Figure 8** illustrates a particle **1** comprising at least one particle **2** dispersed in the first material **11**; and at least one particle **2** located on the surface of said particle **1.**
**Figure 8A** illustrates a particle **1** comprising at least one particle **2** dispersed in the first material **11**; and at least one particle **2** adsorbed with a cement on the surface of said particle **1.**
**Figure 8B** illustrates a particle **1** comprising at least one particle **2** dispersed in the first material **11**; and at least one particle **2** located on the surface with some of its volume trapped in the first material **11.**
**Figure 9** illustrates a particle **1** further comprising at least one nanoparticle **3** dispersed in the first material **11.**
**Figure 10** illustrates a particle **1** further comprising a dense particle **9** dispersed in the first material **11.**
**Figure 10A** illustrates a particle **1** comprising at least one nanoparticle **2** located on its surface and a dense particle **9** dispersed in the first material **11.**
**Figure 10B** illustrates a particle **1** comprising at least one nanoparticle **2** and a dense particle **9** dispersed in the first material **11.**

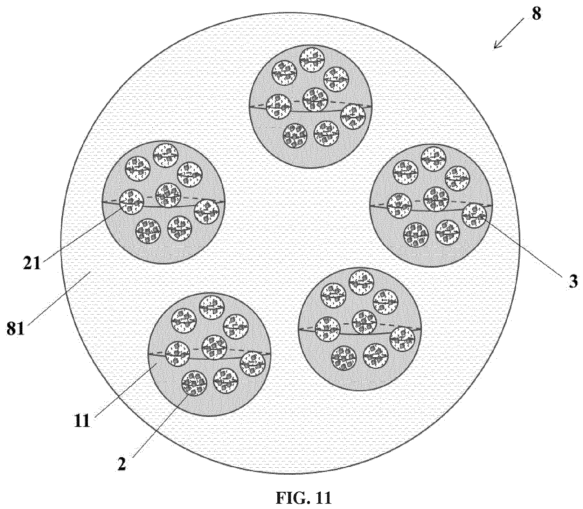

**Figure 11** illustrates a bead **8** comprising a third material **81** and the particle **1** is dispersed in said third material **81.**
**Figure 12** illustrates different nanoparticles **3.**
**Figure 12A** illustrates a core nanoparticle **33** without a shell.
**Figure 12B** illustrates a core **33**/shell **34** nanoparticle **3** with one shell **34.**
**Figure 12C** illustrates a core **33**/shell (**34, 35**) nanoparticle **3** with two different shells (**34, 35**).
**Figure 12D** illustrates a core **33**/shell (**34, 35, 36**) nanoparticle **3** with two different shells (**34, 35**) surrounded by an oxide insulator shell **36.**
**Figure 12E** illustrates a core **33**/crown **37** nanoparticle **32.**
**Figure 12F** illustrates a sectional view of a core **33**/shell **34** nanoparticle **32** with one shell **34.**
**Figure 12G** illustrates a sectional view of a core **33**/shell **(34, 35)** nanoparticle **32** with two different shells (**34, 35**).
**Figure 12H** illustrates a sectional view of a core **33**/shell **(34, 35, 36)** nanoparticle **32** with two different shells (**34, 35**) surrounded by an oxide insulator shell **36.**

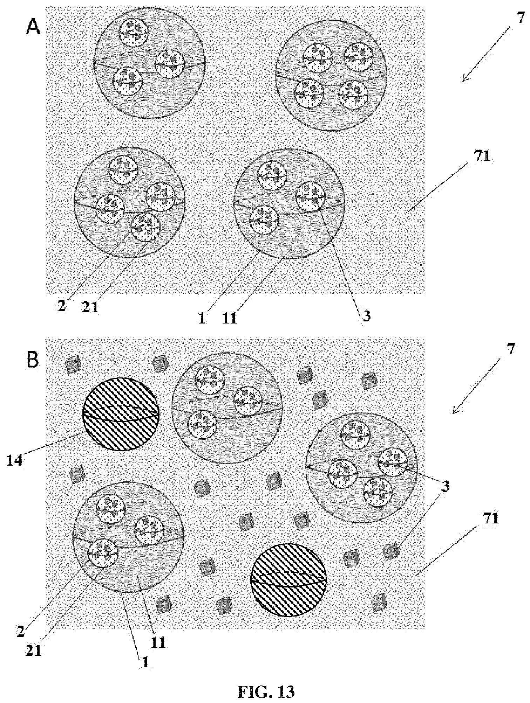

**Figure 13** illustrates a light emitting material **7.**
**Figure 13A** illustrates a light emitting material **7** comprising a host material **71** and at least one particle **1** of the invention.
**Figure 13B** illustrates a light emitting material **7** comprising a host material **71**; at least one particle **1** of the invention; a plurality of particles comprising an inorganic material **14**; and a plurality of 2D nanoparticles **3.**
**Figure 14** illustrates an optoelectronic device.
**Figure 14A** illustrates an optoelectronic device comprising a LED support **4**, a LED chip **5** and ink **15** deposited on said LED chip **5**, wherein the ink **15** covers the LED chip **5.**
**Figure 14B** illustrates an optoelectronic device comprising a LED support **4**, a LED chip **5** and ink **15** deposited on said LED chip **5** wherein the ink **15** covers and surrounds the LED chip **5.**
**Figure 15** illustrates a microsized LED **6** array comprising a LED support **4** and a plurality of microsized LED **6**, wherein the pixel pitch **D** is the distance from the center of a pixel to the center of the next pixel.
**Figure 16** illustrates an optoelectronic device.
**Figure 16A** illustrates an optoelectronic device comprising a LED support **4**, a microsized LED **6** and ink **15** deposited on said microsized LED **6,** wherein the ink **15** covers the microsized LED **6.**
**Figure 16B** illustrates an optoelectronic device comprising a LED support **4**, a microsized LED **6** and ink **15** deposited on said microsized LED **6** wherein the ink **15** covers and surrounds the microsized LED **6.**
**Figure 17A** is a TEM image of CdSe/CdZnS@HfO₂@SiO₂ particles.
**Figure 17B** is a TEM image of CdSe/CdZnS@HfO₂@SiO₂ particles.
**Figure 17C** is a TEM image of HfO₂ particles.
**Figure 18** illustrates a particle **2** comprising a plurality of nanoparticles **3** encapsulated in a material **21.**
**Figure 19** illustrates a particle **2** comprising a plurality of spherical nanoparticles **31** encapsulated in a material **21.**
**Figure 20** illustrates a particle **2** comprising a plurality of 2D nanoparticles **32** encapsulated in a material **21.**
**Figure 21** illustrates a particle **2** comprising a plurality of spherical nanoparticles **31** and a plurality of 2D nanoparticles **32** encapsulated in a material **21.**

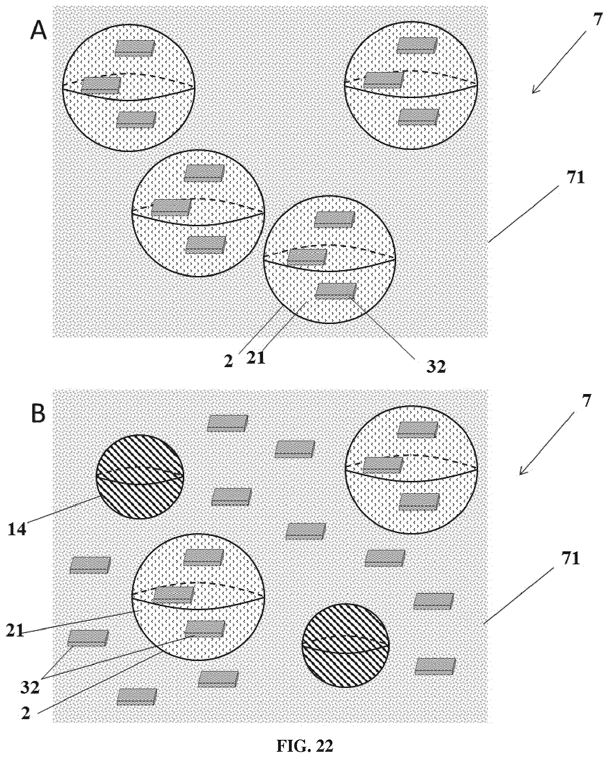

**Figure 22** illustrates a light emitting material **7.**
**Figure 22A** illustrates a light emitting material **7** comprising a host material **71** and at least one particle **2** of the invention comprising a plurality of 2D nanoparticles **32** encapsulated in a material **21.**
**Figure 22B** illustrates a light emitting material **7** comprising a host material **71;** at least one particle **2** of the invention comprising a plurality of 2D nanoparticles **32** encapsulated in a material **21;** a plurality of particles comprising an inorganic material **14;** and a plurality of 2D nanoparticles **32.**
**Figure 23** is TEM images showing nanoparticles (dark contrast) uniformly dispersed in an inorganic material (bright contrast).
**Figure 23A** is TEM images showing CdSe/CdZnS nanoplatelets (dark contrast) uniformly dispersed in SiO₂ (bright contrast - @ SiO₂).
**Figure 23B** is TEM images showing CdSe/CdZnS nanoplatelets (dark contrast) uniformly dispersed in SiO₂ (bright contrast - @ SiO₂).
**Figure 23C** is TEM images showing CdSe/CdZnS nanoplatelets (dark contrast) uniformly dispersed in Al₂O₃ (bright contrast - @Al₂O₃).
**Figure 24** shows the N₂ adsorption isotherm of particles **2.**
**Figure 24A** shows the N₂ adsorption isotherm of particles **2** CdSe/CdZnS@ SiO₂ prepared from a basic aqueous solution and from an acidic solution.
**Figure 24B** shows the N₂ adsorption isotherm of particles **2** CdSe/CdZnS@ Al₂O₃ obtained by heating droplets at 150°C, 300°C and 550°C.
**Figure 25** illustrates a particle **2** comprising a core **22** comprising a plurality of nanoparticles **32** encapsulated in a material, and a shell **23** comprising a plurality of nanoparticles **31** encapsulated in a material.

### EXAMPLES

The present invention is further illustrated by the following examples.

### Example 1: Inorganic nanoparticles preparation

Nanoparticles used in the examples herein were prepared according to methods of the art (Lhuillier E. et al., Acc. Chem. Res., 2015, 48 (1), pp 22-30; Pedetti S. et al., J. Am. Chem. Soc., 2014, 136 (46), pp 16430-16438; Ithurria S. et al., J. Am. Chem. Soc., 2008, 130, 16504-16505; Nasilowski M. et al., Chem. Rev. 2016, 116, 10934-10982).

Nanoparticles used in the examples herein were selected in the group comprising CdSe/CdZnS, CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots.

### Example 2: Particles preparation from a basic aqueous solution - CdSe/CdZnS@SiO₂

100 µL of CdSe/CdZnS nanoplatelets suspended in a basic aqueous solution were mixed with a basic aqueous solution of TEOS at 0.13M previously hydrolyzed for 24 hours, then loaded on a spray-drying set-up. The liquid mixture was sprayed towards a tube furnace heated at a temperature ranging from the boiling point of the solvent to 1000°C with a nitrogen flow. The particles were collected at the surface of a filter.

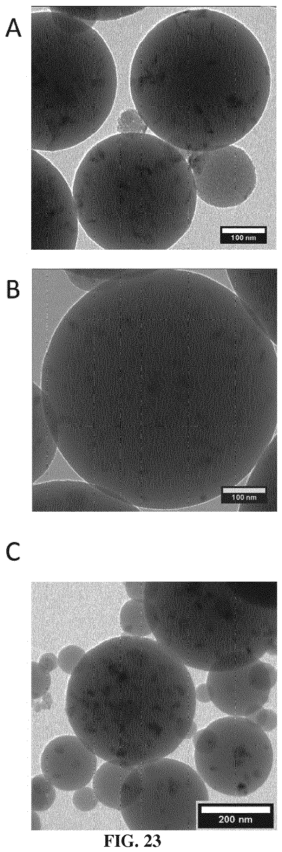

Fig. 23 A-B show TEM images of the resulting particles.

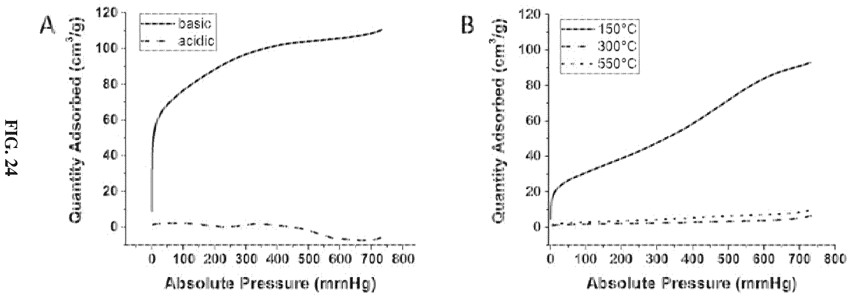

Fig. 24 A shows the N₂ adsorption isotherm of the resulting particles. Said resulting particles are porous.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

### Example 3: Particles preparation from an acidic aqueous solution - CdSe/CdZnS@SiO₂

100 µL of CdSe/CdZnS nanoplatelets suspended in an acidic aqueous solution were mixed with an acidic aqueous solution of TEOS at 0.13M previously hydrolyzed for 24 hours, then loaded on a spray-drying set-up. The liquid mixture was sprayed towards a tube furnace heated at a temperature ranging from the boiling point of the solvent to 1000°C with a nitrogen flow. The particles were collected at the surface of a filter.

Fig. 24 A shows the N₂ adsorption isotherm of the resulting particles. Said resulting particles are not porous.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

### Example 4: Particles preparation from a basic aqueous solution with hetero-elements - CdSe/CdZnS@SiₓCd_{y}Zn_{z}O_{w}

100 µL of CdSe/CdZnS nanoplatelets suspended in an acidic aqueous solution were mixed with an acidic aqueous solution of TEOS at 0.13M previously hydrolyzed for 24 hours in presence of cadmium acetate at 0.01M and zinc oxide at 0.01M, then loaded on a spray-drying set-up. The liquid mixture was sprayed towards a tube furnace heated at a temperature ranging from the boiling point of the solvent to 1000°C with a nitrogen flow. The particles were collected at the surface of a filter.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

### Example 5: Particles preparation from an organic solution and an aqueous solution - CdSe/CdZnS@Al₂O₃

100 µL of CdSe/CdZnS nanoplatelets suspended in heptane were mixed with aluminium tri-sec butoxide and 5 mL of pentane, then loaded on a spray-drying set-up. On another side, a basic aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The particles were collected at the surface of a filter.

Fig. 23 C shows TEM images of the resulting particles.

Fig. 24 B show N₂ adsorption isotherms for particles obtained after heating the droplets at 150°C, 300°C and 550°C. Increasing the heating temperature results in a loss of the porosity. Thus particles obtained by heating at 150°C are porous, whereas the particles obtained by heating at 300°C and 550°C are not porous.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing Al₂O₃ with ZnTe, SiO₂, TiO₂, HfO₂, ZnSe, ZnO, ZnS or MgO, or a mixture thereof. Reaction temperature of the above procedure is adapted according to the inorganic material chosen.

The same procedure was carried out by replacing Al₂O₃ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 6: Particles preparation from an organic solution and an aqueous solution - InP/ZnS@Al₂O₃

4 mL of InP/ZnS nanoparticles suspended in heptane were mixed with aluminium tri-sec butoxide and 400 mL of heptane, then loaded in a spray-drying set-up. On another side, an acidic aqueous solution was prepared and loaded in the same spray-drying set-up, but at a different location than the first hexane solution. The two liquids were sprayed simultaneously with two different means for forming droplets towards a tube furnace heated at a temperature ranging from the boiling point of the solvent to 1000°C with a nitrogen flow. The particles were collected at the surface of a filter.

The same procedure was carried out by replacing InP/ZnS nanoparticles with CdSe, CdS, CdTe, CdSe/CdS, CdSe/ZnS, CdSe/CdZnS, CdS/ZnS, CdS/CdZnS, CdTe/ZnS, CdTe/CdZnS, CdSe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing Al₂O₃ with SiO₂, TiO₂, HfO₂, ZnTe, ZnSe, ZnO, ZnS or MgO, or a mixture thereof. Reaction temperature of the above procedure is adapted according to the inorganic material chosen.

The same procedure was carried out by replacing Al₂O₃ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 7: Particles preparation from an organic solution and an aqueous solution - CH₅N₂-PbBr₃@Al₂O₃

100 µL of CH₅N₂-PbBr₃ nanoparticles suspended in hexane were mixed with aluminium tri-sec butoxide and 5 mL of hexane, then loaded in a spray-drying set-up. On another side, an acidic aqueous solution was prepared and loaded in the same spray-drying set-up, but at a different location than the first hexane solution. The two liquids were sprayed simultaneously with two different means for forming droplets towards a tube furnace heated at a temperature ranging from the boiling point of the solvent to 1000°C with a nitrogen flow. The particles were collected at the surface of a filter.

The same procedure was carried out by replacing Al₂O₃ with SiO₂, TiO₂, HfO₂, ZnTe, ZnSe, ZnO, ZnS or MgO, or a mixture thereof. Reaction temperature of the above procedure is adapted according to the inorganic material chosen.

The same procedure was carried out by replacing Al₂O₃ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 8: Particles preparation from an organic solution and an aqueous solution - CdSe/CdZnS-Au@SiO₂

On one side, 100 µL of gold nanoparticles and 100 µL of CdSe/CdZnS nanoplatelets suspended in an acidic aqueous solution were mixed with an acidic aqueous solution of TEOS at 0.13M previously hydrolyzed for 24 hours, then loaded in a spray-drying set-up. The supension was sprayed towards a tube furnace heated at a temperature ranging from the boiling point of the solvent to 1000°C with a nitrogen flow. The particles were collected at the surface of a GaN substrate. The GaN substrate with the deposited particles was then cut into pieces of 1 mm × 1 mm and electricaly connected to get a LED emitting a mixture of the blue light and the light emitted by the fluorescent nanoparticles.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing SiO₂ with Al₂O₃, TiO₂, HfO₂, ZnTe, ZnSe, ZnO, ZnS or MgO, or a mixture thereof. Reaction temperature of the above procedure is adapted according to the inorganic material chosen.

The same procedure was carried out by replacing SiO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 9: Particles preparation from an organic solution and an aqueous solution - Fe₃O₄@Al₂O₃-CdSe/CdZnS@SiO₂

On one side, 100 µL of Fe₃O₄ nanoparticles suspended in an acidic aqueous solution were mixed with an acidic aqueous solution of TEOS at 0.13M previously hydrolyzed for 24 hours. On another side, 100 µL of CdSe/CdZnS nanoplatelets suspended in heptane were mixed with aluminium tri-sec butoxide and 5 mL of heptane, then loaded on the same spray-drying set-up, but at a different location than the first aqueous solution. The two liquids were sprayed simultaneously with two different means for forming droplets towards a tube furnace heated at a temperature ranging from the boiling point of the solvent to 1000°C with a nitrogen flow. The particles were collected at the surface of a filter. The particles comprise a core of silica containing Fe₃O₄ nanoparticles and a shell of alumina containing CdSe/CdZnS nanoplatelets.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing Al₂O₃ and/or SiO₂ with TiO₂, SiO₂, Al₂O₃, HfO₂, ZnTe, ZnSe, ZnO, ZnS or MgO, or a mixture thereof. Reaction temperature of the above procedure is adapted according to the inorganic material chosen.

The same procedure was carried out by replacing Al₂O₃ and/or SiO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 10: Particles preparation from an organic solution and an aqueous solution - CdS/ZnS nanoplatelets@Al₂O₃

4 mL of CdS/ZnS nanoplatelets suspended in heptane were mixed with aluminium tri-sec butoxide and 400 mL of heptane, then loaded in a spray-drying set-up. On another side, an acidic aqueous solution was prepared and loaded in the same spray-drying set-up, but at a different location than the first hexane solution. The two liquids were sprayed simultaneously with two different means for forming droplets towards a tube furnace heated at a temperature ranging from the boiling point of the solvent to 1000°C with a nitrogen flow. The particles were collected at the surface of a filter.

The same procedure was carried out by replacing CdS/ZnS nanoplatelets with CdSe, CdS, CdTe, CdSe/CdS, CdSe/ZnS, CdSe/CdZnS, CdS/CdZnS, CdTe/ZnS, CdSe/CdZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing Al₂O₃ with SiO₂, TiO₂, HfO₂, ZnTe, ZnSe, ZnO, ZnS or MgO, or a mixture thereof. Reaction temperature of the above procedure is adapted according to the inorganic material chosen.

The same procedure was carried out by replacing Al₂O₃ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 11: Particles preparation from an organic solution and an aqueous solution - InP/ZnS@SiO₂

4 mL of InP/ZnS nanoparticles suspended in an acidic aqueous solution were mixed with an acidic aqueous solution of TEOS at 0.13M previously hydrolyzed for 24 hours, then loaded in a spray-drying set-up. The suspension was sprayed for forming droplets towards a tube furnace heated a temperature ranging from the boiling point of the solvent to 1000°C with a nitrogen flow. The particles were collected at the surface of a filter.

The same procedure was carried out by replacing InP/ZnS nanoparticles with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, CdSe/CdZnS, InP/CdS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing SiO₂ with TiO₂, Al₂O₃, HfO₂, ZnTe, ZnSe, ZnO, ZnS or MgO, or a mixture thereof. Reaction temperature of the above procedure is adapted according to the inorganic material chosen.

The same procedure was carried out by replacing SiO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 12: Particles preparation from an organic solution and an aqueous solution, followed by a treatment of ammonia vapors- CdSe/CdZnS@ZnO

100 µL of CdSe/CdZnS nanoplatelets suspended in heptane were mixed with zinc methoxyethoxide and 5 mL of pentane, then loaded on a spray-drying set-up as described in the invention. On another side, a basic aqueous solution was prepared and loaded on the same spray-drying set-up, but at a different location than the first heptane solution. On another side, an ammonium hydroxide solution was loaded on the same spray-drying system, between the tube furnace and the filter. The two first liquids were sprayed while the third one was heated at 35°C by an external heating system to produce ammonia vapors, simultaneously towards a tube furnace heated at a temperature ranging from the boiling point of the solvent to 1000°C with a nitrogen flow. The particles were collected at the surface of a filter.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing ZnO with TiO₂, SiO₂, HfO₂, Al₂O₃, ZnTe, ZnSe, ZnS or MgO, or a mixture thereof. Reaction temperature of the above procedure is adapted according to the inorganic material chosen.

The same procedure was carried out by replacing ZnO with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 13: Particles preparation from an organic solution and an aqueous solution, followed by an extra shell coating - CdSe/CdZnS@Al₂O₃@MgO

100 µL of CdSe/CdZnS nanoplatelets suspended in heptane were mixed with zinc methoxyethoxide and 5 mL of pentane, then loaded on a spray-drying set-up as described in the invention. On another side, a basic aqueous solution was prepared and loaded on the same spray-drying set-up, but at a different location than the first heptane solution. The two liquids were sprayed simultaneously towards a tube furnace heated at a temperature ranging from the boiling point of the solvent to 1000°C with a nitrogen flow. The particles were directed towards a tube where an extra MgO shell was coated at the surface of the particles by an ALD process, said particles being suspended in the gas. The particles were finally collected on the inner wall of the tube where the ALD was performed.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

### Example 14: Particles preparation from an organic solution and an aqueous solution - CdSe/CdZnS-Fe₃O₄@SiO₂

On one side, 100 µL of Fe₃O₄ nanoparticles and 100 µL of CdSe/CdZnS nanoplatelets suspended in an acidic aqueous solution were mixed with an acidic aqueous solution of TEOS at 0.13M previously hydrolyzed for 24 hours, then loaded in a spray-drying set-up as described in the invention. On another side, an acidic aqueous solution was prepared and loaded on the same spray-drying set-up, but at a different location than the first heptane solution. The two liquids were sprayed simultaneously towards a tube furnace heated at a temperature ranging from the boiling point of the solvent to 1000°C with a nitrogen flow. The particles were collected at the surface of a filter.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

### Example 15: Core/shell particles preparation from an organic solution and an aqueous solution - Au@Al₂O₃ in the core and CdSe/CdZnS@SiO₂ in the shell

On one side, 100 µL of CdSe/CdZnS nanoplatelets suspended in an acidic aqueous solution were mixed with an acidic aqueous solution of TEOS at 0.13M previously hydrolyzed for 24 hours, then loaded on a spray-drying set-up as described in the invention. On another side, 100 µL of Au nanoparticles suspended in heptane were mixed with aluminium tri-sec butoxide and 5 mL of heptane, then loaded on the same spray-drying set-up, but at a different location than the first aqueous solution. The two liquids were sprayed simultaneously towards a tube furnace heated at a temperature ranging from the boiling point of the solvent to 1000°C with a nitrogen flow. The particles were collected at the surface of a filter. The particles comprise a core of alumina containing gold nanoparticles and a shell of silica containing CdSe/CdZnS nanoplatelets.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

### Example 16: Particles preparation - phosphor nanoparticles@SiO₂

Phosphor nanoparticles were suspended in a basic aqueous solution were mixed with a basic aqueous solution of TEOS at 0.13M previously hydrolyzed for 24 hours, then loaded on a spray-drying set-up. The liquid mixture was sprayed towards a tube furnace heated at a temperature ranging from the boiling point of the solvent to 1000°C with a nitrogen flow. The particles were collected at the surface of a filter.

Phosphor nanoparticles used for this example were: Yttrium aluminium garnet nanoparticles (YAG, Y₃Al₅O₁₂), (Ca,Y)-α-SiAlON:Eu nanoparticles, ((Y,Gd)₃(Al,Ga)₅O₁₂:Ce) nanoparticles, CaAlSiN₃:Eu nanoparticles, sulfide-based phosphor nanoparticles, PFS:Mn⁴⁺ nanoparticles (potassium fluorosilicate).

### Example 17: Particles preparation - phosphor nanoparticles@Al₂O₃

Phosphor nanoparticles were suspended in heptane were mixed with aluminium tri-sec butoxide and 400 mL of heptane, then loaded in a spray-drying set-up. On another side, an acidic aqueous solution was prepared and loaded in the same spray-drying set-up, but at a different location than the first hexane solution. The two liquids were sprayed simultaneously with two different means for forming droplets towards a tube furnace heated at a temperature ranging from the boiling point of the solvent to 1000°C with a nitrogen flow. The particles were collected at the surface of a filter.

Phosphor nanoparticles used for this example were: Yttrium aluminium garnet nanoparticles (YAG, Y₃Al₅O₁₂), (Ca,Y)-α-SiAlON:Eu nanoparticles, ((Y,Gd)₃(Al,Ga)₅O₁₂:Ce) nanoparticles, CaAlSiN₃:Eu nanoparticles, sulfide-based phosphor nanoparticles, PFS:Mn⁴⁺ nanoparticles (potassium fluorosilicate).

### Example 18: Particles preparation - CdSe/CdZnS@HfO₂

100 µL of CdSe/CdZnS nanoplatelets suspended in heptane (10mg/mL) were mixed with Hafnium n-butoxide and 5 mL of pentane, then loaded on a spray-drying set-up. On another side, a basic aqueous solution was prepared and loaded on the same spray-drying set-up, but at a different location than the first heptane solution. The two liquids were sprayed simultaneously towards a tube furnace heated at a temperature ranging from the boiling point of the solvent to 1000°C with a nitrogen flow. Particles were collected at the surface of a filter.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

### Example 19: Particles preparation - phosphor nanoparticles@HfO₂

1µm of phosphor nanoparticles (*cf.* list below) suspended in heptane (10mg/mL) were mixed with hafnium n-butoxide and 5 mL of pentane, then loaded on a spray-drying set-up. On another side, an aqueous solution was prepared and loaded on the same spray-drying set-up, but at a different location than the first heptane solution. The two liquids were sprayed simultaneously towards a tube furnace heated at a temperature ranging from the boiling point of the solvent to 1000°C with a nitrogen flow. The resulting particles phosphors particles@HfO₂ were collected at the surface of a filter.

Phosphor nanoparticles used for this example were: Yttrium aluminium garnet nanoparticles (YAG, Y₃Al₅O₁₂), (Ca,Y)-α-SiAlON:Eu nanoparticles, ((Y,Gd)₃(Al,Ga)₅O₁₂:Ce) nanoparticles, CaAlSiN₃:Eu nanoparticles, sulfide-based phosphor nanoparticles, PFS:Mn⁴⁺ nanoparticles (potassium fluorosilicate).

### Example 20: Particles preparation from an organometallic precursor

100 µL of CdSe/CdZnS nanoplatelets suspended in heptane were mixed with an organometallic precursor selected in the group below in pentane under controlled atmosphere, then loaded on a spray-drying set-up. On another side, an aqueous solution was prepared and loaded on the same spray-drying set-up, but at a different location than the first heptane solution. The two liquids were sprayed simultaneously towards a tube furnace heated from room temperature to 300°C with a nitrogen flow. The particles were collected at the surface of a filter.

The procedure was carried out with an organometallic precursor selected in the group comprising: Al[N(SiMe₃)₂]₃, trimethyl aluminium, triisobutylaluminum, trioctylaluminum, triphenylaluminum, dimethyl aluminium, trimethyl zinc, dimethyl zinc, diethylzinc, Zn[(N(TMS)₂]₂, Zn[(CF₃SO₂)₂N]₂, Zn(Ph)₂, Zn(C₆F₅)₂, Zn(TMHD)₂ (β-diketonate), Hf[C₅H₄(CH₃)]₂(CH₃)₂, HfCH₃(OCH₃)[C₅H₄(CH₃)]₂, [[(CH₃)₃Si]₂N]₂HfCl₂, (C₅H₅)₂Hf(CH₃)₂, [(CH₂CH₃)₂N]₄Hf, [(CH₃)₂N]₄Hf, [(CH₃)₂N]₄Hf, [(CH₃)(C₂H₅)N]₄Hf, [(CH₃)(C₂H₅)N]₄Hf, 2,2',6,6'-tetramethyl-3,5-heptanedione zirconium (Zr(THD)₄), C₁₀H₁₂Zr, Zr(CH₃C₅H₄)₂CH₃OCH₃, C₂₂H₃₆Zr, [(C₂H₅)₂N]₄Zr, [(CH₃)₂N]₄Zr, [(CH₃)₂N]₄Zr, Zr(NCH₃C₂H₅)₄, Zr(NCH₃C₂H₅)₄, C₁₈H₃₂O₆Zr, Zr(C₈H₁₅O₂)₄, Zr(OCC(CH₃)₃CHCOC(CH₃)₃)₄, Mg(C₅H₅)₂, or C₂₀H₃₀Mg, or a mixture thereof. Reaction temperature of the above procedure is adapted according to the organometallic precursor chosen.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing Al₂O₃ with TiO₂, ZnO, MgO, HfO₂ or ZrO₂. The same procedure was carried out by replacing Al₂O₃ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof.

The same procedure was carried out by replacing the aqueous solution with another liquid or vapor source of oxidation.

### Example 21: Particles preparation from an organometallic precursor - CdSe/CdZnS@ZnTe

100 µL of CdSe/CdZnS nanoplatelets suspended in heptane were mixed with two organometallic precursors selected in the group below in pentane under inert atmosphere then loaded on a spray-drying set-up. The suspension was sprayed towards a tube furnace heated from RT to 300°C with a nitrogen flow. The particles were collected at the surface of a filter.

The procedure was carried out by with a first organometallic precursor selected in the group comprising: dimethyl telluride, diethyl telluride, diisopropyl telluride, di-t-butyl telluride, diallyl telluride, methyl allyl telluride, dimethyl selenide, or dimethyl sulfur, or a mixture thereof. Reaction temperature of the above procedure is adapted according to the organometallic precursor chosen.

The procedure was carried out by with a second organometallic precursor selected in the group comprising: dimethyl zinc, trimethyl zinc, diethylzinc, Zn[(N(TMS)₂]₂, Zn[(CF₃SO₂)₂N]₂, Zn(Ph)₂, Zn(C₆F₅)₂, or Zn(TMHD)₂ (β-diketonate), or a mixture thereof. Reaction temperature of the above procedure is adapted according to the organometallic precursor chosen.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe2/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing ZnTe with ZnS or ZnSe, or a mixture thereof.

The same procedure was carried out by replacing ZnTe with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof.

### Example 22: Particles preparation from an organometallic precursor - CdSe/CdZnS@ZnS

100 µL of CdSe/CdZnS nanoplatelets suspended in heptane were mixed with an organometallic precursor selected in the group below in pentane under inert atmosphere, then loaded on a spray-drying set-up. On another side, a vapor source of H₂S was inserted in the same spray-drying set-up. The suspension was sprayed towards a tube furnace heated from RT to 300°C with a nitrogen flow. The particles were collected at the surface of a filter.

The procedure was carried out with an organometallic precursor selected in the group omprising: dimethyl zinc, trimethyl zinc, diethylzinc, Zn[(N(TMS)₂]₂, Zn[(CF₃SO₂)₂N]₂, Zn(Ph)₂, Zn(C₆F₅)₂, Zn(TMHD)₂ (β-diketonate), or a mixture thereof. Reaction temperature of the above procedure is adapted according to the organometallic precursor chosen.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing ZnS with ZnSe or ZnTe, or a mixture thereof.

The same procedure was carried out by replacing ZnS with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof.

The same procedure was carried out by replacing H₂S with H₂Se, H₂Te or other gas.

### Example 23: InP/GaP/ZnSe/ZnS@Al₂O₃@HfO₂

### 1st step

100 µL of InP/GaP/ZnSe/ZnS nanocrystals suspended in heptane (10mg/mL) were mixed with aluminium tri-sec butoxide and 5 mL of pentane, then loaded on a spray-drying set-up. On another side, a basic aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The resulting particles InP/GaP/ZnSe/ZnS@Al₂O₃ were collected at the surface of a filter.

### 2nd step

5mg of InP/GaP/ZnSe/ZnS@Al₂O₃ particles were suspended in 5 mL of pentane and mixed with hafnium n-butoxide, then loaded on a spray-drying set-up. On another side, a basic aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The luminescent particles InP/GaP/ZnSe/ZnS@Al₂O₃@HfO₂ were collected at the surface of a filter.

The same procedure was carried out by replacing InP/GaP/ZnSe/ZnS nanocrystals with CdSe/CdZnS, CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing InP/GaP/ZnSe/ZnS nanocrystals with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing Al₂O₃ and/or HfO₂ with TiO₂, ZnTe, Al₂O₃, SiO₂, HfO₂, ZnSe, ZnO, ZnS, SiZrO₂, SiHfO₂ or MgO, or a mixture thereof. Reaction temperature of the above procedure is adapted according to the inorganic material chosen.

The same procedure was carried out by replacing Al₂O₃ and/or HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 24: InP/ZnS/ZnSe/ZnS@Al₂O₃@HfO₂

### 1st step

100 µL of InP/ZnS/ZnSe/ZnS nanocrystals suspended in heptane (10mg/mL) were mixed with aluminium tri-sec butoxide and 5 mL of pentane, then loaded on a spray-drying set-up. On another side, a basic aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The resulting particles InP/ZnS/ZnSe/ZnS@Al₂O₃ were collected at the surface of a filter.

### 2nd step

5mg of InP/ZnS/ZnSe/ZnS@Al₂O₃ particles were suspended in 5 mL of pentane and mixed with hafnium n-butoxide, then loaded on a spray-drying set-up. On another side, a basic aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The luminescent particles InP/ZnS/ZnSe/ZnS@Al₂O₃@HfO₂ were collected at the surface of a filter.

The same procedure was carried out by replacing InP/ZnS/ZnSe/ZnS nanocrystals with CdSe, CdS, CdTe, CdSe/CdS, CdSe/ZnS, CdSe/CdZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing InP/ZnS/ZnSe/ZnS nanocrystals with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing Al₂O₃ and/or HfO₂ with TiO₂, ZnTe, Al₂O₃, SiO₂, HfO₂, ZnSe, ZnO, ZnS, SiZrO₂, SiHfO₂ or MgO, or a mixture thereof. Reaction temperature of the above procedure is adapted according to the inorganic material chosen.

The same procedure was carried out by replacing Al₂O₃ and/or HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 25: CdSe/CdZnS@HfO₂@Si_{0.8}Hf_{0.2}O₂

### 1st step

100 µL of CdSe/CdZnS nanoplatelets suspended in heptane (10mg/mL) were mixed with hafnium n-butoxide and 5 mL of pentane, then loaded on a spray-drying set-up. On another side, an aqueous solution was prepared and loaded the same spray-drying set-up, but at a different location than the first pentane solution. The two liquids were sprayed simultaneously towards a tube furnace heated at a temperature ranging from the boiling point of the solvent to 1000°C with a nitrogen flow. The resulting particles CdSe/CdZnS@HfO₂ were collected at the surface of a filter.

### 2nd step

50 mg of CdSe/CdZnS@HfO₂ particles were suspended in 20 mL of ethanol and mixed with TEOS, hafnium oxychloride and water, then loaded on a spray-drying set-up. The liquid was sprayed towards a tube furnace heated at a temperature ranging from the boiling point of the solvent to 1000°C with a nitrogen flow. The luminescent particles CdSe/CdZnS@HfO₂@SiHfO₂ were collected at the surface of a filter.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing SiHfO₂ and/or HfO₂ with ZnTe, Al₂O₃, SiO₂, HfO₂, ZnSe, TiO₂, ZnO, ZnS, SiZrO₂, SiHfO₂ or MgO, or a mixture thereof. Reaction temperature of the above procedure is adapted according to the inorganic material chosen.

The same procedure was carried out by replacing SiHfO₂ and/or HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 26: CdSe/CdZnS@HfO₂@Si_{0.8}Zr_{0.2}O₂

### 1st step

100 µL of CdSe/CdZnS nanoplatelets suspended in heptane (10mg/mL) were mixed with hafnium n-butoxide and 5 mL of pentane, then loaded on a spray-drying set-up. On another side, an aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The resulting particles CdSe/CdZnS@HfO₂ were collected at the surface of a filter.

### 2nd step

50 mg of CdSe/CdZnS@HfO₂ particles were suspended in 20 mL of ethanol and mixed with TEOS, zirconium oxychloride and water, then loaded on a spray-drying set-up. The liquid was sprayed towards a tube furnace heated at a temperature ranging from the boiling point of the solvent to a temperature ranging from the boiling point of the solvent to 1000°C with a nitrogen flow. The luminescent particles CdSe/CdZnS@HfO₂@SiZrO₂ were collected at the surface of a filter.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing SiZrO₂ and/or HfO₂ with ZnTe, Al₂O₃, SiO₂, HfO₂, ZnSe, TiO₂, ZnO, ZnS, SiZrO₂, SiHfO₂ or MgO, or a mixture thereof. Reaction temperature of the above procedure is adapted according to the inorganic material chosen.

The same procedure was carried out by replacing SiZrO₂ and/or HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 27: CdSe/CdZnS@Al₂O₃@HfO₂

### 1st step

100 µL of CdSe/CdZnS nanoplatelets suspended in heptane (10mg/mL) were mixed with aluminium tri-sec butoxide and 5 mL of pentane, then loaded on a spray-drying set-up. On another side, an aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The resulting particles CdSe/CdZnS@Al₂O₃ (particles **2**) were collected at the surface of a filter.

### 2nd step

5mg of CdSe/CdZnS@Al₂O₃ particles were suspended in 5 mL of pentane and mixed with hafnium n-butoxide, then loaded on a spray-drying set-up. On another side, an aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The luminescent particles CdSe/CdZnS@Al₂O₃@HfO₂ were collected at the surface of a filter.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing Al₂O₃ and/or HfO₂ with ZnTe, TiO₂, Al₂O₃, SiO₂, HfO₂, ZnSe, ZnO, ZnS, SiZrO₂, SiHfO₂ or MgO, or a mixture thereof. Reaction temperature of the above procedure is adapted according to the inorganic material chosen.

The same procedure was carried out by replacing Al₂O₃ and/or HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 28: CdSe/CdZnS@Al₂O₃ and SnO₂ particles encapsulated in Al₂O₃

5mg of a previously prepared CdSe/CdZnS@Al₂O₃ particles (size: 150 nm) were suspended in 5 mL of pentane along with larger particles (SnO₂, 2 µm) and mixed with aluminium tri-sec butoxide, then loaded on a spray-drying set-up. On another side, a basic aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The luminescent particles, CdSe/CdZnS@Al₂O₃ and SnO₂ particles encapsulated in Al₂O₃, were collected at the surface of a filter.

Note: the amount of aluminium tri-sec butoxide is calculated so that the amount of Al₂O₃ formed would form a layer around the SnO₂ particle so that it is thicker than the solid diameter.

The same procedure was carried out by replacing CdSe/CdZnS nanoplatelets and/or SnO₂ particles with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets and/or SnO₂ particles with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing Al₂O₃ with ZnTe, Al₂O₃, TiO₂, SiO₂, HfO₂, ZnSe, ZnO, ZnS, SiZrO₂, SiHfO₂ or MgO, or a mixture thereof. Reaction temperature of the above procedure is adapted according to the inorganic material chosen.

The same procedure was carried out by replacing Al₂O₃ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 29: Phosphor particles@Al₂O₃@HfO₂

### 1st step

1µm of phosphor particles (*cf.* list below) suspended in heptane (10mg/mL) were mixed with aluminium tri-sec butoxide and 5 mL of pentane, then loaded on a spray-drying set-up. On another side, an aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The resulting particles phosphors particles@Al₂O₃ were collected at the surface of a filter.

### 2nd step

5mg of phosphors particles@Al₂O₃ were suspended in 5 mL of pentane and mixed with hafnium n-butoxide, then loaded on a spray-drying set-up. On another side, an aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The luminescent particles phosphor particles@Al₂O₃@HfO₂ were collected at the surface of a filter.

Phosphor particles used for this example were: Yttrium aluminium garnet particles (YAG, Y₃Al₅O₁₂), (Ca,Y)-α-SiAlON:Eu particles, ((Y,Gd)₃(Al,Ga)₅O₁₂:Ce) particles, CaAlSiN₃:Eu particles, sulfide-based phosphor particles, PFS:Mn⁴⁺ particles (potassium fluorosilicate).

The same procedure was carried out by replacing Al₂O₃ and/or HfO₂ with TiO₂, ZnTe, Al₂O₃, SiO₂, HfO₂, ZnSe, ZnO, ZnS, SiZrO₂, SiHfO₂ or MgO, or a mixture thereof. Reaction temperature of the above procedure is adapted according to the inorganic material chosen.

The same procedure was carried out by replacing Al₂O₃ and/or HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 30: CdSe/CdZnS@HfO₂@Al₂O₃

### 1st step

100 µL of CdSe/CdZnS nanoplatelets suspended in heptane (10mg/mL) were mixed with hafnium n-butoxide and 5 mL of pentane, then loaded on a spray-drying set-up. On another side, a basic aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The resulting particles CdSe/CdZnS@HfO₂ were collected at the surface of a filter.

### 2nd step

5mg of CdSe/CdZnS@HfO₂ particles were suspended in 5 mL of pentane and mixed with aluminium tri-sec butoxide, then loaded on a spray-drying set-up. On another side, a basic aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The luminescent particles CdSe/CdZnS@HfO₂@Al₂O₃ were collected at the surface of a filter.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing Al₂O₃ and/or HfO₂ with TiO₂, ZnTe, Al₂O₃, SiO₂, HfO₂, ZnSe, ZnO, ZnS, SiZrO₂, SiHfO₂ or MgO, or a mixture thereof. Reaction temperature of the above procedure is adapted according to the inorganic material chosen.

The same procedure was carried out by replacing Al₂O₃ and/or HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 31: CdSe/CdZnS@HfO₂ and SnO₂ particles encapsulated in Al₂O₃

5mg of a previously prepared CdSe/CdZnS@HfO₂ particles (size: 150 nm) were suspended in 5 mL of pentane along with larger particles (SnO₂, 2 µm) and mixed with aluminium tri-sec butoxide, then loaded on a spray-drying set-up. On another side, an aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The luminescent particles, CdSe/CdZnS@HfO₂ and SnO₂ particles encapsulated in Al₂O₃, were collected at the surface of a filter.

Note: the amount of aluminium tri-sec butoxide is calculated so that the amount of Al₂O₃ formed would form a layer around the SnO₂ particle so that it is thicker than the solid diameter.

The same procedure was carried out by replacing CdSe/CdZnS nanoplatelets and/or SnO₂ particles with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets and/or SnO₂ particles with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing Al₂O₃ and/or HfO₂ with TiO₂, ZnTe, Al₂O₃, SiO₂, HfO₂, ZnSe, ZnO, ZnS, SiZrO₂, SiHfO₂ or MgO, or a mixture thereof. Reaction temperature of the above procedure is adapted according to the inorganic material chosen.

The same procedure was carried out by replacing Al₂O₃ and/or HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 32: Phosphor particles@HfO₂@Al₂O₃

### 1st step

1µm of phosphor particles (*cf.* list below) suspended in heptane (10mg/mL) were mixed with hafnium n-butoxide and 5 mL of pentane, then loaded on a spray-drying set-up. On another side, an aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The resulting particles phosphors particles@HfO₂ were collected at the surface of a filter.

### 2nd step

5mg of phosphors particles@HfO₂ were suspended in 5 mL of pentane and mixed with aluminium tri-sec butoxide, then loaded on a spray-drying set-up. On another side, an aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The luminescent particles phosphor particles @HfO₂@Al₂O₃ were collected at the surface of a filter.

Phosphor particles used for this example were: Yttrium aluminium garnet particles (YAG, Y₃Al₅O₁₂), (Ca,Y)-α-SiAlON:Eu particles, ((Y,Gd)₃(Al,Ga)₅O₁₂:Ce) particles, CaAlSiN₃:Eu particles, sulfide-based phosphor particles, PFS:Mn⁴⁺ particles (potassium fluorosilicate).

The same procedure was carried out by replacing Al₂O₃ and/or HfO₂ with TiO₂, ZnTe, Al₂O₃, SiO₂, HfO₂, ZnSe, ZnO, ZnS, SiZrO₂, SiHfO₂ or MgO, or a mixture thereof. Reaction temperature of the above procedure is adapted according to the inorganic material chosen.

The same procedure was carried out by replacing Al₂O₃ and/or HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 33: Preparation of CdSe/CdZnS@HfO₂@SiO₂ comprising SnO₂ nanoparticles by microemulsion

CdSe/CdZnS@HfO₂ and SnO₂ nanoparticles (30-40nm diameter) were coated with SiO₂ using reverse micelles of polyoxyethylene cetylether (Nihon surfactant, C-15) using cyclohexane (purity 99.0%) as the organic phase. The concentration of the surfactant in the organic solvent was 0.5 mol/L. The microemulsion solution was prepared by injecting an aqueous solution (4.0 mL, denoted as aq.) containing 100mg of CdSe/CdZnS@HfO₂ and SnO₂ nanoparticles (varying proportions) into the organic surfactant solution (100 mL) at 50°C under magnetic stirring. An oxalic acid solution ((COOH)₂ aq., 1 mol/L, 3.0 mL) was used to charge positively the oxides surface. Tetraethylorthosilicate (TEOS, 0.86 mol/L in the microemulsion solution) as a SiO₂ source and diluted NH₄OH solution (2.70 mol/l, 15.0 ml) were charged into the microemulsion containing CdSe/CdZnS@HfO₂ and SnO₂ nanoparticles, and subjected to hydrolysis at 50°C for 60 min. The molar ratio of water to surfactant in the solution during TEOS hydrolysis was 23. The solid formed was centrifuged, thoroughly washed with propanol, dried at 80°C overnight, and a thermal treatment at 130°C for 24h was performed in air.

The same procedure was carried out by replacing CdSe/CdZnS nanoplatelets and/or SnO₂ nanoparticles with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets and/or SnO₂ nanoparticles with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing SiO₂ and/or HfO₂ with TiO₂, ZnTe, Al₂O₃, SiO₂, HfO₂, ZnSe, ZnO, ZnS, SiZrO₂, SiHfO₂ or MgO, or a mixture thereof. Reaction temperature of the above procedure is adapted according to the inorganic material chosen.

The same procedure was carried out by replacing SiO₂ and/or HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 34: Semiconductor nanoplatelets@Al₂O₃@SiO₂

The dry solid 0.05 g, *i.e.*, semiconductor nanoplatelets@Al₂O₃, is weighted under dry atmosphere (glovebox) and is dispersed in 1 mL of pure/dry THF, then 0.07 mL of 2.3 mol.L⁻¹ HCl solution is added. The solution is then heated in a closed vessel to 70°C. A solution (1 mL) containing TEOS (TetraEthyl OrthoSilicate) (0.5 mmol.L⁻¹) in clean THF is added dropwise over a period of 0.1 µmol.min⁻¹ under stirring. The mixture is then refluxed for about 1 h. The product is then filtered and washed consecutively with 20/80 water/THF (3 × 5 mL), EtOH (3 × 5 mL), and Et₂O (3 × 5 mL), and dried at 80°C under vacuum.

The same procedure was carried out by replacing semiconductor nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing Al₂O₃ and/or SiO₂ with TiO₂, ZnTe, Al₂O₃, SiO₂, HfO₂, ZnSe, ZnO, ZnS, SiZrO₂, SiHfO₂ or MgO, or a mixture thereof. Reaction temperature of the above procedure is adapted according to the inorganic material chosen.

The same procedure was carried out by replacing Al₂O₃ and/or SiO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 35: Semiconductor nanoplatelets@HfO₂@SiO₂

The dry solid 0.05 g, *i.e.*, semiconductor nanoplatelets@HfO₂, is weighted under dry atmosphere (glovebox) and is dispersed in 1 mL of pure/dry THF, then 0.07 mL of 2.3 mol.L⁻¹ HCl solution is added. The solution is then heated in a closed vessel to 70°C. A solution (1 mL) containing TEOS (TetraEthyl OrthoSilicate) (0.5 mmol.L⁻¹) in clean THF is added dropwise over a period of 0.1 µmol.min⁻¹ under stirring. The mixture is then refluxed for about 1 h. The product is then filtered and washed consecutively with 20/80 water/THF (3 × 5 mL), EtOH (3 × 5 mL), and Et₂O (3 × 5 mL), and dried at 80°C under vacuum.

Note 1: Trialkoxy Azidoalkyl silane, Trialkoxy Aminoalkyl silane or Trialkoxy alkylThiol silane can be added to the TEOS solution to add versatile functionalities the solid for further functionalization.

The same procedure was carried out by replacing semiconductor nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing HfO₂ and/or SiO₂ with TiO₂, ZnTe, Al₂O₃, SiO₂, HfO₂, ZnSe, ZnO, ZnS, SiZrO₂, SiHfO₂ or MgO, or a mixture thereof. Reaction temperature of the above procedure is adapted according to the inorganic material chosen.

The same procedure was carried out by replacing HfO₂ and/or SiO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 36: Semiconductor nanoplatelets@Al₂O₃@SiO₂

Semiconductor nanoplatelets@Al₂O₃ particles are dispersed in 16.7wt% H₂O in an anhydrous ethanol to reach 5 wt.% solid loading and then ultrasonicated to break down agglomerates. A 20 wt.% of TEOS+silane in ethanol solution (quantity varied to tune SiO₂ thickness) was carefully added to the suspension step by step. The amounts of added TEOS were calculated based on the surface area of semiconductor nanoplatelets@Al₂O₃ particle and the desired shell thickness, assuming complete conversion of TEOS to silica. The appropriate pH value of the suspension was adjusted using ammonia to pH = 11. Afterward, the suspension was stirred at 50°C for 6h to control the thickness of the coating layer through the hydrolysis and condensation of TEOS on the surface of semiconductor nanoplatelets@Al₂O₃ particle. Resulting particles were then collected by centrifuged, washed with anhydrous ethanol and dried in an oven at 80°C.

The same procedure was carried out by replacing semiconductor nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing Al₂O₃ and/or SiO₂ with ZnTe, TiO₂, Al₂O₃, SiO₂, HfO₂, ZnSe, ZnO, ZnS, SiZrO₂, SiHfO₂ or MgO, or a mixture thereof. Reaction temperature of the above procedure is adapted according to the inorganic material chosen.

The same procedure was carried out by replacing Al₂O₃ and/or SiO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 37: CdSe/CdZnS@HfO₂@SiO₂

### 1st step

100 µL of CdSe/CdZnS nanoplatelets suspended in heptane (10mg/mL) were mixed with Hafnium n-butoxide and 5 mL of pentane, then loaded on a spray-drying set-up. On another side, a basic aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The resulting particles CdSe/CdZnS@HfO₂ were collected at the surface of a filter.

### 2nd step

50 mg of CdSe/CdZnS@HfO₂ particles were suspended in 20 mL of water and mixed with TEOS and ammonia, then loaded on a spray-drying set-up. The liquid was sprayed towards a tube furnace heated at a temperature ranging from the boiling point of the solvent to 1000°C with a nitrogen flow. The luminescent particles CdSe/CdZnS@HfO₂@SiO₂ were collected at the surface of a filter.

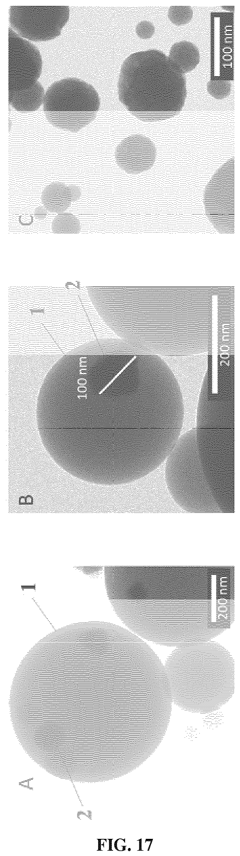

Fig. 17A and 17B show as-synthetized CdSe/CdZnS@HfO₂@SiO₂ particles.

Fig. 17C show a TEM image of HfO₂ particles, it is clear from that pictures that CdSe/CdZnS@HfO₂ seen in Figures 17A and 17B have a morphology consistent with HfO₂ particles.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing SiO₂ and/or HfO₂ with TiO₂, ZnTe, Al₂O₃, SiO₂, HfO₂, ZnSe, ZnO, ZnS, SiZrO₂, SiHfO₂ or MgO, or a mixture thereof. Reaction temperature of the above procedure is adapted according to the inorganic material chosen.

The same procedure was carried out by replacing SiO₂ and/or HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 38: Luminescent particles preparation from an organometallic precursor

100 µL of CdSe/CdZnS@HfO₂ particles suspended in heptane were mixed with an organometallic precursor selected in the group below in pentane under controlled atmosphere, then loaded on a spray-drying set-up. On another side, an aqueous solution was prepared and loaded on the same spray-drying set-up, but at a different location than the first heptane solution. The two liquids were sprayed simultaneously towards a tube furnace heated from room temperature to 300°C with a nitrogen flow. The particles were collected at the surface of a filter.

The procedure was carried out with an organometallic precursor selected in the group comprising: Al[N(SiMe₃)₂]₃, trimethyl aluminium, triisobutylaluminum, trioctylaluminum, triphenylaluminum, dimethyl aluminium, trimethyl zinc, dimethyl zinc, diethylzinc, Zn[(N(TMS)₂]₂, Zn[(CF₃SO₂)₂N]₂, Zn(Ph)₂, Zn(C₆F₅)₂, Zn(TMHD)₂ (β-diketonate), Hf[C₅H₄(CH₃)]₂(CH₃)₂, HfCH₃(OCH₃)[C₅H₄(CH₃)]₂, [[(CH₃)₃Si]₂N]₂HfCl₂, (C₅H₅)₂Hf(CH₃)₂, [(CH₂CH₃)₂N]₄Hf, [(CH₃)₂N]₄Hf, [(CH₃)₂N]₄Hf, [(CH₃)(C₂H₅)N]₄Hf, [(CH₃)(C₂H₅)N]₄Hf, 2,2',6,6'-tetramethyl-3,5-heptanedione zirconium (Zr(THD)₄), C₁₀H₁₂Zr, Zr(CH₃C₅H₄)₂CH₃OCH₃, C₂₂H₃₆Zr, [(C₂H₅)₂N]₄Zr, [(CH₃)₂N]₄Zr, [(CH₃)₂N]₄Zr, Zr(NCH₃C₂H₅)₄, Zr(NCH₃C₂H₅)₄, C₁₈H₃₂O₆Zr, Zr(C₈H₁₅O₂)₄, Zr(OCC(CH₃)₃CHCOC(CH₃)₃)₄, Mg(C₅H₅)₂, or C₂₀H₃₀Mg, or a mixture thereof. Reaction temperature of the above procedure is adapted according to the organometallic precursor chosen.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing HfO₂ with ZnTe, TiO₂, Al₂O₃, SiO₂, HfO₂, ZnSe, ZnO, ZnS, SiZrO₂, SiHfO₂ or MgO, or a mixture thereof.

The same procedure was carried out by replacing HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof.

The same procedure was carried out by replacing the aqueous solution with another liquid or vapor source of oxidation.

### Example 39: Luminescent particles preparation from an organometallic precursor-CdSe/CdZnS@HfO₂@ZnTe

100 µL of CdSe/CdZnS@HfO₂ particles suspended in heptane were mixed with two organometallic precursors selected in the group below in pentane under inert atmosphere then loaded on a spray-drying set-up. The suspension was sprayed towards a tube furnace heated from RT to 300°C with a nitrogen flow. The particles were collected at the surface of a filter.

The procedure was carried out by with a first organometallic precursor selected in the group comprising: dimethyl telluride, diethyl telluride, diisopropyl telluride, di-t-butyl telluride, diallyl telluride, methyl allyl telluride, dimethyl selenide, or dimethyl sulfur, or a mixture thereof. Reaction temperature of the above procedure is adapted according to the organometallic precursor chosen.

The procedure was carried out by with a second organometallic precursor selected in the group comprising: dimethyl zinc, trimethyl zinc, diethylzinc, Zn[(N(TMS)₂]₂, Zn[(CF₃SO₂)₂N]₂, Zn(Ph)₂, Zn(C₆F₅)₂, or Zn(TMHD)₂ (β-diketonate), or a mixture thereof. Reaction temperature of the above procedure is adapted according to the organometallic precursor chosen.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS2/ZnS, CuInSe2/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing ZnTe with ZnS or ZnSe, or a mixture thereof.

The same procedure was carried out by replacing HfO₂ with ZnTe, TiO₂, Al₂O₃, SiO₂, HfO₂, ZnSe, ZnO, ZnS, SiZrO₂, SiHfO₂ or MgO. The same procedure was carried out by replacing HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof.

The same procedure was carried out by replacing the aqueous solution with another liquid or vapor source of oxidation.

### Example 40: Luminescent particles preparation from an organometallic precursor - CdSe/CdZnS@HfO₂@ZnS

100 µL of CdSe/CdZnS@HfO₂ particles suspended in heptane were mixed with an organometallic precursor selected in the group below in pentane under inert atmosphere, then loaded on a spray-drying set-up. On another side, a vapor source of H₂S was inserted in the same spray-drying set-up. The suspension was sprayed towards a tube furnace heated from RT to 300°C with a nitrogen flow. The particles were collected at the surface of a filter.

The procedure was carried out with an organometallic precursor selected in the group omprising: dimethyl zinc, trimethyl zinc, diethylzinc, Zn[(N(TMS)₂]₂, Zn[(CF₃SO₂)₂N]₂, Zn(Ph)₂, Zn(C₆F₅)₂, Zn(TMHD)₂ (β-diketonate), or a mixture thereof. Reaction temperature of the above procedure is adapted according to the organometallic precursor chosen.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing ZnS with ZnSe or ZnTe, or a mixture thereof.

The same procedure was carried out by replacing HfO₂ with ZnTe, TiO₂, Al₂O₃, SiO₂, HfO₂, ZnSe, ZnO, ZnS, SiZrO₂, SiHfO₂ or MgO, or a mixture thereof. The same procedure was carried out by replacing HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer

The same procedure was carried out by replacing the aqueous solution with another liquid or vapor source of oxidation.

The same procedure was carried out by replacing H₂S with H₂Se, H₂Te or other gas.

### Example 41: Ink

Particles of the invention were prepared, collected and then dispersed in a solvent composed of 40 µl of toluene and 20 µl of PMMA (10 wt% in toluene). The resulting suspension was homogeneously mixed using ultrasonic bath (37 kHz, 480 W, sweep mode) for 1 minute.

### Example 42: Ink

0.1 g of particles of the invention having an emission peak centered at 620 nm were mixed with a mixed solvent of 70 g of chlorobenzene and 24.9 g of cyclohexane, and 5 g of Ttiton X-100 as an additive was added to the mixture to prepare an ink composition for inkjet printing.

### Example 43: Ink

10 mg of particles of the invention in toluene is added to 1.0 mL of Ebecyl 150 and degassed under reduced pressure to remove the toluene and oxygen. Once the toluene is removed, three purge and N₂ back-fill cycles are completed and then 10 mg of TiO₂ (1% by weight) is added to the formulation and the mixture is degassed under reduced pressure while stirring in order to disperse the TiO₂. The formulation is then ready for ink preparation.

### Example 44: Ink

An ink composition was prepared comprising: 40 wt.% to 60 wt. % polyethylene glycol dimethacrylate monomer, or polyethylene glycol diacrylate monomer (number average molecular weights in the range from about 230 g/mole to about 430 g mole); 25 wt.% to 50 wt.% monoacrylate monomer, or monomethacrylate monomer (viscosity in the range from about 10 cps to about 27 cps at 22 °C); 4 wt.% to 10 wt. % multifunctional acrylate crosslinking agent, or a multifunctional methacrylate crosslinking agent; and 0.1 wt.% to 10 wt.% crosslinking photoinitiator; and 0.01 wt.% to 50 wt.% particles of the invention.

The resulting ink composition has a surface tension of between about 32 dynes/cm and about 45 dynes/cm at 22 °C.

### Example 45: Ink

An ink composition was prepared comprising: from 30 wt. % to 50 wt. % of a polyethylene glycol dimethacrylate monomer, or a polyethylene glycol diacrylate monomer (number average molecular weights in the range from 230 g/mole to 430 g/mole); from 4 wt. % to 10 wt. % of a multifunctional acrylate crosslinking agent, or a multifunctional methacrylate crosslinking agent; from 40 wt. % to 60 wt. % of a spreading modifier comprising an alkoxylated aliphatic diacrylate monomer, or an alkoxylated aliphatic dimethacrylate monomer (viscosity in the range from 14 cps to 18 cps at 22°C and surface tension in the range from 35 dynes/cm to 39 dynes/cm at 22°C); and 0.01 wt.% to 50 wt.% particles of the invention.

### Example 46: Ink

An ink composition was prepared comprising: from 30 wt. % to 50 wt. % of a monomer selected from the group consisting of a polyethylene glycol dimethacrylate monomer, a polyethylene glycol diacrylate monomer (number average molecular weights in the range from 230 g/mole to 430 g/mole); from 4 wt. % to 10 wt. % of a crosslinking agent selected from the group consisting of a multifunctional acrylate crosslinking agent, a multifunctional methacrylate crosslinking agent; from 40 wt. % to 60 wt. % of a spreading modifier selected from the group consisting of an alkoxylated aliphatic diacrylate monomer, an alkoxylated aliphatic dimethacrylate monomer; and 0.01 wt.% to 50 wt.% particles of the invention.

The resulting ink composition has a viscosity in the range from 14 cps to 18 cps at 22°C. and a surface tension in the range from 35 dynes/cm to 39 dynes/cm at 22°C.

### Example 47: Ink

An ink composition was prepared comprising: 75-95 wt. % of a polyethylene glycol dimethacrylate monomer, or a polyethylene glycol diacrylate monomer (number average molecular weights in the range from about 230 g/mole to about 430 g/mole); 4-10 wt. % of pentaerythritol tetraacrylate, or pentaerythritol tetramethacrylate; 1-15 wt. % of a spreading modifier (viscosity in the range from about 14 to about 18 cps at 22°C and surface tension in the range from about 35 to about 39 dynes/cm at 22°C); and 0.01 wt.% to 50 wt.% particles of the invention.

### Example 48: Ink

An ink composition was prepared comprising: 70 wt. % to 96 wt. % di(meth)acrylate monomers or a combination of di(meth)acrylate monomers and mono(meth)acrylate monomers; 4 wt. % to 10 wt. % multifunctional (meth)acrylate crosslinking agent; and 0.1 wt. % to 5 wt. % particles of the invention; wherein said particles are particles **1** as prepared in the examples hereabove; or particles **2** as prepared in the examples hereabove;

The resulting ink composition has a viscosity in the range from 2 cps to 30 cps and a surface tension at 22° C. in the range from 25 dyne/cm to 45 dyne/cm at a temperature in the range from 22° C. to 40° C.

### REFERENCES

1 - Particle
11 - First material
12 - Core of the particle
13 - Shell of the particle
14 - Inorganic material
15 - Ink
2 -Particle
21 - Second material
22 - Core of the particle 2
23 - Shell of the particle 2
3 - Nanoparticle
31 - Spherical Nanoparticle
32 - 2D nanoparticle
33 - Core of a nanoparticle
34 - First shell of a nanoparticle
35 - Second shell of a nanoparticle
36 - Insulator shell of a nanoparticle
37 - Crown of a nanoparticle
4 - LED support
5 - LED chip
6 - Microsized LED
7 - Light emitting material
71 - Host material
8 - Bead
81 - Third material
9 - Dense particle
D - Pixel pitch

## Claims

1. An ink comprising:
- at least one particle (1) comprising a first material (11) and at least one liquid vehicle;
wherein the particle (1) comprises at least one particle (2) comprising a second material (21) and at least one nanoparticle (3) dispersed in said second material (21);
wherein the first material (11) and the second material (21) have an attenuation coefficient less or equal to 1×10⁻² cm⁻¹ at 460 nm;
wherein the at least one nanoparticle (3) is a luminescent nanoparticle and comprises at least 1% of semiconductor nanoplatelets; or
- at least one particle (2) comprising a plurality of nanoparticles (3) encapsulated in a material (21) and at least one liquid vehicle;
wherein said particle (2) has a surface roughness less or equal to 5% of the largest dimension of said particle (2), wherein said surface roughness is the height difference between the highest peak and the deepest cavity on the surface of said particle (2),
wherein the at least one nanoparticle (3) is a luminescent nanoparticle and comprises at least 1% of semiconductor nanoplatelets; or
- at least one particle (1) comprising a first material (11) and at least one liquid vehicle;
wherein the particle (1) comprises at least one particle (2) comprising a second material (21) and at least one nanoparticle (3) dispersed in said second material (21);
wherein said particle (1) has a surface roughness less or equal to 5% of the largest dimension of said particle (1), wherein said surface roughness is the height difference between the highest peak and the deepest cavity on the surface of said particle (1);
wherein the at least one nanoparticle (3) is a luminescent nanoparticle and comprises at least 1% of semiconductor nanoplatelets.

2. The ink according to claim **1,** wherein the first material (11) limits or prevents the diffusion of outer molecular species or fluids (liquid or gas) into said first material (11).

3. The ink according to claim **1** or **2,** wherein the first material (11) has a density ranging from 1 g/cm³ to 10 g/cm³.

4. The ink according to any one of claims **1** to **3,** wherein the first material (11) has a density superior or equal to the density of the second material (21).

5. The ink according to any one of claims **1** to **4,** wherein the first material (11) has a thermal conductivity at standard conditions of at least 0.1 W/(m.K).

6. The ink according to any one of claims **1** to **5,** wherein the at least one nanoparticle (3) is a semiconductor nanocrystal.

7. The ink according to claim **6,** wherein the semiconductor nanocrystal comprises a core comprising a material of formula MₓN_{y}E_{z}A_{w}, wherein:
M is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof;
N is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof;
E is selected from the group consisting of O, S, Se, Te, C, N, P, As, Sb, F, Cl, Br, I, or a mixture thereof;
A is selected from the group consisting of O, S, Se, Te, C, N, P, As, Sb, F, Cl, Br, I, or a mixture thereof; and
x, y, z and w are independently a decimal number from 0 to 5; x, y, z and w are not simultaneously equal to 0; x and y are not simultaneously equal to 0; z and w may not be simultaneously equal to 0.

8. The ink according to claim **6** or **7,** wherein the semiconductor nanocrystal comprises at least one shell comprising a material of formula MₓN_{y}E_{z}A_{w}, wherein:
M is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, A1, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof;
N is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof;
E is selected from the group consisting of O, S, Se, Te, C, N, P, As, Sb, F, Cl, Br, I, or a mixture thereof;
A is selected from the group consisting of O, S, Se, Te, C, N, P, As, Sb, F, Cl, Br, I, or a mixture thereof; and
x, y, z and w are independently a decimal number from 0 to 5; x, y, z and w are not simultaneously equal to 0; x and y are not simultaneously equal to 0; z and w may not be simultaneously equal to 0.

9. The ink according to claim **6** or **7,** wherein the semiconductor nanocrystal comprises at least one crown comprising a material of formula MₓN_{y}E_{z}A_{w}, wherein:
M is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof;
N is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof;
E is selected from the group consisting of O, S, Se, Te, C, N, P, As, Sb, F, Cl, Br, I, or a mixture thereof;
A is selected from the group consisting of O, S, Se, Te, C, N, P, As, Sb, F, Cl, Br, I, or a mixture thereof; and
x, y, z and w are independently a decimal number from 0 to 5; x, y, z and w are not simultaneously equal to 0; x and y are not simultaneously equal to 0; z and w may not be simultaneously equal to 0.

10. The ink according to any one of claims **6** to **9,** wherein the semiconductor nanocrystal is a semiconductor nanoplatelet.

11. The ink according to any one of claims **1** to **10,** wherein the at least one liquid vehicle comprises a liquid including but not limited to: 1-methoxy-2-propanol, 2-pyrrolidinone, C4 to C8 1,2-alkanediol, aliphatic or alicycle ketone, methyl ethyl ketone, C1-C4 alkanol such as for example methanol, ethanol, methanol propanol, or isopropanol, ketones, esters, ether of ethylene glycol or propylene glycol, acetals, acrylic resin, polyvinyl acetate, polyvinyl alcohol, polyamide resin, polyurethane resin, epoxy resin, alkyd ester, nitrated cellulose, ethyl cellulose, sodium carboxymethyl cellulose, alkyds, maleics, cellulose derivatives, formaldehyde, rubber resin, phenolics, propyl acetate, glycol ether, aliphatic hydrocarbon, acetate, ester acrylic, cellulose ester, nitrocellulose, modified resin, alkoxylated alcohol, 2-pyrrolidone, a homolog of 2-pyrrolidone, glycol, water, or a mixture thereof.

12. A pattern comprising at least one ink according to any one of claims **1** to **11** deposited by inkjet printing on a support.

13. The pattern according to claim **12,** wherein the support is a LED chip or microsized LED.

14. A particle (1) deposited on a support by inkjet printing;
wherein the particle (1) comprises:
- a first material (11), and at least one particle (2) comprising a second material (21) and at least one nanoparticle (3) dispersed in said second material (21); and
wherein the first material (11) and the second material (21) have an attenuation coefficient less or equal to 1×10⁻² cm⁻¹ at 460 nm;
wherein the at least one nanoparticle (3) is a luminescent nanoparticle and comprises at least 1%, of semiconductor nanoplatelets; or
- a first material (11), and at least one particle (2) comprising a second material (21) and at least one nanoparticle (3) dispersed in said second material (21); and
wherein said particle (1) has a surface roughness less or equal to 5% of the largest dimension of said particle (1), wherein said surface roughness is the height difference between the highest peak and the deepest cavity on the surface of said particle (1);
wherein the at least one nanoparticle (3) is a luminescent nanoparticle and comprises at least 1%, of semiconductor nanoplatelets.

15. A particle (2) deposited on a support by inkjet printing;
wherein said particle (2) comprises a plurality of nanoparticles (3) encapsulated in a material (21);
wherein said particle (2) has a surface roughness less or equal to 5% of the largest dimension of said particle (2), wherein said surface roughness is the height difference between the highest peak and the deepest cavity on the surface of said particle (2); and
wherein the nanoparticles (3) are luminescent nanoparticles and comprise at least 1%, of semiconductor nanoplatelets.

16. An optoelectronic device comprising at least one ink according to any-one of claims **1** to **11.**

17. A method for depositing an ink according to any-one of claims **1** to **11** on a support comprising:
- printing the ink on a support using inkjet printing; and
- evaporating the solvent and/or the liquid vehicle.

## Patentansprüche

1. Tinte, umfassend:
- mindestens ein Partikel (1), das ein erstes Material (11) und mindestens einen flüssigen Träger umfasst;
wobei das Partikel (1) mindestens ein Partikel (2) umfasst, welches ein zweites Material (21) und mindestens ein in dem zweiten Material (21) dispergiertes Nanopartikel (3) umfasst;
wobei das erste Material (11) und das zweite Material (21) einen Dämpfungskoeffizienten von kleiner als oder gleich 1×10⁻² cm⁻¹ bei 460 nm aufweisen;
wobei das mindestens eine Nanopartikel (3) ein lumineszierendes Nanopartikel ist und mindestens 1 % Halbleiter-Nanoplättchen umfasst; oder
- mindestens ein Partikel (2), das eine Vielzahl von in einem Material (21) verkapselten Nanopartikeln (3) und mindestens einen flüssigen Träger umfasst;
wobei das Partikel (2) eine Oberflächenrauigkeit von kleiner als oder gleich 5 % der größten Abmessung des Partikels (2) aufweist, wobei es sich bei der Oberflächenrauigkeit um die Höhendifferenz zwischen der höchsten Erhebung und der tiefsten Senke auf der Oberfläche des Partikels (2) handelt,
wobei das mindestens eine Nanopartikel (3) ein lumineszierendes Nanopartikel ist und mindestens 1 % Halbleiter-Nanoplättchen umfasst; oder
- mindestens ein Partikel (1), das ein erstes Material (11) und mindestens einen flüssigen Träger umfasst;
wobei das Partikel (1) mindestens ein Partikel (2) umfasst, das ein zweites Material (21) und mindestens ein in dem zweiten Material (21) dispergiertes Nanopartikel (3) umfasst;
wobei das Partikel (1) eine Oberflächenrauigkeit von kleiner als oder gleich 5 % der größten Abmessung des Partikels (1) aufweist, wobei es sich bei der Oberflächenrauigkeit um die Höhendifferenz zwischen der höchsten Erhebung und der tiefsten Senke auf der Oberfläche des Partikels (1) handelt;
wobei das mindestens eine Nanopartikel (3) ein lumineszierendes Nanopartikel ist und mindestens 1 % Halbleiter-Nanoplättchen umfasst.

2. Tinte nach Anspruch **1,** wobei das erste Material (11) die Diffusion von äußeren molekularen Spezies oder Fluiden (flüssig oder gasförmig) in das erste Material (11) begrenzt oder verhindert.

3. Tinte nach Anspruch **1** oder **2,** wobei das erste Material (11) eine Dichte im Bereich von 1 g/cm³ bis 10 g/cm³ aufweist.

4. Tinte nach einem der Ansprüche **1** bis **3,** wobei das erste Material (11) eine Dichte aufweist, die größer als oder gleich der Dichte des zweiten Materials (21) ist.

5. Tinte nach einem der Ansprüche **1** bis **4,** wobei das erste Material (11) eine Wärmeleitfähigkeit bei Standardbedingungen von mindestens 0,1 W/(m.K) aufweist.

6. Tinte nach einem der Ansprüche **1** bis **5,** wobei es sich bei dem mindestens einen Nanopartikel (3) um einen Halbleiter-Nanokristall handelt.

7. Tinte nach Anspruch **6,** wobei der Halbleiter-Nanokristall einen Kern umfasst, der ein Material der Formel MₓN_{y}E_{z}A_{w} umfasst, wobei:
M ausgewählt ist aus der Gruppe bestehend aus Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs, oder einer Mischung davon;
N ausgewählt ist aus der Gruppe bestehend aus Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs, oder einer Mischung davon;
E ausgewählt ist aus der Gruppe bestehend aus O, S, Se, Te, C, N, P, As, Sb, F, Cl, Br, I, oder einer Mischung davon;
A ausgewählt ist aus der Gruppe bestehend aus O, S, Se, Te, C, N, P, As, Sb, F, Cl, Br, I, oder einer Mischung davon; und
x, y, z und w unabhängig eine Dezimalzahl von 0 bis 5 sind; x, y, z und w nicht gleichzeitig gleich 0 sind; x und y nicht gleichzeitig gleich 0 sind; z und w nicht gleichzeitig gleich 0 sein dürfen.

8. Tinte nach Anspruch **6** oder **7,** wobei der Halbleiter-Nanokristall mindestens eine Schale umfasst, die ein Material der Formel MₓN_{y}E_{z}A_{w} umfasst, wobei:
M ausgewählt ist aus der Gruppe bestehend aus Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs, oder einer Mischung davon;
N ausgewählt ist aus der Gruppe bestehend aus Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs, oder einer Mischung davon;
E ausgewählt ist aus der Gruppe bestehend aus O, S, Se, Te, C, N, P, As, Sb, F, Cl, Br, I, oder einer Mischung davon;
A ausgewählt ist aus der Gruppe bestehend aus O, S, Se, Te, C, N, P, As, Sb, F, Cl, Br, I, oder einer Mischung davon; und
x, y, z und w unabhängig eine Dezimalzahl von 0 bis 5 sind; x, y, z und w nicht gleichzeitig gleich 0 sind; x und y nicht gleichzeitig gleich 0 sind; z und w nicht gleichzeitig gleich 0 sein dürfen.

9. Tinte nach Anspruch **6** oder **7,** wobei der Halbleiter-Nanokristall mindestens eine Krone umfasst, die ein Material der Formel MₓN_{y}E_{z}A_{w} umfasst, wobei:
M ausgewählt ist aus der Gruppe bestehend aus Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs, oder einer Mischung davon;
N ausgewählt ist aus der Gruppe bestehend aus Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs, oder einer Mischung davon;
E ausgewählt ist aus der Gruppe bestehend aus O, S, Se, Te, C, N, P, As, Sb, F, Cl, Br, I, oder einer Mischung davon;
A ausgewählt ist aus der Gruppe bestehend aus O, S, Se, Te, C, N, P, As, Sb, F, Cl, Br, I, oder einer Mischung davon; und
x, y, z und w unabhängig eine Dezimalzahl von 0 bis 5 sind; x, y, z und w nicht gleichzeitig gleich 0 sind; x und y nicht gleichzeitig gleich 0 sind; z und w nicht gleichzeitig gleich 0 sein dürfen.

10. Tinte nach einem der Ansprüche **6** bis **9,** wobei es sich bei dem Halbleiter-Nanokristall um ein Halbleiter-Nanoplättchen handelt.

11. Tinte nach einem der Ansprüche **1** bis **10,** wobei der mindestens eine flüssige Träger eine Flüssigkeit umfasst, einschließlich unter anderem: 1-Methoxy-2-propanol, 2-Pyrrolidinon, C4- bis C8-1,2-Alkandiol, aliphatisches oder alicyclisches Keton, Methylethylketon, C1-C4-Alkanol wie zum Beispiel Methanol, Ethanol, Methanolpropanol oder Isopropanol, Ketone, Ester, Ether von Ethylenglykol oder Propylenglykol, Acetale, Acrylharz, Polyvinylacetat, Polyvinylalkohol, Polyamidharz, Polyurethanharz, Epoxidharz, Alkydester, nitrierte Cellulose, Ethylcellulose, Natriumcarboxymethylcellulose, Alkyde, Maleine, Cellulosederivate, Formaldehyd, Gummiharz, Phenole, Propylacetat, Glykolether, aliphatischer Kohlenwasserstoff, Acetat, Ester, Acryl, Celluloseester, Nitrocellulose, modifiziertes Harz, alkoxylierter Alkohol, 2-Pyrrolidon, ein Homolog von 2-Pyrrolidon, Glykol, Wasser, oder eine Mischung davon.

12. Muster, das mindestens eine Tinte nach einem der Ansprüche **1** bis **11** umfasst, die durch Tintenstrahldruck auf eine Unterlage abgeschieden wurde.

13. Muster nach Anspruch **12,** wobei es sich bei der Unterlage um einen LED-Chip oder eine Micro-LED handelt.

14. Partikel (1), das durch Tintenstrahldruck auf eine Unterlage abgeschieden wird;
wobei das Partikel (1) umfasst:
- ein erstes Material (11), und mindestens ein Partikel (2), welches ein zweites Material (21) und mindestens ein in dem zweiten Material (21) dispergiertes Nanopartikel (3) umfasst; und
wobei das erste Material (11) und das zweite Material (21) einen Dämpfungskoeffizienten von kleiner als oder gleich 1×10⁻² cm⁻¹ bei 460 nm aufweisen;
wobei das mindestens eine Nanopartikel (3) ein lumineszierendes Nanopartikel ist und mindestens 1 % Halbleiter-Nanoplättchen umfasst; oder
- ein erstes Material (11), und mindestens ein Partikel (2), welches ein zweites Material (21) und mindestens ein in dem zweiten Material (21) dispergiertes Nanopartikel (3) umfasst; und
wobei das Partikel (1) eine Oberflächenrauigkeit von kleiner als oder gleich 5 % der größten Abmessung des Partikels (1) aufweist, wobei es sich bei der Oberflächenrauigkeit um die Höhendifferenz zwischen der höchsten Erhebung und der tiefsten Senke auf der Oberfläche des Partikels (1) handelt;
wobei das mindestens eine Nanopartikel (3) ein lumineszierendes Nanopartikel ist und mindestens 1 % Halbleiter-Nanoplättchen umfasst.

15. Partikel (2), das durch Tintenstrahldruck auf eine Unterlage abgeschieden wird;
wobei das Partikel (2) eine Vielzahl von in einem Material (21) verkapselten Nanopartikeln (3) umfasst;
wobei das Partikel (2) eine Oberflächenrauigkeit von kleiner als oder gleich 5 % der größten Abmessung des Partikels (2) aufweist, wobei es sich bei der Oberflächenrauigkeit um die Höhendifferenz zwischen der höchsten Erhebung und der tiefsten Senke auf der Oberfläche des Partikels (2) handelt; und
wobei die Nanopartikel (3) lumineszierende Nanopartikel sind und mindestens 1 % Halbleiter-Nanoplättchen umfassen.

16. Optoelektronische Vorrichtung, die mindestens eine Tinte nach einem der Ansprüche **1** bis **11** umfasst.

17. Verfahren zum Abscheiden einer Tinte nach einem der Ansprüche **1** bis **11** auf eine Unterlage, umfassend:
- Drucken der Tinte unter Verwendung von Tintenstrahldruck auf eine Unterlage; und
- Verdunsten des Lösungsmittels und/oder des flüssigen Trägers.

## Revendications

1. Encre comprenant :
- au moins une particule (1) comprenant un premier matériau (11) et au moins un véhicule liquide ;
dans laquelle la particule (1) comprend au moins une particule (2) comprenant un second matériau (21) et au moins une nanoparticule (3) dispersée dans ledit second matériau (21) ;
dans laquelle le premier matériau (11) et le second matériau (21) ont un coefficient d'atténuation inférieur ou égal à 1×10⁻² cm⁻¹ à 460 nm ;
dans laquelle la au moins une nanoparticule (3) est une nanoparticule luminescente et comprend au moins 1% de nanoplaquettes semi-conductrices ; ou
- au moins une particule (2) comprenant une pluralité de nanoparticules (3) encapsulées dans un matériau (21) et au moins un véhicule liquide ;
dans laquelle ladite particule (2) a une rugosité de surface inférieure ou égale à 5% de la plus grande dimension de ladite particule (2), dans laquelle ladite rugosité de surface est la différence de hauteur entre le pic le plus élevé et la cavité la plus profonde sur la surface de ladite particule (2),
dans laquelle la au moins une nanoparticule (3) est une nanoparticule luminescente et comprend au moins 1% de nanoplaquettes semi-conductrices ; ou
- au moins une particule (1) comprenant un premier matériau (11) et au moins un véhicule liquide ;
dans laquelle la particule (1) comprend au moins une particule (2) comprenant un second matériau (21) et au moins une nanoparticule (3) dispersée dans ledit second matériau (21) ;
dans laquelle ladite particule (1) a une rugosité de surface inférieure ou égale à 5% de la plus grande dimension de ladite particule (1), dans laquelle ladite rugosité de surface est la différence de hauteur entre le pic le plus élevé et la cavité la plus profonde sur la surface de ladite particule (1) ;
dans laquelle la au moins une nanoparticule (3) est une nanoparticule luminescente et comprend au moins 1% de nanoplaquettes semi-conductrices.

2. Encre selon la revendication 1, dans laquelle le premier matériau (11) limite ou empêche la diffusion d'espèces moléculaires extérieures ou de fluides (liquide ou gaz) dans ledit premier matériau (11).

3. Encre selon la revendication 1 ou 2, dans laquelle le premier matériau (11) a une densité allant de 1 g/cm³ à 10 g/cm³.

4. Encre selon l'une quelconque des revendications 1 à 3, dans laquelle le premier matériau (11) a une densité supérieure ou égale à la densité du deuxième matériau (21).

5. Encre selon l'une quelconque des revendications 1 à 4, dans laquelle le premier matériau (11) a une conductivité thermique aux conditions standard d'au moins 0,1 W/(m.K).

6. Encre selon l'une quelconque des revendications 1 à 5, dans laquelle la au moins une nanoparticule (3) est un nanocristal semi-conducteur.

7. Encre selon la revendication 6, dans laquelle le nanocristal semi-conducteur comprend un coeur comprenant un matériau de formule MₓN_{y}E_{z}A_{w}, dans laquelle :
M est choisi dans le groupe constitué de Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs ou un mélange de ceux-ci ;
N est choisi dans le groupe constitué par Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs ou un mélange de ceux-ci ;
E est choisi dans le groupe constitué par O, S, Se, Te, C, N, P, As, Sb, F, Cl, Br, I, ou un mélange de ceux-ci ;
A est choisi dans le groupe constitué par O, S, Se, Te, C, N, P, As, Sb, F, Cl, Br, I, ou un mélange de ceux-ci ; et
x, y, z et w sont indépendamment un nombre décimal de 0 à 5 ; x, y, z et w ne sont pas simultanément égaux à 0 ; x et y ne sont pas simultanément égaux à 0 ; z et w peuvent ne pas être simultanément égaux à 0.

8. Encre selon la revendication 6 ou 7, dans laquelle le nanocristal semi-conducteur comprend au moins une coque comprenant un matériau de formule MₓN_{y}E_{z}A_{w}, dans laquelle :
M est choisi dans le groupe constitué de Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs ou un mélange de ceux-ci ;
N est choisi dans le groupe constitué par Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs ou un mélange de ceux-ci ;
E est choisi dans le groupe constitué par O, S, Se, Te, C, N, P, As, Sb, F, Cl, Br, I, ou un mélange de ceux-ci ;
A est choisi dans le groupe constitué par O, S, Se, Te, C, N, P, As, Sb, F, Cl, Br, I, ou un mélange de ceux-ci ; et
x, y, z et w sont indépendamment un nombre décimal de 0 à 5 ; x, y, z et w ne sont pas simultanément égaux à 0 ; x et y ne sont pas simultanément égaux à 0 ;
z et w peuvent ne pas être simultanément égaux à 0.

9. Encre selon la revendication 6 ou 7, dans laquelle le nanocristal semi-conducteur comprend au moins une couronne comprenant un matériau de formule MₓN_{y}E_{z}A_{w}, dans laquelle :
M est choisi dans le groupe constitué de Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs ou un mélange de ceux-ci ;
N est choisi dans le groupe constitué par Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs ou un mélange de ceux-ci ;
E est choisi dans le groupe constitué par O, S, Se, Te, C, N, P, As, Sb, F, Cl, Br, I, ou un mélange de ceux-ci ;
A est choisi dans le groupe constitué par O, S, Se, Te, C, N, P, As, Sb, F, Cl, Br, I, ou un mélange de ceux-ci ; et
x, y, z et w sont indépendamment un nombre décimal de 0 à 5 ; x, y, z et w ne sont pas simultanément égaux à 0 ; x et y ne sont pas simultanément égaux à 0 ;
z et w peuvent ne pas être simultanément égaux à 0.

10. Encre selon l'une quelconque des revendications 6 à 9, dans laquelle le nanocristal semi-conducteur est une nanoplaquette semi-conductrice.

11. Encre selon l'une quelconque des revendications 1 à 10, dans laquelle le au moins un véhicule liquide comprend un liquide comprenant notamment : le 1-méthoxy-2-propanol, la 2-pyrrolidinone, le 1,2-alcanediol en C4 à C8, la cétone aliphatique ou alicyclique, la méthyléthylcétone, l'alcanol en C1-C4 comme par exemple le méthanol, l'éthanol, le méthanol propanol, ou l'isopropanol, les cétones, les esters, l'éther d'éthylène glycol ou de propylène glycol, les acétals, la résine acrylique, l'acétate de polyvinyle, alcool polyvinylique, résine polyamide, résine polyuréthane, résine époxy, ester alkyde, cellulose nitrée, éthylcellulose, carboxyméthylcellulose sodique, alkydes, maléiques, dérivés de la cellulose, formaldéhyde, résine de caoutchouc, phénoliques, acétate de propyle, éther de glycol, hydrocarbure aliphatique, acétate, ester acrylique, ester de cellulose, nitrocellulose, résine modifiée, alcool alcoxylé, 2-pyrrolidone, un homologue de la 2-pyrrolidone, glycol, eau, ou un mélange de ceux-ci.

12. Motif comprenant au moins une encre selon l'une quelconque des revendications 1 à 11 déposée par impression jet d'encre sur un support.

13. Motif selon la revendication 12, dans lequel le support est une puce de DEL ou une DEL de taille réduite.

14. Une particule (1) déposée sur un support par impression à jet d'encre ;
dans laquelle la particule (1) comprend :
- un premier matériau (11), et au moins une particule (2) comprenant un second matériau (21) et au moins une nanoparticule (3) dispersée dans ledit second matériau (21) ; et
dans laquelle le premier matériau (11) et le second matériau (21) ont un coefficient d'atténuation inférieur ou égal à 1×10⁻² cm⁻¹ à 460 nm ;
dans laquelle la au moins une nanoparticule (3) est une nanoparticule luminescente et comprend au moins 1% de nanoplaquettes semi-conductrices ; ou
- un premier matériau (11), et au moins une particule (2) comprenant un second matériau (21) et au moins une nanoparticule (3) dispersée dans ledit second matériau (21) ; et
dans laquelle ladite particule (1) a une rugosité de surface inférieure ou égale à 5% de la plus grande dimension de ladite particule (1), dans lequel ladite rugosité de surface est la différence de hauteur entre le pic le plus élevé et la cavité la plus profonde sur la surface de ladite particule (1) ;
dans laquelle la au moins une nanoparticule (3) est une nanoparticule luminescente et comprend au moins 1% de nanoplaquettes semi-conductrices.

15. Une particule (2) déposée sur un support par impression à jet d'encre ;
dans laquelle ladite particule (2) comprend une pluralité de nanoparticules (3) encapsulées dans un matériau (21) ;
dans laquelle ladite particule (2) a une rugosité de surface inférieure ou égale à 5% de la plus grande dimension de ladite particule (2), dans laquelle ladite rugosité de surface est la différence de hauteur entre le pic le plus élevé et la cavité la plus profonde sur la surface de ladite particule (2) ; et
dans laquelle les nanoparticules (3) sont des nanoparticules luminescentes et comprennent au moins 1% de nanoplaquettes semi-conductrices.

16. Dispositif optoélectronique comprenant au moins une encre selon l'une quelconque des revendications 1 à 11.

17. Procédé de dépôt d'une encre selon l'une quelconque des revendications 1 à 11 sur un support comprenant :
- - l'impression de l'encre sur un support en utilisant l'impression à jet d'encre ; et
- - l'évaporation du solvant et/ou du véhicule liquide.
